# EUROPEAN PATENT SPECIFICATION

(11) **EP 3 675 194 B1**
(45) Date of publication and mention of the grant of the patent: **05.04.2023**
(21) Application number: 19220143.2
(22) Date of filing: 30.12.2019
(51) Int. Cl.: H01L 51/00

(54) **ORGANIC LIGHT-EMITTING DEVICE AND APPARATUS INCLUDING THE SAME**
ORGANISCHE LICHTEMITTIERENDE VORRICHTUNG UND EINRICHTUNG DAMIT
DISPOSITIF ÉLECTROLUMINESCENT ET APPAREIL LE COMPRENANT

(30) Priority: 28.12.2018 JP 2018248433; 04.09.2019 KR 20190109515
(43) Date of publication of application: 01.07.2020
(73) Proprietor: Samsung Electronics Co., Ltd., Gyeonggi-do 16677 (KR)
(72) Inventor: NUMATA, Masaki, Yokohama-shi, Kanagawa 230-0027 (JP); KINOSHITA, Masaru, Yokohama-shi, Kanagawa 230-0027 (JP); ITO, Mitsunori, Yokohama-shi, Kanagawa 230-0027 (JP); SOTOYAMA, Wataru, Yokohama-shi, Kanagawa 230-0027 (JP)
(74) Representative: Elkington and Fife LLP

(56) References cited:
- EP-A1- 3 244 466
- WO-A1-2013/112557
- US-A1- 2014 070 196

## Description

### FIELD OF THE INVENTION

One or more embodiments relate to an organic light-emitting device and an apparatus including the same.

### BACKGROUND OF THE INVENTION

Organic light-emitting devices are self-emission devices that produce full-color images, and also have wide viewing angles, high contrast ratios, short response times, and excellent characteristics in terms of brightness, driving voltage, and response speed, compared to devices in the art.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light. The prior art EP 3 244 466 A1 discloses an organic light emitting device which includes a first and second compound in the emission layer and a third compound in the hole transport layer.

### SUMMARY OF THE INVENTION

Aspects of the present disclosure provide an organic light-emitting device including an emission layer including three compounds that are different from each other, and an apparatus including the organic light-emitting device.

Additional aspects will be set forth in part in the description which follows and, in part, will be apparent from the description, or may be learned by practice of the presented embodiments.

An aspect of the present disclosure provides an organic light-emitting device including:
a first electrode;
a second electrode; and
an emission layer between the first electrode and the second electrode,
wherein the emission layer includes a first compound, a second compound, and a third compound,
the first compound includes at least one compound represented by one of Formulae 1-1 to 1-4,
the second compound includes at least one compound represented by one of Formulae 2-1 to 2-4, and
the third compound includes at least one compound containing at least one group selected from a triphenylene group, a dibenzofuran group, a dibenzothiophene group, a fluorene group, and a biscarbazole group, wherein a band gap between a highest occupied molecular orbital (HOMO) energy level and a lowest unoccupied molecular orbital (LUMO) energy level of the third compound is 3.3 eV or more:

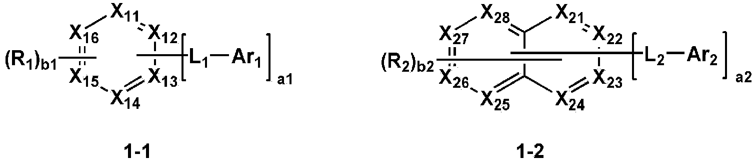

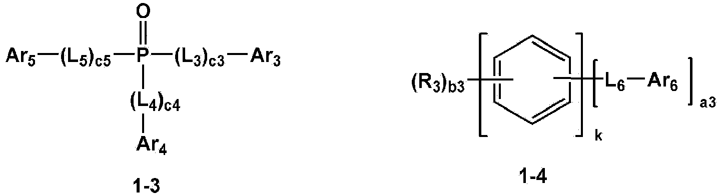

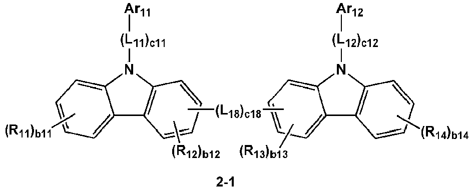

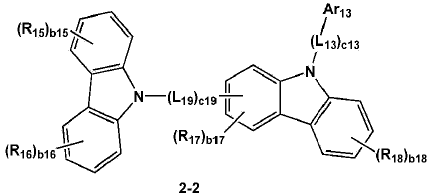

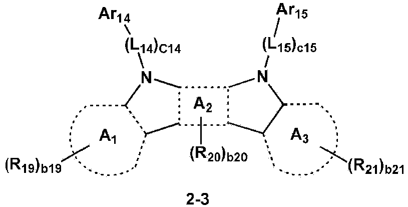

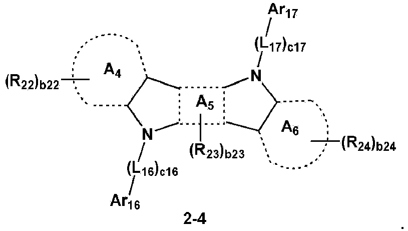

In Formulae 1-1 to 1-4,
X₁₁ to X₁₆ and X₂₁ to X₂₈ may each independently be C or N,
at least one selected from X₁₁ to X₁₆ may be N,
at least one selected from X₂₁ to X₂₈ may be N,
L₁ to L₆ may each independently be selected from a single bond, a substituted or unsubstituted C₆-C₃₀ arylene group, a substituted or unsubstituted C₁-C₃₀ heteroarylene group, a divalent non-aromatic condensed polycyclic group, and a divalent non-aromatic condensed heteropolycyclic group,
c3 to c5 may each independently be an integer from 1 to 3,
Ar₁ to Ar₆ may each independently be selected from a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group,
any two adjacent groups among Ar₃ to Ar₅ may optionally be linked to each other to form a condensed ring via a single bond,
a1 to a3 may each independently be an integer from 1 to 3,
R₁ to R₃ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b1 may be an integer from 0 to 4,
b2 may be an integer from 0 to 6,
b3 may be an integer from 7 to 11, and
k may be 3 or 4.

In Formulae 2-1 to 2-4,
A₁ to A₆ may each independently be selected from a C₅-C₃₀ carbocyclic group and a C₁-C₃₀ heterocyclic group,
L₁₁ to L₁₉ may each independently be selected from a single bond, a substituted or unsubstituted C₆-C₃₀ arylene group, a substituted or unsubstituted C₁-C₃₀ heteroarylene group, a substituted or unsubstituted divalent non-aromatic condensed polycyclic group, and a substituted or unsubstituted divalent non-aromatic condensed heteropolycyclic group,
c11 to c19may each independently be an integer from 1 to 3,
Ar₁₁, Ar₁₂, and Ar₁₄ to Ar₁₇ may each independently be selected from a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group, wherein each of Ar₁₄ and Ar₁₅ may not be an indolocarbazole group, and each of Ar₁₆ and Ar₁₇ may not be a naphthyl group at the same time,
Ar₁₃ may be selected from a substituted or unsubstituted C₆-C₃₀ aryl group and a substituted or unsubstituted monovalent non-aromatic condensed polycyclic group,
R₁₁ to R₂₄ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group, a substituted or unsubstituted C₆-C₃₀ aryl group, and a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group,
b11, b14, b15, b16, and b18 to b24 may each independently be an integer from 0 to 4,
b12, b13, and b17 may each independently be an integer from 0 to 3,
at least one substituent of the substituted C₆-C₃₀ arylene group, the substituted C₁-C₃₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₆-C₃₀ aryl group, the substituted C₁-C₃₀ heteroaryl group, the substituted monovalent non-aromatic condensed polycyclic group, and the substituted monovalent non-aromatic condensed heteropolycyclic group may be selected from:
   deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇) and -P(=O)(Q₂₈)(Q₂₉); and
   -N(Q₃₁)(Q₃₂), -Si(Q₃₃)(Q₃₄)(Q₃₅), -B(Q₃₆)(Q₃₇), and -P(=O)(Q₃₈)(Q₃₉), and
   Q1 to Q9, Q11 to Q19, Q21 to Q29, and Q31 to Q39 may each independently be selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

Another aspect of the present disclosure provides an apparatus including the organic light-emitting device. For example, the apparatus may include a light-emitting device and an electronic device, wherein the light-emitting device may include a lightening and a display, and the electronic device may include a computer, a mobile phone, an electronic dictionary, a medical device, and a projector.

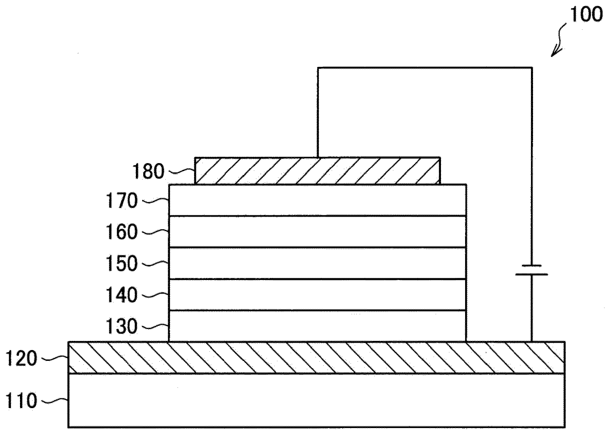

### BRIEF DESCRIPTION OF THE DRAWING

These and/or other aspects will become apparent and more readily appreciated from the following description of the embodiments, taken in conjunction with FIGURE which is a schematic view of an organic light-emitting device according to an embodiment.

### DETAILED DESCRIPTION OF THE EMBODIMENTS

Hereinafter, the present disclosure will be described in detail by explaining embodiments with reference to the accompanying drawing. In addition, like reference numerals in the present specification and drawing denote like elements having substantially the same functions and/or features, and thus their description will be omitted.

It will be understood that when an element is referred to as being "on" another element, it can be directly on the other element or intervening elements may be present therebetween In contrast, when an element is referred to as being "directly on" another element, there are no intervening elements present

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.
Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

An aspect of the present disclosure provides an organic light-emitting device including: a first electrode; a second electrode; and an emission layer between the first electrode and the second electrode, wherein the emission layer includes a first compound, a second compound, and a third compound, the first compound includes at least one compound represented by one of Formulae 1-1 to 1-4, the second compound includes at least one compound represented by one of Formulae 2-1 to 2-4, and the third compound includes at least one compound containing at least one group selected from a triphenylene group, a dibenzofuran group, a dibenzothiophene group, a fluorene group, and a biscarbazole group, wherein a band gap between a highest occupied molecular orbital (HOMO) band energy level and a lowest unoccupied molecular orbital (LUMO) band energy level of the third compound is 3.3 eV or more:

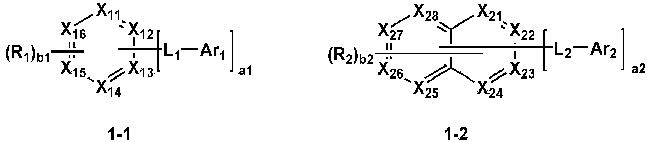

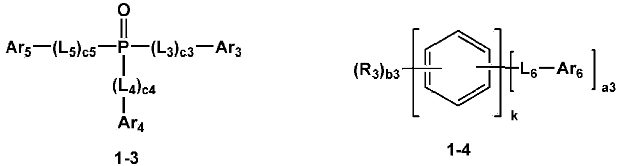

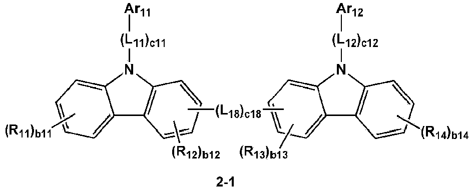

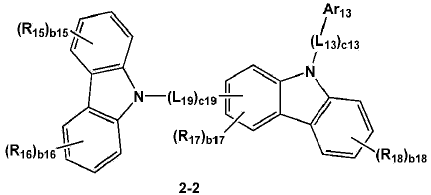

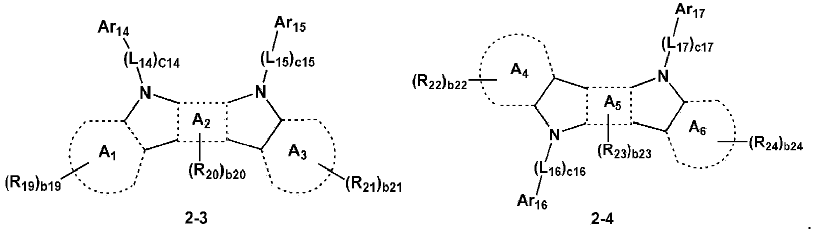

Formulae 1-1 to 1-4 will be described in detail below.

X₁₁ to X₁₆ and X₂₁ to X₂₈ may each independently be C or N.

In one embodiment, at least one selected from X₁₁ to X₁₆ may be N, and at least one selected from X₂₁ to X₂₈ may be N.

For example, (i) X₁₁ may be N, and X₁₂ to X₁₆ may each be C, (ii) X₁₁ and X₁₂ may each be N, and X₁₃ to X₁₆ may each be C, (iii) X₁₁ and X₁₃ may each be N, and X₁₂ and X₁₄ to X₁₆ may each be C, (iv) X₁₁ and X₁₄ may each be N, and X₁₂, X₁₃, X₁₆, and X₁₆ may each be C, (v) X₁₁ to X₁₃ may each be N, and X₁₄ to X₁₆ may each be C, (vi) X₁₁, X₁₂, and X₁₄ may each be N, and X₁₃, X₁₆, and X₁₆ may each be C, or (vii) X₁₁, X₁₃, and X₁₅ may each be N, and X₁₂, X₁₄, and X₁₆ may each be C.

For example, (i) X₂₁ may be N, and X₂₂ to X₂₈ may each be C, (ii) X₂₂ may be N, and X₂₁ and X₂₃ to X₂₈ may each be C, (iii) X₂₁ and X₂₂ may each be N, and X₂₃ to X₂₈ may each be C, (iv) X₂₁ and X₂₃ may each be N, and X₂₂ and X₂₄ to X₂₈ may each be C, or (v) X₂₁ and X₂₄ may each be N, and X₂₂, X₂₃, and X₂₅ to X₂₈ may each be C.

L₁ to L₆ may each independently be selected from a single bond, a substituted or unsubstituted C₆-C₃₀ arylene group, a substituted or unsubstituted C₁-C₃₀ heteroarylene group, a divalent non-aromatic condensed polycyclic group, and a divalent non-aromatic condensed heteropolycyclic group.

In one embodiment, L₁ to L₆ and L₁₁ to L₁₉ may each independently be selected from:
a single bond, a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzoimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments of the present disclosure are not limited thereto.
c3 to c5 may each independently be an integer from 1 to 3.

Ar₁ to Ar₆ may each independently be selected from a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group, wherein any two adjacent groups among Ar₃ to Ar₅ may optionally be linked to each other via a single bond to form a condensed ring.

In one embodiment, Ar₁ to Ar₆ may each independently be selected from:
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an indolocarbazolyl group, an indolodibenzofuranyl group, an indolodibenzothiophenyl group, an indolofluorenyl group, an indolospiro-fluorenyl group, an indolophenanthrenyl group, an indolotriphenylenyl group, an indoloazadibenzofuranyl group, and an indoloazadibenzothiophenyl group; and
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an indolocarbazolyl group, an indolodibenzofuranyl group, an indolodibenzothiophenyl group,an indolofluorenyl group, an indolospiro-fluorenyl group, an indolophenanthrenyl group, an indolotriphenylenyl group, an indoloazadibenzofuranyl group, and an indoloazadibenzothiophenyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an indolocarbazolyl group, an indolodibenzofuranyl group, an indolodibenzothiophenyl group,an indolofluorenyl group, an indolospiro-fluorenyl group, an indolophenanthrenyl group, an indolotriphenylenyl group, an indoloazadibenzofuranyl group, and an indoloazadibenzothiophenyl group, but embodiments of the present disclosure are not limited thereto.
a1 to a3 may each independently be an integer from 1 to 3.

In one embodiment, when a1 is an integer of 2 or more, two or more -L₁-Ar₁ group(s) may be identical to or different from each other. For example, when a1 is 3, three -L₁-Ar₁ group(s) may be different from each other. When having such a structure, a compound may have low crystallinity, thereby improving dissolubility of the compound.

In one or more embodiments, when a2 is an integer of 2 or more, two or more -L₂-Ar₂ group(s) may be identical to or different from each other. For example, when a2 is 2, two -L₂-Ar₂ group(s) may be different from each other. When having such a structure, a compound may have low crystallinity, thereby improving dissolubility of the compound.

In one or more embodiments, when a3 is an integer of 2 or more, two or more -L₆-Ar₆ group(s) may be identical to or different from each other. For example, when a3 is 2, two -L₆-Ar₆ group(s) may be different from each other. When having such a structure, a compound may have low crystallinity, thereby improving dissolubility of the compound.

R₁ to R₃ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group.

In one or more embodiments, R₁ to R₃ may each independently be selected from:
hydrogen, deuterium, -F, -Cl, -Br, -I, a cyano group, a C₁-C₂₀ alkyl group, and a C₁-C₂₀ alkoxy group; and
a C₁-C₂₀ alkyl group and a C₁-C₂₀ alkoxy group, each substituted with at least one selected from deuterium, -F, -Cl, -Br, -I, a cyano group, a C₁-C₂₀ alkyl group, and a C₁-C₂₀ alkoxy group, but embodiments of the present disclosure are not limited thereto.

For example, R₁ to R₃ may each independently be selected from:
hydrogen, deuterium, -F, -Cl, -Br, -I, a cyano group, a methyl group, an ethyl group, a propyl group, an isopropyl group, a butyl group, an isobutyl group, a tert-butyl group, a sec-butyl group, a methoxy group, an ethoxy group, a propoxy group, and a butoxy group; and
a methyl group, an ethyl group, a propyl group, an isopropyl group, a butyl group, an isobutyl group, a tert-butyl group, a sec-butyl group, a methoxy group, an ethoxy group, a propoxy group, and a butoxy group, each substituted with at least one selected from deuterium, -F, -Cl, -Br, -I, a cyano group, a methyl group, an ethyl group, a propyl group, an isopropyl group, a butyl group, an isobutyl group, a tert-butyl group, a sec-butyl group, a methoxy group, an ethoxy group, a propoxy group, and a butoxy group.
b1 may be an integer from 0 to 4, b2 may be an integer from 0 to 6, and b3 may be an integer from 7 to 11.
k may be 3 or 4.

In one embodiment, when k is 3, a compound having a structure in which three benzene rings are condensed, for example, an anthracene group or a phenanthrene group may be included. When k is 4, a compound having a structure in which four benzene rings are condensed, for example, a chrysene group, a tetracene group, or a benzanthracene group may be included.

Hereinafter, Formulae 2-1 to 2-4 will be described in detail.

A₁ to A₆ may each independently be selected from a C₅-C₃₀ carbocyclic group and a C₁-C₃₀ heterocyclic group.

In one embodiment, A₁, A₂, A₃, A₄, A₅, and A₆ may each independently be selected from:
a benzene group, a naphthalene group, an anthracene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and benzothiadiazole group, but embodiments of the present disclosure are not limited thereto.

For example, A₂ and A₅ may each independently be a benzene group or a naphthalene group, and A₁, A₃, A₄, and A₆ may each independently be selected from a benzene group, a naphthalene group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a benzopyrazole group, a benzimidazole group, a benzoxazole group, a benzothiazole group, a benzoxadiazole group, and benzothiadiazole group.

For example, A₁ to A₆ may be all benzene groups.

L₁₁ to L₁₉ may each independently be selected from a single bond, a substituted or unsubstituted C₆-C₃₀ arylene group, a substituted or unsubstituted C₁-C₃₀ heteroarylene group, a substituted or unsubstituted divalent non-aromatic condensed polycyclic group, and a substituted or unsubstituted divalent non-aromatic condensed heteropolycyclic group.

L₁₁ to L₁₉ may each be understood by referring to description presented herein. c11 to c19 may each independently be an integer from 1 to 3.

Ar₁₁, Ar₁₂, and Ar₁₄ to Ar₁₇ may each independently be selected from a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group, neither of Ar₁₄ and Ar₁₅ may be an indolocarbazole group, and each of Ar₁₆ and Ar₁₇ may not be a naphthyl group at the same time.

In one embodiment, Ar₁₁, Ar₁₂, and Ar₁₄ to Ar₁₇ may each independently be selected from:
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and a group represented by Formula a below; and
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and a group represented by Formula a below, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and -N(Q₁₁)(Q₁₂),
neither of Ar₁₄ and Ar₁₅ may be an indolocarbazole group, and each of Ar₁₆ and Ar₁₇ may not be a naphthalene group at the same time, and
Q₁₁ and Q₁₂ may each independently be selected from a phenyl group, a biphenyl group, a terphenyl group, and a naphthyl group:

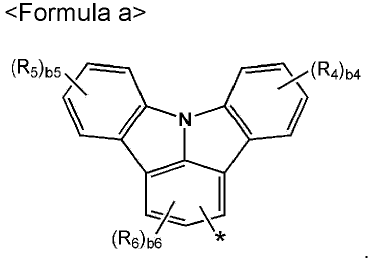

In Formula a,
R₄ to R₆ may each independently be selected from:
hydrogen, deuterium, -F, -Cl, -Br, -I, a cyano group, a C₁-C₂₀ alkyl group, and a C₁-C₂₀ alkoxy group; and
a C₁-C₂₀ alkyl group and a C₁-C₂₀ alkoxy group, each substituted with at least one selected from deuterium, -F, -Cl, -Br, -I, a cyano group, a C₁-C₂₀ alkyl group, and a C₁-C₂₀ alkoxy group,
b4 is an integer from 0 to 4,
b5 is an integer from 0 to 4,
b6 is an integer from 0 to 2, and
"*" indicates a binding site to a neighboring group.

Ar₁₃ may be selected from a substituted or unsubstituted C₆-C₃₀ aryl group and a substituted or unsubstituted monovalent non-aromatic condensed polycyclic group.

In one embodiment, Ar₁₃ may be selected from:
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group;
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group, but embodiments of the present disclosure are not limited thereto.
R₁₁ to R₂₄ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group, a substituted or unsubstituted C₆-C₃₀ aryl group, and a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group.

In one embodiment, R₁₁ to R₂₄ may each independently be selected from:
hydrogen, deuterium, -F, -Cl, -Br, -I, a cyano group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, and a cyano group;
a phenyl group, a biphenyl group, a terphenyl group, a fluorenyl group, a spiro-fluorenyl group, a benzofluorenyl group, a dibenzofluorenyl group, a pyridinyl group, a pyrazinyl group, a pyrimidinyl group, a pyridazinyl group, a carbazolyl group, a dibenzofuranyl group, a dibenzothiophenyl group, a benzocarbazolyl group, and a dibenzocarbazolyl group; and
a phenyl group, a biphenyl group, a terphenyl group, a fluorenyl group, a spiro-fluorenyl group, a benzofluorenyl group, a dibenzofluorenyl group, a pyridinyl group, a pyrazinyl group, a pyrimidinyl group, a pyridazinyl group, a carbazolyl group, a dibenzofuranyl group, a dibenzothiophenyl group, a benzocarbazolyl group, and a dibenzocarbazolyl group, each substituted with at least one selected from a C₁-C₂₀ alkyl group, a C₁-C₂₀ alkoxy group, a phenyl group, a biphenyl group, a terphenyl group, a fluorenyl group, a spiro-fluorenyl group, a benzofluorenyl group, a dibenzofluorenyl group, a pyridinyl group, a pyrazinyl group, a pyrimidinyl group, a pyridazinyl group, a carbazolyl group, a dibenzofuranyl group, a dibenzothiophenyl group, a benzocarbazolyl group, and a dibenzocarbazolyl group that are each substituted with at least one selected from deuterium, -F, -Cl, -Br, -I, and a cyano group, but embodiments of the present disclosure are not limited thereto.
b11, b14, b15, b16, and b18 to b24 may each independently be an integer from 0 to 4.
b12, b13, and b17 may each independently be an integer from 0 to 3.

The third compound may include at least one group selected from groups represented by Formulae 3-1 to 3-4:

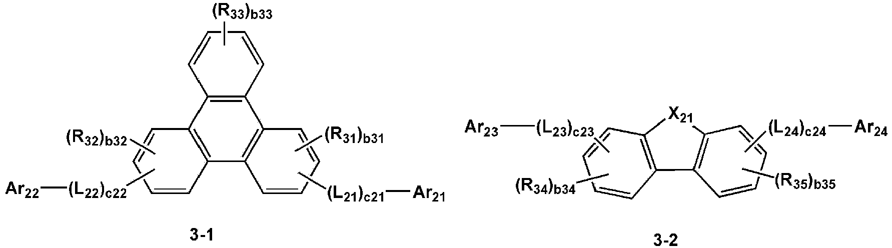

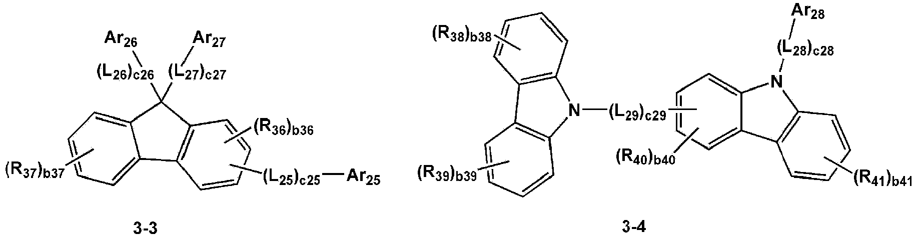

In Formulae 3-1 to 3-4,
X₂₁ may be O or S,
L₂₁ to L₂₉ may each independently be selected from a single bond, a substituted or unsubstituted C₆-C₃₀ arylene group, a substituted or unsubstituted C₁-C₃₀ heteroarylene group, a divalent non-aromatic condensed polycyclic group, and a divalent non-aromatic condensed heteropolycyclic group,
c21 to c29 may each independently be an integer from 1 to 3,
Ar₂₁ to Ar₂₈ may each independently be selected from hydrogen, a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group,
each of Ar₂₁ and Ar₂₂ may not be hydrogen at the same time,
Ar₂₆ and Ar₂₇ may optionally be linked to form a condensed ring via a single bond,
R₃₁ to R₄₁ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b31, b32, b34, b35, b36, and b40 may each independently be an integer from 0 to 3, and
b33, b37, b38, b39, and b41 may each independently be an integer from 0 to 4.

In one embodiment, Ar₂₃ and Ar₂₄ in Formula 3-2 may be different from each other, and when having such a structure, a compound may have low crystallinity, thereby improving dissolubility of the compound.

In one embodiment, L₂₁ to L₂₉ may each independently be selected from:
a single bond, a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzoimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a pentalenyl group, an indenyl group, a naphthyl group, an azulenyl group, a heptalenyl group, an indacenyl group, an acenaphthyl group, a fluorenyl group, a spiro-fluorenylene group, a benzofluorenylene group, a dibenzofluorenylene group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments of the present disclosure are not limited thereto.

In one embodiment, Ar₂₁ to Ar₂₈ may each independently be selected from:
hydrogen, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group;
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group.

In one embodiment, Formula 1-1 may be represented by Formula 1-1(1),
Formula 1-2 may be represented by Formula 1-2(1), and
Formula 1-4 may be represented by one of Formulae 1-4(1), 1-4(2), and 1-4(3):

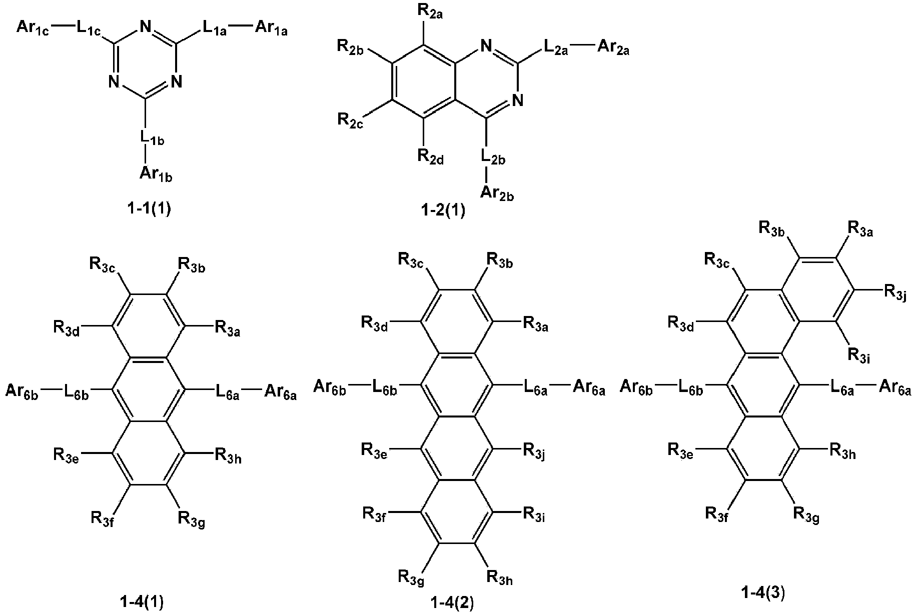

In Formula 1-1(1) L₁ₐ, L_{1b}, and L_{1c} may each independently be understood by referring to the description presented in connection with L₁, and Ar₁ₐ, Ar_{1b}, and Ar_{1c} may each independently be understood by referring to the description presented in connection with Ar₁.

In Formula 1-2(1), L₂ₐ and L_{2b} may each independently be understood by referring to the description presented in connection with L₂, Ar₂ₐ and Ar_{2b} may each independently be understood by referring to the description presented in connection with Ar₂, and R₂ₐ, R_{2b}, R_{2c}, and R_{2d} may each independently be understood by referring to the description presented in connection with R₂.

In Formula 1-4(1) to 1-4(3), L₆ₐ and L_{6b} may each independently be understood by referring to the description presented in connection with L₆, Ar₆ₐ and Ar_{6b} may each independently be understood by referring to the description presented in connection with Ar₆ and R₃ₐ to R₃ⱼ may each independently be understood by referring to the description presented in connection with R₃.

In Formula 1-1(1), Ar₁ₐ, Ar_{1b}, and Ar_{1c} may be different from each other, and a compound having such a structure may have low crystallinity, thereby improving dissolubility of the compound.

The first compound may include at least one of the following compounds:

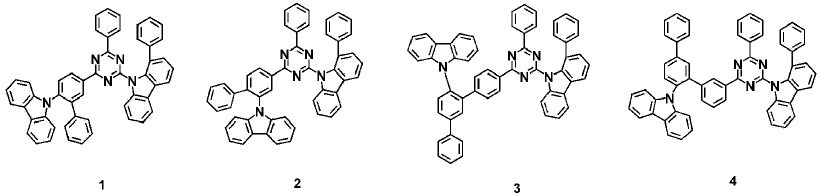

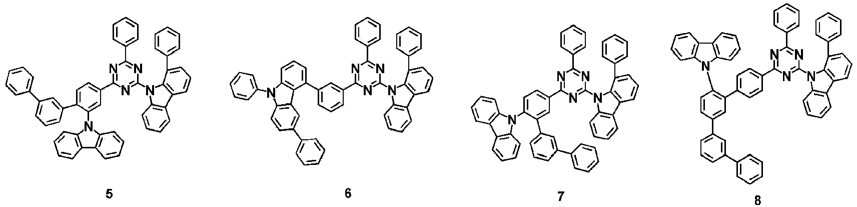

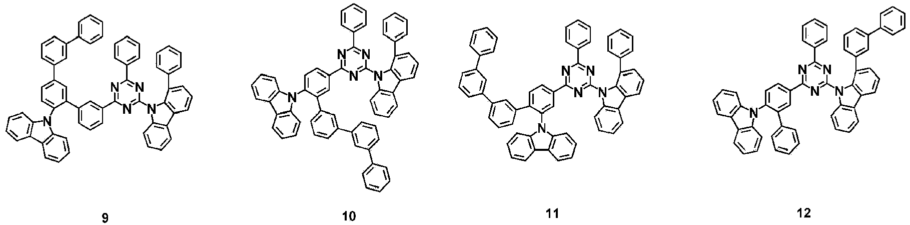

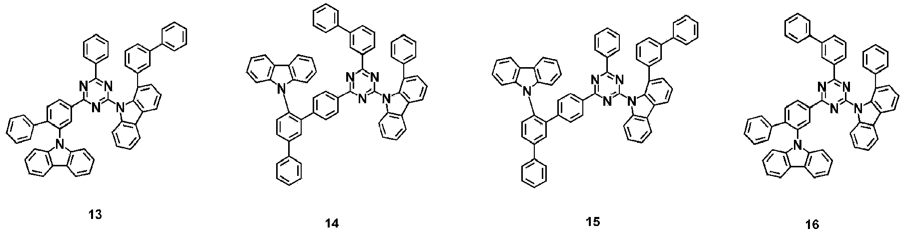

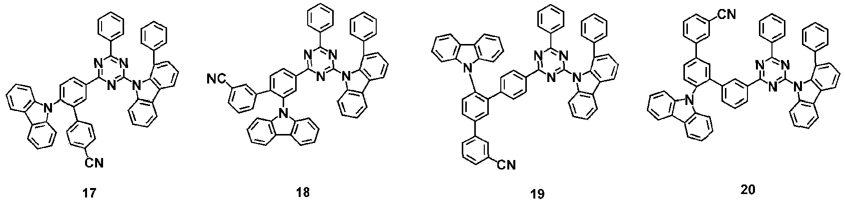

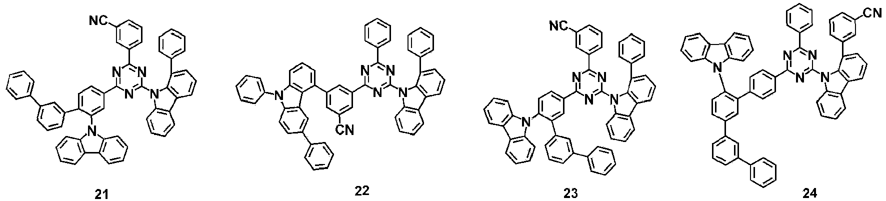

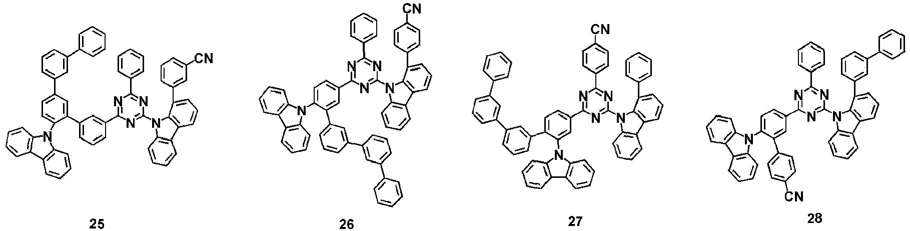

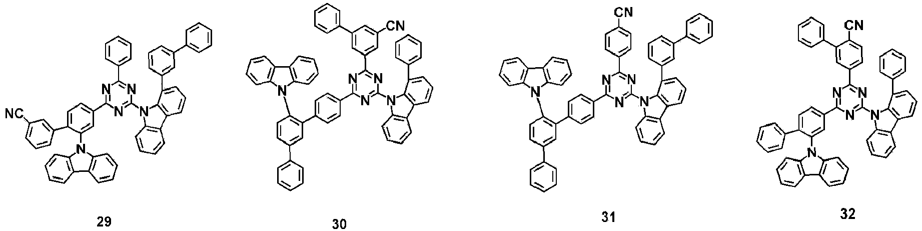

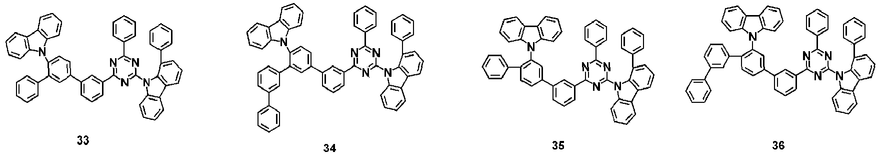

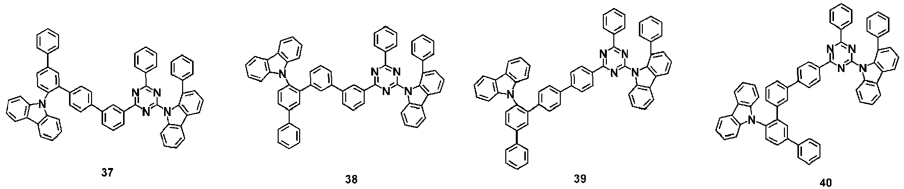

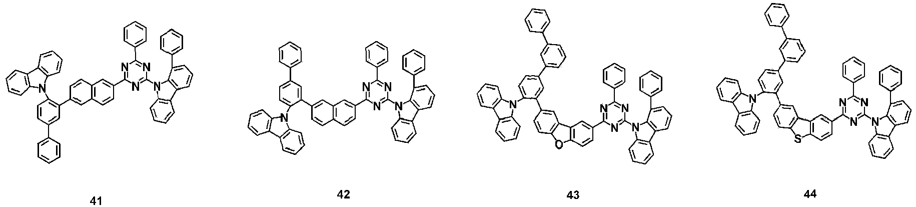

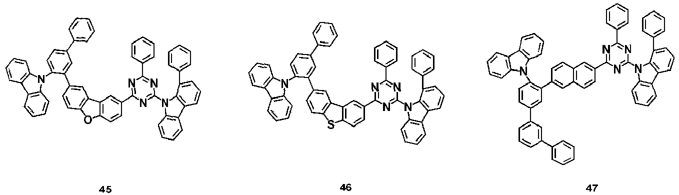

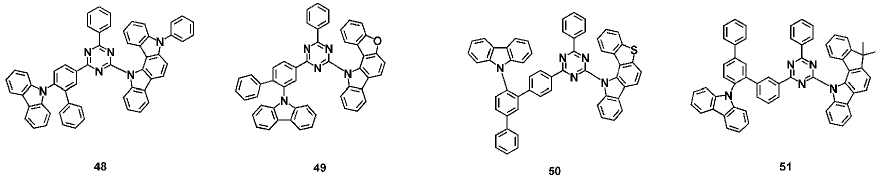

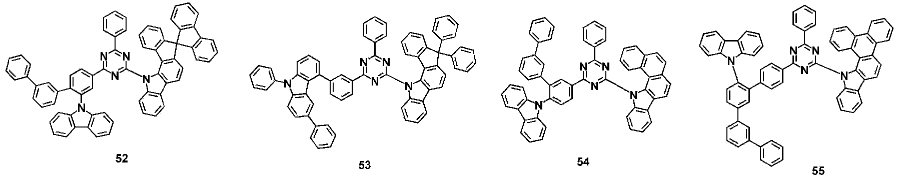

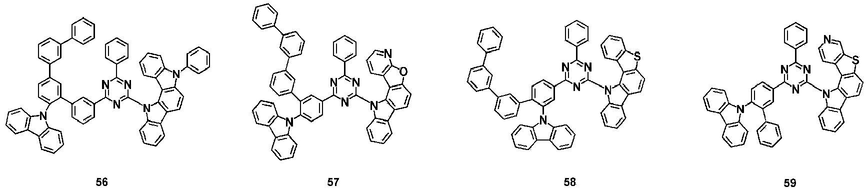

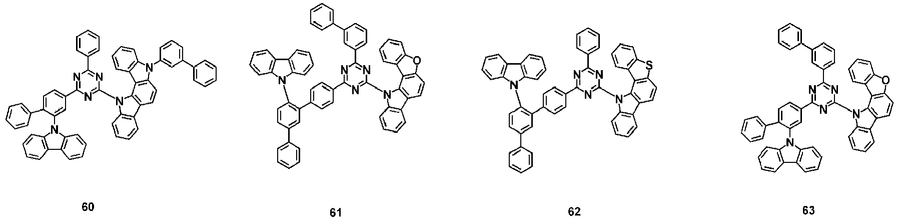

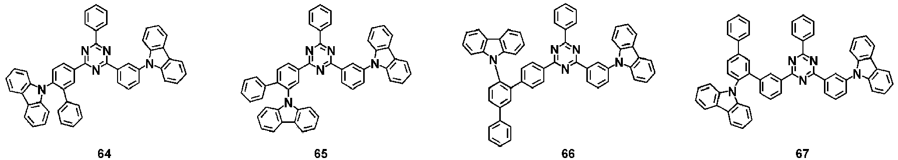

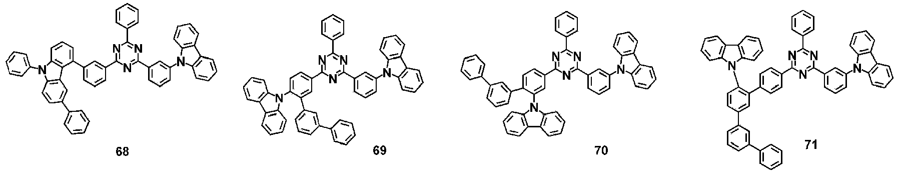

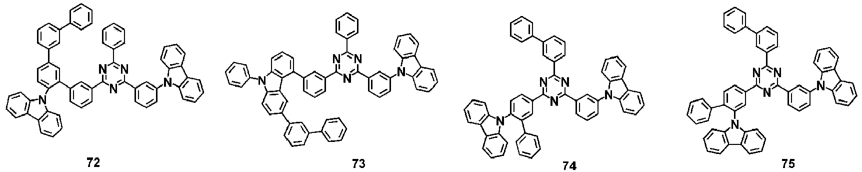

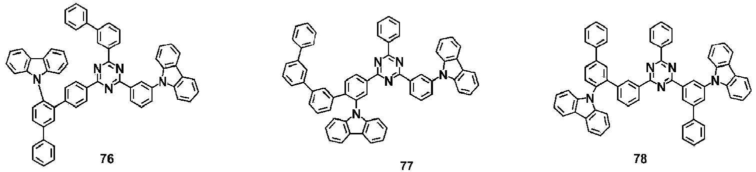

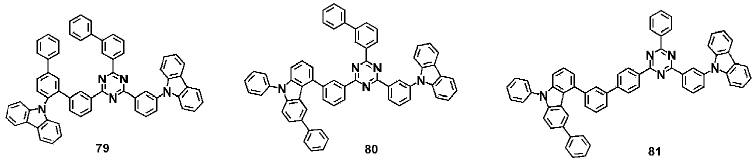

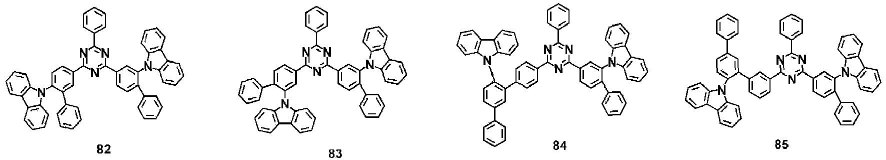

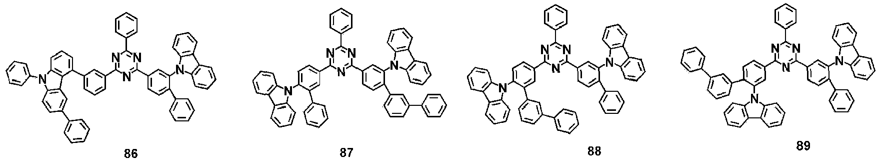

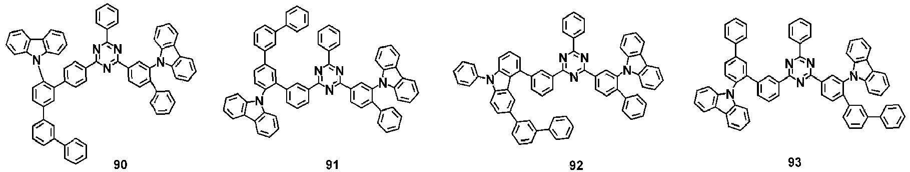

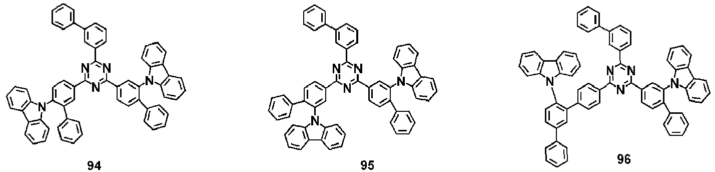

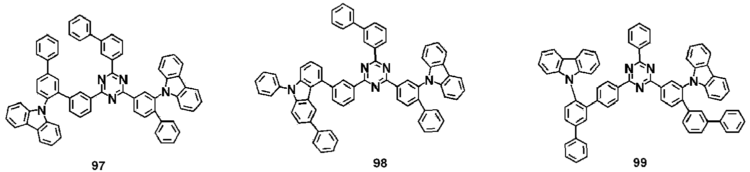

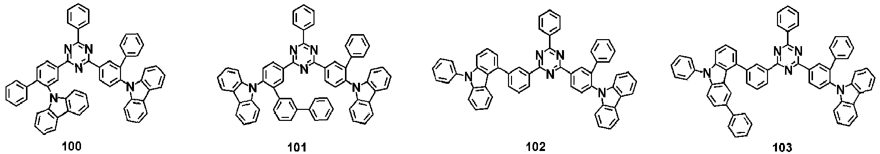

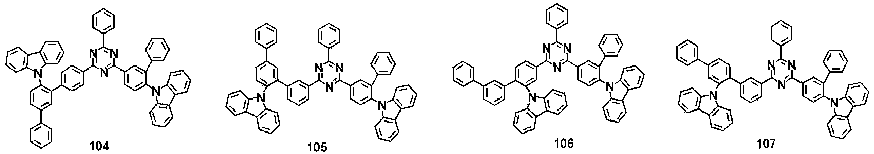

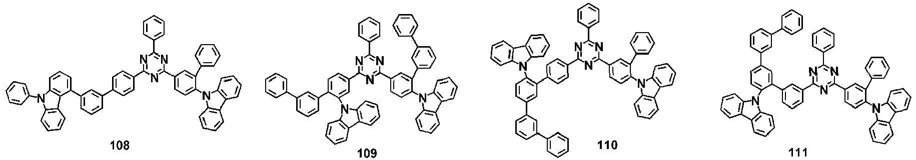

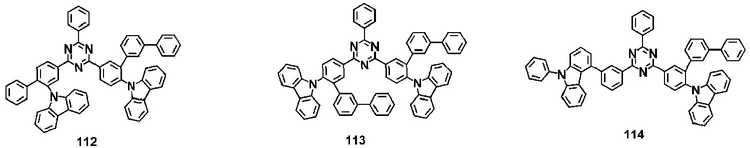

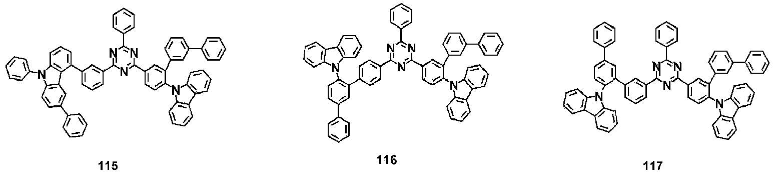

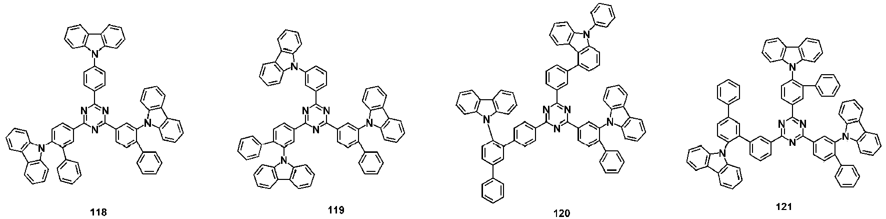

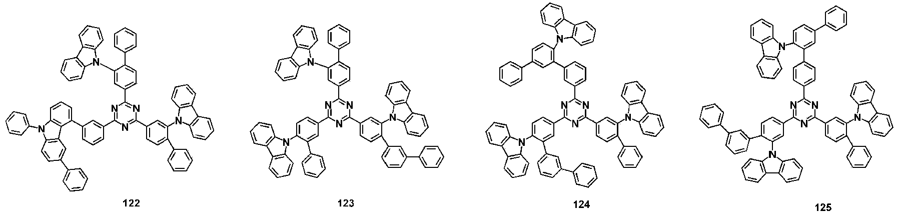

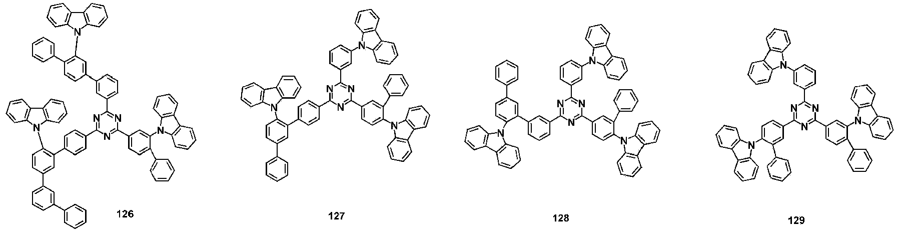

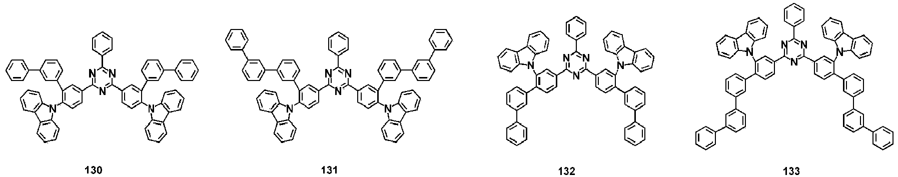

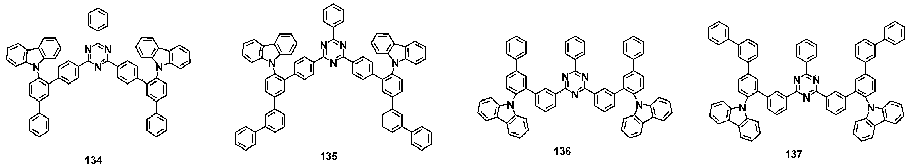

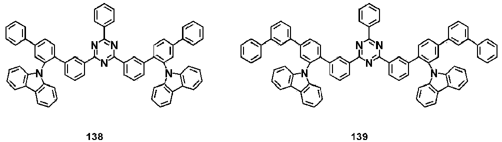

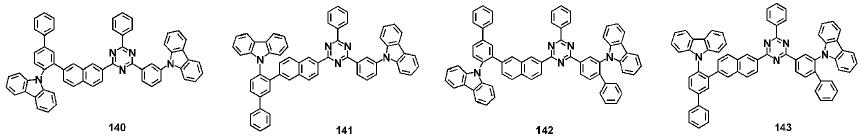

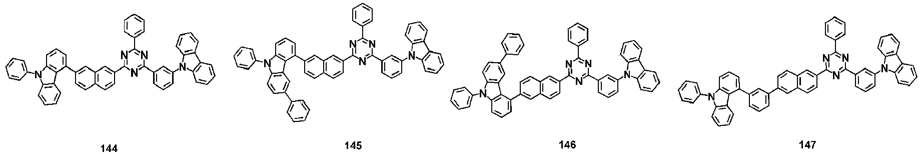

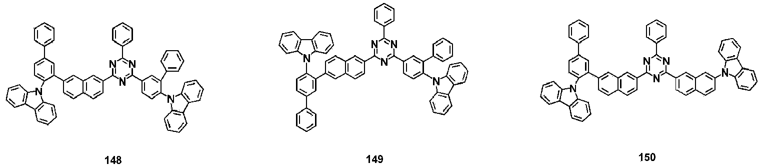

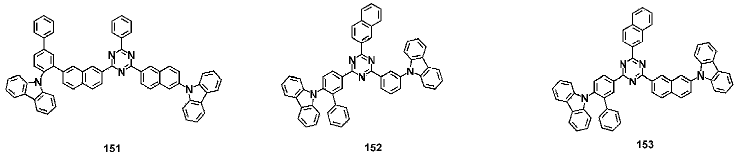

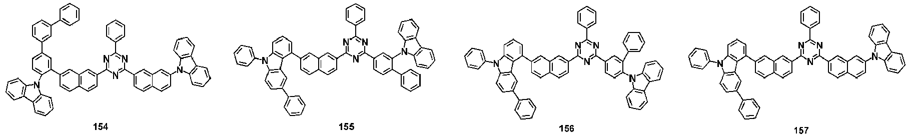

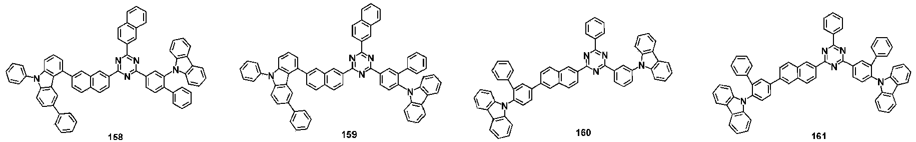

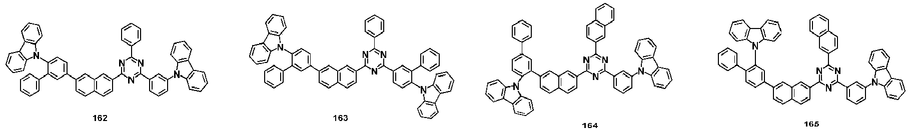

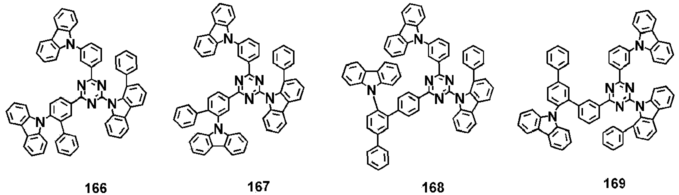

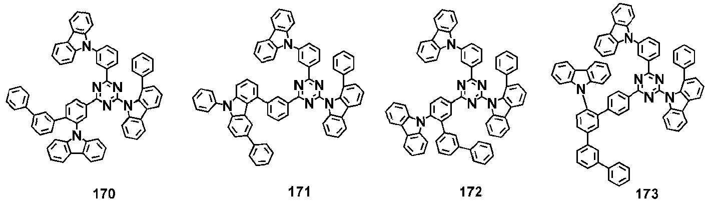

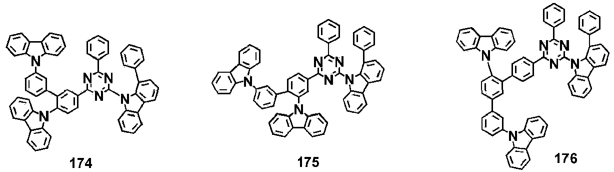

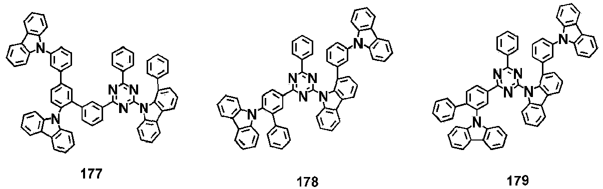

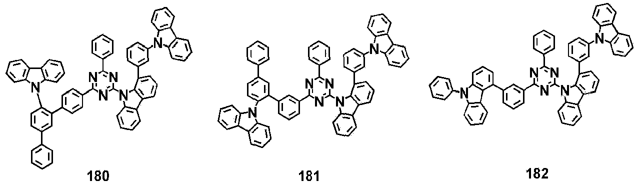

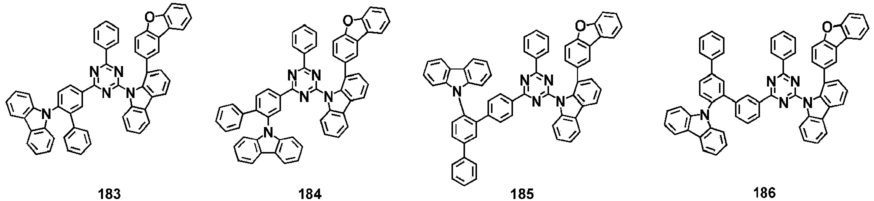

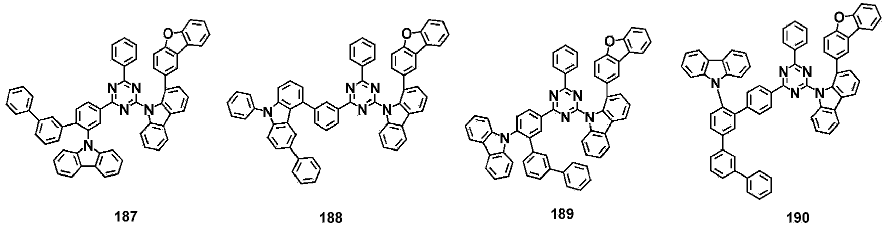

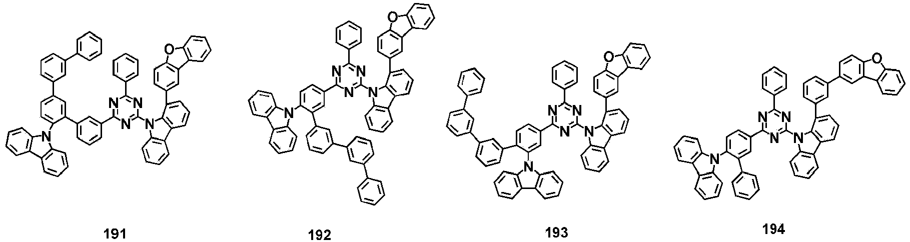

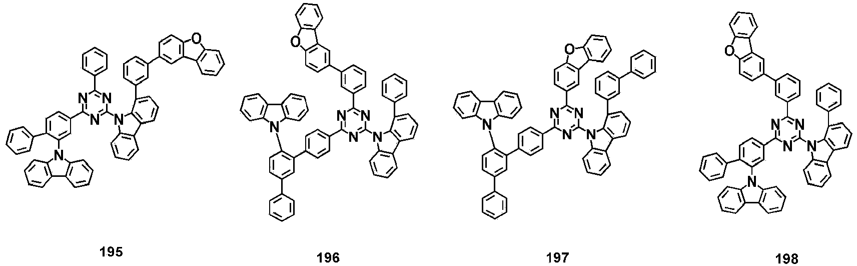

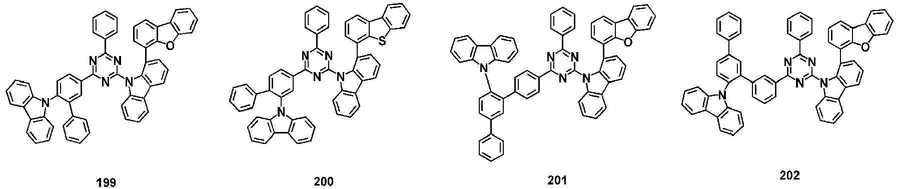

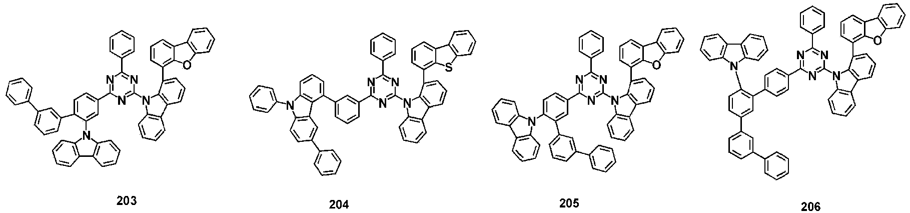

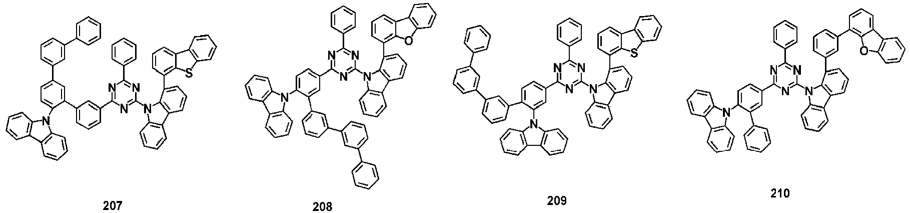

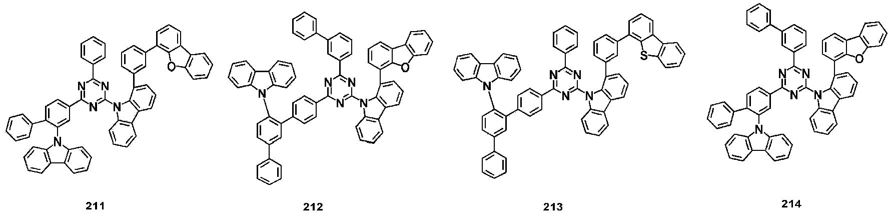

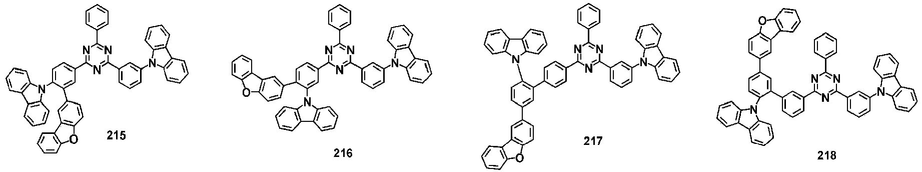

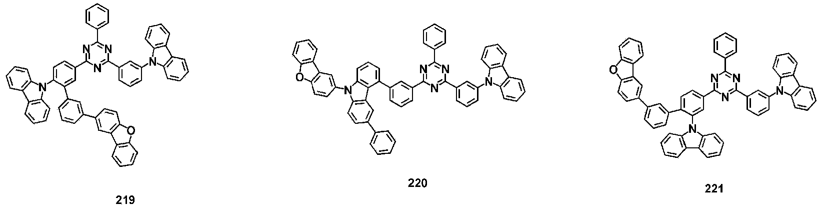

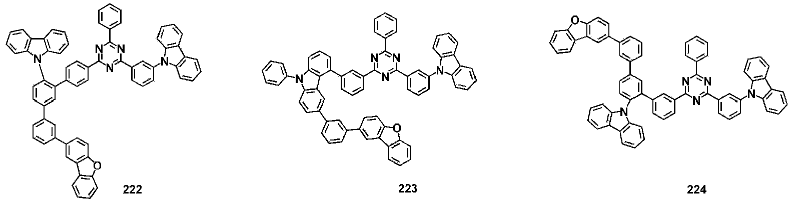

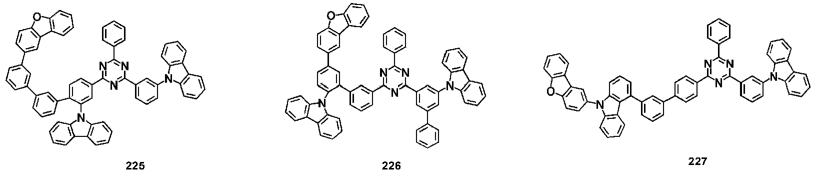

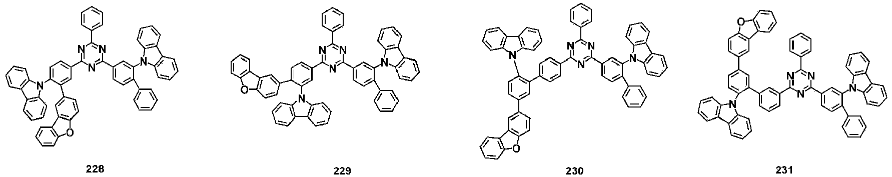

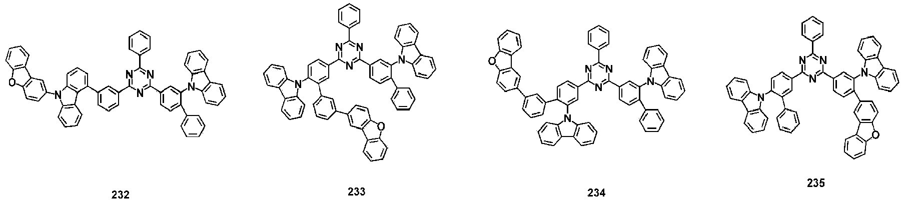

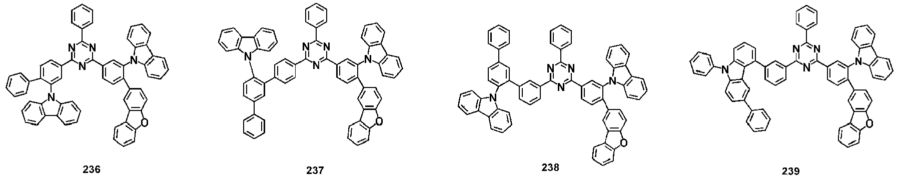

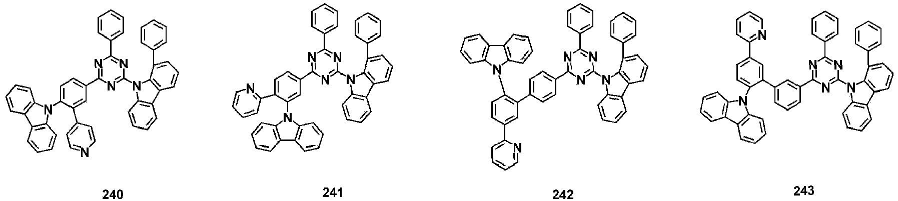

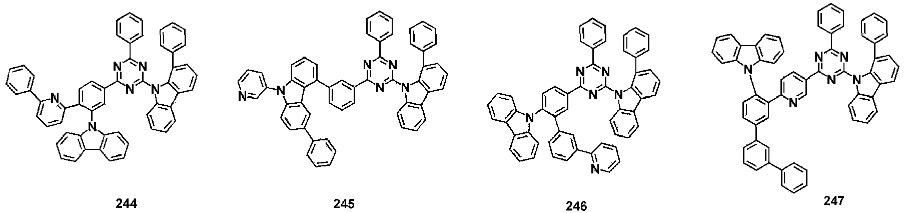

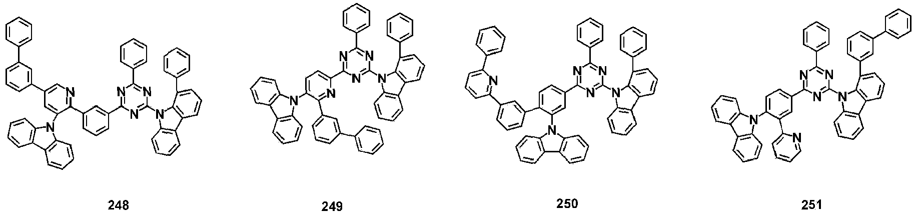

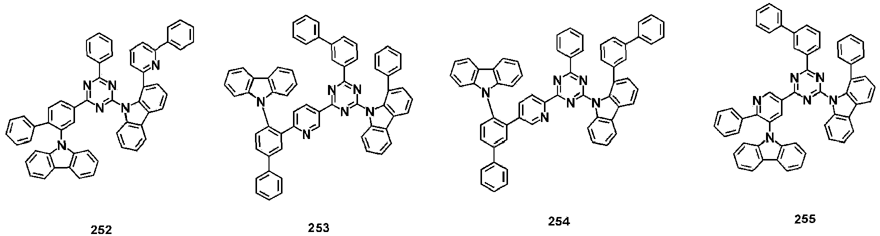

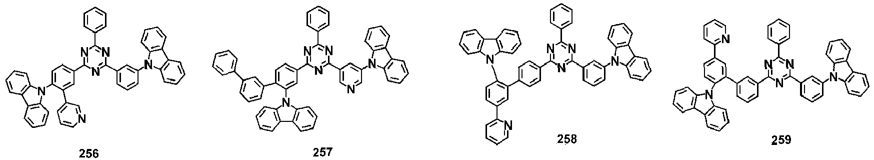

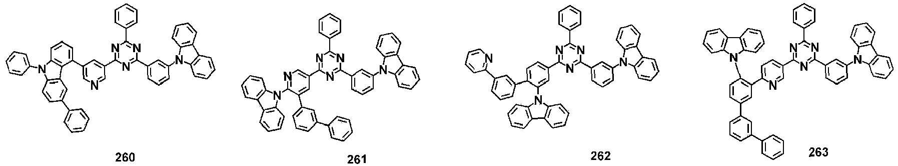

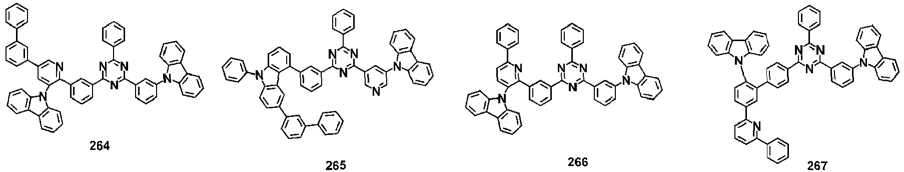

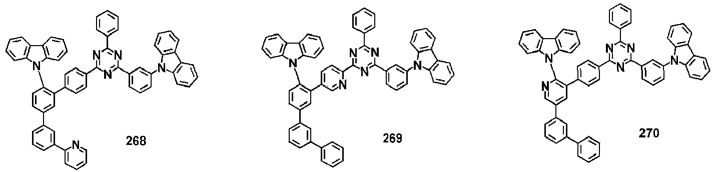

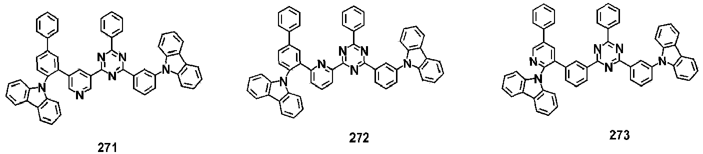

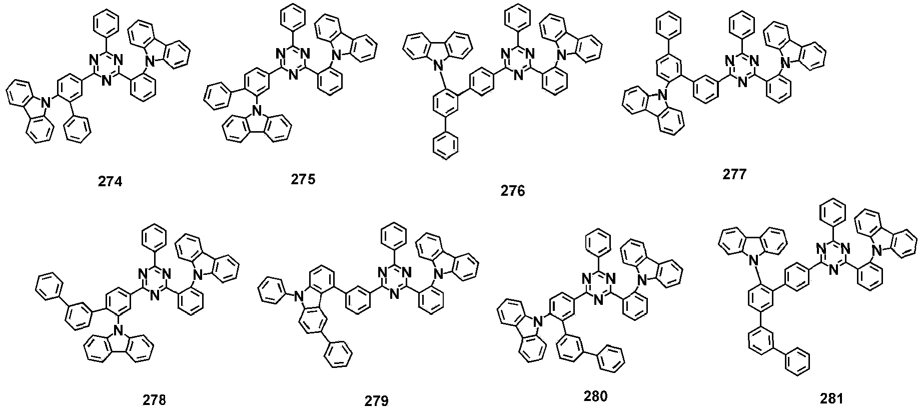

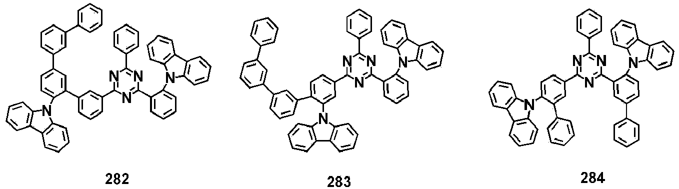

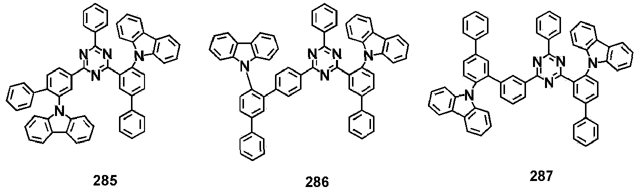

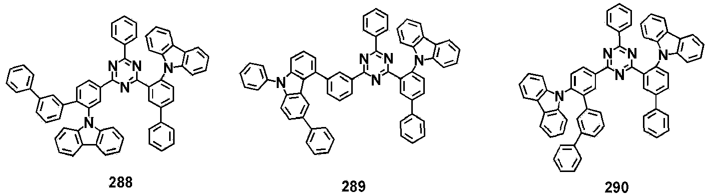

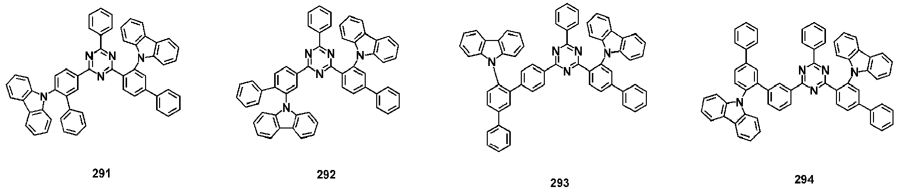

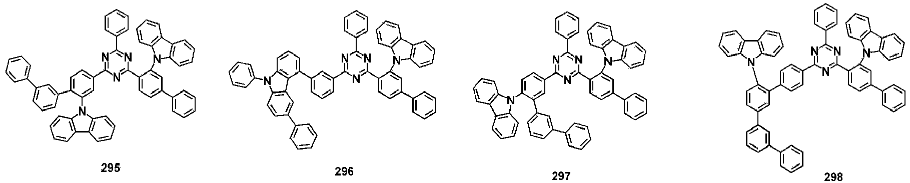

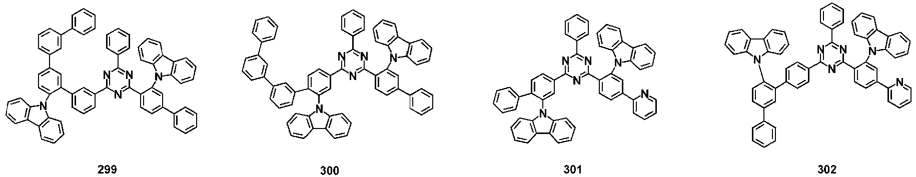

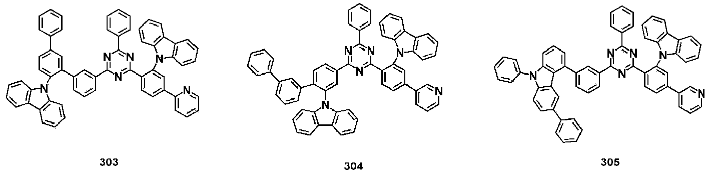

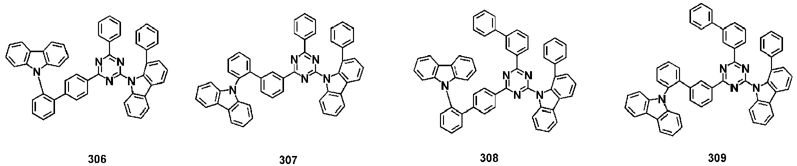

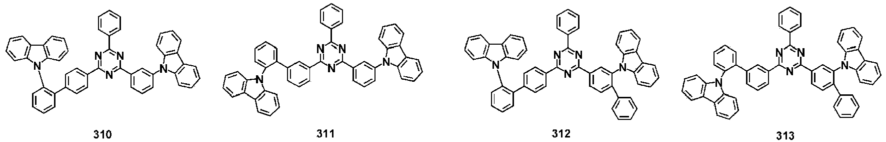

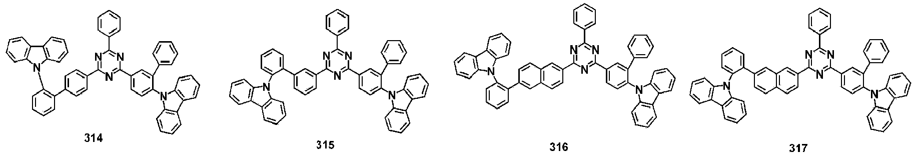

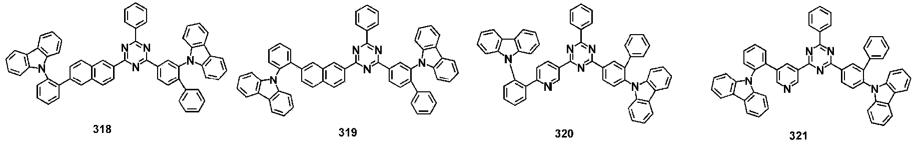

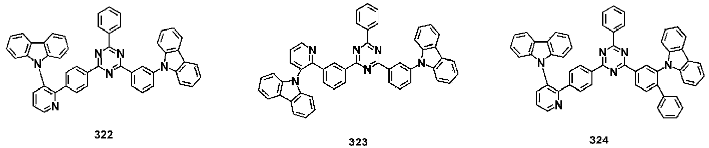

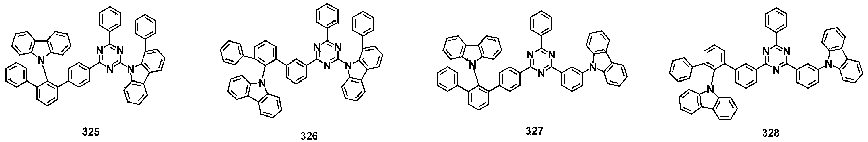

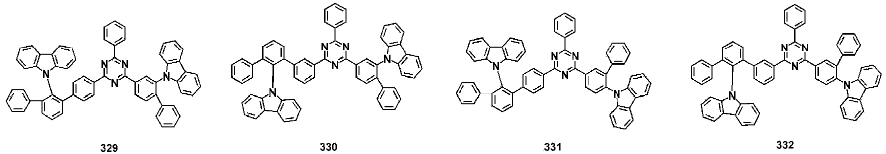

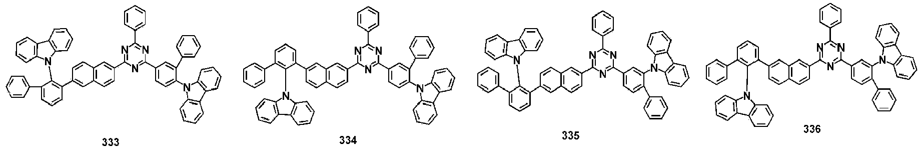

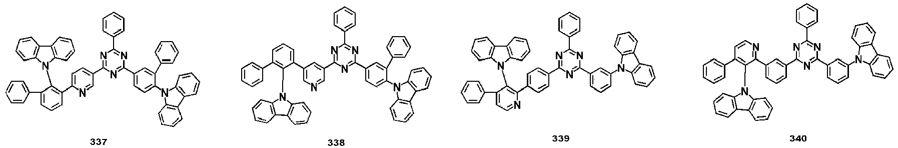

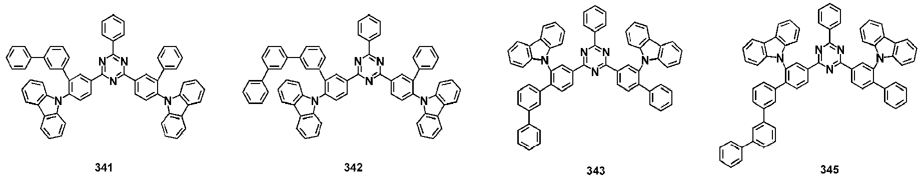

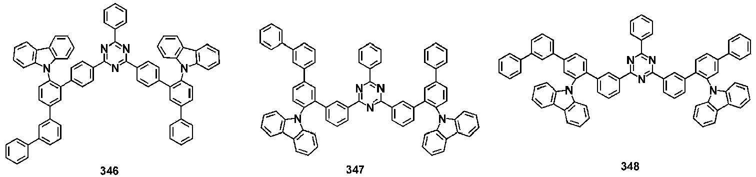

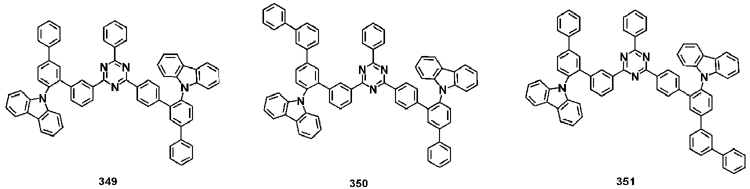

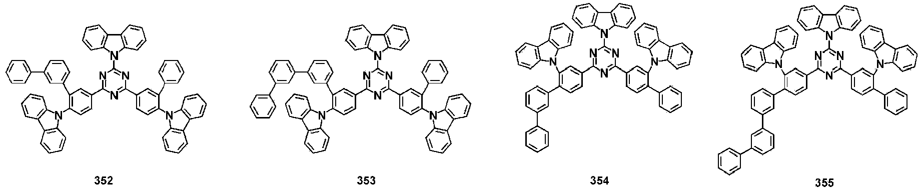

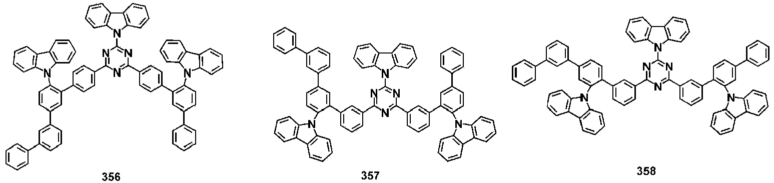

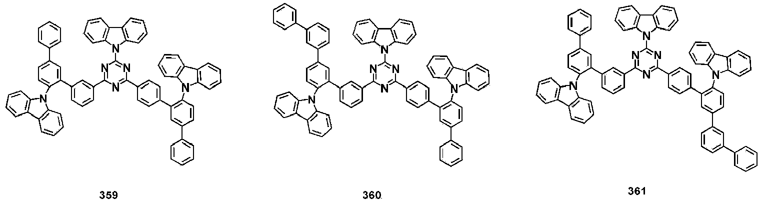

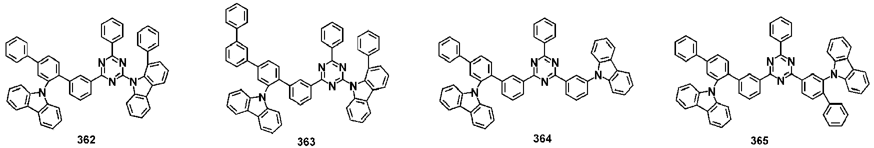

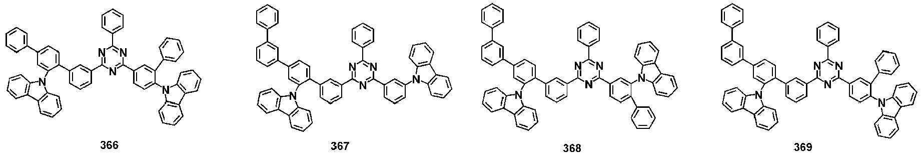

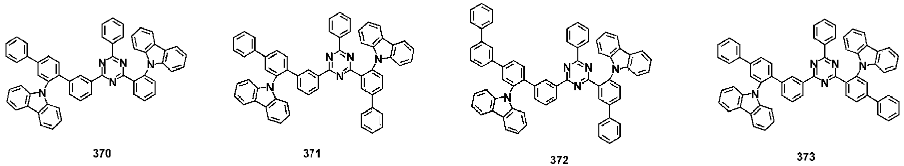

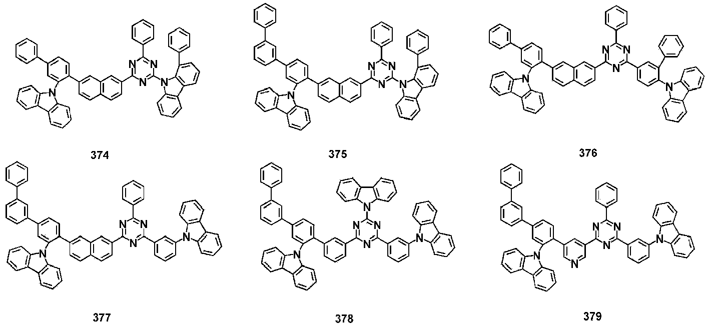

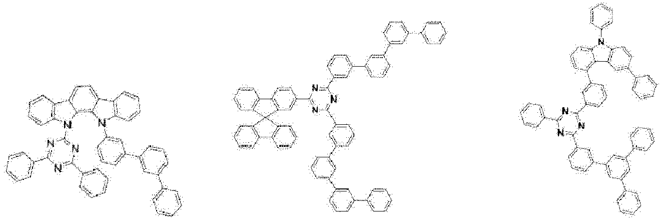

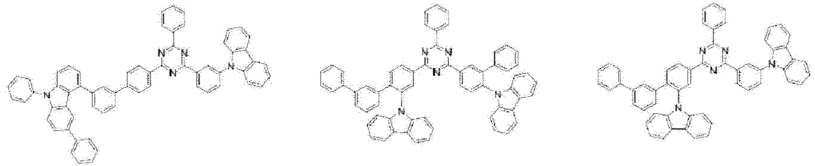

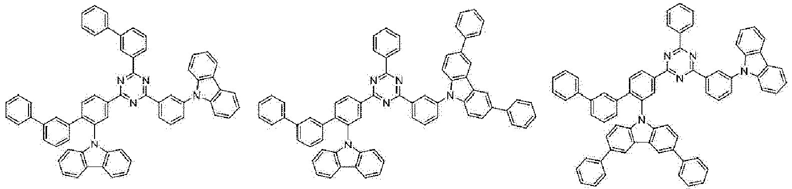

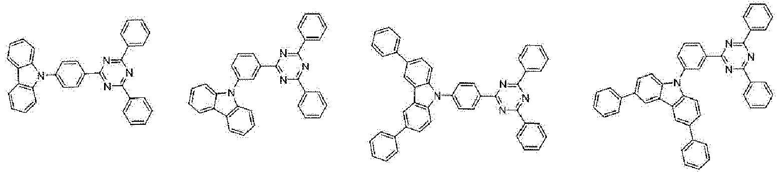

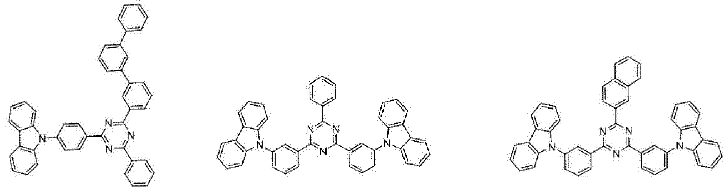

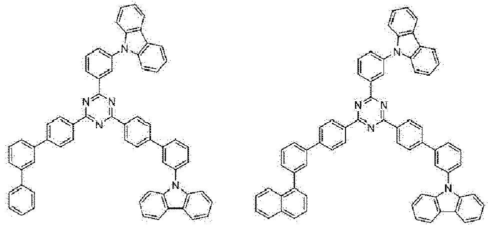

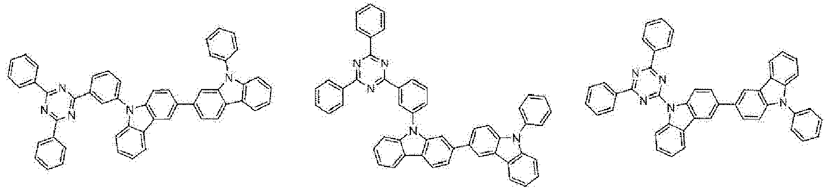

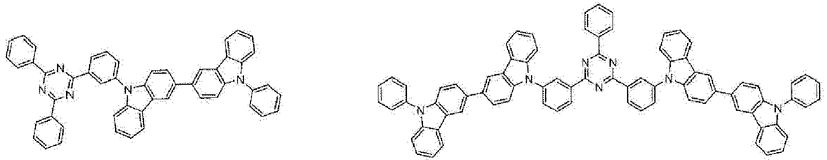

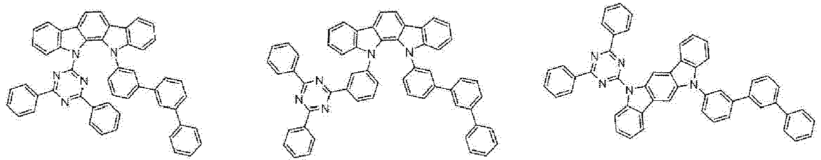

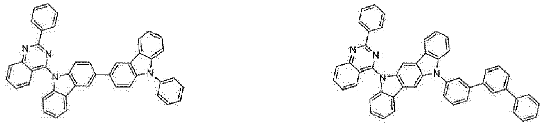

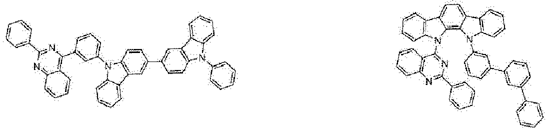

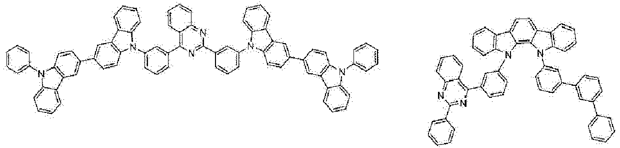

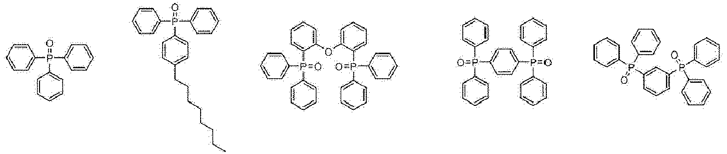

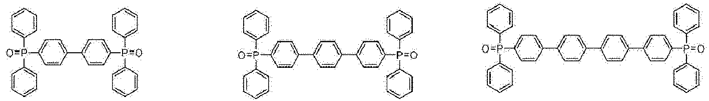

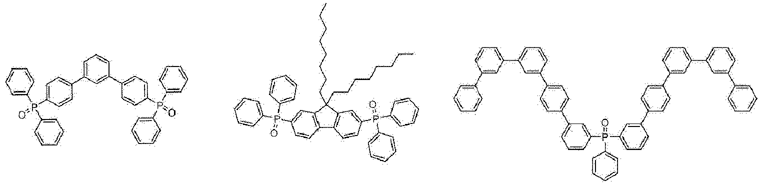

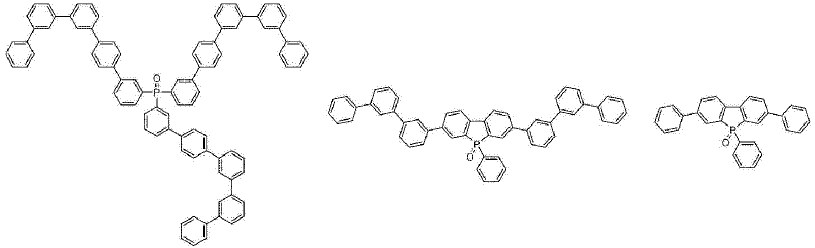

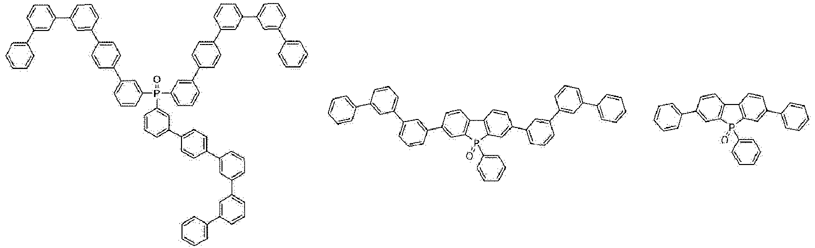

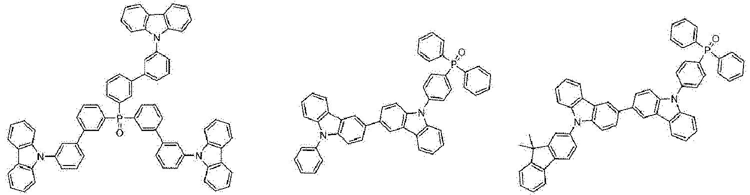

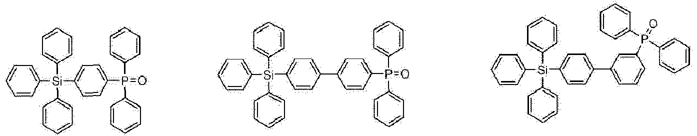

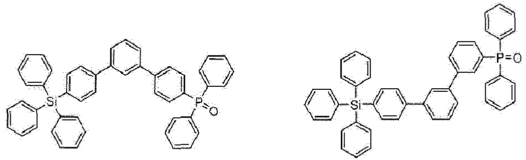

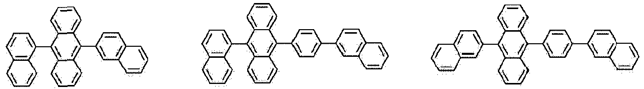

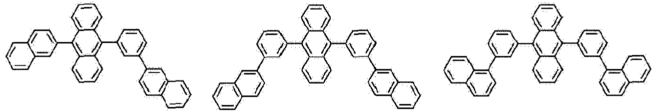

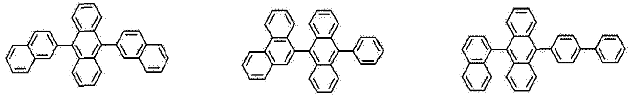

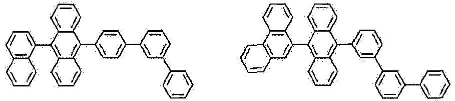

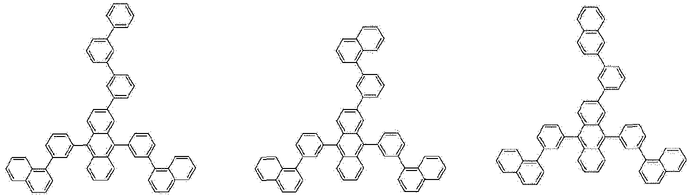

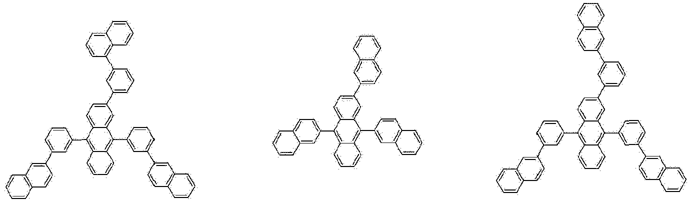

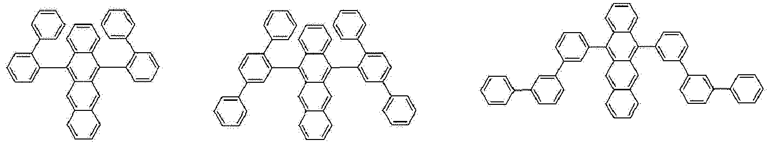

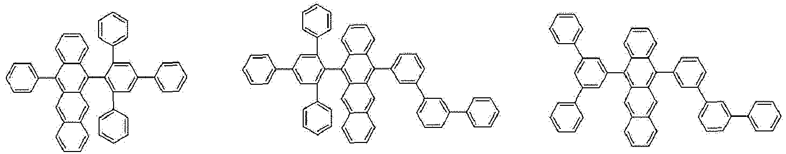

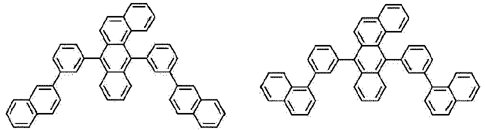

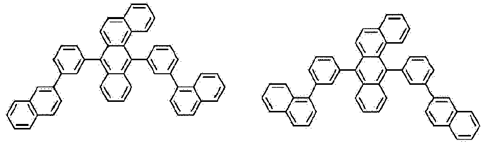

The first compound may be an electron transport host compound having electron transport capacity. A single type or a combination or two or more types of the first compound may be included.

An amount of the first compound may be about 10 mass% or more and 80 mass% or less, for example, about 25 mass% or more and about 60 mass% or less, based on 100 mass% of the total mass of the first compound, the second compound, and the third compound.

In particular, in terms of further improving current efficiency, the amount of the first compound may be about 30 mass% or more and 50 mass% or less based on 100 mass% of the total mass of the first compound, the second compound, and the third compound. In addition, in terms of further improving durability, amount of the first compound may be about 35 mass% or more and 55 mass% or less based on 100 mass% of the total mass of the first compound, the second compound, and the third compound.

In one embodiment, Formula 2-1 may be represented by Formula 2-1(1),
Formula 2-2 may be represented by Formula 2-2(1),
Formula 2-3 may be represented by one of Formulae 2-3(1) to 2-3(3), and
Formula 2-4 may be represented by one of Formulae 2-4(1) to 2-4(3):

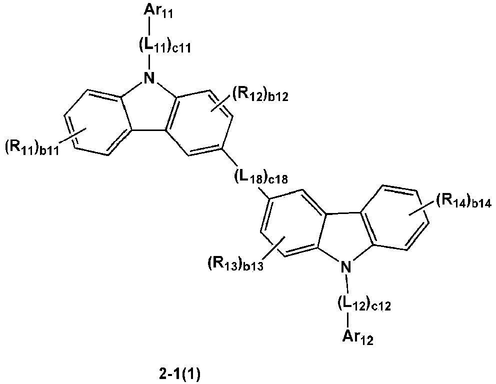

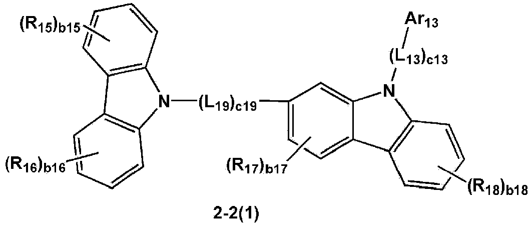

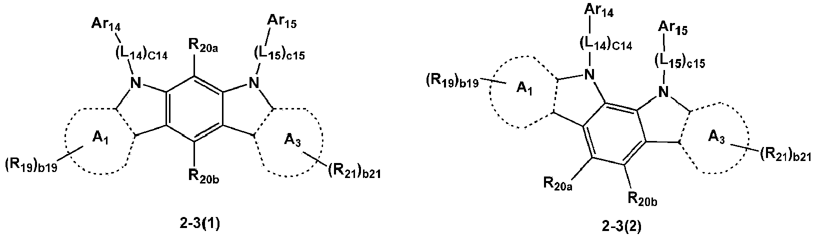

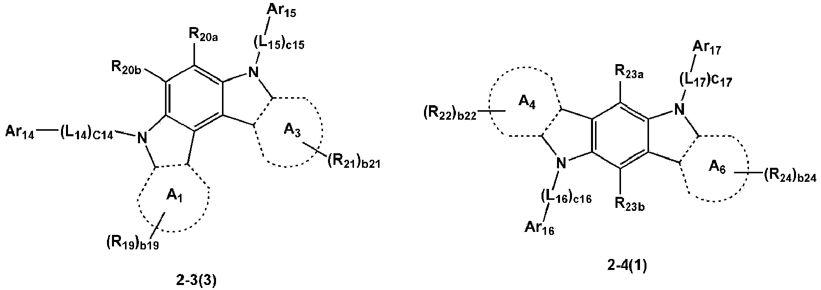

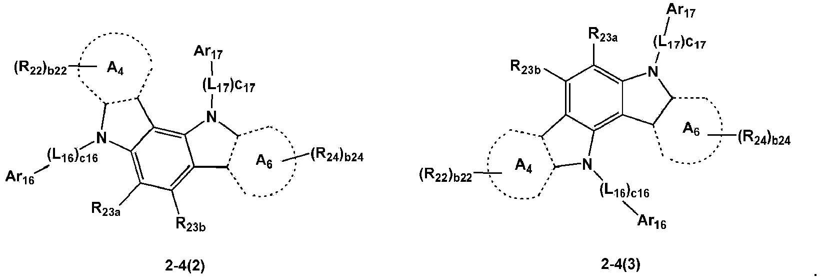

R₂₀ₐ and R_{20b} in Formulae 2-3(1) to 2-3(3) may each independently be understood by referring to the description presented in connection with R₂₀.

R₂₃ₐ and R_{23b} in Formulae 2-4(1) to 2-4(3) may each independently be understood by referring to the description presented in connection with R₂₃.

The second compound may include at least one of the following compounds:

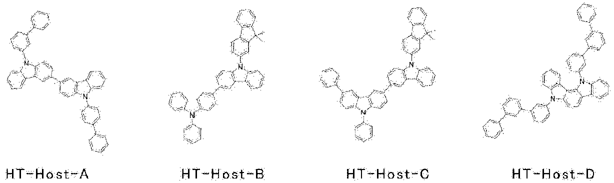

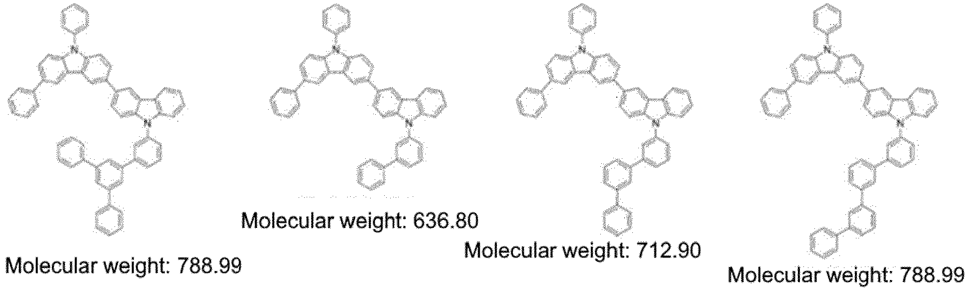

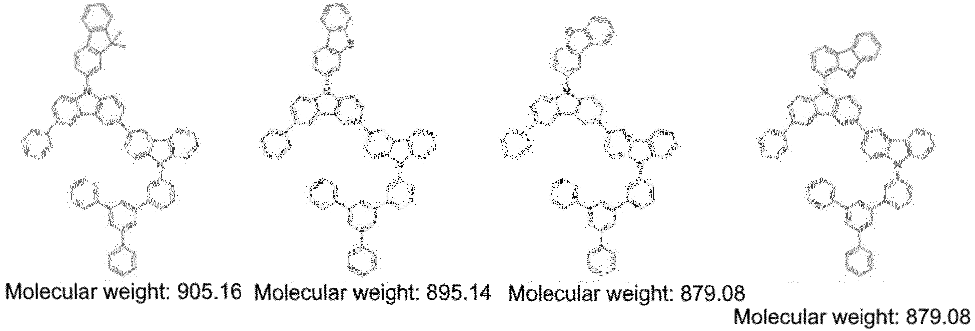

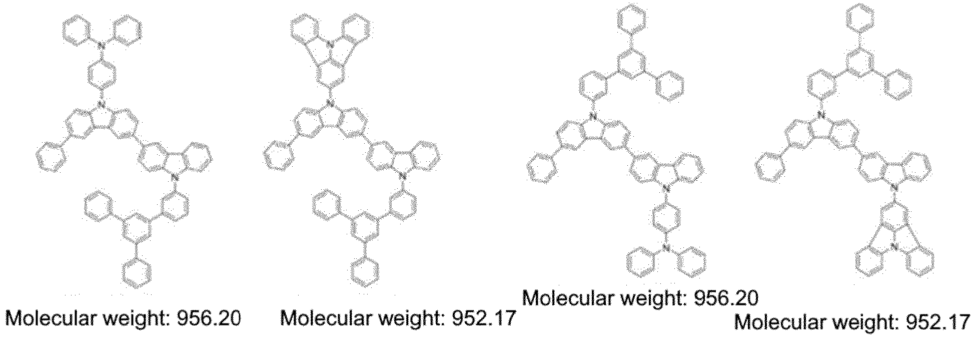

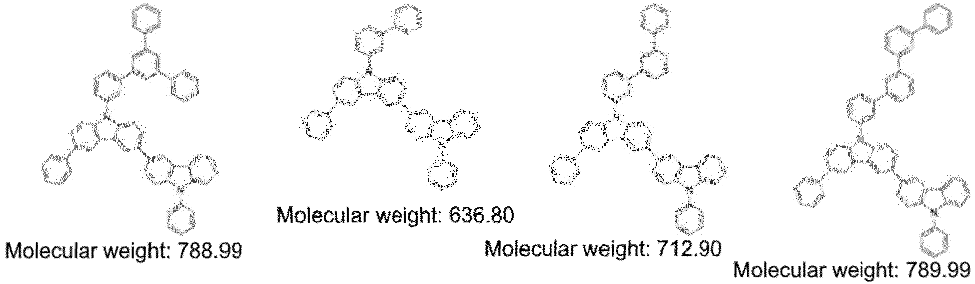

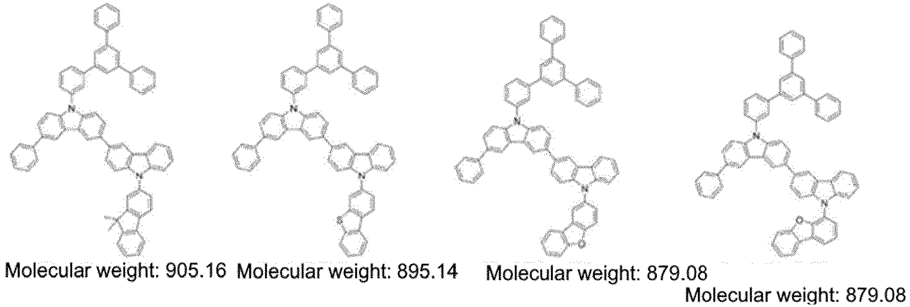

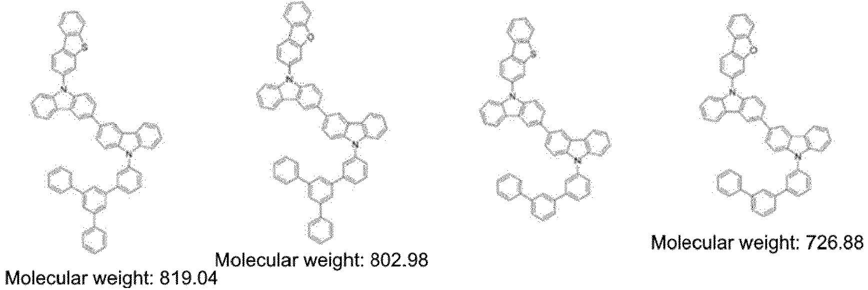

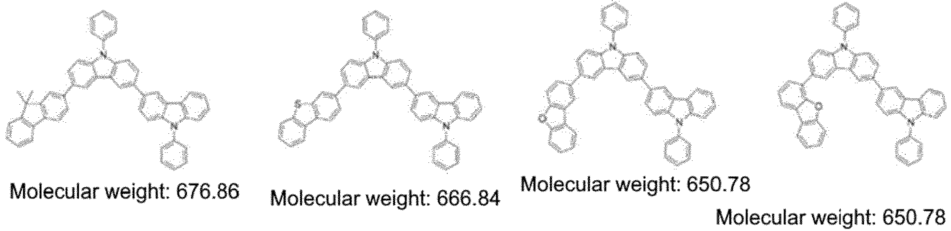

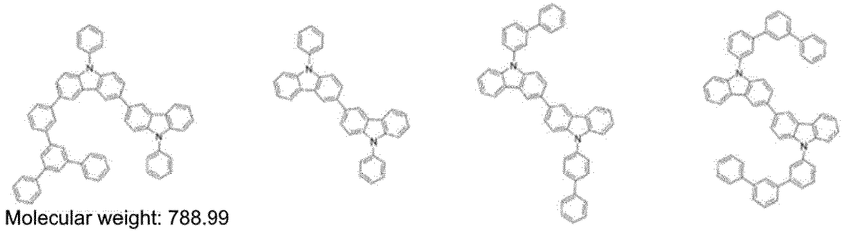

The second compound may be a hole transport host compound having hole transport capacity. A single type or a combination of two or more types of the second compound may be included.

An amount of the second compound may be about 10 mass% or more and 80 mass% or less, for example, about 25 mass% or more and about 60 mass% or less, based on 100 mass% of the total mass of the first compound, the second compound, and the third compound.

The third compound may include at least one of the following compounds:

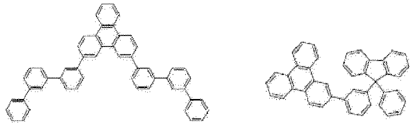

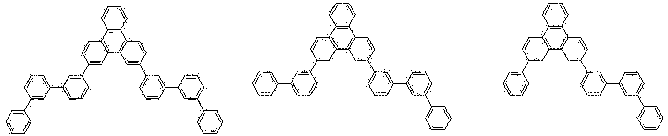

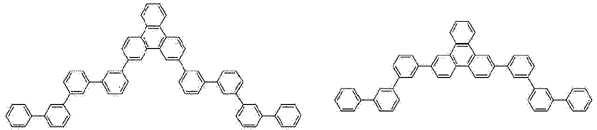

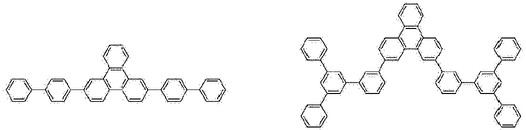

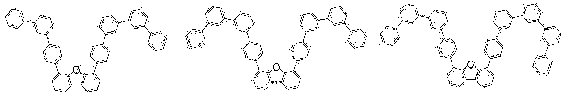

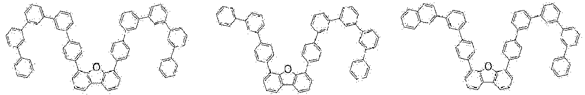

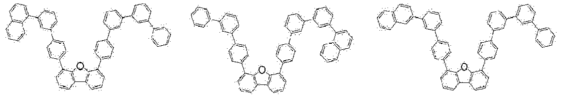

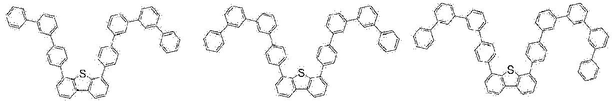

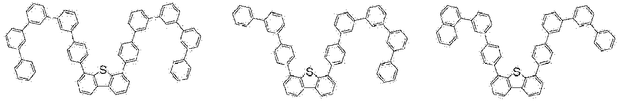

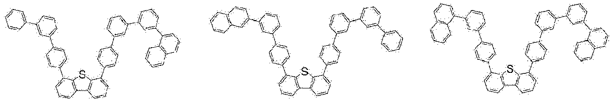

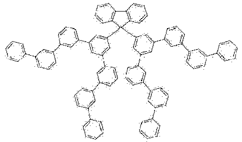

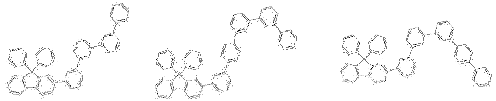

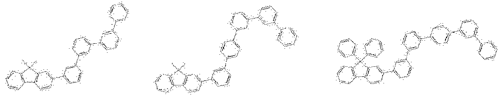

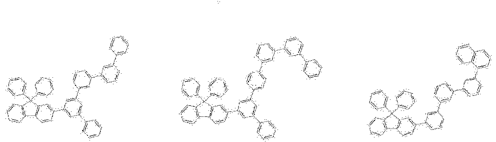

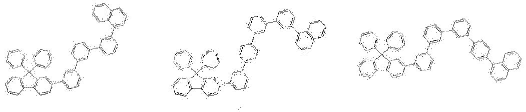

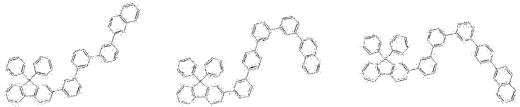

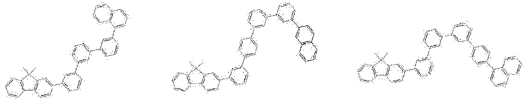

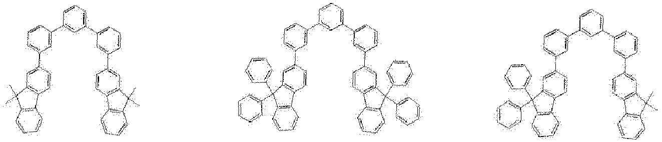

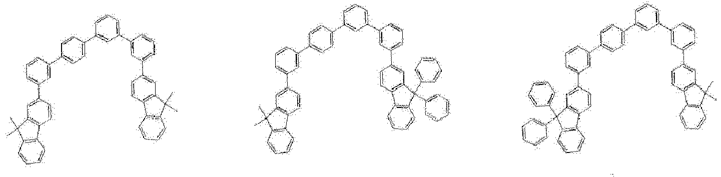

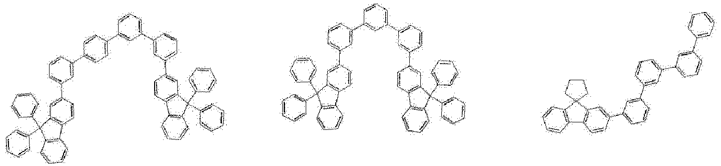

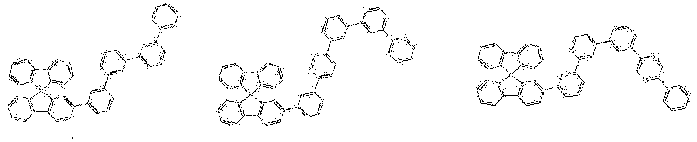

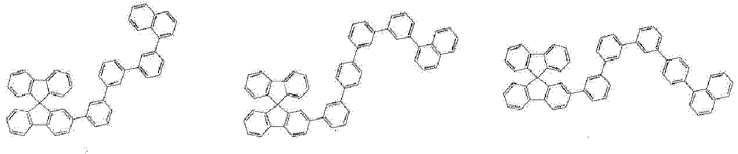

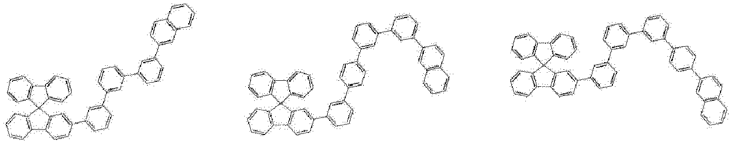

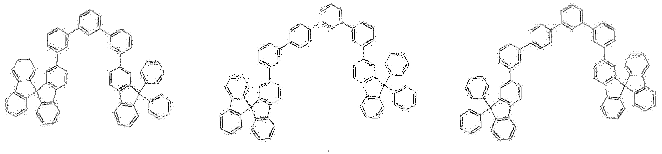

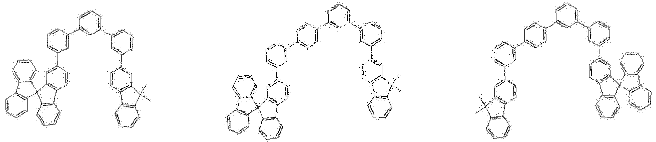

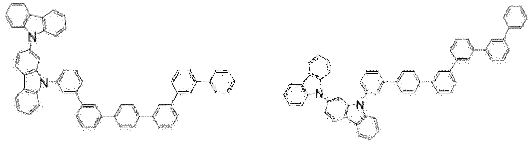

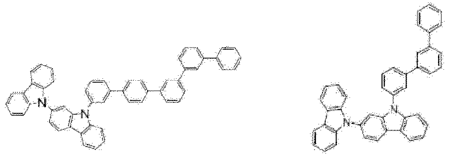

A single type or a combination or two or more types of the third compound may be included.

The third compound is a compound having a HOMO-LUMO energy gap (Eg) of 3.3 eV or more, and is also called as a wide-bandgap compound. When the HOMO-LUMO energy gap (Eg) is less than 3.3 eV, the long lifespan effect obtained by applying a wide-bandgap compound as a host material may be degraded. In addition, the upper limit of the HOMO-LUMO energy gap (Eg) is not particularly, but may be 4 eV or less.

In Examples, characteristics in terms of solubility with respect for a coating solvent to be used, emission color, and compatibility of the first compound (i.e., electron transport host), the second compound (i.e., hole transport host), and a dopant material that are used together are considered among such wide-bandgap compounds.

An amount of the third compound may be about 15 mass% or more and 40 mass% or less, for example, about 16 mass% or more and 35 mass% or less, based on 100 mass% of the total mass of the first compound, the second compound, and the third compound.

When the host compound having the three different characteristics are mixed in a state in which phase separation does not occur to form an emission layer according to a solution process, the HOMO and LUMO energy levels become smooth, thereby reducing an electron injection barrier. In addition, at the same time, the charge mobility may be controlled by adjusting a mixed ratio of charge host compounds, thereby realizing high-performance devices.

In addition, since the first compound, the second compound, and the third compound show high dissolubility for a solvent, film formation capability by wet coating, for example, solution coating is significantly applicable. In addition, the organic light-emitting device including the first compound, the second compound, and the third compound may have improved emission efficiency and emission lifespan, when manufactured by solution coating.

In one embodiment, the first compound may include at least one compound represented by Formula 1-1 or 1-4 above, the second compound may include at least one compound represented by Formula 2-1 or 2-4 above, the third compound may include at least one compound represented by Formula 3-2 below:

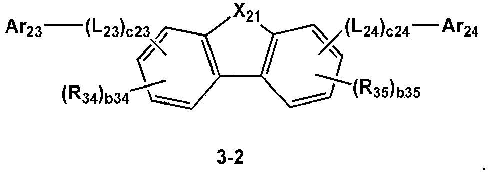

In Formula 3-2,
X₂₁ may be O or S,
L₂₃ to L₂₄ may each independently be selected from a substituted or unsubstituted C₆-C₃₀ arylene group,
c23 and c24 may each independently be 1, 2, or 3,
Ar₂₃ and Ar₂₄ may each independently be selected from hydrogen and a substituted or unsubstituted C₆-C₃₀ aryl group,
R₃₄ and R₃₅ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group, and
b34 and b35 may each independently be an integer from 0 to 3.

In one or more embodiments, the first compound may include at least one compound represented by Formula 1-1 above, the second compound may include at least one compound represented by Formula 2-1 above, and the third compound may include at least one compound represented by Formula 3-1 below:

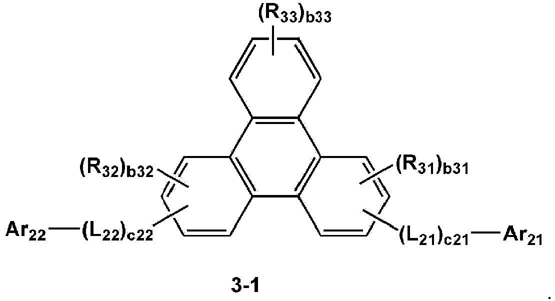

In Formula 3-1,
L₂₁ to L₂₂ may each independently be selected from a substituted or unsubstituted C₆-C₃₀ arylene group,
c21 and c22 may each independently be 1, 2, or 3,
Ar₂₁ and Ar₂₂ may each independently be selected from hydrogen and a substituted or unsubstituted C₆-C₃₀ aryl group, wherein each of Ar₂₁ and Ar₂₂ may not be hydrogen at the same time,
R₃₁ to R₃₃ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b31 and b32 may each independently be an integer from 0 to 3, and
b33 may be an integer from 0 to 4.

In one or more embodiments, the first compound may include at least one compound represented by Formula 1-1 above, the second compound may include at least one compound represented by Formula 2-1 above, and the third compound may include at least compound represented by Formula 3-4 below:

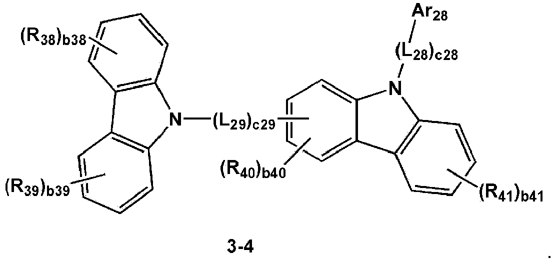

In Formula 3-4,
L₂₈ to L₂₉ may each independently be selected from a single bond and a substituted or unsubstituted C₆-C₃₀ arylene group,
c28 and c29 may each independently be an integer from 1, 2, or 3,
Ar₂₈ may be selected from hydrogen and a substituted or unsubstituted C₆-C₃₀ aryl group,
R₃₈ to R₄₁ may each independently be selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b38, b39, and b41 may each independently be an integer from 0 to 4, and
b40 may be an integer from 0 to 2.

By combining three different types of the host having such a specific structure described above, an emission layer having excellent emission efficiency and excellent lifespan characteristics due to excellent dissolubility for a solvent may be prepared.

In one embodiment, the emission layer may further include a fluorescent dopant, a phosphorescent dopant, or a combination thereof.

For example, for the fluorescent dopant and the phosphorescent dopant, the following materials may be used. For example, the fluorescent dopant may include a perlene and a derivative thereof, a rubrene and a deriavative thereof, a coumarin and a derivative thereof, a 4-dicyanomethylene-2-(p-dimethylaminostyryl)-6-methyl-4H-pyran (DCM) and a derivative thereof, a pyrene and a derivative thereof, and the like, and the phosphorescent dopant may include an iridium complex, such as bis[2-(4,6-difluorophenyl)pyridinate] picolinate iridium (III) (Firpic), bis(1-phenylisoquinoline)(acetylacetonate) iridium (III) (Ir(piq)₂(acac)), tris(2-phenylpyridine) iridium (III) (Ir(ppy)₃), tris(2-(3-p-xylyl)phenyl)pyridine iridium (III) (dopant), and the like, an osmium complex, a platinum complex, and the like, but embodiments of the present disclosure are not limited thereto.

When the emission layer includes a host and a dopant, am amount of the dopant may be in a range of about 0.01 parts by weight to about 15 parts by weight based on 100 parts by weight of the host, but embodiments of the present disclosure are not limited thereto.

The emission layer may be formed to a thickness from about 10 nm to about 60 nm.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

### [Organic light-emitting device]

Hereinafter, an organic light-emitting device according to an embodiment will be described in connection with the FIGURE. The FIGURE is a schematic cross-sectional view of an organic light-emitting device according to an embodiment.

An organic light-emitting device 100 according to an embodiment includes a substrate 110, a first electrode 120 disposed on the substrate 110, a hole injection layer 130 disposed on the first electrode 120, a hole transport layer 140 disposed on the hole injection layer 130, an emission layer 150 disposed on the hole transport layer 140, an electron transport layer 160 disposed on the emission layer 150, an electron injection layer 170 disposed on the electron transport layer 160, and a second electrode 180 disposed on the electron injection layer 170.

The substrate 110 may be any substrate that is used in an organic light-emitting device according to the related art. For example, the substrate 110 may be a glass substrate, a silicon substrate, or a transparent plastic substrate, each having excellent mechanical strength, thermal stability, surface smoothness, ease of handling, and water resistance, but embodiments of the present disclosure are not limited thereto.

The first electrode 120 may be formed on the substrate 110. The first electrode 120 may be, for example, an anode, and may be formed of a material with a high work function to facilitate hole injection, such as an alloy or a conductive compound. The first electrode 120 may be a reflective electrode, a semi-reflective electrode, or a transmissive electrode. The first electrode 120 may have a single-layered structure or a multi-layered structure including two or more layers. For example, the first electrode 120 may be a transparent electrode formed of indium tin oxide (ITO), indium zinc oxide (IZO), tin oxide (SnO₂), or zinc oxide (ZnO), which has excellent transparency and conductivity. On the transparent first electrode 120, magnesium (Mg), aluminum (Al), aluminum-lithium (Al-Li), calcium (Ca), magnesium-indium (Mg-In), or magnesium-silver (Mg-Ag) may be disposed, so as to form a reflective electrode. In one embodiment, the first electrode 120 may have a three-layered structure of ITO/Ag/ITO, but embodiments of the present disclosure are not limited thereto.

The hole transport region may be disposed on the first electrode 120.

The hole transport region may include at least one selected from selected from the hole injection layer 130, the hole transport layer 140, a electron blocking layer (not shown), and a buffer layer (not shown).

The hole transport region may include only either the hole injection layer 130 or the hole transport layer 140. In one embodiment, the hole transport region may have a hole injection layer/hole transport layer structure or a hole injection layer/hole transport layer/electron blocking layer structure, wherein for each structure, constituting layers are sequentially stacked from the first electrode 120 in the stated order.

The hole injection layer 130 may include, for example, at least one selected from poly(ether ketone)-containing triphenylamine (TPAPEK), 4-isopropyl-4'-methyldiphenyliodonium tetrakis (pentafluorophenyl) borate (PPBI), N,N'-diphenyl-N,N'-bis-[4-(phenyl-m-tolyl-amino)-phenyl]-biphenyl-4,4'-diamine (DNTPD), copper phthalocyanine, 4,4',4"-tris(3-methylphenylphenylamino) triphenylamine (m-MTDATA), N,N'-di(1-naphthyl)-N,N'-diphenylbenzidine (NPB), 4,4',4"-tris(diphenylamino) triphenylamine (TDATA), 4,4',4"-tris(N,N-2-naphthylphenylamino) triphenylamine (2-TNATA), polyaniline/dodecylbenzenesulphonic acid (PANI/DBSA), poly(3,4-ethylenedioxythiophene)/poly(4-styrenesulfonate) (PEDOT/PSS), polyaniline/10-camphorsulfonic acid (PANI/CSA), and polyaniline/poly(4-styrenesulfonate) (PANI/PSS).

The hole injection layer 130 may be formed to a thickness from about 10 nm to about 1,000 nm, for example, from about 10 nm to about 100 nm.

The hole transport layer 140 may include, for example, at least one selected from a carbazole derivative, such as 1,1-bis[(di-4-tolylamino)phenyl] cyclohexane (TAPC), N-phenylcarbazole, and polyvinylcarbazole, N,N'-bis(3-methylphenyl)-N,N'-diphenyl-[1,1-biphenyl]-4,4'-diamine (TPD), 4,4',4"-tris(N-carbazolyl) triphenylamine (TCTA), N,N'-di(1-naphthyl)-N,N'-diphenylbenzidine (NPB), and poly(9,9-dioctyl-fluorene-co-N-(4-butylphenyl)-diphenylamine (TFB).

The hole transport layer 140 may be formed to a thickness from about 10 nm to about 1,000 nm, for example, from about 10 nm to about 150 nm.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 or Compound HT-D2 below, but are not limited thereto:

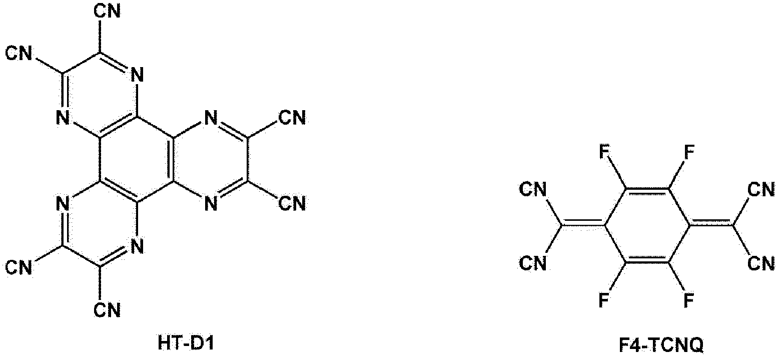

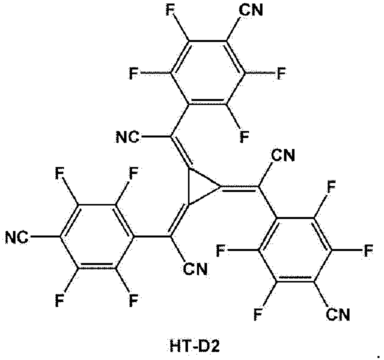

Meanwhile, when the hole transport region includes a buffer layer, a material for forming the buffer layer may be selected from materials for the hole transport region described above and materials for a host to be explained later. However, the material for the electron blocking layer is not limited thereto.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP.

The emission layer 150 may be formed on the hole transport region. The emission layer 150 is a layer emitting light upon fluorescence or phosphorescence. The emission layer 150 may include a host and/or a dopant, and the host may include the first compound, the second compound, and the third compound that are different from each other. The first compound, the second compound, and the third compound are the same as described above.

The electron transport region may be formed on the emission layer 150.

The electron transport region may include at least one selected from a hole blocking layer (not shown), the electron transport layer 160, and the electron injection layer 170.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

For example, to prevent diffusion of excitons or holes to the electron transport layer 160, the organic light-emitting device 100 may include a hole blocking layer between the electron transport layer 160 and the emission layer 150. The hole blocking layer may include, for example, at least one selected from an oxadiazole derivative, a triazole derivative, BCP, Bphen, and BAIq, but a material therefor is not limited thereto:

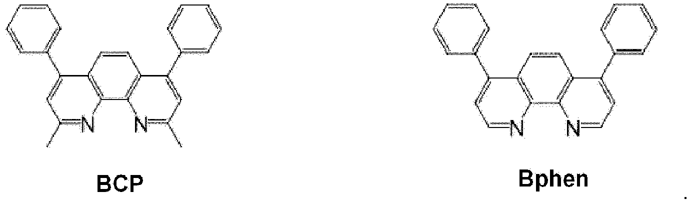

A thickness of the hole blocking layer may be from about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer 160 may include tris(8-quinolinato) aluminum (Alq₃), BAlq; a pyridine ring-containing compound, such as 1,3,5-tri[(3-pyridyl)-phen-3-yl]benzene); a triazine ring-containing compound, such as 2,4,6-tris(3'-(pyridine-3-yl)biphenyl-3-yl)-1,3,5-triazine; an imidazole ring-containing compound, such as 2-(4-(N-phenylbenzimidazolyl-1-yl-phenyl)-9,10-dinaphthylanthracene; a triazole ring-containing compound, such as TAZ and NTAZ; 1,3,5-tris(N-phenyl-benzimidazol-2-yl)benzene (TPBi), BCP, Bphen, and the like:

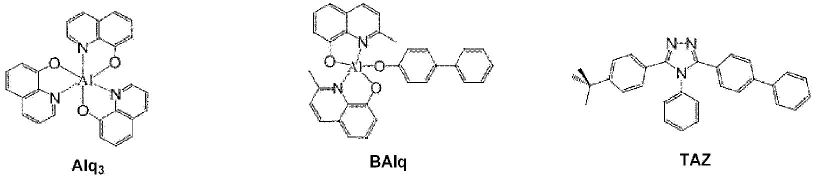

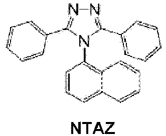

In one or more embodiments, the electron transport layer 160 may include KLET-01, KLET-02, KLET-03, KLET-10, KLET-M1 (available from Chemipro Kasei), or the like that is available on the market.

The electron transport layer 160 may further include, in addition to the materials described above, a metal-containing material.

The metal-containing material may include a Li complex. The Li complex may include, for example, Compound ET-D1 (lithium quinolate, LiQ) or ET-D2:

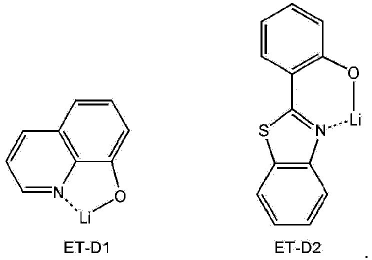

The electron transport layer 160 may be, for example, formed to a thickness from about 15 nm to about 50 nm.

The electron injection layer 170 may be formed on the electron transport layer 160.

The electron injection layer 170 may include, for example, a lithium compound, such as 8-hydroxyquinolinato lithium (Liq) and lithium fluoride (LiF), sodium chloride (NaCl), cesium fluoride (CsF), lithium oxide (Li₂O), or barium oxide (BaO).

The electron injection layer 170 may be formed to a thickness from about 0.3 nm to about 9 nm.

The second electrode 180 may be formed on the substrate 170. The second electrode 180 may be, specifically, a cathode, and may be formed of a material with small work function among metal, alloy, electrically conductive compound, and a combination thereof. For example, the second electrode 180 may be formed as a reflective electrode formed of metal, such as lithium (Li), magnesium (Mg), aluminum (Al), calcium (Ca), or the like, or alloy, such as aluminum-lithium (Al-Li), magnesium-indium (Mg-In), magnesium-silver (Mg-Ag), or the like. In one or more embodiments, the second electrode 180 having a thickness of about 20 nm or less, by a metal or alloy thin-film or a transparent conductive film, such as indium tin oxide (In₂O₃-SnO₂) and indium zinc oxide (In₂O₃-ZnO).

In addition, the stacked structure of the organic light-emitting device 100 according to an embodiment is not limited to the embodiments above. The organic light-emitting device 100 according to an embodiment may be formed to have other known stacked structures. For example, in the organic light-emitting device 100, one or more layers among the hole injection layer 130, the hole transport layer 140, the electron transport layer 160, and the electron injection layer 170 may be omitted, or other layers may be further included. In addition, each layer of the organic light-emitting device 100 may be single-layered or multi-layered.

A manufacturing method of each layer of the organic light-emitting device 100 according to an embodiment is not particularly limited, and for example, various methods, such as vacuum vapor deposition, solution coating, Langmuir-Blodgett (LB) deposition, or the like may be used.

The solution coating may include spin coat, casting, micro gravure coating, gravure coating, bar coating, roll coating, wire bar coating, dip coating, spray coating, screen printing, flexographic printing, offset printing, ink jet printing, and the like.

A solvent used in the solution coating may include toluene, xylene, diethyl ether, chloroform, ethyl acetate, dichloromethane, tetrahydrofuran, acetone, acetonitrile, N,N-dimethylformamide, dimethylsulfoxide, anisole, hexamethylphosphoric acid triamide, 1,2-dichloro ethane, 1,1,2-trichloro ethane, chlorobenzene, o-dichlorobenzene, dioxane, a cyclohexane, n-pentane, n-hexane, n-heptane, n-octane, n-nonan, n-decan, methyl ethyl ketone, cyclohexanone, butyl acetate, ethyl cellosolve, acetate, ethylene glycol, ethylene glycol monobutyl ether, ethylene glycol monoethyl ether, ethylene glycol monomethyl ether, dimethoxyethane, propylene glycol, diethoxy methane, triethylene glycol monoethyl ether, glycerin, 1,2-hexanediol, methanol, ethanol, propanol, isopropanol, cyclohexanol, N-methyl-2-pyrrolidone, or the like. The solvent is not limited as long as it is capable of dissolving a material used to form each layer.

A concentration of a composition used in the solution coating may be, in consideration of coating property or the like, for example, from about 0.1 weight% to about 10 weight%, and for example, from about 0.5 weight% to about 5 weight%, but embodiments of the present disclosure are not limited thereto.

Conditions for the vacuum deposition may vary according to a material being used, a structure and thermal characteristics of a desired layer. For example, the depositions may include a deposition temperature of about 100 °C to about 500 °C, a vacuum degree of about 10⁻⁸ to about 10⁻³ torr, and a deposition rate of about 0.01 Å/sec to about 100 Å/sec. However, the conditions are not limited thereto.

In one embodiment, the first electrode 120 may be an anode, and the second electrode 180 may be a cathode.

For example, the first electrode 120 may be an anode, and the second electrode 180 may be a cathode. The organic light-emitting device 100 may also include an organic layer including the emission layer 150 and disposed between the first electrode 120 and the second electrode 180, and the organic layer may further include a hole transport region between the first electrode 120 and the emission layer 150 and an electron transport region between the emission layer 150 and the second electrode 180, wherein the hole transport region may include at least one selected from the hole injection layer 130, the hole transport layer 140, the buffer layer, and the electron blocking layer, and the electron transport region may include at least one selected from the hole blocking layer, the electron transport layer 160, and the electron injection layer 170.

In one or more embodiments, the first electrode 120 may be a cathode, and the second electrode 180 may be an anode.

Hereinbefore, the organic light-emitting device according to an embodiment has been described in connection with the FIGURE.

### [Description of substituents]

The expression "X and Y may each independently be" as used herein refers to a case where X and Y may be identical to each other, or a case where X and Y may be different from each other.

The term "substituted" as used herein refers to a case where hydrogen of a substituent such as R₁₁ may be further substituted with other substituents.

The term "C₁-C₆₀ alkyl group" as used herein refers to a linear or branched aliphatic saturated hydrocarbon monovalent group having 1 to 24 carbon atoms, and examples thereof include a methyl group, an ethyl group, an n-propyl group, an isopropyl group, an n-butyl group, an isobutyl group, a sec-butyl group, a tert-butyl group, an n-pentyl group, an isopentyl group, a tert-pentyl group, a neopentyl group, a 1,2-dimethylpropyl group, an n-hexyl group, an isohexyl group, a 1,3-dimethylbutyl group, a 1-isopropylpropyl group, a 1,2-dimethylbutyl group, an n-heptyl group, a 1,4-dimethylpentyl group, a 3-ethylpentyl group, a 2-methyl-1-isopropylpropyl group, a 1-ethyl-3-methylbutyl group, an n-octyl group, a 2-ethylhexyl group, a 3-methyl-1-isopropylbutyl group, a 2-methyl-1-isopropyl group, a 1-tert-butyl-2-methylpropyl group, an n-nonyl group, a 3,5,5-trimethyldecyl group, an n-decyl group, an isodecyl group, an n-undecyl group, a 1-methyldecyl group, an n-dodecyl group, an n-tridecyl group, an n-tetradecyl group, an n-pentadecyl group, an n-hexadecyl group, an n-heptadecyl group, an n-octadecyl group, an n-nonadecyl group, an n-eicosyl group, an n-heneicosyl group, an n-docosyl group, an n-tricosyl group, an n-tetracosyl group, and the like.

The term "C₁-C₆₀ alkylene group" as used herein refers to a divalent group having the same structure as the C₁-C₂₄ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, a propoxy group, an isopropoxy group, an n-butoxy group, an isobutoxy group, a sec-butoxy group, a tert-butoxy group, an n-pentoxy group, an isopentoxy group, a tert-pentoxy group, a neopentoxy group, an n-hexyloxy group, an isohexyloxy group, a heptyloxy group, an octyloxy group, an nonyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, a 2-ethylhexyloxy group, a 3-ethylpentyloxy group, and the like.

The term "C₁-C₂₄ alkylthio group" as used herein refers to a monovalent group represented by -SA₁₀₂ (wherein A₁₀₂ is the C₁-C₂₄ alkyl group).

The term "C₃-C₃₀ cycloalkyl group" as used herein refers to a monovalent saturated hydrocarbon monocyclic group having 3 to 30 carbon atoms involved in the ring formation, and examples thereof include a cyclopropyl group, a cyclobutyl group, a cyclopentyl group, a cyclohexyl group, and a cycloheptyl group. The term "C₃-C₃₀ cycloalkylene group" as used herein refers to a divalent group having the same structure as the C₃-C₃₀ cycloalkyl group.

The term "C₁-C₁₀ heterocycloalkyl group" as used herein refers to a monovalent monocyclic group having at least one heteroatom selected from N, O, Si, P, and S as a ring-forming atom and 1 to 10 carbon atoms, and examples thereof include a 1,2,3,4-oxatriazolidinyl group, a tetrahydrofuranyl group, and a tetrahydrothiophenyl group.

The term "C₃-C₁₀ cycloalkenyl group" as used herein refers to a monovalent monocyclic group that has 3 to 10 carbon atoms and at least one double bond in the ring thereof and does not have aromacity, and detailed examples thereof are a cyclopentenyl group, a cyclohexenyl group, and a cycloheptenyl group. A C₃-C₁₀ cycloalkenylene group used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, and S as a ring-forming atom, 1 to 10 carbon atoms, and at least one double bond in its ring. Detailed examples of the C₁-C₁₀ heterocycloalkenyl group are a 2,3-hydrofuranyl group and a 2,3-hydrothiophenyl group. A C₁-C₁₀ heterocycloalkenylene group used herein refers to a divalent group having the same structure as the C₁-C₁₀ heterocycloalkenyl group.

The term "C₆-C₃₀ aryl group" as used herein refers to a monovalent group having a carbocyclic aromatic system having 6 to 30 carbon atoms involved in the ring formation (that is, when substituted with a substituent, the atom included in the substituent is not counted as the carbon involved in the ring formation), and the term "C₆-C₃₀ arylene group" as used herein refers to a divalent group having a carbocyclic aromatic system having 6 to 30 carbon atoms. Non-limiting examples of the C₆-C₃₀ aryl group include a phenyl group, a naphthyl group, an anthracenyl group, a phenanthrenyl group, a pyrenyl group, and a chrysenyl group. When the C₆-C₃₀ aryl group and the C₆-C₃₀ arylene group each include two or more rings, the rings may be fused to each other.

The term "C₆-C₃₀ aryloxy group" as used herein refers to a group represented by -OA₁₀₃ (wherein A₁₀₃ is the C₆-C₃₀ aryl group), and examples thereof include a 1-naphthyloxy group, a 2-naphthyloxy group, a 2-azulenyloxy group, and the like.

The term "C₆-C₃₀ arylthio group" as used herein refers to a group represented by -SA₁₀₄ (wherein A₁₀₄ is the C₆-C₃₀ aryl group).

The term "C₁-C₃₀ heteroaryl group" as used herein refers to a monovalent group having a heterocyclic aromatic system that has at least one heteroatom selected from N, O, Si, P, and S as a ring-forming atom, and 1 to 30 carbon atoms. The term "C₁-C₃₀ heteroarylene group" as used herein refers to a divalent group having a heterocyclic aromatic system that has at least one heteroatom selected from N, O, Si, P, and S as a ring-forming atom, and 1 to 30 carbon atoms. Non-limiting examples of the C₁-C₃₀ heteroaryl group include a pyridinyl group, a pyrimidinyl group, a pyrazinyl group, a pyridazinyl group, a triazinyl group, a quinolinyl group, and an isoquinolinyl group. When the C₅-C₃₀ heteroaryl group and the C₅-C₃₀ heteroarylene group each include two or more rings, the rings may be condensed with each other.

The term "C₆-C₃₀ heteroaryloxy group" as used herein refers to a group represented by -OA₁₀₅ (wherein A₁₀₅ is the C₆-C₃₀ heteroaryl group). Examples thereof include a 2-furanyloxy group, a 2-thienyloxy group, a 2-indolyloxy group, a 3-indolyloxy group, a 2-benzofuriloxy group, and a 2-benzothienyloxy group.

The term "C₆-C₃₀ heteroarylthio group" as used herein refers to a group represented by -SA₁₀₆ (wherein A₁₀₆ is the C₆-C₃₀ heteroaryl group).

The term "C₇-C₃₀ arylalkyl group" as used herein refers to an aryl group added to an alkyl group, and is a monovalent group in which the sum of carbon atoms of the alkyl group and the aryl group that constitute the C₇-C₃₀ arylalkyl group is 7 to 30. Examples thereof include a benzyl group, a phenylethyl group, a phenylpropyl group, a naphthylmethyl group, and the like.

The term "C₆-C₃₀ arylalkyloxy group" as used herein refers to a group represented by -OA₁₀₅ (wherein A₁₀₅ is the C₆-C₃₀ heteroaryl group).

The term "C₆-C₃₀ arylalkyloxy group" as used herein refers to a group represented by -SA₁₀₆ (wherein A₁₀₆ is the C₇-C₃₀ arylalkyl group).

The term "C₈-C₃₀ arylalkenyl group" as used herein refers to an aryl group in an alkenyl group, and is a monovalent group in which the sum of carbon atoms of the alkenyl group and the aryl group that constitute the C₈-C₃₀ arylalkenyl group is 8 to 30.

The term "C₈-C₃₀ arylalkynyl group" as used herein refers to an aryl group in an alkynyl group, and is a monovalent group in which sum of carbon atoms of the alkynyl group and the aryl group that constitute the C₈-C₃₀ arylalkynyl group is 8 to 30.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The term "C₅-C₃₀ carbocyclic group" as used herein refers to a monocyclic group or a polycyclic group, and, according to its chemical structure, a monovalent, divalent, trivalent, tetravalent, pentavalent, or hexavalent group.

The term "C₁-C₃₀ heterocyclic group" as used herein refers to a saturated or unsaturated cyclic group having, as a ring-forming atom, at least one heteroatom selected from N, O, Si, P, and S other than 1 to 30 carbon atoms. The term "C₁-C₃₀ heterocyclic group" as used herein refers to a monocyclic group or a polycyclic group, and, according to its chemical structure, a monovalent, divalent, trivalent, tetravalent, pentavalent, or hexavalent group.

In the present specification, at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be selected from:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₁ to Q₉, Q₁₁ to Q₁₉, Q₂₁ to Q₂₉, and Q₃₁ to Q₃₉ may each independently be selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

### [Others]

The expression "A to B" refers to a range beginning from A to B.

Hereinbefore, embodiments of the present disclosure will now be described more fully with reference to the accompanying drawings, but the present disclosure is not limited these embodiments. It will be apparent to those of ordinary skill in the art that various modifications or changes may be made within the technical scope of the present disclosure. It will be understood that various modifications and modifications belong to the technical scope of the present disclosure.

Hereinafter, by referring to Examples and Comparative Examples, the organic light-emitting device including the emission layer including three different compounds will be described in detail, Examples below are examples only, and the condensed cyclic compound and the organic light-emitting device according to embodiments are not limited to Examples below. The wording " 'B' was used instead of 'A' " used in describing Synthesis Examples means that a molar equivalent of 'B' was identical to a molar equivalent of 'A'.

### [Examples]

### Synthesis Example

### Synthesis of ET-HOST-A to ET-HOST-F, HT-HOST-A to HT-HOST-D, and WG-HOST-A to WG-HOST-F

ET-HOST, HT-HOST, and WG-HOST that are used in present Example may be prepared by coupling and substitution reactions well known to one of ordinary skill in the art. Such reactions are well-known techniques, and are described in detail in various documents. For example, examples of the documents are [Yamamoto, Progress in Polymer Science, Vol. 17, p 1153(1992)], [Colon et al., Journal of Polymer Science, Part A, Polymer chemistry Edition, Vol. 28, P. 367 (1990)], [T. Ishiyama et al., J. Org. Chem. 1995 60, 7508-7510], [M. Murata et al., J. Org. Chem. 1997 62, 6458-6459], [M. Murata et al., J. Org. Chem. 2000 65, 164-168], [L.Zhu, et al., J. Org. Chem. 2003 68, 3729-3732], [Stille, J.K. Angew. Chem. Int. Ed. Engl. 1986, 25, 508], [Kumada, M. Pire. Appl. Chem. 1980, 52, 669], [Negishi, E. Acc. Chem. Res. 1982, 15, 340], and US 5,962,631, and the like.

### Synthesis of material for forming hole transport layer (P-1, FA-14)

Based on the method of preparing Compound T disclosed in International Patent Application No. 2011/159872, Polymer P-1 represented by the following formula was synthesized. Here, the number average molecular weight (Mn) of Polymer P-1 measured by gel-permeation chromatography (GPC) was 141,000, and the weight-average molecular weight (Mw) of Polymer P-1 was 511,000:

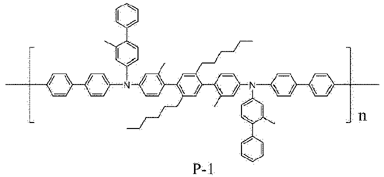

In addition, FA-14 (see the formula below) disclosed in US 2016/0315259 was synthesized according to the method known in the art:

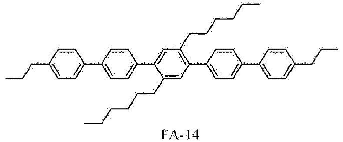

### Evaluation Example 1: Measurement of energy band gap

HOMO and LUMO energy levels of WG-HOST Compounds used in Examples were measured by a DFT method of Gaussian program (structurally optimized at a level of B3LYP, 6-31G(d,p)), and results thereof are shown in Table 1.

**[Table 1]**

| Compound | HOMO (eV) | LUMO (eV) | Band gap energy (eV) |
|---|---|---|---|
| WG-HOST-A | 6.25 | 2.86 | 3.39 |
| WG-HOST-B | 6.61 | 2.73 | 3.88 |
| WG-HOST-C | 6.22 | 2.86 | 3.36 |
| WG-HOST-D | 6.24 | 2.80 | 3.44 |
| WG-HOST-E | 6.25 | 2.71 | 3.54 |
| WG-HOST-F | 6.19 | 2.76 | 3.36 |

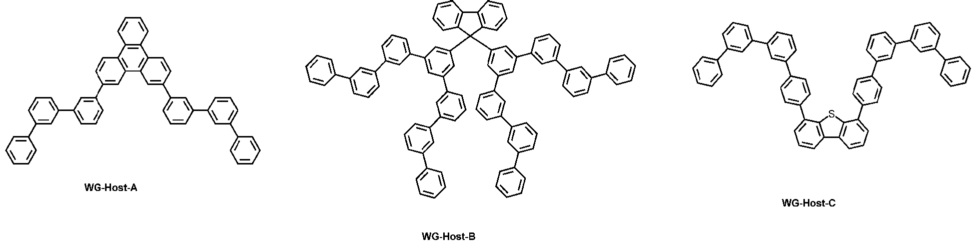

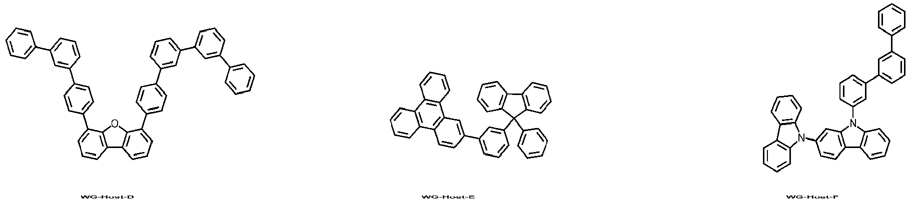

### Example 1

A glass substrate on which an indium tin oxide (ITO) electrode (also referred to as a first electrode or an anode) having a thickness of 1,500 Å is formed was sonicated with distilled water. Once washing with distilled water was finished, the glass substrate was sonicated with isopropyl alcohol, acetone, and methanol, in the stated order, dried, and provided to a plasma washer. Next, the glass substrate was cleaned for 5 minutes using an oxygen plasma, and provided to a vacuum evaporator.

Compound PEDOT-PSS (available by Sigma-Aldrich ) was coated on the ITO electrode of the glass substrate according to spin coating, and dried to form a hole injection layer having a thickness of 150 Å. A solution obtained by dissolving P-1 and FA-14 in an anisol solvent (P-1:FA-14=80:20 weight%) was coated on the hole injection layer according to spin coating, and dried to form a hole transport layer having a thickness of 1,250 Å.

Next, by using host compound materials and dopant materials listed in Table 2 below, tris(2-(3-p-xylyl)phenyl)pyridine iridium (III) (TEG, see the formula below) was dissolved in a methylbenzoate solvent to obtain solid contents. A composition (dopant amount: 10 weight%) for forming an emission layer including 4 weight% of the solids was coated on the hole transport layer by spin coating, dried at a temperature of 240 °C for 30 minutes to form an emission layer having a thickness of 550 Å.

On the emission layer, (8-hydroxyquinolato)lithium (Liq) and KLET-03 (available by ChemiPro Hwaseung Co., Ltd.) were co-deposited at a weight ratio of 1:1 by vacuum deposition to form an electron transport layer having a thickness of 200 Å. LiF was vacuum-deposited on the electron transport layer to form an electron injection layer having a thickness of 35 Å, and Al was vacuum-deposited on the electron injection layer to form a second electrode (also, referred to as a cathode) having a thickness of 1,000 Å, thereby completing the manufacture of an organic light-emitting device.

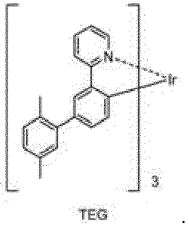

### Examples 2 to 17 and Comparative Examples 1 to 10

Organic light-emitting devices were manufactured in the same manner as in Example 1, except that host compounds listed in Table 2 were used at respective ratios when preparing a composition for forming the emission layer.

### Evaluation Example 2: Evaluation of characteristics of organic light-emitting device (1)

The current efficiency and lifespan characteristics of the organic light-emitting devices manufactured according to Examples 1 to 17 and Comparative Examples 1 to 10 were evaluated. Specific measurement methods are as follows, and results thereof are shown in Table 2.
(1) Measurement of current efficiency

After applying a voltage to the manufactured organic light-emitting device, current was increased until luminance reached 6,000 nit (cd/m²) and was maintained constant. Here, current density per unit area with respect to the light-emitting device area, and the luminance (cd/m²) was divided by the current density (A/m²), thereby calculating current efficiency (cd/A).

### (2) Measurement of lifespan

The time that lapsed when 95 % (T₉₅) of initial luminance was calculated for each organic light-emitting device.

**[Table 2]**

| No. | Host | Efficiency (cd/A) | Lifespan (T96) (hrs) |
|---|---|---|---|
| Example 1 | ET-Host-A:HT-Host-A:WG-Host-A= 1:1:1 | 51 | 225 |
| Example 2 | ET-Host-A:HT-Host-A:WG-Host-A= 4:3:3 | 54 | 175 |
| Example 3 | ET-Host-A:HT-Host-A:WG-Host-A= 5:3:2 | 56 | 153 |
| Example 4 | ET-Host-B: HT-Host-A: WG-Host-B = 1:1:1 | 56 | 72 |
| Example 5 | ET-Host-C:HT-Host-A:WG-Host-A= 1:1:1 | 57 | 74 |
| Example 6 | ET-Host-D:HT-Host-A:WG-Host-A= 1:1:1 | 50 | 231 |
| Example 7 | ET-Host-E:HT-Host-A:WG-Host-A= 1:1:1 | 59 | 290 |
| Example 8 | ET-Host-F:HT-Host-A:WG-Host-A= 1:1:1 | 61 | 277 |
| Example 9 | ET-Host-E:HT-Host-C:WG-Host-A= 1:1:1 | 62 | 296 |
| Example 10 | ET-Host-E:HT-Host-B:WG-Host-A= 1:1:1 | 63 | 323 |
| Example 11 | ET-Host-E:HT-Host-A:WG-Host-C= 1:1:1 | 44 | 209 |
| Example 12 | ET-Host-E:HT-Host-A:WG-Host-D= 1:1:1 | 58 | 223 |
| Example 13 | ET-Host-E:HT-Host-A:WG-Host-E= 1:1:1 | 68 | 249 |
| Example 14 | ET-Host-E:HT-Host-A:WG-Host-F= 1:1:1 | 54 | 187 |
| Example 15 | ET-Host-F:HT-Host-C:WG-Host-D= 1:1:1 | 50 | 189 |
| Example 16 | ET-Host-F:HT-Host-B:WG-Host-D= 1:1:1 | 52 | 370 |
| Example 17 | ET-Host-F:HT-Host-D:WG-Host-D= 1:1:1 | 48 | 326 |
| Comparative Example 1 | ET-Host-A:HT-Host-A= 5:5 | 54 | 40 |
| Comparative Example 2 | ET-Host-A:WG-Host-A= 5:5 | 51 | 73 |
| Comparative Example 3 | ET-Host-B:HT-Host-A= 5:5: | 60 | 44 |
| Comparative Example 4 | ET-Host-B:WG-Host-A= 5:5 | 51 | 11 |
| Comparative Example 5 | ET-Host-C:HT-Host-A= 5:5 | 36 | 1 |
| Comparative Example 6 | ET-Host-C:WG-Host A-= 5:5 | 44 | 3 |
| Comparative Example 7 | ET-Host-F:HT-Host-1:WG-Host-D= 1:1:1 | 43 | 71 |
| Comparative Example 8 | ET-Host-F:HT-Host-2:WG-Host-D= 1:1:1 | 47 | 52 |
| Comparative Example 9 | ET-Host-F:HT-Host-3:WG-Host-D= 1:1:1 | 53 | 46 |
| Comparative Example 10 | ET-Host-F:PGH3-1:WG-Host-D=1:1:1 | 58 | 23 |

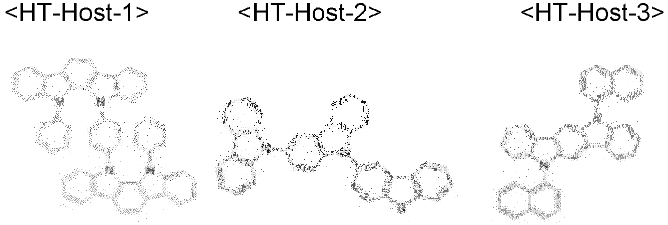

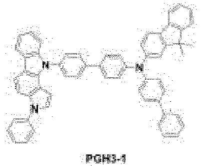

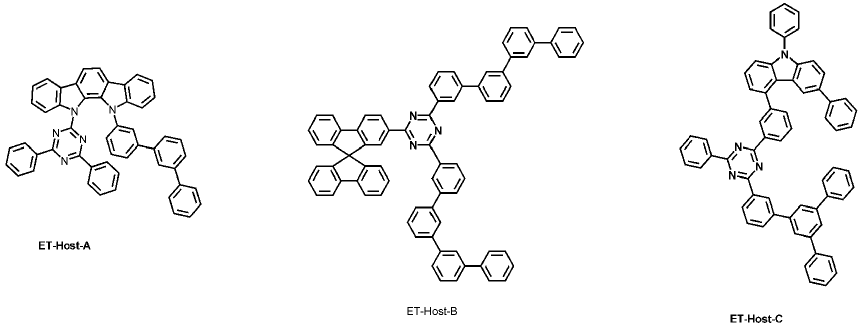

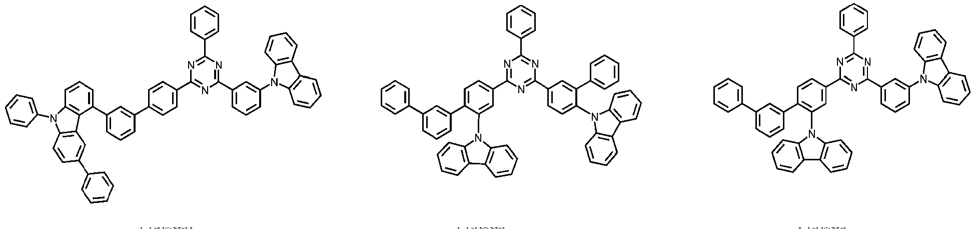

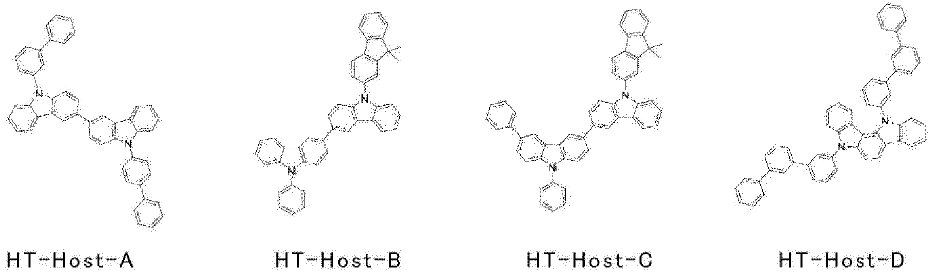

### Examples 18 to 24

Organic light-emitting devices were manufactured in the same manner as in Example 1, except that host compounds listed in Table 3 were used at respective ratios when preparing a composition for forming the emission layer, and a platinum complex represented by the following formula was used as the dopant: 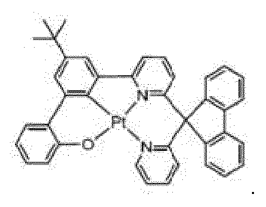 .

### Evaluation Example 3: Evaluation of characteristics of organic light-emitting device (2)

The current efficiency and lifespan characteristics of the organic light-emitting devices manufactured according to Examples 18 to 24 were evaluated. Specific measurement methods are the same as described above, and results thereof are shown in Table 3.

**[Table 3]**

| No. | Host | Efficiency (cd/A) | Lifespan (T₉₅) (hrs) |
|---|---|---|---|
| Example 18 | ET-Host-E:HT-Host-A:WG-Host-A= 1:1:1 | 56 | 233 |
| Example 19 | ET-Host-F:HT-Host-A:WG-Host-A= 1:1:1 | 58 | 247 |
| Example 20 | ET-Host-E:HT-Host-B:WG-Host-A= 1:1:1 | 66 | 203 |
| Example 21 | ET-Host-E:HT-Host-B:WG-Host-A= 4:3:3 | 59 | 158 |
| Example 22 | ET-Host-E:HT-Host-B:WG-Host-D= 1:1:1 | 63 | 252 |
| Example 23 | ET-Host-F:HT-Host-C:WG-Host-D= 1:1:1 | 63 | 307 |
| Example 24 | ET-Host-F:HT-Host-B:WG-Host-D= 1:1:1 | 65 | 283 |

### Example 25 and Comparative Examples 11 to 12

Organic light-emitting devices were manufactured in the same manner as in Example 1, except that host compounds listed in Table 4 were used at respective ratios when preparing a composition for forming the emission layer, and an iridium complex represented by the following formula was used as the dopant:

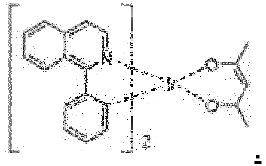

### Evaluation Example 4: Evaluation of characteristics of organic light-emitting device (3)

The current efficiency and lifespan characteristics of the organic light-emitting devices manufactured according to Example 25 and Comparative Examples 11 to 12 were evaluated. Specific measurement methods are the same as described above, and results thereof are shown in Table 4.

**[Table 4]**

| No. | Host | Efficiency (cd/A) | Lifespan (T₉₅) (hrs) |
|---|---|---|---|
| Example 25 | ET-Host-A:HT-Host-A:WG-Host-A-= 1:1:1 | 7.4 | 6.4 |
| Comparative Example 11 | ET-Host-A:HT-Host-A= 5:5 | 7.1 | 1 |
| Comparative Example 12 | ET-Host-A:WG-Host-A-= 5:5 | 6.8 | 1 |

### Example 26 and Comparative Example 13

Organic light-emitting devices were manufactured in the same manner as in Example 1, except that host compounds listed in Table 5 were used at respective ratios when preparing a composition for forming the emission layer, and FIrPic represented by the following formula was used as the dopant:

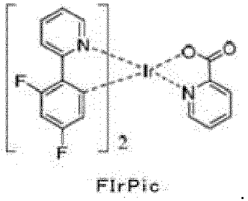

### Evaluation Example 5: Evaluation of characteristics of organic light-emitting device (4)

The current efficiency and lifespan characteristics of the organic light-emitting devices manufactured according to Example 26 and Comparative Example 13 were evaluated. Specific measurement methods are the same as described above, and results thereof are shown in Table 5.

**[Table 5]**

| No. | Host | Efficie ncy (cd/A) | Lifespan (T₉₅) (hrs) |
|---|---|---|---|
| Example 26 | ET-Host-A:HT-Host-A:WG-Host-A= 1:1:1 | 19 | 15 |
| Comparative Example 13 | ET-Host-A:HT-Host-A= 5:5 | 18 | 3 |

### Example 27 and Comparative Examples 14 and 15

Organic light-emitting devices were manufactured in the same manner as in Example 1, except that host compounds listed in Table 6 were used at respective ratios when preparing a composition for forming the emission layer, and Blue Dopant-A represented by the following formula was used as the dopant:

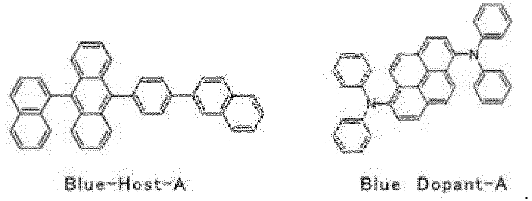

### Evaluation Example 6: Evaluation of characteristics of organic light-emitting device (5)

The current efficiency and lifespan characteristics of the organic light-emitting devices manufactured according to Example 27 and Comparative Examples 14 and 15 were evaluated. Specific measurement methods are the same as described above, and results thereof are shown in Table 6.

**[Table 6]**

| No. | Host | Efficiency (cd/A) | Lifespan (T₉₅) (hrs) |
|---|---|---|---|
| Example 27 | Blue-Host-A:HT-Host-A:WG-Host-D= 1:1:1 | 4.2 | 75 |
| Comparativ e Example 14 | Blue-Host-A:HT-Host-A= 5:5 | 3.1 | 27 |
| Comparativ e Example 15 | Blue-Host-A:HT-Host-A= 7:3 | 3.3 | 30 |

Referring to Tables 2 to 6, it was confirmed that the organic light-emitting devices manufactured according to Examples using the three host compounds disclosed herein showed the current efficiency (i.e., luminance efficiency) that was almost equivalent to or higher than that of the organic light-emitting devices manufactured according to Comparative Examples, and also exhibited significantly improved lifespan characteristics. In addition, the organic light-emitting devices manufactured according to Examples showed good film formation capability. Therefore, it was confirmed that the host compounds disclosed herein were useful as materials for forming the organic light-emitting devices by solution coating.

In addition, since the host compounds used in Examples were able to form the emission layer of the organic light-emitting device by coating methods, the host compounds are preferable in view of mass production.

According to the one or more embodiments, due to inclusion of three different compounds in the emission layer of the organic light-emitting device, the organic light-emitting device showed improved efficiency and lifespan characteristics.

## Claims

1. An organic light-emitting device comprising:
a first electrode;
a second electrode; and
an emission layer between the first electrode and the second electrode,
wherein the emission layer comprises a first compound, a second compound, and a third compound,
the first compound includes at least one compound represented by one of Formulae 1-1 to 1-4,
the second compound includes at least one compound represented by one of Formulae 2-1 to 2-4, and
the third compound includes at least one compound containing at least one group selected from a triphenylene group, a dibenzofuran group, a dibenzothiophene group, a fluorene group, and a biscarbazole group, wherein a band gap between a highest occupied molecular orbital (HOMO) energy level and a lowest unoccupied molecular orbital (LUMO) energy level of the third compound is 3.3 eV or more: 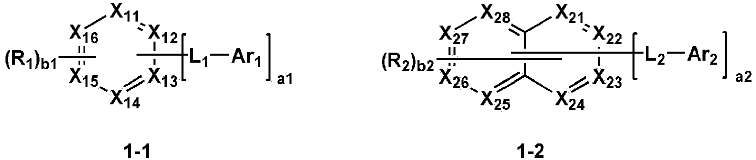 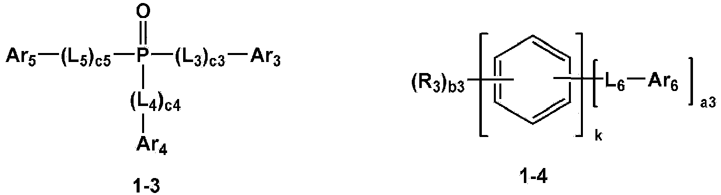 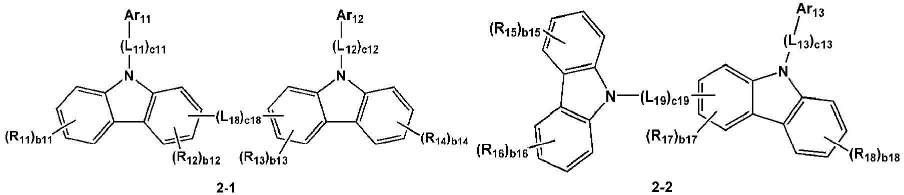 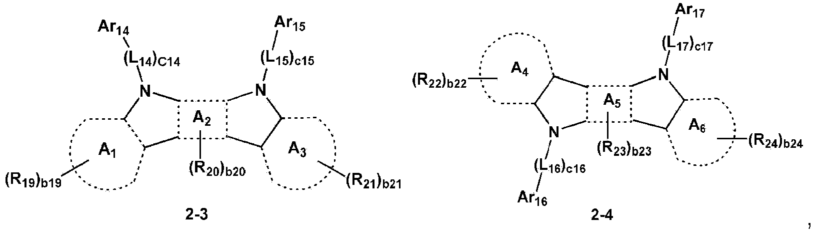
wherein, in Formulae 1-1 to 1-4,
X₁₁ to X₁₆ and X₂₁ to X₂₈ are each independently C or N,
at least one selected from X₁₁ to X₁₆ is N,
at least one selected from X₂₁ to X₂₈ is N,
L₁ to L₆ are each independently selected from a single bond, a substituted or unsubstituted C₆-C₃₀ arylene group, a substituted or unsubstituted C₁-C₃₀ heteroarylene group, a divalent non-aromatic condensed polycyclic group, and a divalent non-aromatic condensed heteropolycyclic group,
c3 to c5 are each independently an integer from 1 to 3,
Ar₁ to Ar₆ are each independently selected from a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group,
any two adjacent groups among Ar₃ to Ar₅ are optionally linked to each other via a single bond to form a condensed ring,
a1 to a3 are each independently an integer from 1 to 3,
R₁ to R₃ are each independently selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b1 is an integer from 0 to 4,
b2 is an integer from 0 to 6,
b3 is an integer from 7 to 11, and
k is 3 or 4, and
in Formulae 2-1 to 2-4,
A₁ to A₆ are each independently selected from a C₅-C₃₀ carbocyclic group and a C₁-C₃₀ heterocyclic group,
L₁₁ to L₁₉ are each independently selected from a single bond, a substituted or unsubstituted C₆-C₃₀ arylene group, a substituted or unsubstituted C₁-C₃₀ heteroarylene group, a substituted or unsubstituted divalent non-aromatic condensed polycyclic group, and a substituted or unsubstituted divalent non-aromatic condensed heteropolycyclic group,
c11 to c19 are each independently an integer from 1 to 3,
Ar₁₁, Ar₁₂, and Ar₁₄ to Ar₁₇ are each independently selected from a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group, wherein each of Ar₁₄ and Ar₁₅ is not an indolocarbazole group, and each of Ar₁₆ and Ar₁₇ is not a naphthyl group at the same time,
Ar₁₃ is selected from a substituted or unsubstituted C₆-C₃₀ aryl group and a substituted or unsubstituted monovalent non-aromatic condensed polycyclic group,
R₁₁ to R₂₄ are each independently selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group, a substituted or unsubstituted C₆-C₃₀ aryl group, and a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group,
b11, b14, b15, b16, and b18 to b24 are each independently an integer from 0 to 4,
b12, b13, and b17 are each independently an integer from 0 to 3,
at least one substituent of the substituted C₆-C₃₀ arylene group, the substituted C₁-C₃₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₆-C₃₀ aryl group, the substituted C₁-C₃₀ heteroaryl group, the substituted monovalent non-aromatic condensed polycyclic group, and the substituted monovalent non-aromatic condensed heteropolycyclic group is selected from:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₁ to Q₉, Q₁₁ to Q₁₉, Q₂₁ to Q₂₉, and Q₃₁ to Q₃₉ are each independently selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

2. The organic light-emitting device of claim 1, wherein
L₁ to L₆ and L₁₁ to L₁₉ are each independently selected from a single bond, a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzoimidazolylene group, a benzofuranylene(benzofuranylene group, a benzothiophenylene group, an isobenzothiazolylene group, a benzoxazolylene group, an isobenzoxazolyl group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a pentalenyl group, an indenyl group, a naphthyl group, an azulenyl group, a heptalenyl group, an indacenyl group, an acenaphthyl group, a fluorenyl group, a spiro-fluorenylene group, a benzofluorenylene group, a dibenzofluorenylene group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group.

3. The organic light-emitting device of claim 1 or 2, wherein
Ar₁ to Ar₆ are each independently selected from:
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an indolocarbazolyl group, an indolodibenzofuranyl group, an indolodibenzothiophenyl group, an indolofluorenyl group, an indolospiro-fluorenyl group, an indolophenanthrenyl group, an indolotriphenylenyl group, an indoloazadibenzofuranyl group, and an indoloazadibenzothiophenyl group; and
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an indolocarbazolyl group, an indolodibenzofuranyl group, an indolodibenzothiophenyl group, an indolofluorenyl group, an indolospiro-fluorenyl group, an indolophenanthrenyl group, an indolotriphenylenyl group, an indoloazadibenzofuranyl group, and an indoloazadibenzothiophenyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an indolocarbazolyl group, an indolodibenzofuranyl group, an indolodibenzothiophenyl group, an indolofluorenyl group, an indolospiro-fluorenyl group, an indolophenanthrenyl group, an indolotriphenylenyl group, an indoloazadibenzofuranyl group, and an indoloazadibenzothiophenyl group.

4. The organic light-emitting device of any one of claims 1-3, wherein
R₁ to R₃ are each independently selected from:
hydrogen, deuterium, -F, -Cl, -Br, -I, a cyano group, a C₁-C₂₀ alkyl group, and a C₁-C₂₀ alkoxy group; and
a C₁-C₂₀ alkyl group and a C₁-C₂₀ alkoxy group, each substituted with at least one selected from deuterium, -F, -Cl, -Br, -I, a cyano group, a C₁-C₂₀ alkyl group, and C₁-C₂₀ alkoxy group.

5. The organic light-emitting device of any one of claims 1-4, wherein
A₁, A₂, A₃, A₄, A₅, and A₆ are each independently selected from a benzene group, a naphthalene group, an anthracene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group.

6. The organic light-emitting device of any one of claims 1-5, wherein
Ar₁₁, Ar₁₂, and Ar₁₄ to Ar₁₇ are each independently selected from:
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and a group represented by Formula a; and
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and a group represented by Formula a, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group and -N(Q₁₁)(Q₁₂),
each of Ar₁₄ and Ar₁₅ is not an indolocarbazole group, and each of Ar₁₆ and Ar₁₇ is not a naphthalene group at the same time, and
Q₁₁ and Q₁₂ are each independently selected from a phenyl group, a biphenyl group, a terphenyl group, and a naphthyl group: 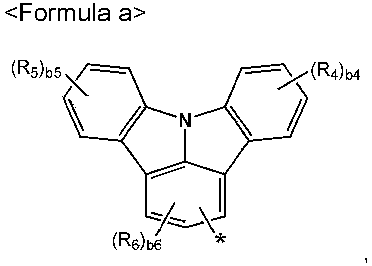
wherein, in Formula a,
R₄ to R₆ are each independently selected from:
hydrogen, deuterium, -F, -Cl, -Br, -I, a cyano group, a C₁-C₂₀ alkyl group, and a C₁-C₂₀ alkoxy group; and
a C₁-C₂₀ alkyl group and a C₁-C₂₀ alkoxy group, each substituted with at least one selected from deuterium, -F, -Cl, -Br, -I, a cyano group, a C₁-C₂₀ alkyl group, and a C₁-C₂₀ alkoxy group,
b4 is an integer from 0 to 4,
b5 is an integer from 0 to 4,
b6 is an integer from 0 to 2,
"*" indicates a binding site to a neighboring atom.

7. The organic light-emitting device of any one of claims 1-6, wherein
Ar₁₃ is selected from:
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group;
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group; and/or
wherein
R₁₁ to R₂₄ are each independently selected from:
hydrogen, deuterium, -F, -Cl, -Br, -I, a cyano group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, and a cyano group;
a phenyl group, a biphenyl group, a terphenyl group, a fluorenyl group, a spiro-fluorenyl group, a benzofluorenyl group, a dibenzofluorenyl group, a pyridinyl group, a pyrazinyl group, a pyrimidinyl group, a pyridazinyl group, a carbazolyl group, a dibenzofuranyl group, a dibenzothiophenyl group, a benzocarbazolyl group, and a dibenzocarbazolyl group; and
a phenyl group, a biphenyl group, a terphenyl group, a fluorenyl group, a spiro-fluorenyl group, a benzofluorenyl group, a dibenzofluorenyl group, a pyridinyl group, a pyrazinyl group, a pyrimidinyl group, a pyridazinyl group, a carbazolyl group, a dibenzofuranyl group, a dibenzothiophenyl group, a benzocarbazolyl group, and a dibenzocarbazolyl group, each substituted with at least one selected from a C₁-C₂₀ alkyl group, a C₁-C₂₀ alkoxy group, a phenyl group, a biphenyl group, a terphenyl group, a fluorenyl group, a spiro-fluorenyl group, a benzofluorenyl group, a dibenzofluorenyl group, a pyridinyl group, a pyrazinyl group, a pyrimidinyl group, a pyridazinyl group, a carbazolyl group, a dibenzofuranyl group, a dibenzothiophenyl group, a benzocarbazolyl group, and a dibenzocarbazolyl group that are each substituted with at least one selected from deuterium, -F, -Cl, -Br, -I, and a cyano group.

8. The organic light-emitting device of any one of claims 1-7, wherein
the third compound includes at least one compound represented by one of Formulae 3-1 to 3-4 below: 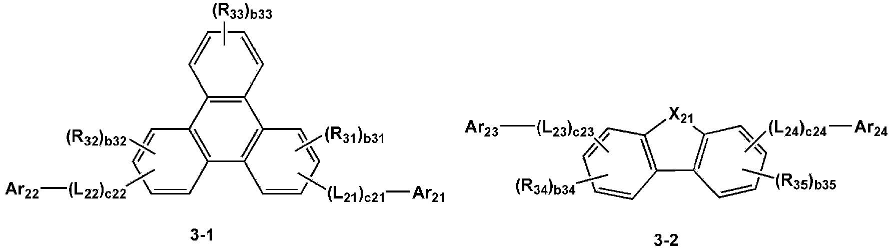 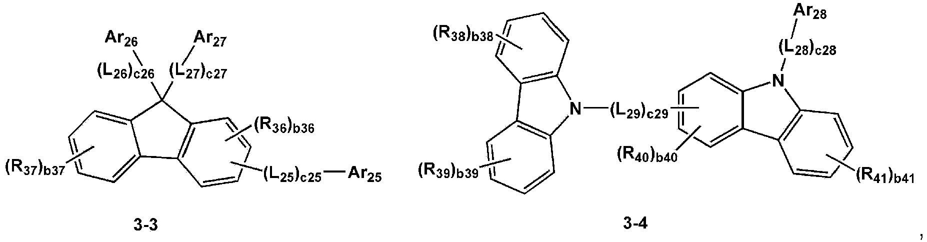
wherein, in Formulae 3-1 to 3-4,
X₂₁ is O or S,
L₂₁ to L₂₉ are each independently selected from a single bond, a substituted or unsubstituted C₆-C₃₀ arylene group, a substituted or unsubstituted C₁-C₃₀ heteroarylene group, a divalent non-aromatic condensed polycyclic group, and a divalent non-aromatic condensed heteropolycyclic group,
c21 to c29 are each independently an integer from 1 to 3,
Ar₂₁ to Ar₂₈ are each independently selected from hydrogen, a substituted or unsubstituted C₆-C₃₀ aryl group, a substituted or unsubstituted C₁-C₃₀ heteroaryl group, a substituted or unsubstituted monovalent non-aromatic condensed polycyclic group, and a substituted or unsubstituted monovalent non-aromatic condensed heteropolycyclic group,
each of Ar₂₁ and Ar₂₂ is not hydrogen at the same time,
Ar₂₆ and Ar₂₇ are optionally linked to each other via a single bond to form a condensed ring,
R₃₁ to R₄₁ are each independently selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b31, b32, b34, b35, b36, and b40 are each independently an integer from 0 to 3, and
b33, b37, b38, b39, and b41 are each independently an integer from 0 to 4; preferably wherein
Ar₂₁ to Ar₂₈ are each independently selected from:
hydrogen, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group;
a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a biphenyl group, a terphenyl group, a quaterphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, and an ovalenyl group.

9. The organic light-emitting device of any one of claims 1-8, wherein
Formula 1-1 is represented by Formula 1-1 (1),
Formula 1-2 is represented by Formula 1-2(1),
Formula 1-4 is represented by one of Formulae 1-4(1), 1-4(2), and 1-4(3): 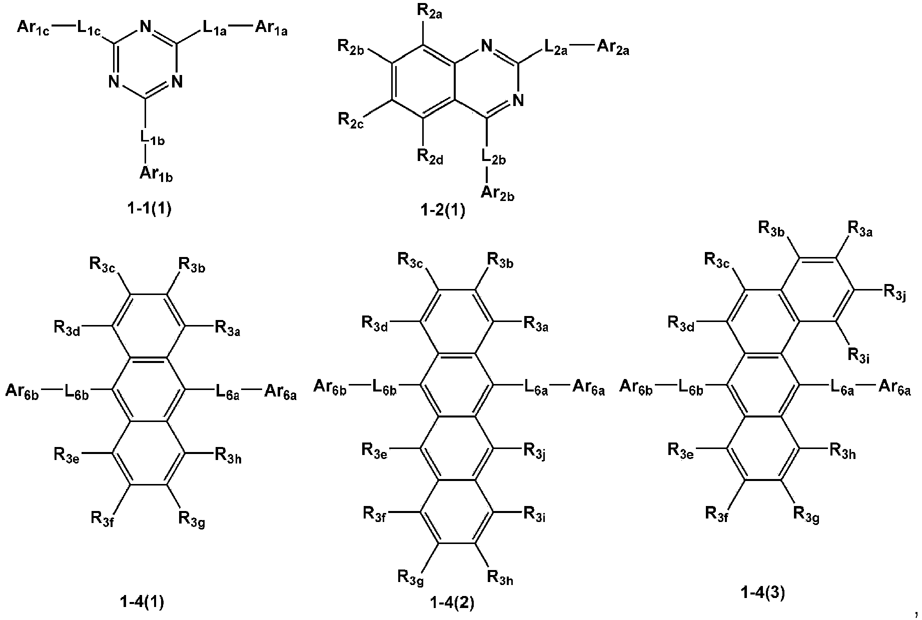
wherein, in Formula 1-1(1), L₁ₐ, L_{1b}, and L_{1c} are understood by referring to the description presented in connection with L₁ of claim 1, and Ar₁ₐ, Ar_{1b}, and Ar_{1c} are understood by referring to the description presented in connection with Ar₁ of claim 1, and
in Formula 1-2(1), L₂ₐ and L_{2b} are understood by referring to the description presented in connection with L₂ of claim 1, Ar₂ₐ and Ar_{2b} are understood by referring to the description presented in connection with Ar₂ of claim 1, and R₂ₐ, R_{2b}, R_{2c}, and R_{2d} are understood by referring to the description presented in connection with R₂ of claim 1,
in Formula 1-4(1) to 1-4(3), L₆ₐ and L_{6b} are understood by referring to the description presented in connection with L₆ of claim 1, Area and Ar_{6b} are understood by referring to the description presented in connection with Ar₆ of claim 1 and R₃ₐ to R₃ⱼ are understood by referring to the description presented in connection with R₃ of claim 1.

10. The organic light-emitting device of any one of claims 1-9, wherein
the first compound includes at least one of the following compounds:

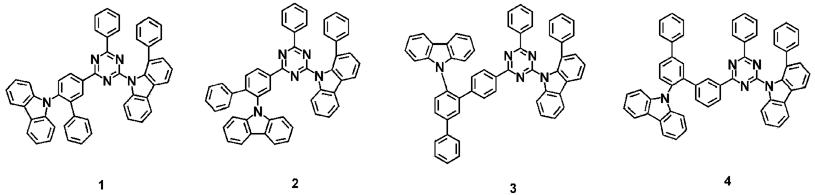

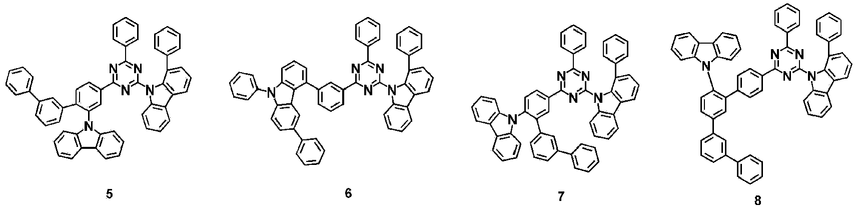

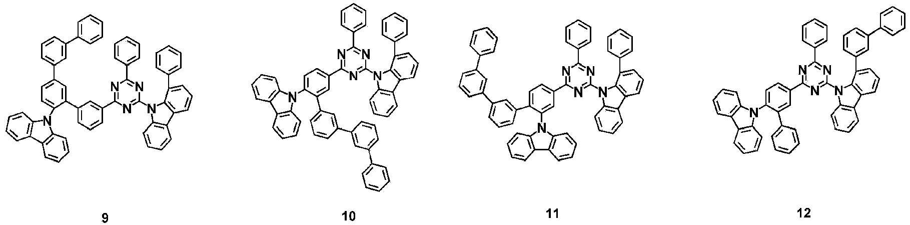

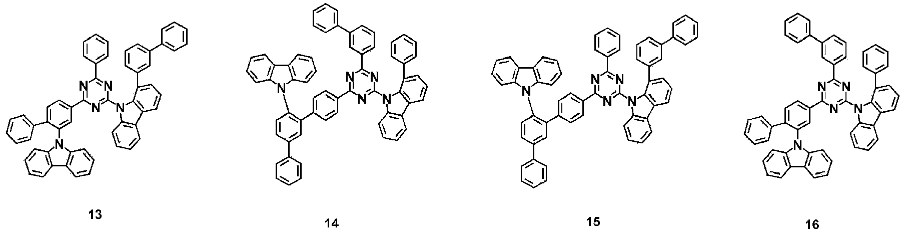

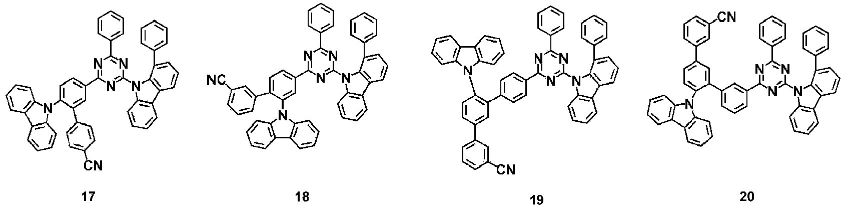

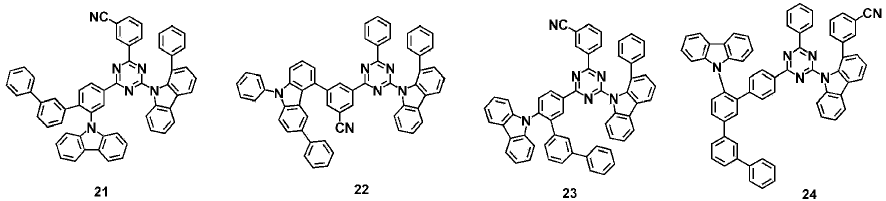

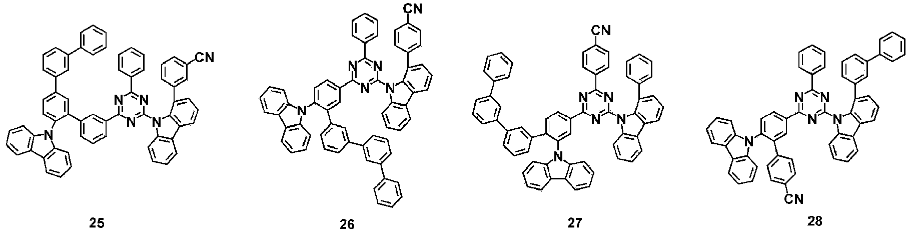

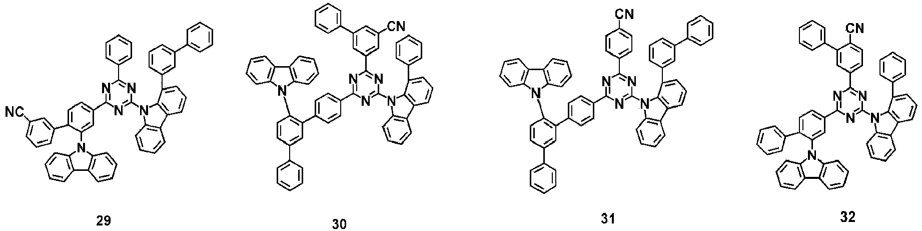

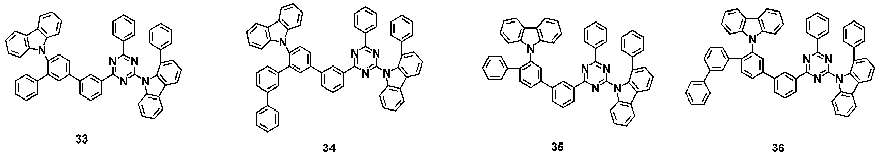

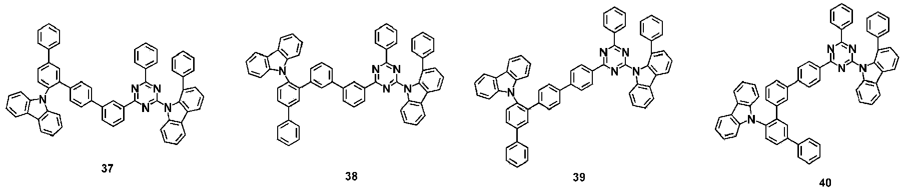

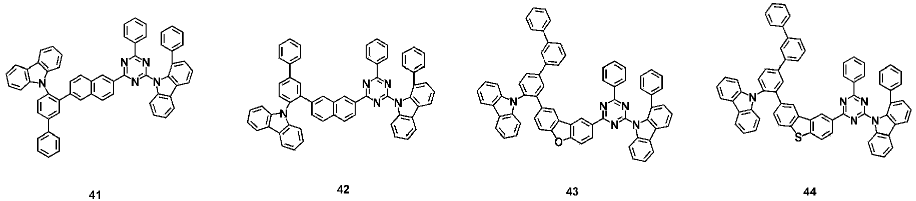

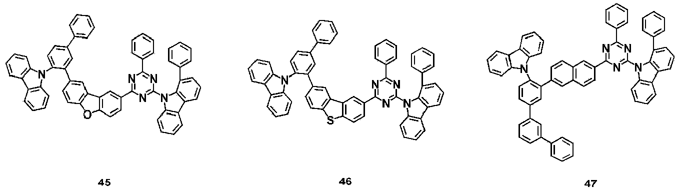

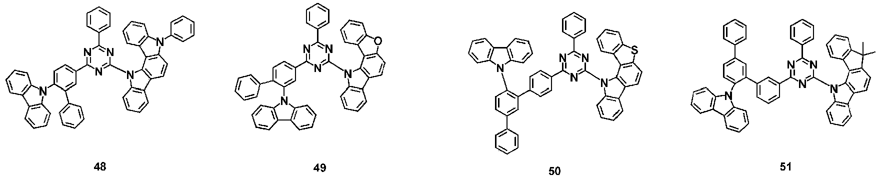

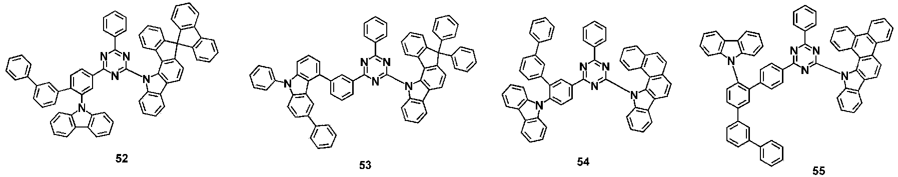

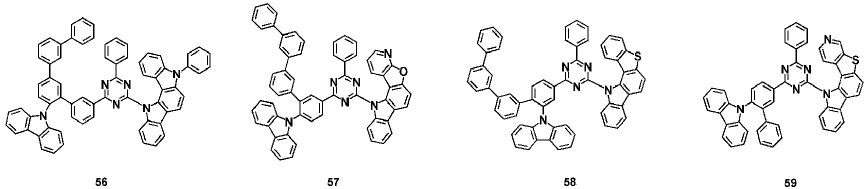

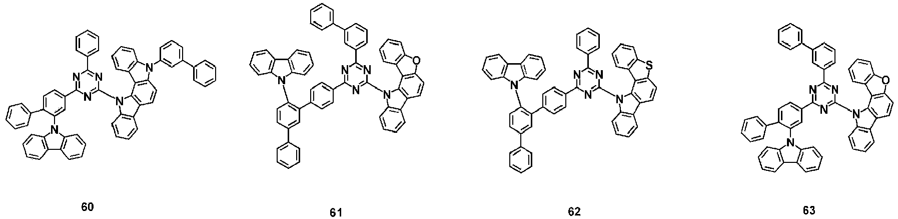

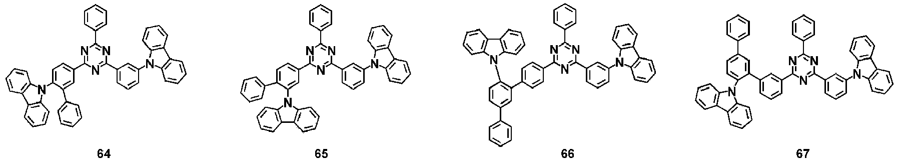

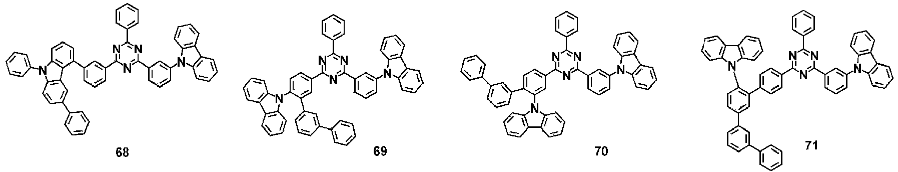

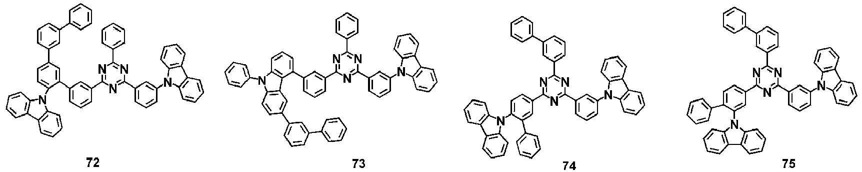

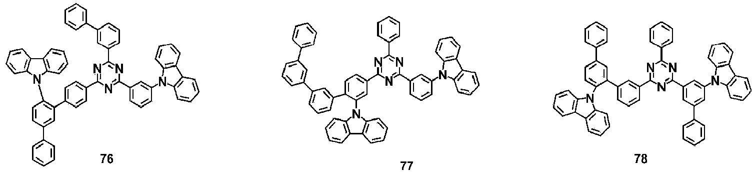

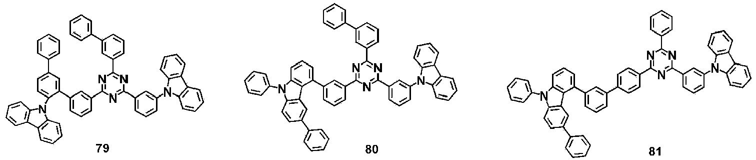

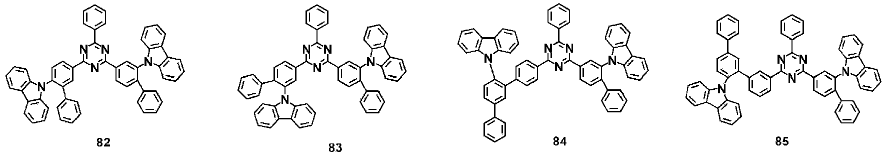

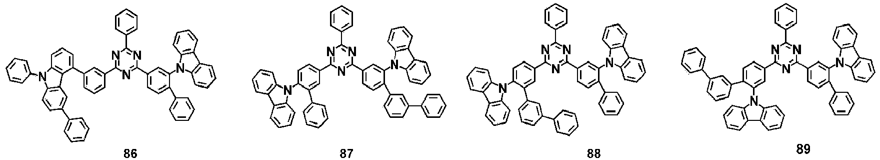

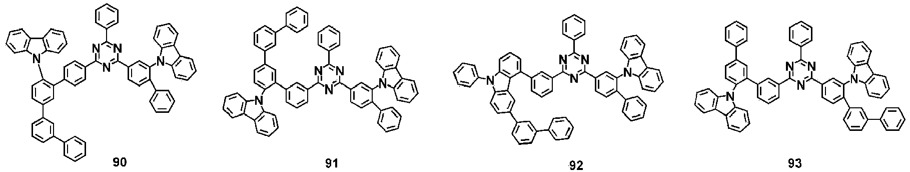

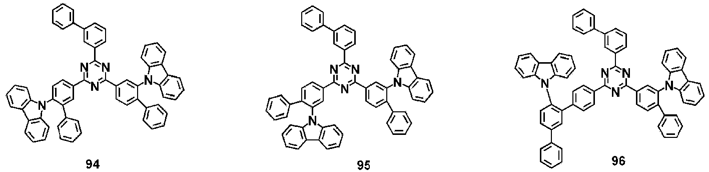

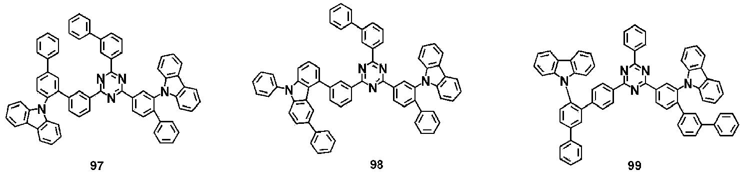

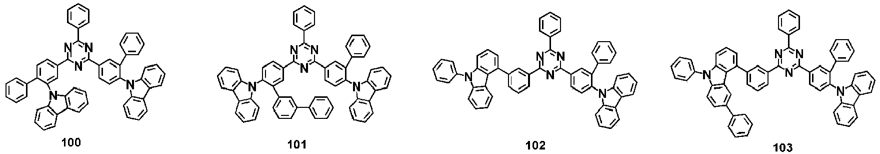

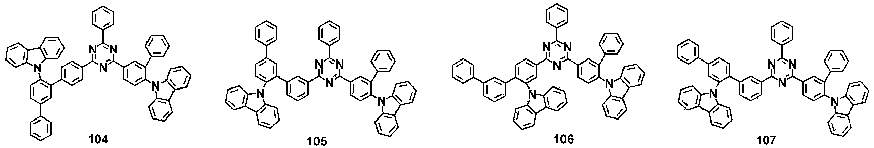

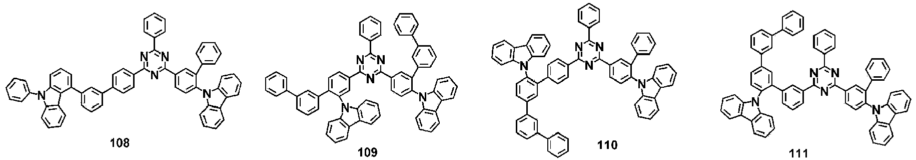

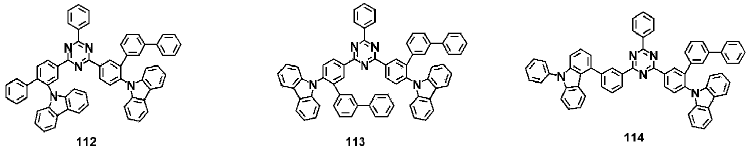

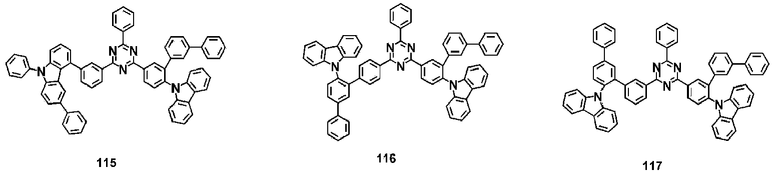

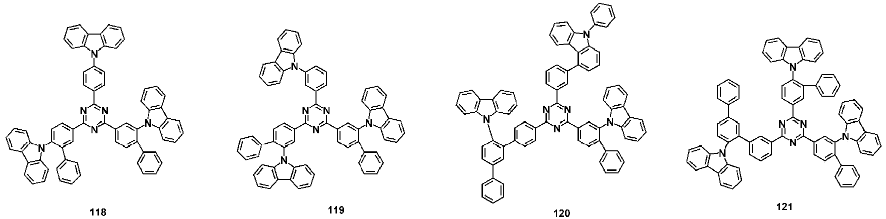

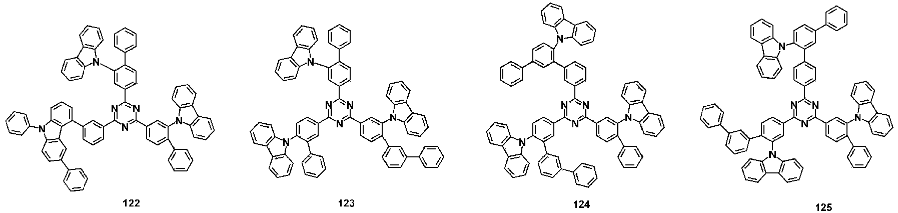

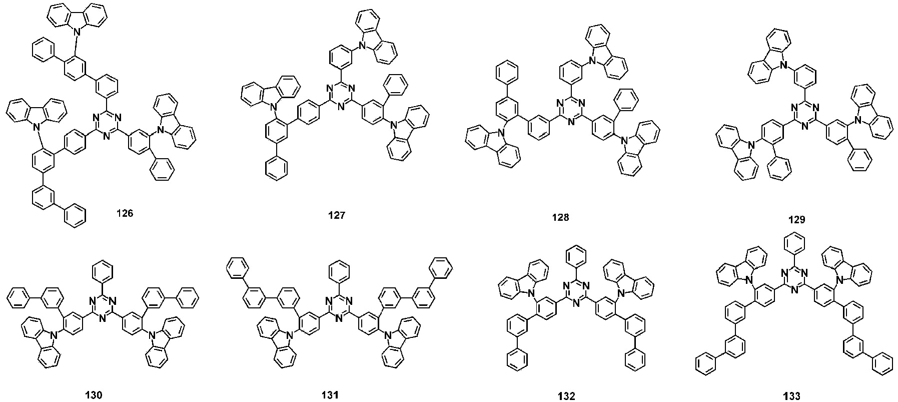

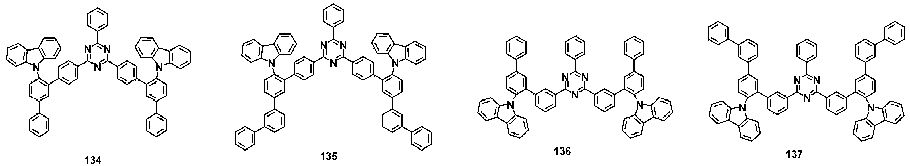

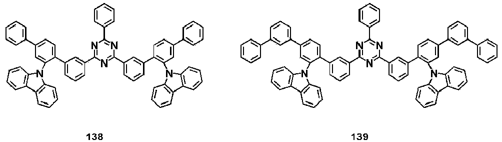

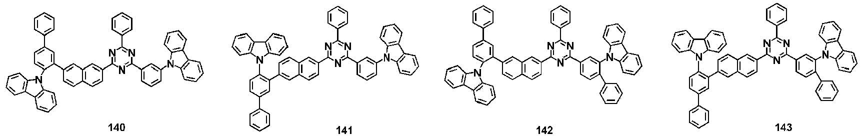

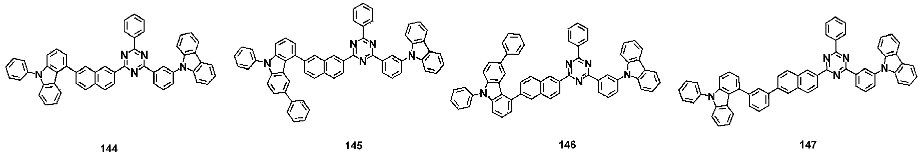

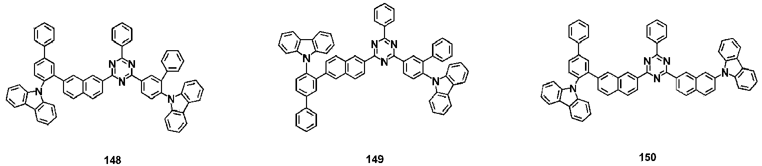

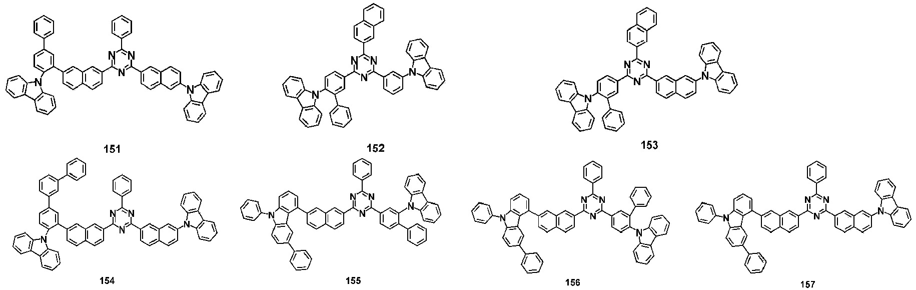

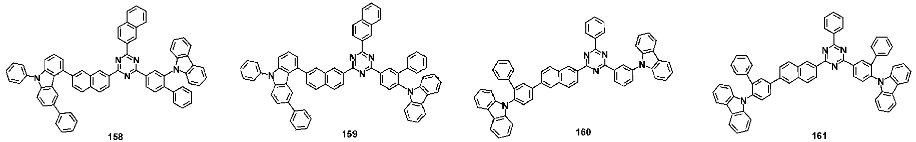

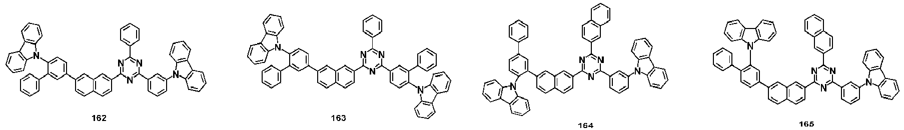

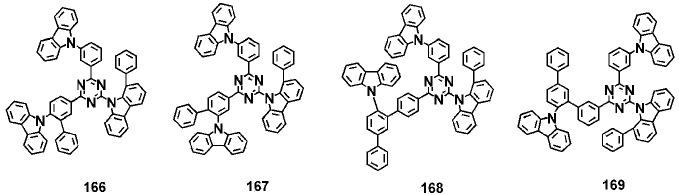

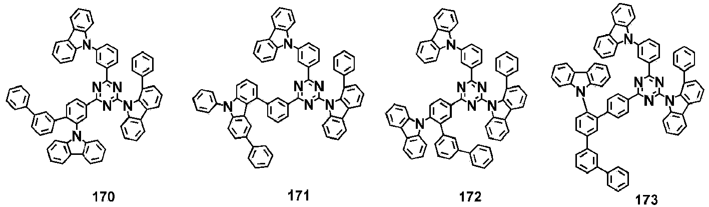

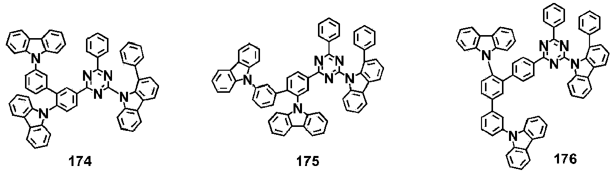

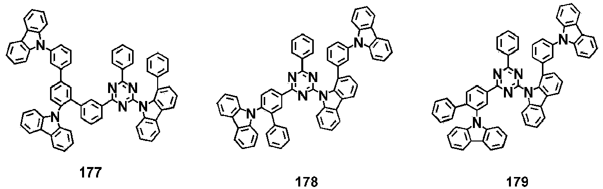

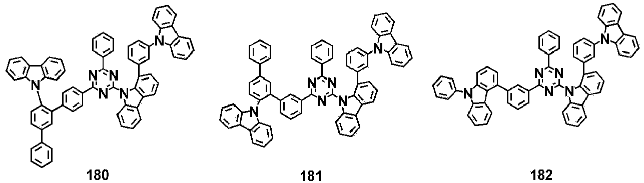

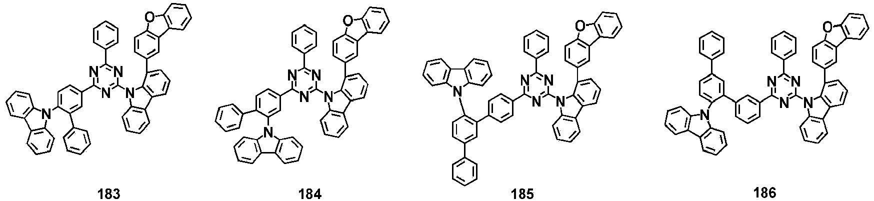

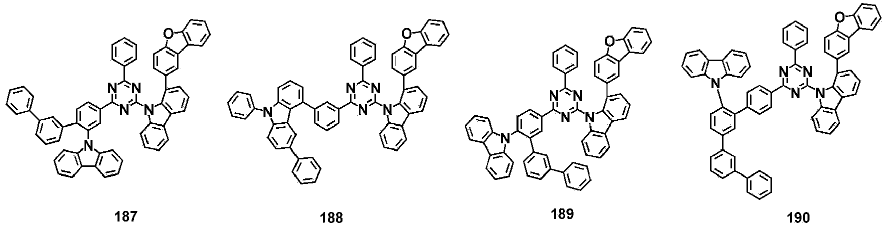

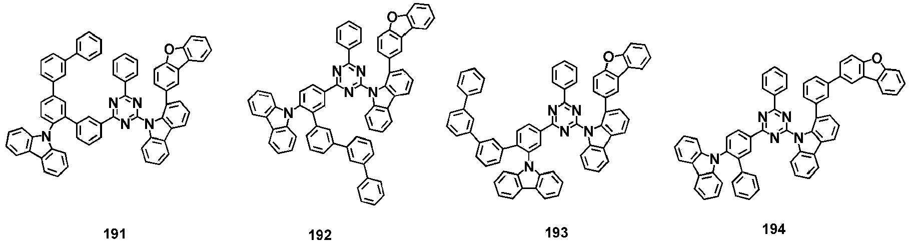

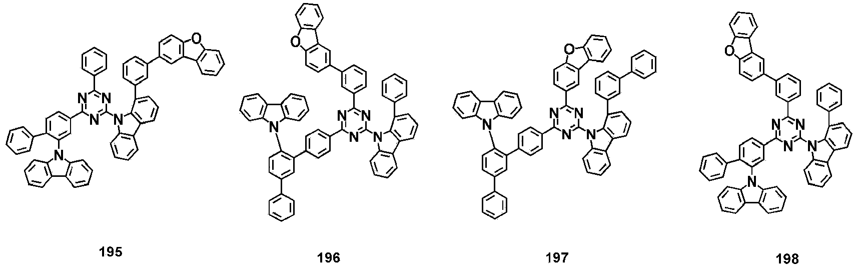

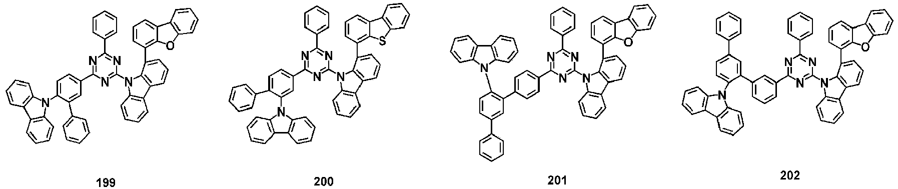

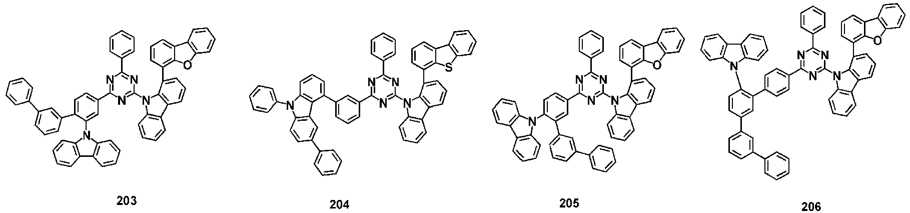

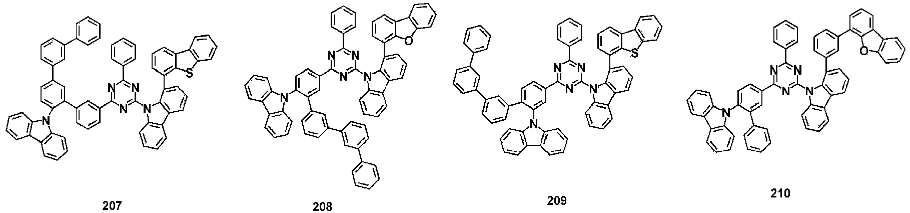

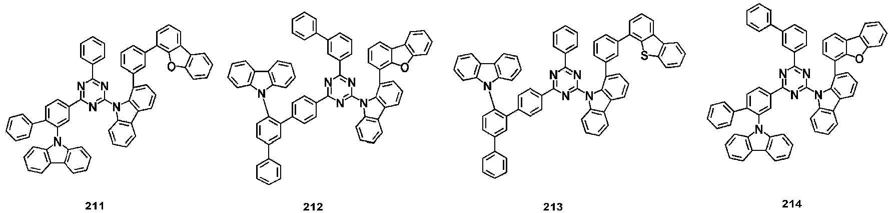

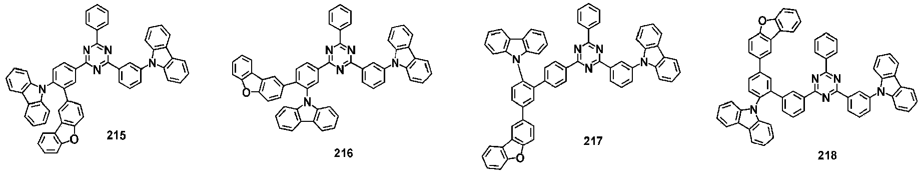

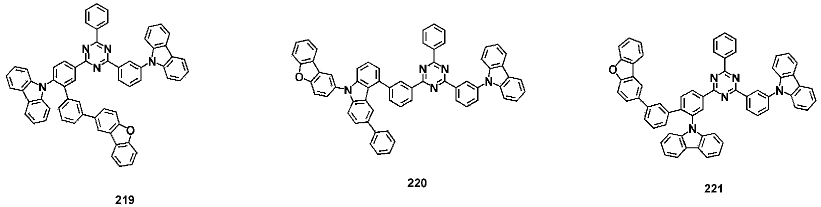

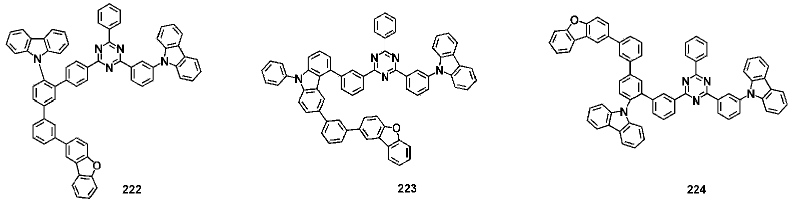

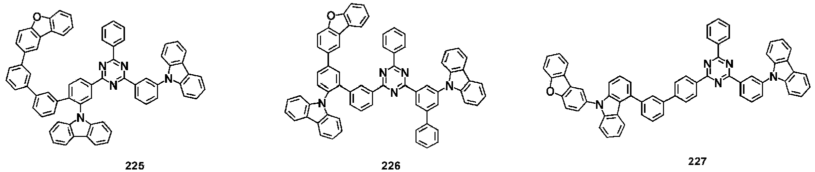

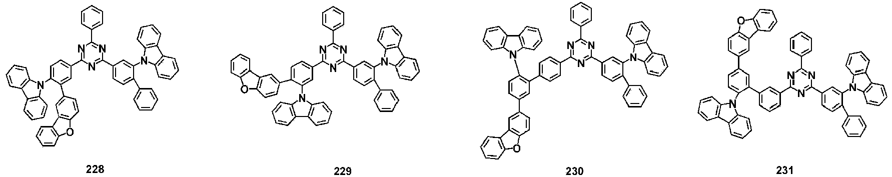

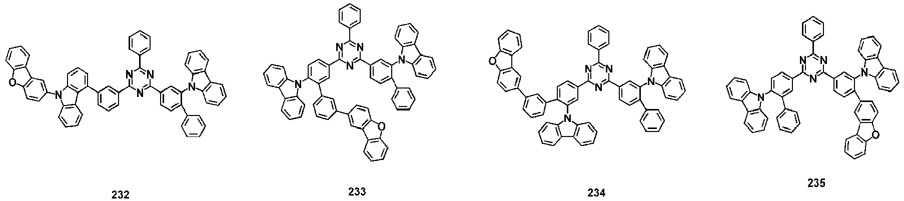

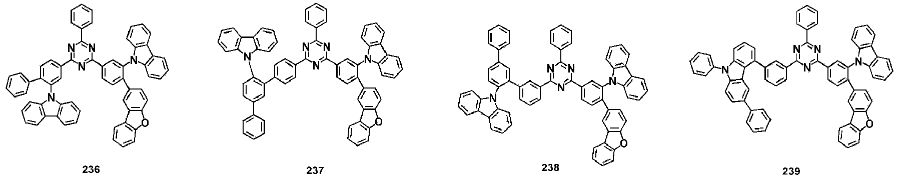

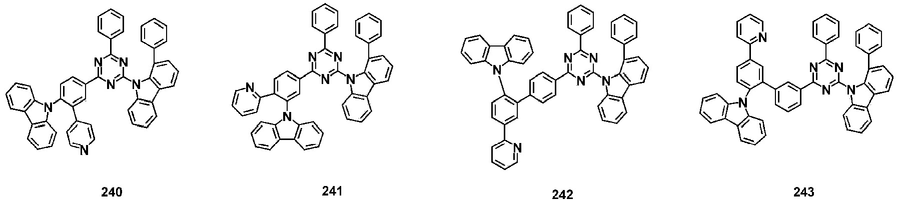

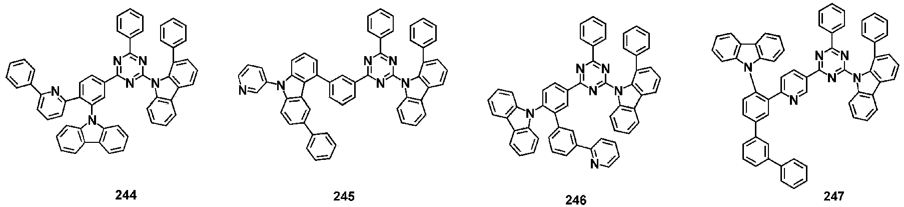

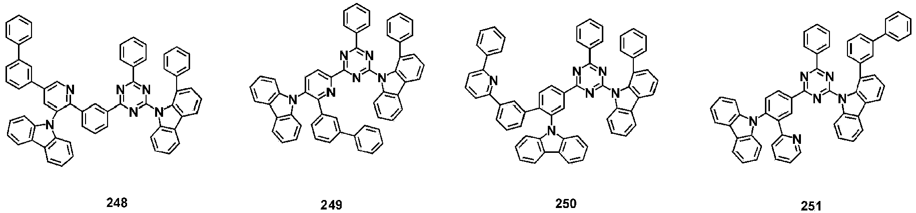

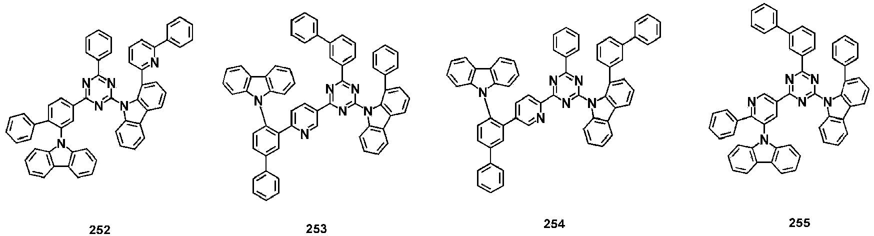

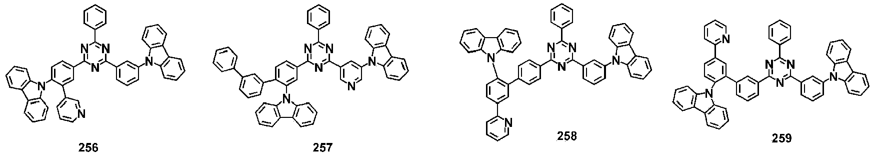

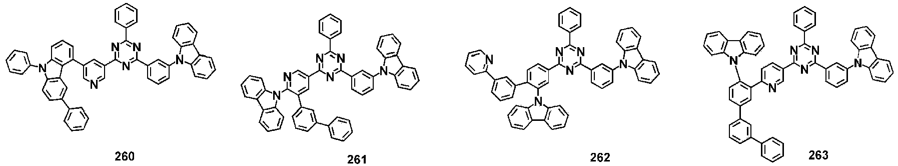

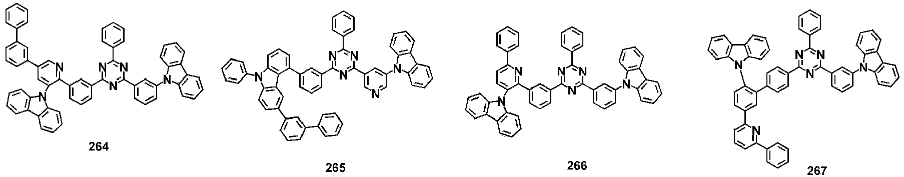

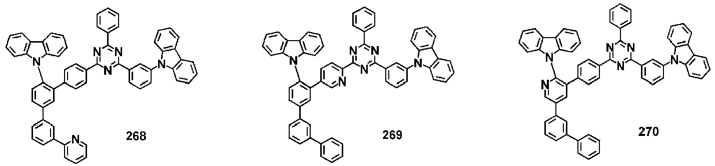

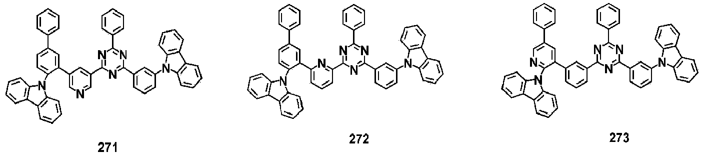

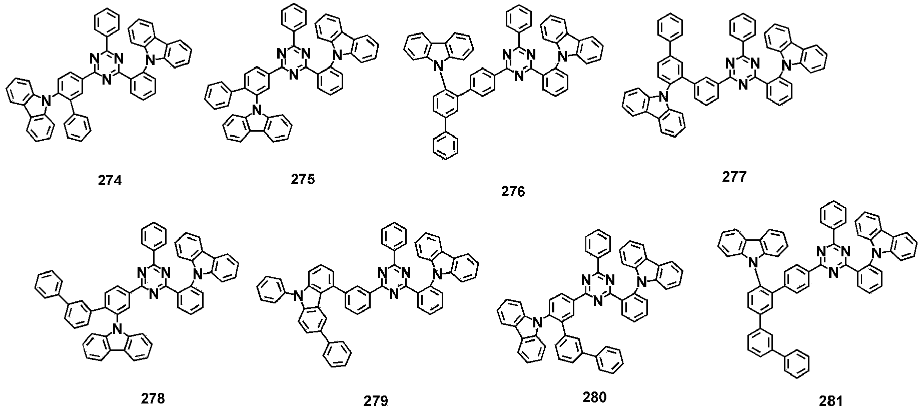

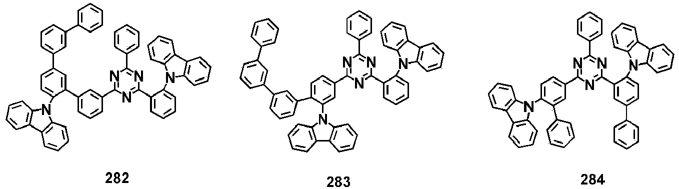

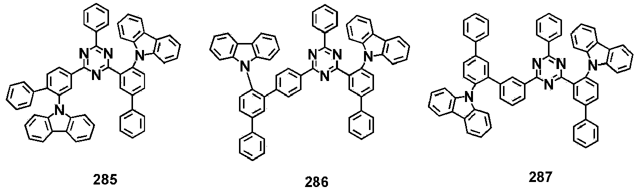

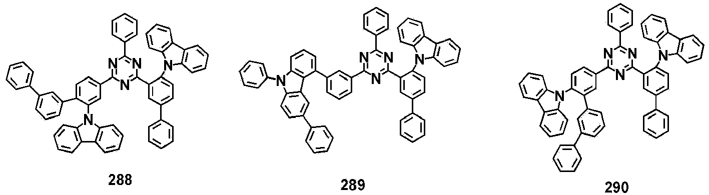

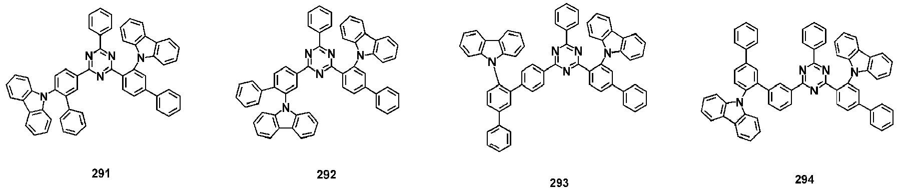

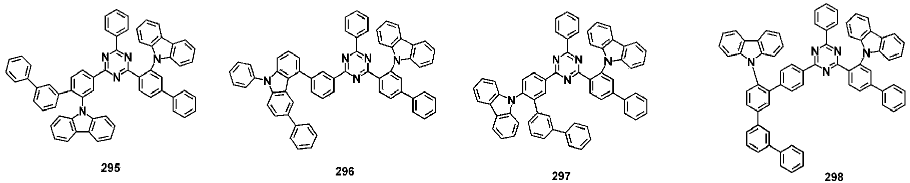

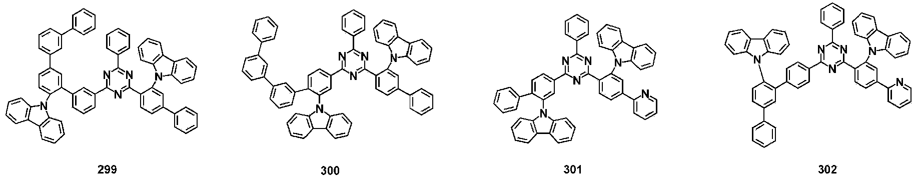

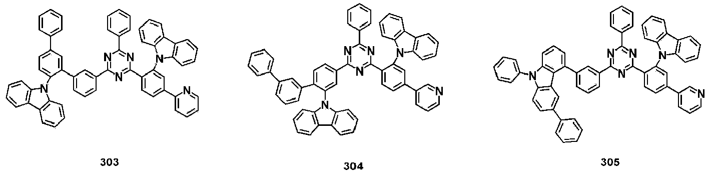

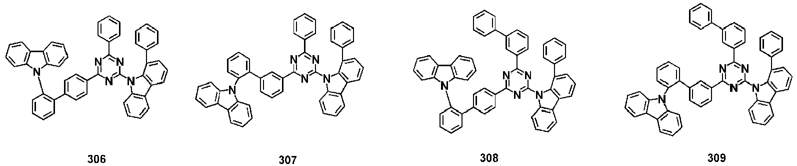

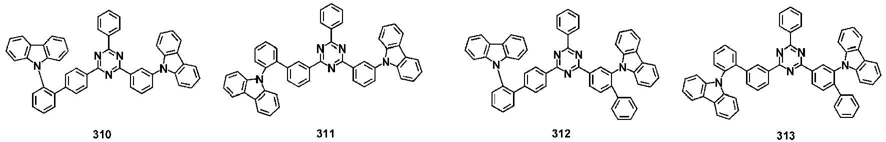

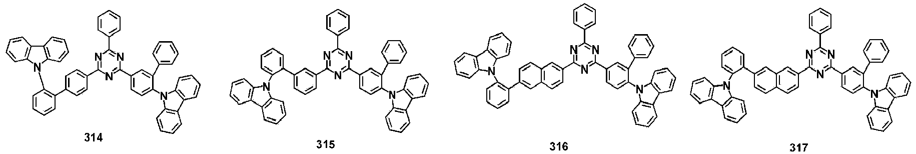

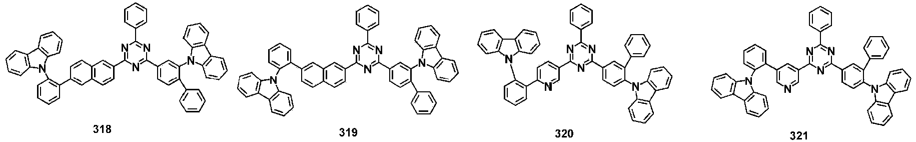

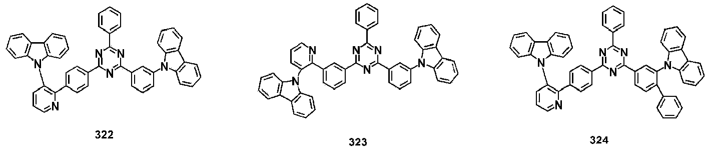

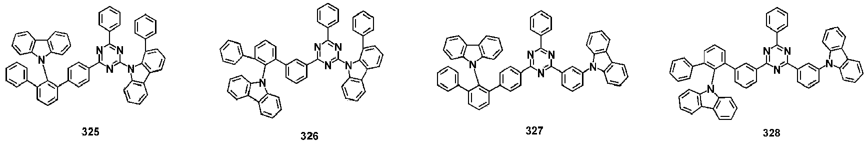

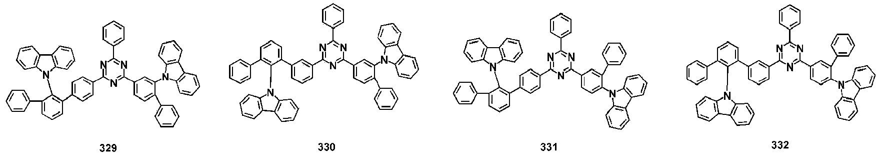

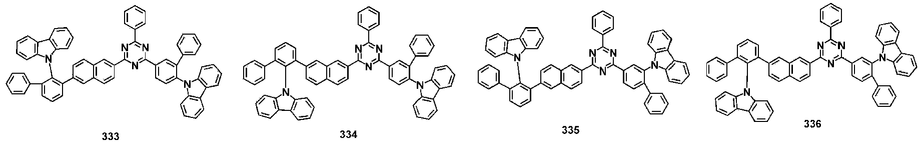

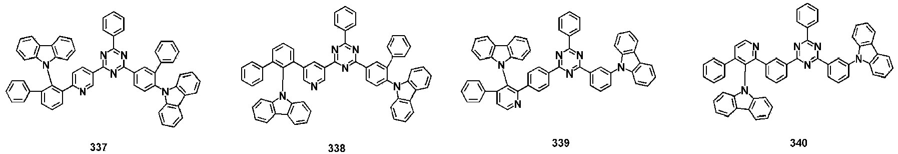

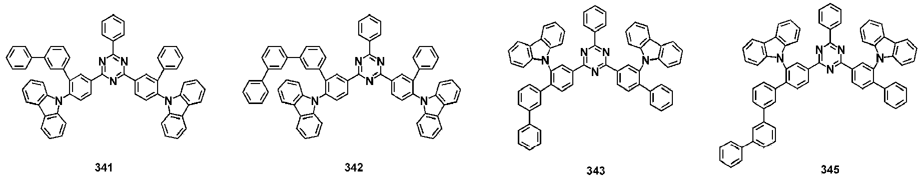

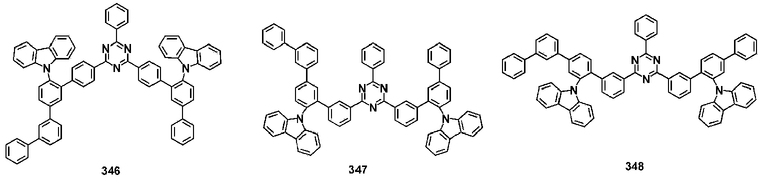

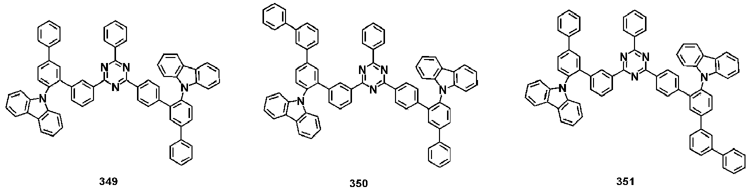

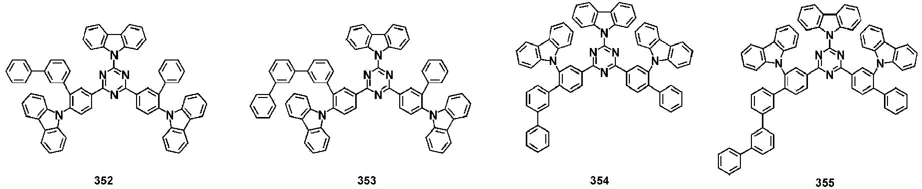

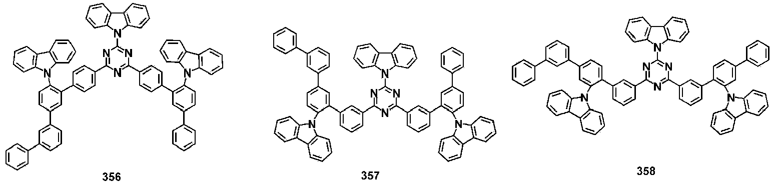

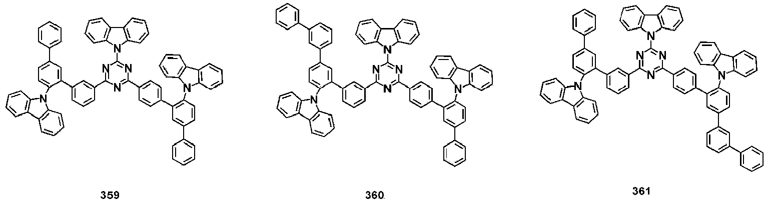

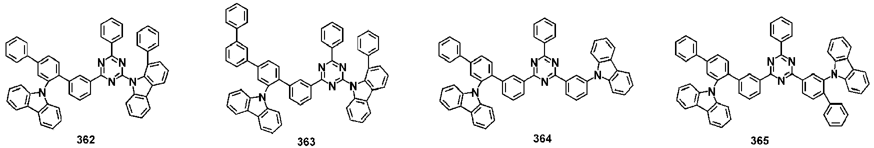

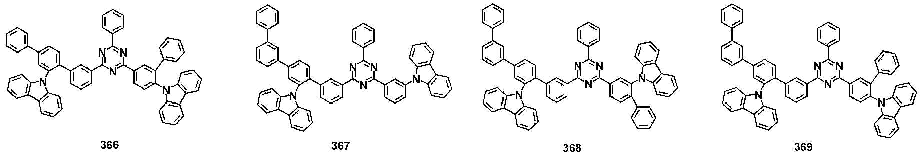

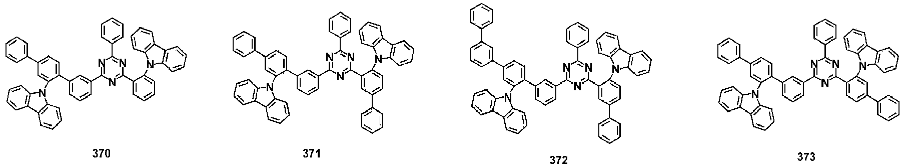

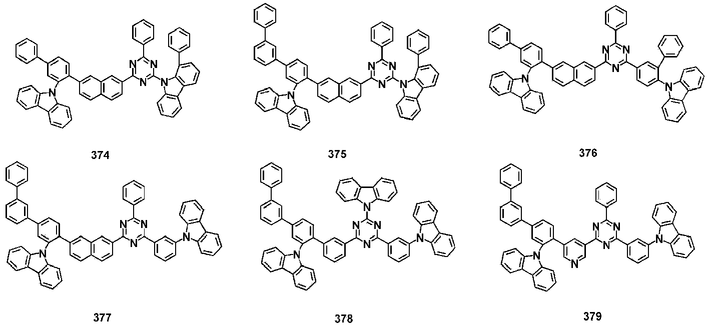

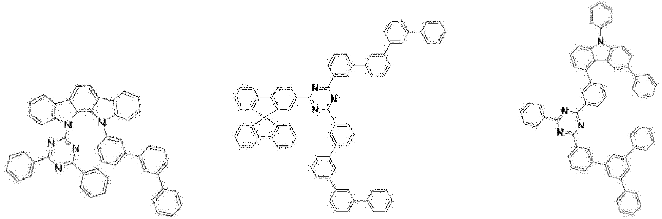

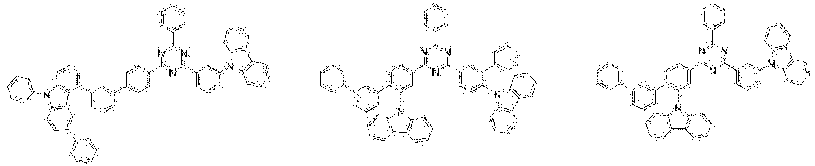

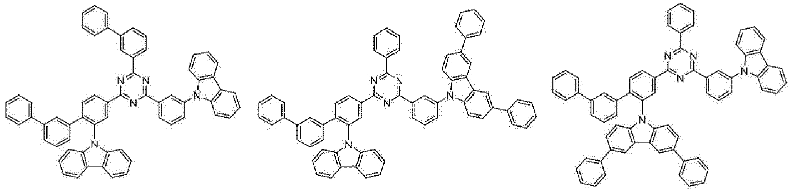

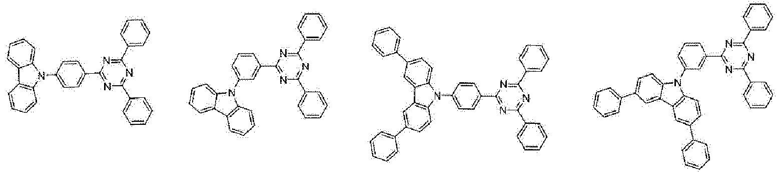

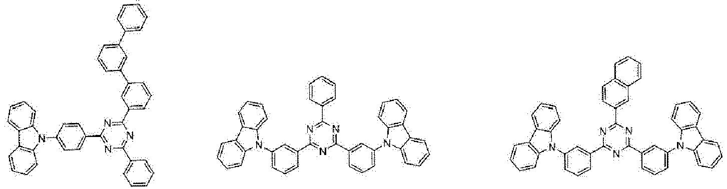

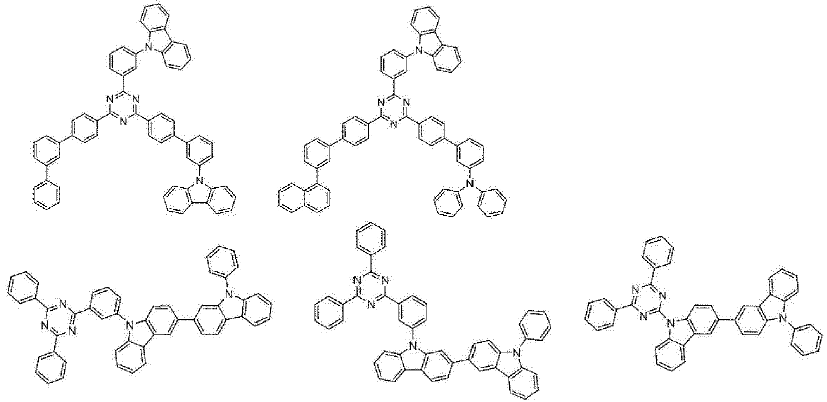

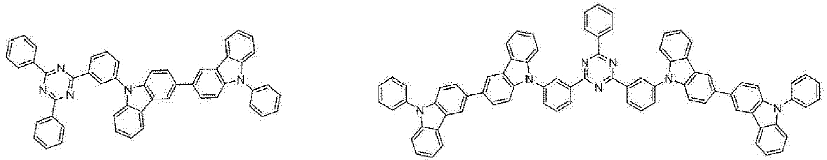

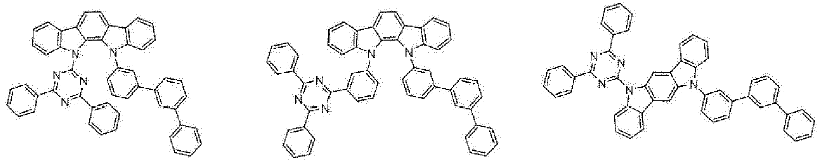

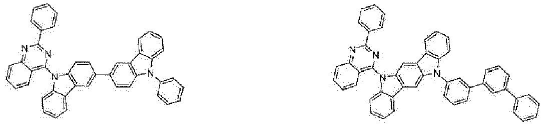

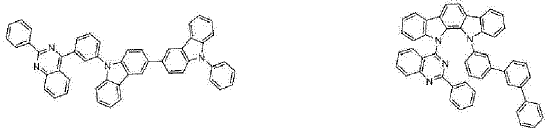

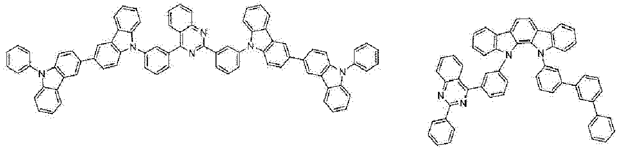

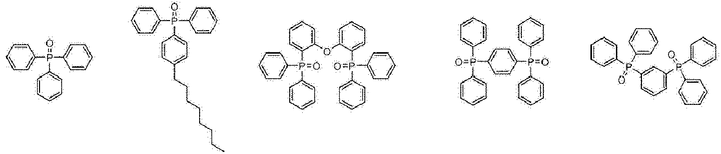

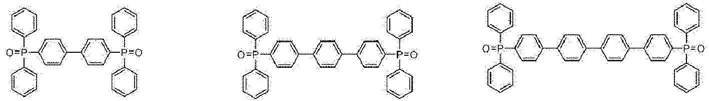

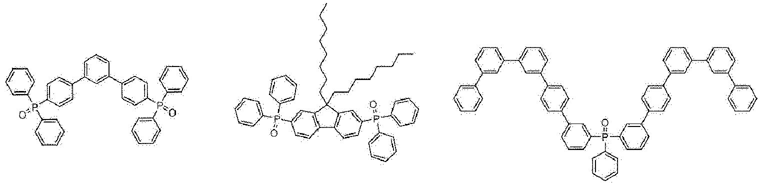

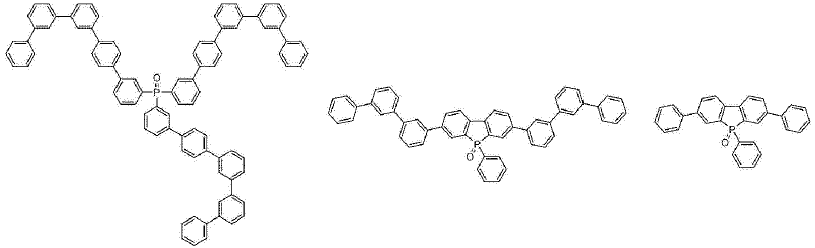

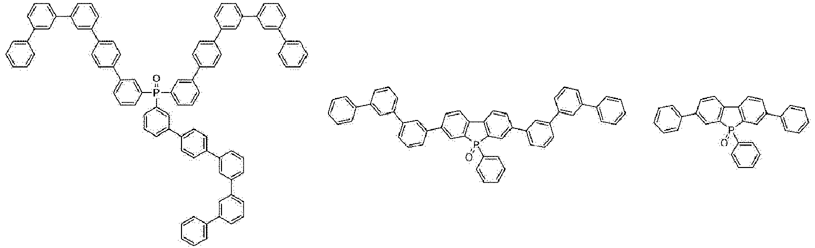

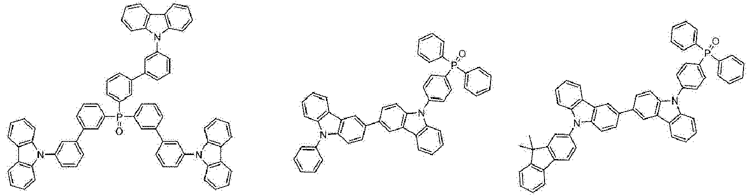

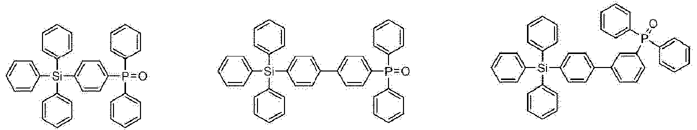

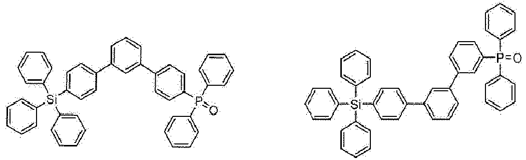

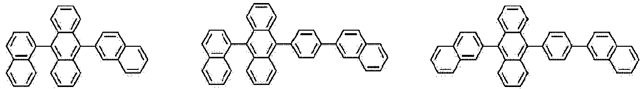

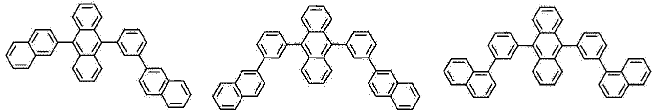

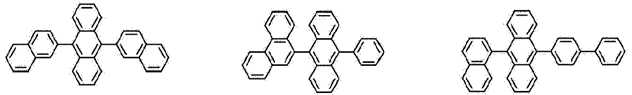

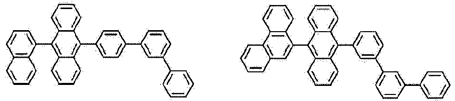

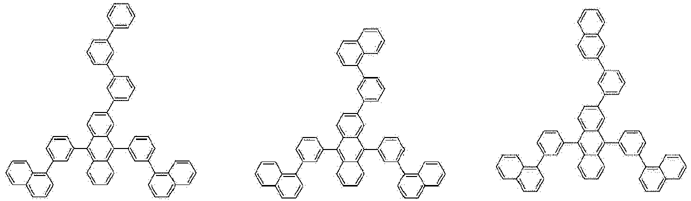

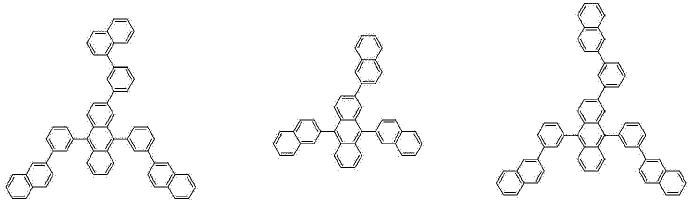

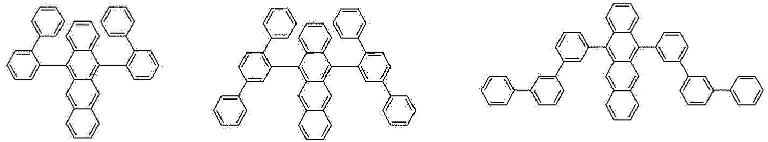

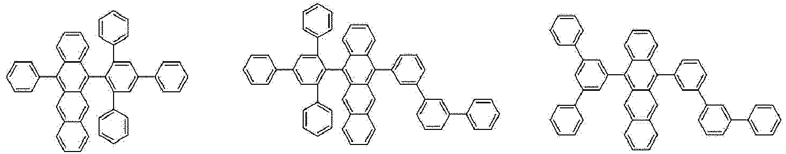

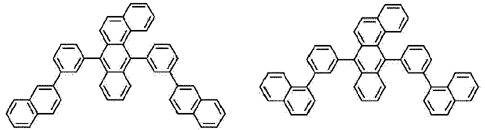

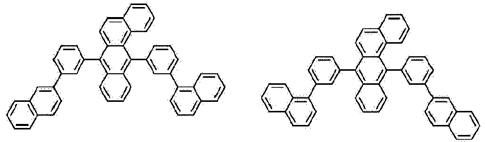

11. The organic light-emitting device of any one of claims 1-10, wherein
Formula 2-1 is represented by Formula 2-1 (1),
Formula 2-2 is represented by Formula 2-2(1),
Formula 2-3 is represented by one of Formulae 2-3(1) to 2-3(3),
Formula 2-4 is represented by one of Formulae 2-4(1) to 2-4(3): 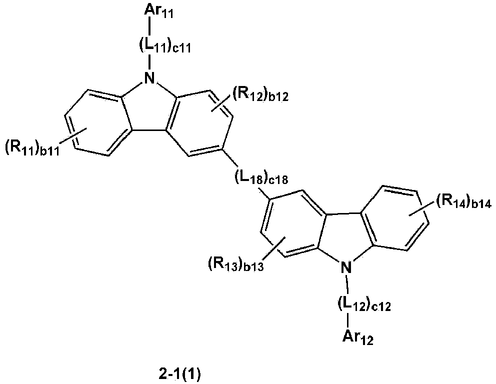 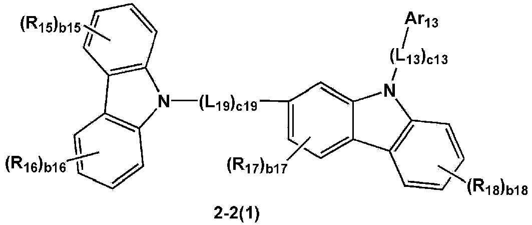 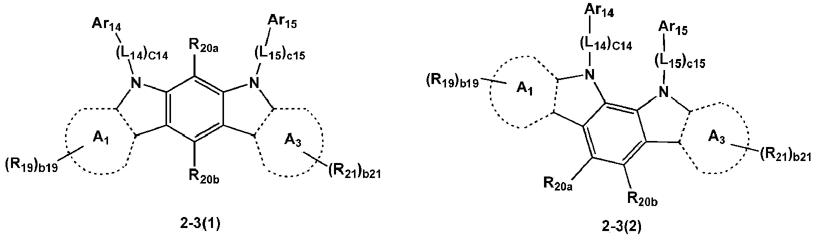 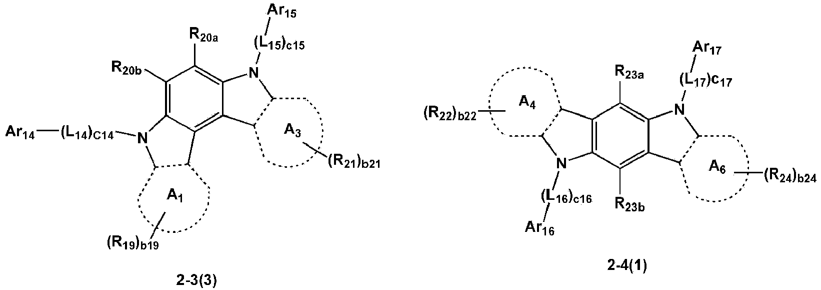 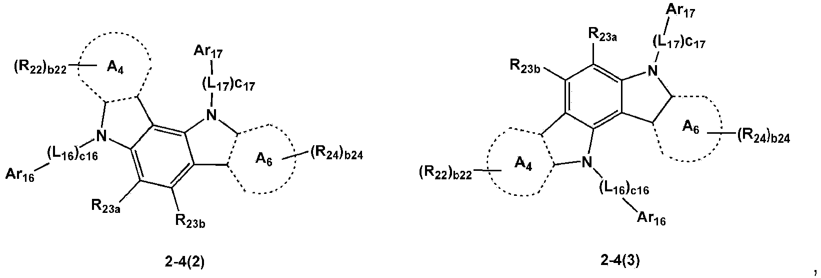
wherein, in Formulae 2-3(1) to 2-3(3), R₂₀ₐ and R_{20b} are understood by referring to the description presented in connection with R₂₀ of claim 1, and
in Formulae 2-4(1) to 2-4(3), R₂₃ₐ and R_{23b} R_{29b} are understood by referring to the description presented in connection with R₂₃ of claim 1.

12. The organic light-emitting device of any one of claims 1-11, wherein the second compound includes at least one of the following compounds: 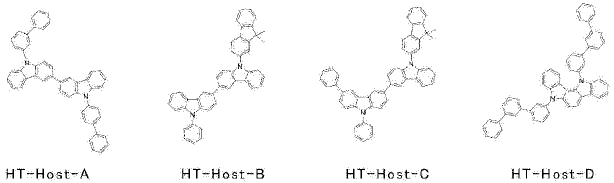 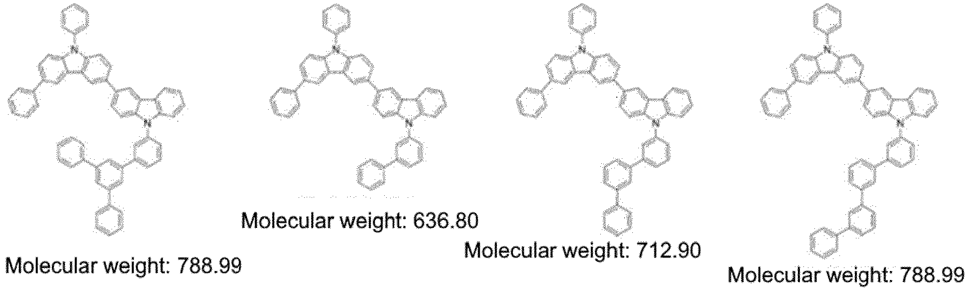 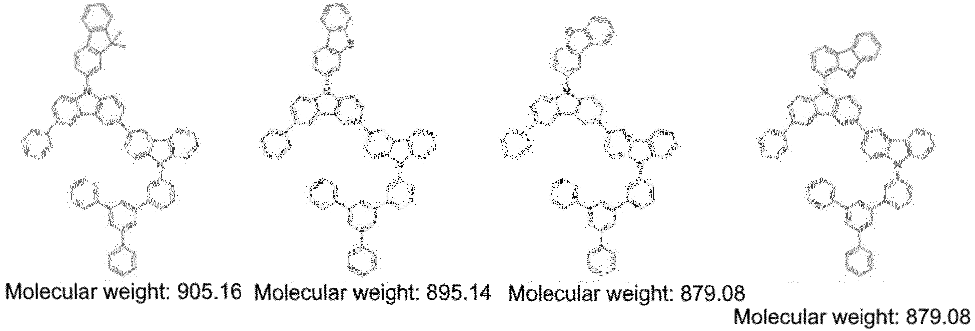 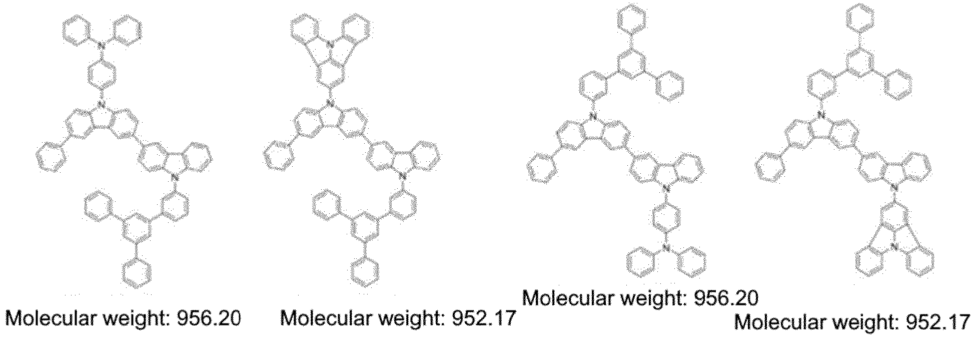 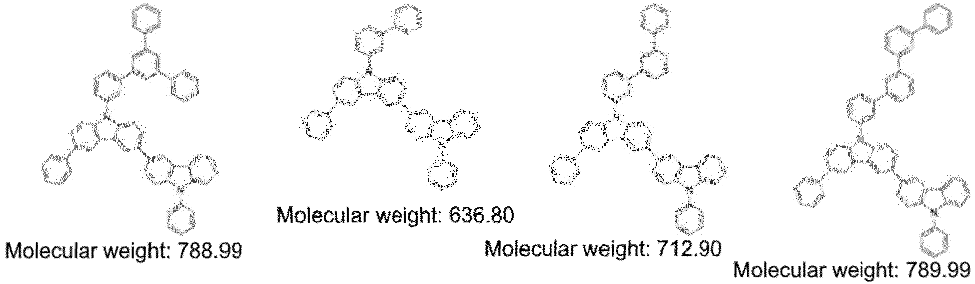 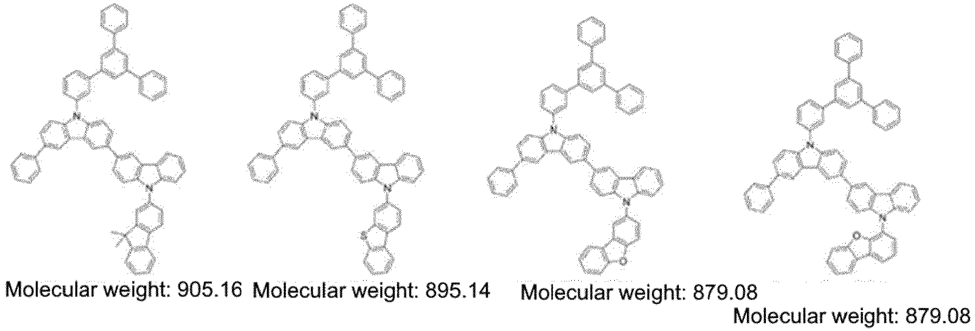 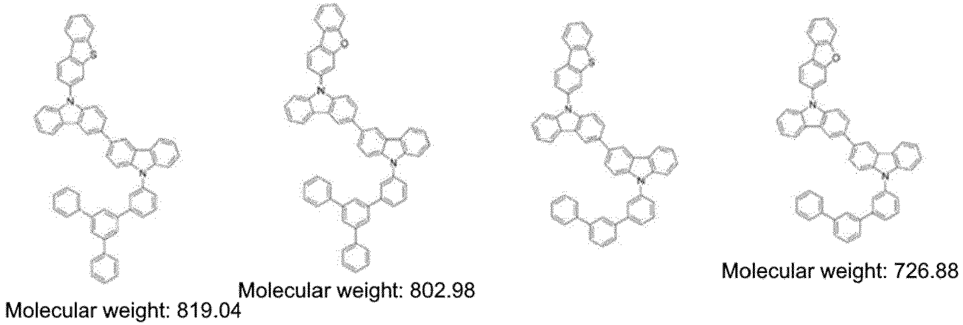 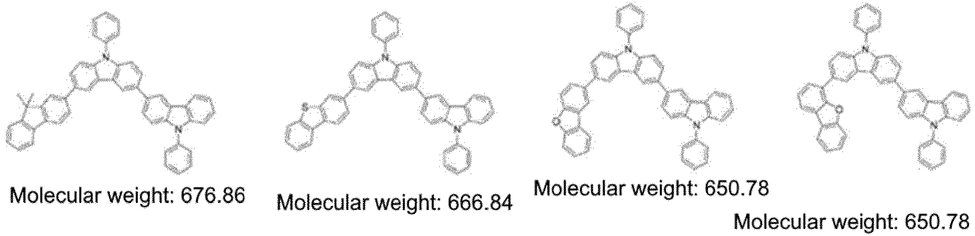 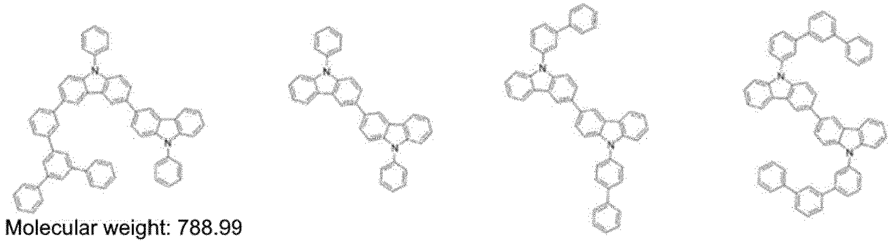 ; and/or
wherein the third compound includes at least one of the following compounds:

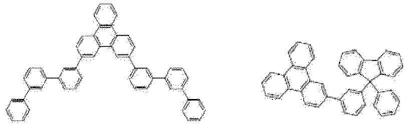

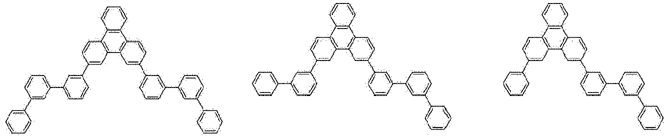

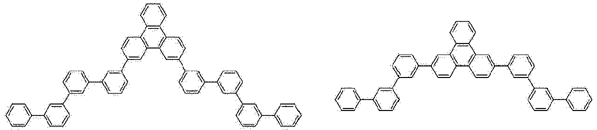

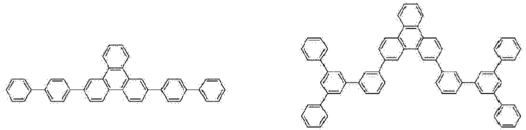

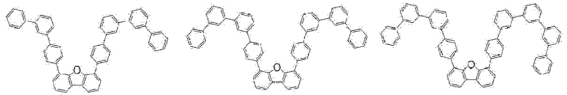

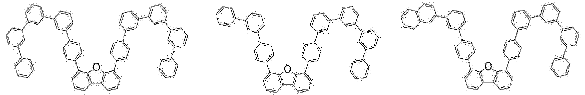

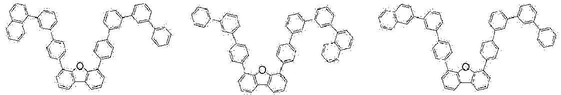

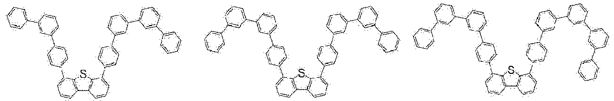

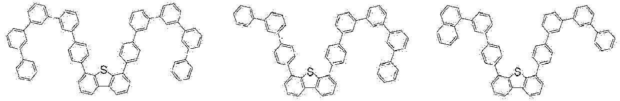

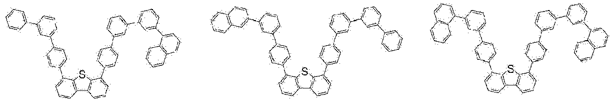

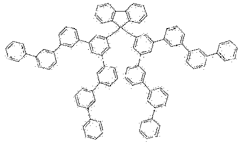

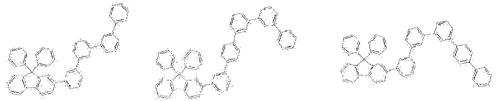

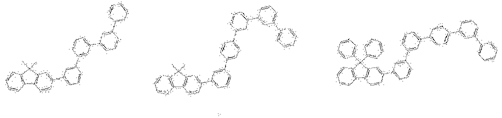

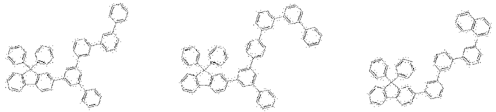

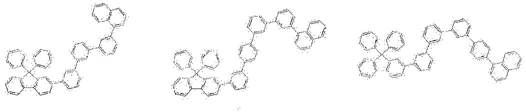

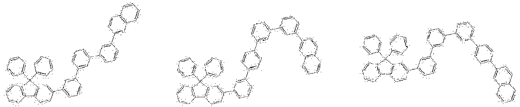

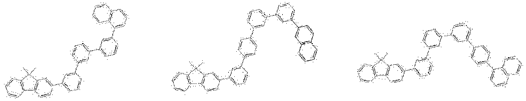

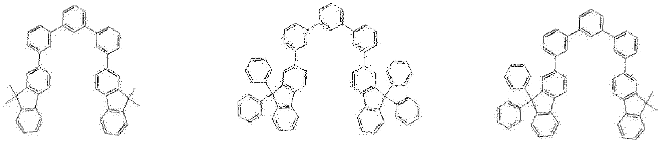

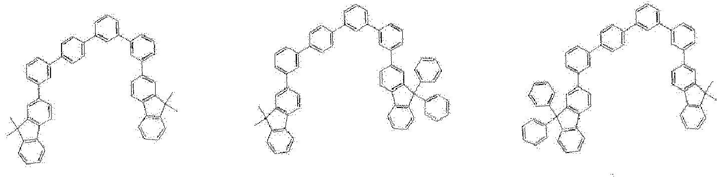

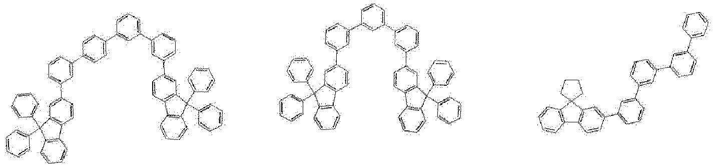

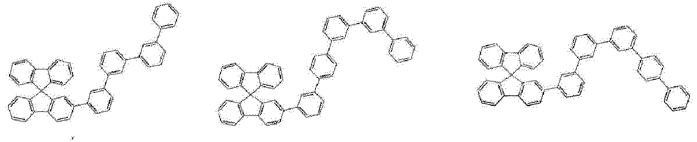

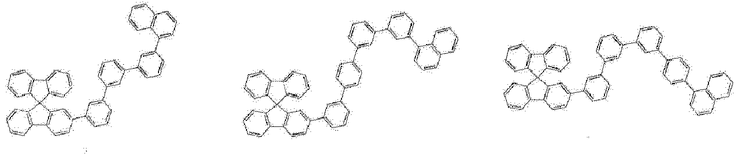

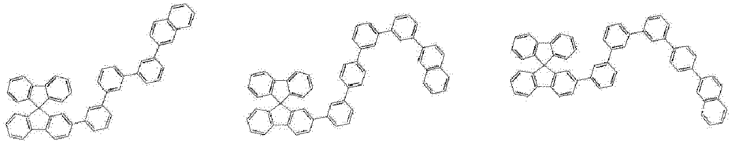

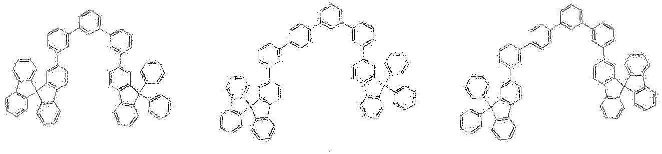

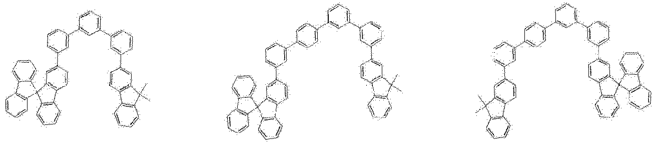

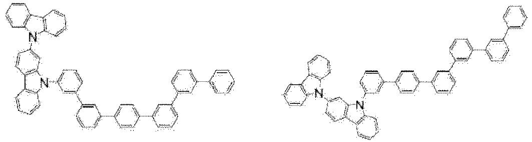

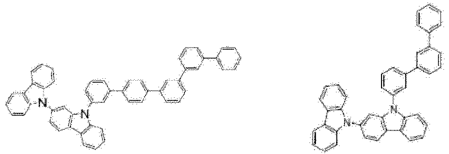

13. The organic light-emitting device of any one of claims 1-12, wherein
the first compound includes at least one compound represented by Formula 1-1 or 1-4,
the second compound includes at least one compound represented by Formula 2-1 or 2-4, and
the third compound includes at least one compound represented by Formula 3-2: 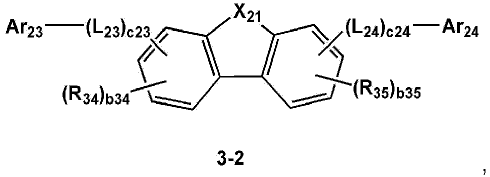
wherein, in Formula 3-2,
X₂₁ is O or S,
L₂₃ to L₂₄ are each independently selected from a substituted or unsubstituted C₆-C₃₀ arylene group,
c23 and c24 are each independently 1, 2, or 3,
Ar₂₃ and Ar₂₄ are each independently selected from hydrogen and a substituted or unsubstituted C₆-C₃₀ aryl group,
R₃₄ and R₃₅ are each independently selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group, and
b34 and b35 are each independently an integer from 0 to 3; and/or
wherein
the first compound includes at least one compound represented by Formula 1-1,
the second compound includes at least one compound represented by Formula 2-1, and
the third compound includes at least one compound represented by Formula 3-1: 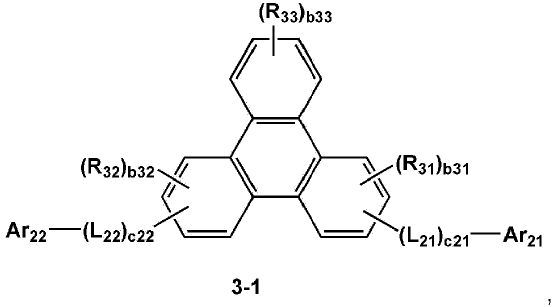
wherein, in Formula 3-1,
L₂₁ to L₂₂ are each independently selected from a substituted or unsubstituted C₆-C₃₀ arylene group,
c21 and c22 are each independently 1, 2, or 3,
Ar₂₁ and Ar₂₂ are each independently selected from hydrogen and a substituted or unsubstituted C₆-C₃₀ aryl group, wherein each of Ar₂₁ and Ar₂₂ is not hydrogen at the same time,
R₃₁ to R₃₃ are each independently selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b31 and b32 are each independently an integer from 0 to 3, and
b33 is an integer from 0 to 4; and/or
wherein
the first compound includes at least one compound represented by Formula 1-1,
the second compound includes at least one compound represented by Formula 2-1, and
the third compound includes at least one compound represented by Formula 3-4: 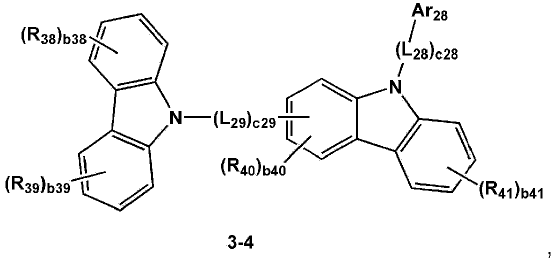
wherein, in Formula 3-4,
L₂₈ to L₂₉ are each independently selected from a single bond and a substituted or unsubstituted C₆-C₃₀ arylene group,
c28 and c29 are each independently 1, 2, or 3,
Ar₂₈ is selected from hydrogen and a substituted or unsubstituted C₆-C₃₀ aryl group,
R₃₈ to R₄₁ are each independently selected from hydrogen, deuterium, -F, -Cl, -Br, -I, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, and a substituted or unsubstituted C₁-C₆₀ alkoxy group,
b38, b39, and b41 are each independently an integer from 0 to 4, and
b40 is an integer from 0 to 2.

14. The organic light-emitting device of any one of claims 1-13, wherein
the emission layer further comprises a fluorescent dopant, a phosphorescent dopant, or a combination thereof.

15. An apparatus including the organic light-emitting device of any one of claims 1-14.

## Patentansprüche

1. Organische lichtemittierende Vorrichtung, umfassend:
eine erste Elektrode;
eine zweite Elektrode; und
eine Emissionsschicht zwischen der ersten Elektrode und der zweiten Elektrode,
wobei die Emissionsschicht eine erste Verbindung, eine zweite Verbindung und eine dritte Verbindung umfasst,
die erste Verbindung mindestens eine Verbindung beinhaltet, die durch eine der Formeln 1-1 bis 1-4 dargestellt ist,
die zweite Verbindung mindestens eine Verbindung beinhaltet, die durch eine der Formeln 2-1 bis 2-4 dargestellt ist, und
die dritte Verbindung mindestens eine Verbindung beinhaltet, die mindestens eine Gruppe enthält, die aus einer Triphenylengruppe, einer Dibenzofurangruppe, einer Dibenzothiophengruppe, einer Fluorengruppe und einer Biscarbazolgruppe ausgewählt ist, wobei eine Bandlücke zwischen einem Energieniveau des höchsten besetzten Molekülorbitals (HOMO) und einem Energieniveau des niedrigsten unbesetzten Molekülorbitals (LUMO) der dritten Verbindung 3,3 eV oder mehr beträgt: 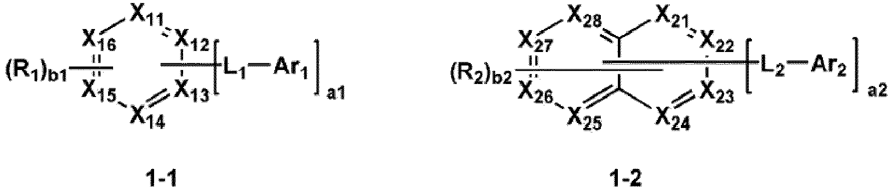 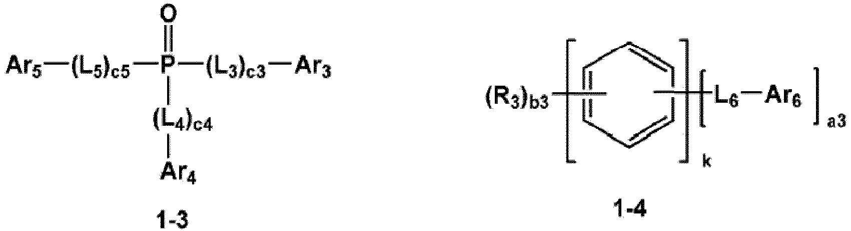 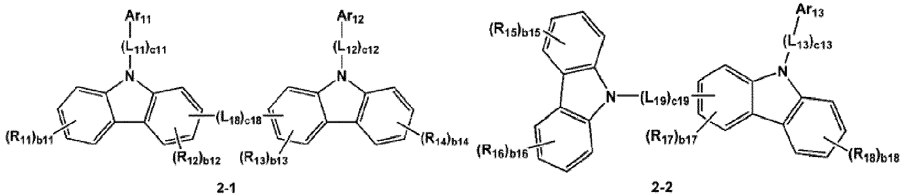 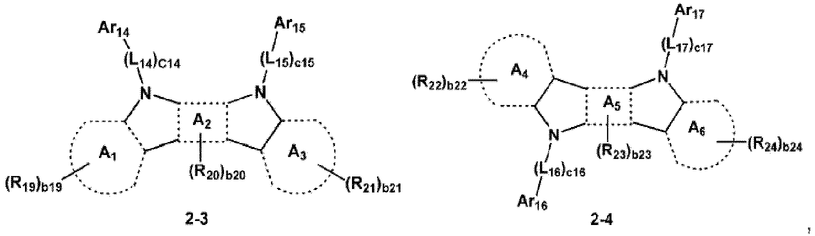
wobei in den Formeln 1-1 bis 1-4,
X₁₁ bis X₁₆ und X₂₁ bis X₂₈ jeweils unabhängig C oder N sind,
mindestens eines ausgewählt aus X₁₁ bis X₁₆ N ist,
mindestens eines ausgewählt aus X₂₁ bis X₂₈ N ist,
L₁ bis L₆ jeweils unabhängig aus einer Einfachbindung, einer substituierten oder unsubstituierten C₆-C₃₀-Arylengruppe, einer substituierten oder unsubstituierten C₁-C₃₀-Heteroarylengruppe, einer zweiwertigen, nichtaromatischen, anellierten, polycyclischen Gruppe und einer zweiwertigen, nichtaromatischen, anellierten, heteropolycyclischen Gruppe ausgewählt sind,
c3 bis c5 jeweils unabhängig eine ganze Zahl von 1 bis 3 sind,
Ar₁ bis Ar₆ sind jeweils unabhängig aus einer substituierten oder unsubstituierten C₆-C₃₀-Arylgruppe, einer substituierten oder unsubstituierten C₁-C₃₀-Heteroarylgruppe, einer substituierten oder unsubstituierten, einwertigen, nichtaromatischen, anellierten, polycyclischen Gruppe und einer substituierten oder unsubstituierten, einwertigen, nichtaromatischen, anellierten, heteropolycyclischen Gruppe ausgewählt sind,
beliebige zwei benachbarte Gruppen von Ar₃ bis Ar₅ optional über eine Einfachbindung miteinander verknüpft sind, um einen anellierten Ring zu bilden,
a1 bis a3 jeweils unabhängig eine ganze Zahl von 1 bis 3 sind,
R₁ bis R₃ jeweils unabhängig aus Wasserstoff, Deuterium, -F, -Cl, -Br, -I, einer Cyanogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe und einer substituierten oder unsubstituierten C₁-C₆₀-Alkoxygruppe ausgewählt sind,
b1 eine ganze Zahl von 0 bis 4 ist,
b2 eine ganze Zahl von 0 bis 6 ist,
b3 eine ganze Zahl von 7 bis 11 ist, und
k 3 oder 4 ist und
in den Formeln 2-1 bis 2-4,
A₁ bis A₆ jeweils unabhängig aus einer carbocyclischen C₅-C₃₀-Gruppe und einer heterocyclischen C₁-C₃₀-Gruppe ausgewählt sind,
L₁₁ bis L₁₉ jeweils unabhängig aus einer Einfachbindung, einer substituierten oder unsubstituierten C₆-C₃₀-Arylengruppe, einer substituierten oder unsubstituierten C₁-C₃₀-Heteroarylengruppe, einer substituierten oder unsubstituierten, zweiwertigen, nichtaromatischen, anellierten, polycyclischen Gruppe und einer substituierten oder unsubstituierten, zweiwertigen, nichtaromatischen, anellierten, heteropolycyclischen Gruppe ausgewählt sind,
c11 bis c19 jeweils unabhängig eine ganze Zahl von 1 bis 3 sind,
Ar₁₁, Ar₁₂ und Ar₁₄ bis Ar₁₇ jeweils unabhängig aus einer substituierten oder unsubstituierten C₆-C₃₀-Arylgruppe, einer substituierten oder unsubstituierten C₁-C₃₀-Heteroarylgruppe, einer substituierten oder unsubstituierten, einwertigen, nichtaromatischen, anellierten, polycyclischen Gruppe und einer substituierten oder unsubstituierten, monovalenten, nichtaromatischen, anellierten, heteropolycyclischen Gruppe ausgewählt sind, wobei jedes von Ar₁₄ und Ar₁₅ keine Indolocarbazolgruppe ist und jedes von Ar₁₆ und Ar₁₇ nicht gleichzeitig eine Naphthylgruppe ist,
Ar₁₃ aus einer substituierten oder unsubstituierten C₆-C₃₀-Arylgruppe und einer substituierten oder unsubstituierten, einwertigen, nichtaromatischen, anellierten, polycyclischen Gruppe ausgewählt ist,
R₁₁ bis R₂₄ jeweils unabhängig aus Wasserstoff, Deuterium, -F, -Cl, -Br, -I, einer Cyanogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe und einer substituierten oder unsubstituierten C₁-C₆₀-Alkoxygruppe, einer substituierten oder unsubstituierten C₆-C₃₀-Arylgruppe und einer substituierten oder unsubstituierten C₁-C₃₀-Heteroarylgruppe, einer substituierten oder unsubstituierten, einwertigen, nichtaromatischen, anellierten, polycyclischen Gruppe und einer substituierten oder unsubstituierten, einwertigen, nichtaromatischen, anellierten, heteropolycyclischen Gruppe ausgewählt sind,
b11, b14, b15, b16 und b18 bis b24 jeweils unabhängig eine ganze Zahl von 0 bis 4 sind, b12, b13 und b 17 jeweils unabhängig eine ganze Zahl von 0 bis 3 sind,
mindestens ein Substituent der substituierten C₆-C₃₀-Arylengruppe, der substituierten C₁-C₃₀-Heteroarylengruppe, der substituierten, zweiwertigen, nichtaromatischen, anellierten, polycyclischen Gruppe, der substituierten, zweiwertigen, nichtaromatischen, anellierten, heteropolycyclischen Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₆-C₃₀-Arylgruppe, der substituierten C₁-C₃₀-Heteroarylgruppe, der substituierten, monovalenten, nichtaromatischen, anellierten polycyclischen Gruppe und der substituierten, monovalenten, nichtaromatischen, anellierten, heteropolycyclischen Gruppe ausgewählt ist aus:
Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe und einer C₁-C₆₀-Alkoxygruppe,
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem, ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀ Heteroarylgruppe, einer einwertigen, nichtaromatischen, anellierten, polycyclischen Gruppe, einer einwertigen, nichtaromatischen, anellierten, heteropolycyclischen Gruppe, -N(Q₁₁)(Q₁₂), -Si(Q₁₃)(Q₁₄)(Q₁₅), - B(Q₁₆)(Q₁₇) und -P(=O)(Q₁₈)(Q₁₉);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen, nichtaromatischen, anellierten, polycyclischen Gruppe und einer einwertigen, nichtaromatischen, anellierten, heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen, nichtaromatischen, anellierten, polycyclischen Gruppe und einer einwertigen, nichtaromatischen, anellierten, heteropolycyclischen Gruppe, jeweils substituiert mit mindestens einem, ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen, nichtaromatischen, anellierten, polycyclischen Gruppe, einer einwertigen, nichtaromatischen, anellierten, heteropolycyclischen Gruppe, -N(Q₂₁)(Q₂₂), -Si(Q₂₃)(Q₂₄)(Q₂₅), -B(Q₂₆)(Q₂₇) und -P(=O)(Q₂₈)(Q₂₉); und
-N(Q₃₁)(Q₃₂), -Si(Q₃₃)(Q₃₄)(Q₃₅), -B(Q₃₆)(Q₃₇) und -P(=O)(Q₃₈)(Q₃₉) und
Q₁ bis Q₉, Q₁₁ bis Q₁₉, Q₂₁ bis Q₂₉ und Q₃₁ bis Q₃₉ jeweils unabhängig aus Wasserstoff, Deuterium, -F, -Cl, -Br, -I, einer Hydroxylgruppe, einer Cyanogruppe, eine Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe, substituiert mit mindestens einem, ausgewählt aus einer C₁-C₆₀-Alkylgruppe und einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen, nichtaromatischen, anellierten, polycyclischen Gruppe und einer einwertigen, nichtaromatischen, anellierten, heteropolycyclischen Gruppe ausgewählt sind.

2. Organische lichtemittierende Vorrichtung nach Anspruch 1, wobei
L₁ bis L₆ und L₁₁ bis L₁₉ jeweils unabhängig aus einer Einfachbindung, einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzoimidazolylengruppe, einer Benzofuranylen(benzofuranylengruppe, einer Benzothiophenylengruppe, einer Isobenzothiazolylengruppe, einer Benzoxazolylengruppe, einer Isobenzoxazolylgruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe und einer Dibenzocarbazolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe und einer Dibenzocarbazolylengruppe, jeweils substituiert mit mindestens einem, ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylengruppe, einer Benzofluorenylengruppe, einer Dibenzofluorenylengruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, ein Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe.

3. Organische lichtemittierende Vorrichtung nach Anspruch 1 oder 2, wobei
Ar₁ bis Ar₆ jeweils unabhängig ausgewählt sind aus:
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Indolocarbazolylgruppe, einer Indolodibenzofuranylgruppe, einer Indolodibenzothiophenylgruppe, einer Indolofluorenylgruppe, einer Indolospirofluorenylgruppe, einer Indolophenanthrenylgruppe, einer Indolotriphenylenylgruppe, einer Indoloazadibenzofuranylgruppe und einer Indoloazadibenzothiophenylgruppe; und
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, ein Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Indolocarbazolylgruppe, einer Indolodibenzofuranylgruppe, einer Indolodibenzothiophenylgruppe, einer Indolofluorenylgruppe, einer Indolospirofluorenylgruppe, einer Indolophenanthrenylgruppe, einer Indolotriphenylenylgruppe, einer Indoloazadibenzofuranylgruppe und einer Indoloazadibenzothiophenylgruppe, jeweils substituiert mit mindestens einem, ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Indolocarbazolylgruppe, einer Indolodibenzofuranylgruppe, einer Indolodibenzothiophenylgruppe,einer Indolofluorenylgruppe, einer Indolospirofluorenylgruppe, einer Indolophenanthrenylgruppe, einer Indolotriphenylenylgruppe, einer Indoloazadibenzofuranylgruppe und einer Indoloazadibenzothiophenylgruppe.

4. Organische lichtemittierende Vorrichtung nach einem der Ansprüche 1-3, wobei
R₁ bis R₃ jeweils unabhängig ausgewählt sind aus:
Wasserstoff, Deuterium, -F, -Cl, -Br, -I, einer Cyanogruppe, einer C₁-C₂₀-Alkylgruppe und einer C₁-C₂₀-Alkoxygruppe; und
einer C₁-C₂₀-Alkylgruppe und einer C₁-C₂₀-Alkoxygruppe, jeweils substituiert mit mindestens einem, ausgewählt aus Deuterium, -F, -Cl, -Br, -I, einer Cyanogruppe, einer C₁-C₂₀-Alkylgruppe und einer C₁-C₂₀-Alkoxygruppe.

5. Organische lichtemittierende Vorrichtung nach einem der Ansprüche 1-4, wobei
A₁, A₂, A₃, A₄, A₅ und A₆ jeweils unabhängig aus einer Benzolgruppe, einer Naphthalingruppe, einer Anthracengruppe, einer Thiophengruppe, einer Furangruppe, einer Pyrrolgruppe, einer Indolgruppe, einer Indengruppe, einer Benzosilolgruppe, einer Benzothiophengruppe, einer Benzofurangruppe, einer Carbazolgruppe, einer Fluorengruppe, einer Dibenzosilolgruppe, einer Dibenzothiophengruppe, einer Dibenzofurangruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrazolgruppe, einer Imidazolgruppe, einer Oxazolgruppe, einer Isoxazolgruppe, einer Thiazolgruppe, einer Isothiazolgruppe einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzoxadiazolgruppe und einer Benzothiadiazolgruppe ausgewählt sind.

6. Organische lichtemittierende Vorrichtung nach einem der Ansprüche 1-5, wobei
Ar₁₁, Ar₁₂ und Ar₁₄ bis Ar₁₇ jeweils unabhängig ausgewählt sind aus:
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe und einer durch die Formel a dargestellten Gruppe; und
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe und einer durch die Formel a dargestellten Gruppe, jeweils substituiert mit mindestens einem, ausgewählt aus Deuterium, -F, - Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe und -N(Q₁₁)(Q₁₂),
Ar₁₄ und Ar₁₅ jeweils keine Indolocarbazolgruppe sind und Ar₁₆ und Ar₁₇ jeweils nicht gleichzeitig eine Naphthalingruppe sind, und
Q₁₁ und Q₁₂ jeweils unabhängig aus einer Phenylgruppe, einer Biphenylgruppe, einer Terphenylgruppe und einer Naphthylgruppe ausgewählt sind: 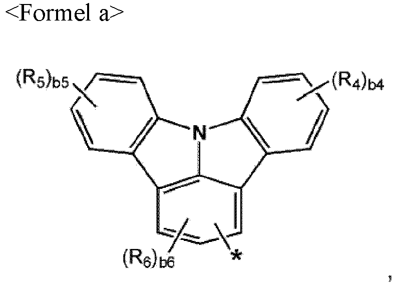
wobei in der Formel a,
R₄ bis R₆ jeweils unabhängig ausgewählt sind aus:
Wasserstoff, Deuterium, -F, -Cl, -Br, -I, einer Cyanogruppe, einer C₁-C₂₀-Alkylgruppe und einer C₁-C₂₀-Alkoxygruppe; und
einer C₁-C₂₀-Alkylgruppe und einer C₁-C₂₀-Alkoxygruppe, jeweils substituiert mit mindestens einem, ausgewählt aus Deuterium, -F, -Cl, -Br, -I, einer Cyanogruppe, einer C₁-C₂₀-Alkylgruppe und einer C₁-C₂₀-Alkoxygruppe,
b4 eine ganze Zahl von 0 bis 4 ist,
b5 eine ganze Zahl von 0 bis 4 ist,
b6 eine ganze Zahl von 0 bis 2 ist,
"^{∗}" eine Bindungsstelle an ein benachbartes Atom angibt.

7. Organische lichtemittierende Vorrichtung nach einem der Ansprüche 1-6, wobei
Ar₁₃ ausgewählt ist aus:
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe und einer Ovalenylgruppe,
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe und einer Ovalenylgruppe, jeweils substituiert mit mindestens einem, ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe und einer Ovalenylgruppe, und/oder
wobei
R₁₁ bis R₂₄ jeweils unabhängig ausgewählt sind aus:
Wasserstoff, Deuterium, -F, -Cl, -Br, -I, einer Cyanogruppe, einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit mindestens einem, ausgewählt aus Deuterium, -F, -Cl, -Br, -I und einer Cyanogruppe;
einer Phenylgruppe, einer Biphenylgruppe, einer Terphenylgruppe, einer Fluorenylgruppe, einer Spirofluorenylgruppe, einer Benzofluorenylgruppe, einer Dibenzofluorenylgruppe, einer Pyridinylgruppe, einer Pyrazinylgruppe, einer Pyrimidinylgruppe, einer Pyridazinylgruppe, einer Carbazolylgruppe, einer Dibenzofuranylgruppe, einer Dibenzothiophenylgruppe, einer Benzocarbazolylgruppe und einer Dibenzocarbazolylgruppe; und
einer Phenylgruppe, einer Biphenylgruppe, einer Terphenylgruppe, einer Fluorenylgruppe, einer Spirofluorenylgruppe, einer Benzofluorenylgruppe, einer Dibenzofluorenylgruppe, einer Pyridinylgruppe, einer Pyrazinylgruppe, einer Pyrimidinylgruppe, einer Pyridazinylgruppe, einer Carbazolylgruppe, einer Dibenzofuranylgruppe, einer Dibenzothiophenylgruppe, einer Benzocarbazolylgruppe und einer Dibenzocarbazolylgruppe, jeweils substituiert mit mindestens einem, ausgewählt aus einer C₁-C₂₀-Alkylgruppe, einer C₁-C₂₀-Alkoxygruppe, einer Phenylgruppe, einer Biphenylgruppe, einer Terphenylgruppe, einer Fluorenylgruppe, einer Spirofluorenylgruppe, einer Benzofluorenylgruppe, einer Dibenzofluorenylgruppe, einer Pyridinylgruppe, einer Pyrazinylgruppe, einer Pyrimidinylgruppe, einer Pyridazinylgruppe, einer Carbazolylgruppe, einer Dibenzofuranylgruppe, einer Dibenzothiophenylgruppe, einer Benzocarbazolylgruppe und einer Dibenzocarbazolylgruppe, die jeweils mit mindestens einem, ausgewählt aus Deuterium, -F, -Cl, -Br, -I und einer Cyanogruppe substituiert sind.

8. Organische lichtemittierende Vorrichtung nach einem der Ansprüche 1-7, wobei
die dritte Verbindung mindestens eine Verbindung beinhaltet, die durch eine der Formeln 3-1 bis 3-4 unten dargestellt ist: 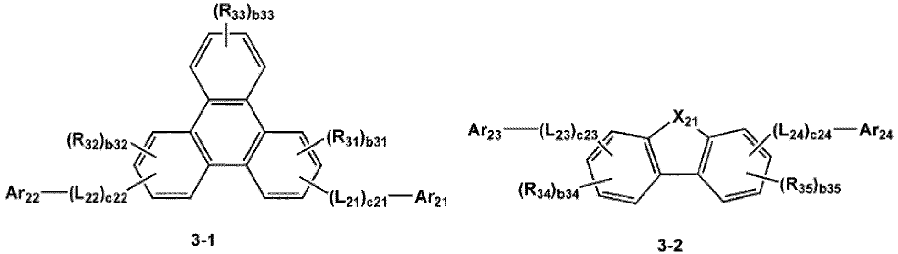 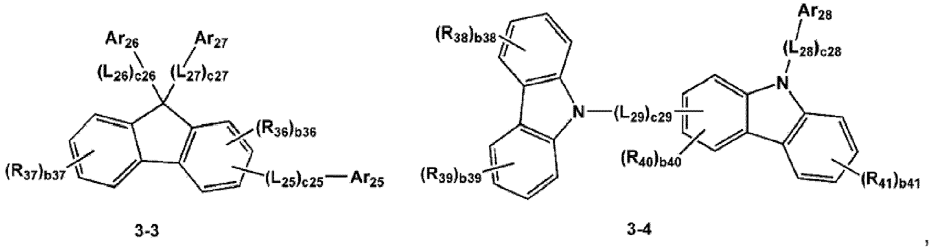
wobei in den Formeln 3-1 bis 3-4,
X₂₁ O oder S ist,
L₂₁ bis L₂₉ jeweils unabhängig aus einer Einfachbindung, einer substituierten oder unsubstituierten C₆-C₃₀-Arylengruppe, einer substituierten oder unsubstituierten C₁-C₃₀-Heteroarylengruppe, einer zweiwertigen, nichtaromatischen, anellierten, polycyclischen Gruppe und einer zweiwertigen, nichtaromatischen, anellierten, heteropolycyclischen Gruppe ausgewählt sind,
c21 bis c29 jeweils unabhängig eine ganze Zahl von 1 bis 3 sind,
Ar₂₁ bis Ar₂₈ jeweils unabhängig aus Wasserstoff, einer substituierten oder unsubstituierten C₆-C₃₀-Arylgruppe, einer substituierten oder unsubstituierten C₁-C₃₀-Heteroarylgruppe, einer substituierten oder unsubstituierten einwertigen, nichtaromatischen, anellierten, polycyclischen Gruppe und einer substituierten oder unsubstituierten, einwertigen, nichtaromatischen, anellierten, heteropolycyclischen Gruppe ausgewählt sind,
Ar₂₁ und Ar₂₂ jeweils nicht gleichzeitig Wasserstoff sind,
Ar₂₆ und Ar₂₇ optional über eine Einfachbindung miteinander verknüpft sind, um einen anellierten Ring zu bilden,
R₃₁ bis R₄₁ jeweils unabhängig aus Wasserstoff, Deuterium, -F, -Cl, -Br, -I, einer Cyanogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe und einer substituierten oder unsubstituierten C₁-C₆₀-Alkoxygruppe ausgewählt sind,
b31, b32, b34, b35, b36 und b40 jeweils unabhängig eine ganze Zahl von 0 bis 3 sind, und b33, b37, b38, b39 und b41 jeweils unabhängig eine ganze Zahl von 0 bis 4 sind;
wobei vorzugsweise
Ar₂₁ bis Ar₂₈ jeweils unabhängig ausgewählt sind aus:
Wasserstoff, einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe und einer Ovalenylgruppe,
einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Pyrenylgruppe, einer Chrysenylgruppe, einer Naphthacenylgruppe, einer Picenylgruppe, einer Perylenylgruppe, ein Pentaphenyl Gruppe, einer Hexacenylgruppe, einer Pentacenylgruppe, einer Rubicenylgruppe, einer Coronenylgruppe und einer Ovalenylgruppe, jeweils substituiert mit mindestens einem, ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer Phenylgruppe, einer Biphenylgruppe, einer Terphenylgruppe, einer Quaterphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe und einer Ovalenylgruppe.

9. Organische lichtemittierende Vorrichtung nach einem der Ansprüche 1-8, wobei
die Formel 1-1 durch die Formel 1-1(1) dargestellt ist,
die Formel 1-2 durch die Formel 1-2(1) dargestellt ist,
die Formel 1-4 durch eine der Formeln 1-4(1), 1-4(2) und 1-4(3) dargestellt ist: 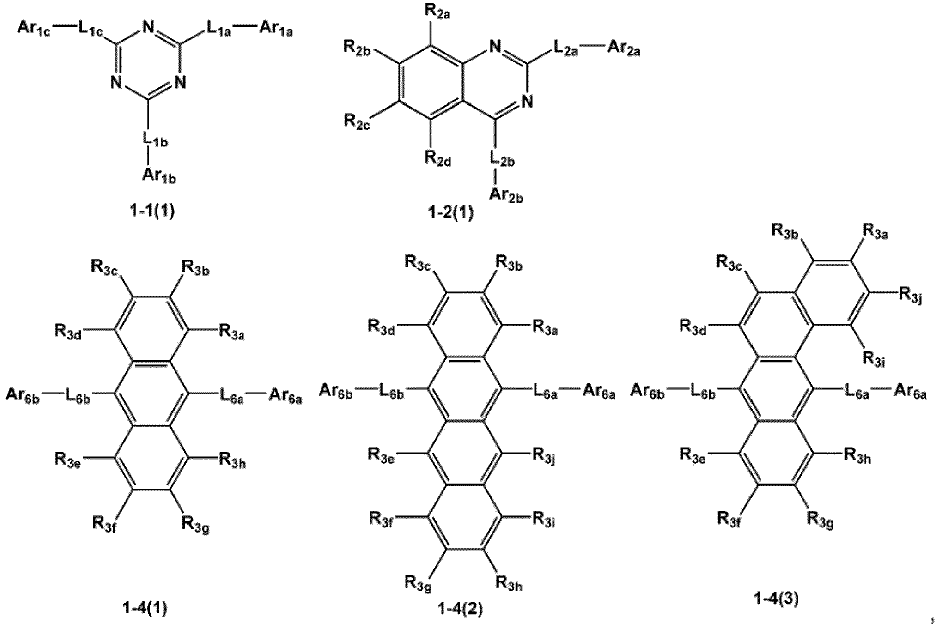
wobei in der Formel 1-1(1) L₁ₐ, L_{1b} und L_{1c} durch Bezugnahme auf die in Verbindung mit L₁ von Anspruch 1 präsentierte Beschreibung zu verstehen sind und Ar₁ₐ, Ar_{1b} und Ar_{1c} durch Bezugnahme auf die in Verbindung mit Ar₁ von Anspruch 1 präsentierte Beschreibung zu verstehen sind, und
in der Formel 1-2(1) L₂ₐ und L_{2b} unter Bezugnahme auf die in Verbindung mit L₂ von Anspruch 1 präsentierte Beschreibung zu verstehen sind, Ar₂ₐ und Ar_{2b} unter Bezugnahme auf die in Verbindung mit Ar₂ von Anspruch 1 präsentierte Beschreibung zu verstehen sind, und R₂ₐ, R_{2b}, R_{2c} und R_{2d} unter Bezugnahme auf die in Verbindung mit R₂ von Anspruch 1 präsentierte Beschreibung zu verstehen sind,
in den Formeln 1-4(1) bis 1-4(3) L₆ₐ und L_{6b} unter Bezugnahme auf die in Verbindung mit L₆ von Anspruch 1 präsentierte Beschreibung zu verstehen sind, Ar₆ₐ und Ar_{6b} unter Bezugnahme auf die in Verbindung mit Ar₆ von Anspruch 1 präsentierte Beschreibung zu verstehen sind, und R₃ₐ bis R₃ⱼ unter Bezugnahme auf die in Verbindung mit R₃ von Anspruch 1 präsentierte Beschreibung zu verstehen sind.

10. Organische lichtemittierende Vorrichtung nach einem der Ansprüche 1-9, wobei
die erste Verbindung mindestens eine der folgenden Verbindungen beinhaltet:

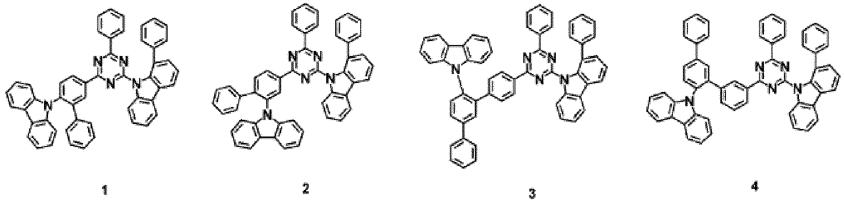

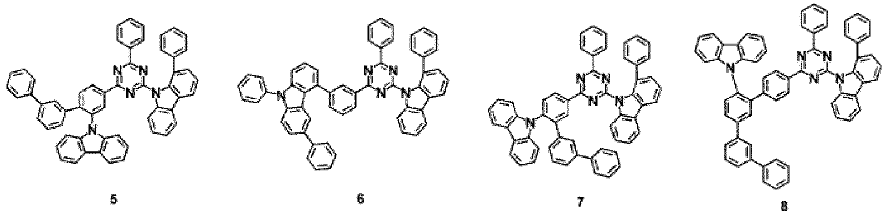

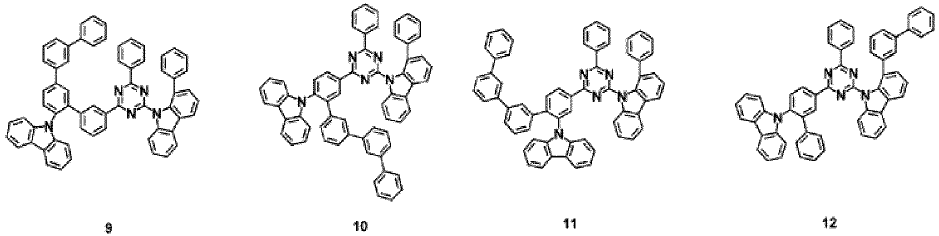

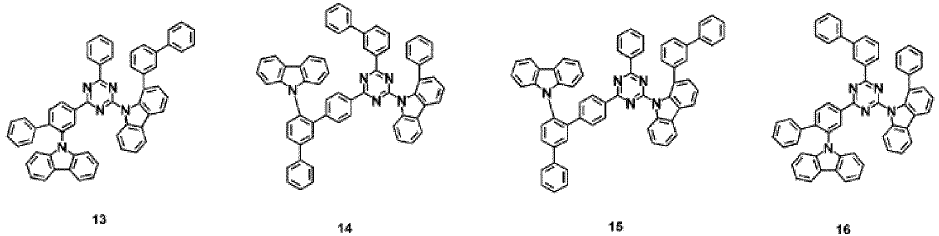

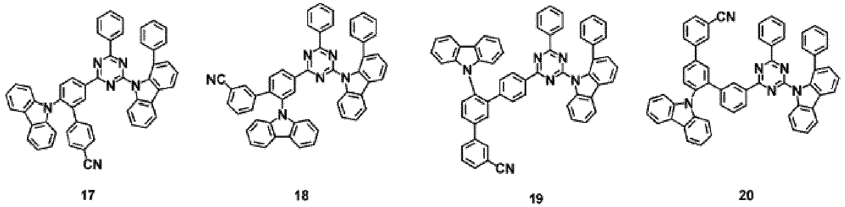

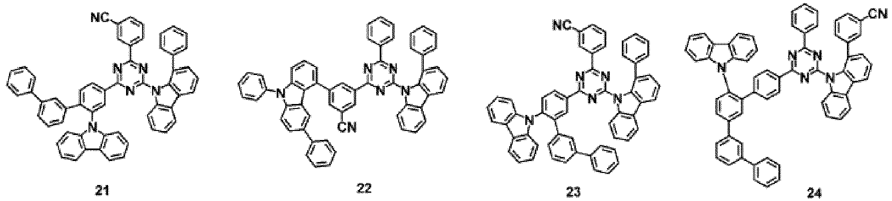

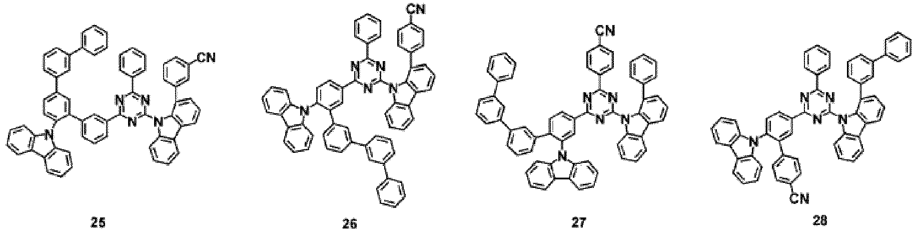

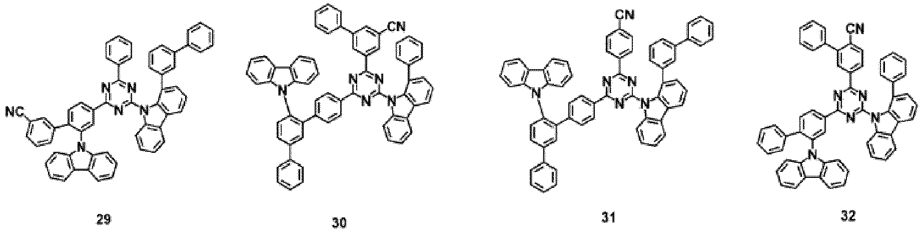

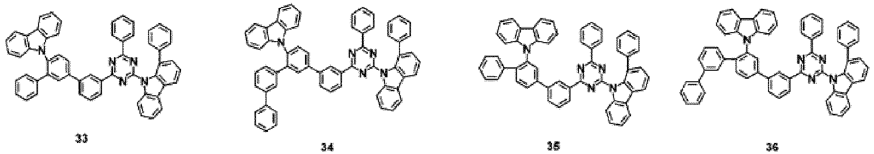

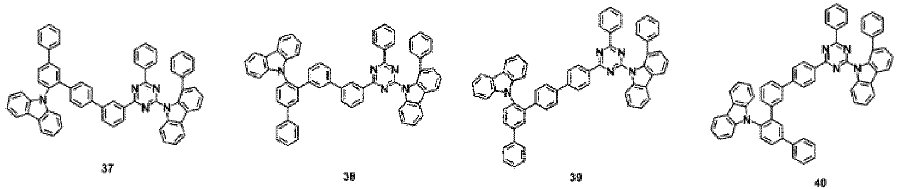

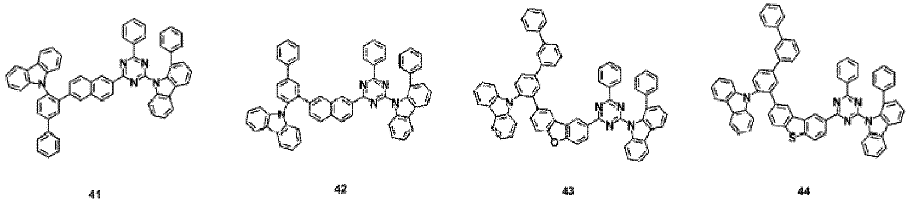

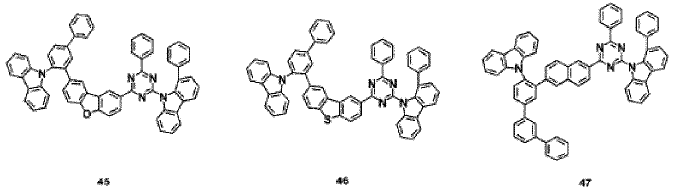

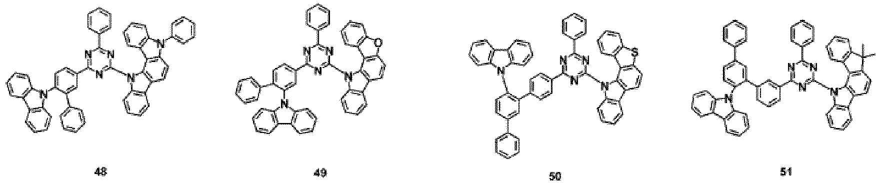

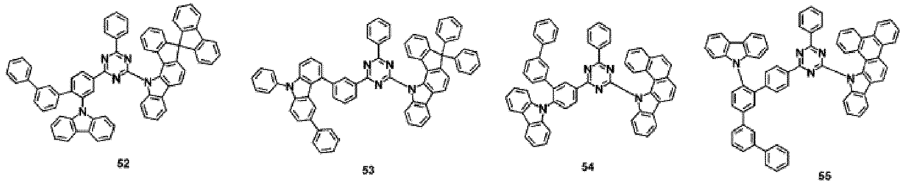

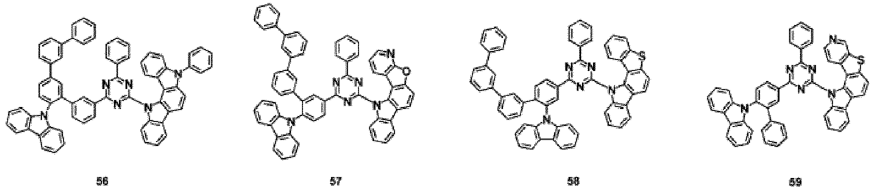

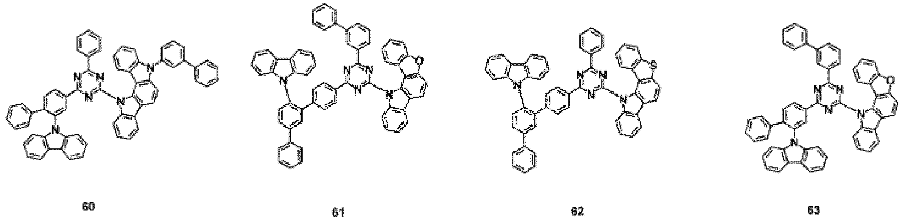

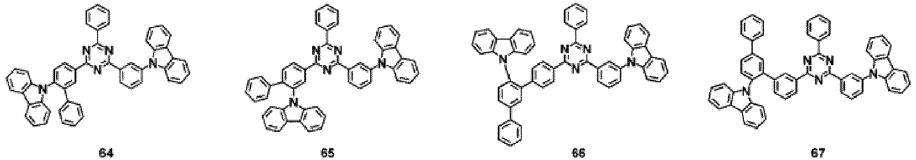

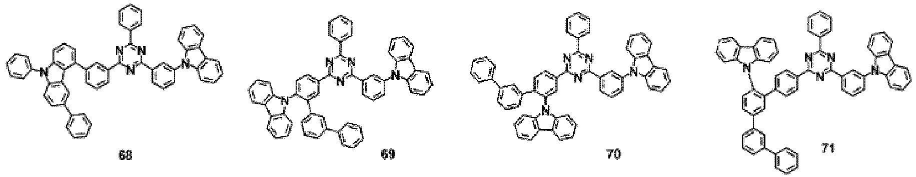

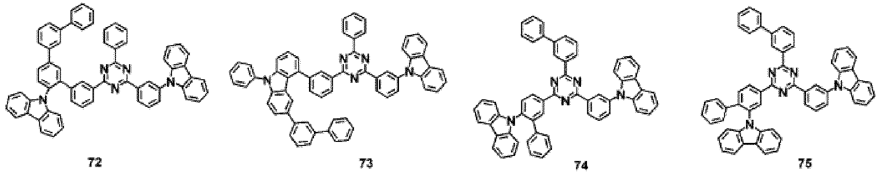

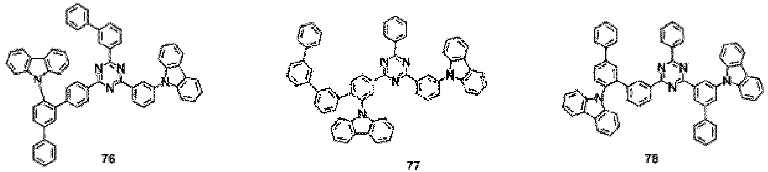

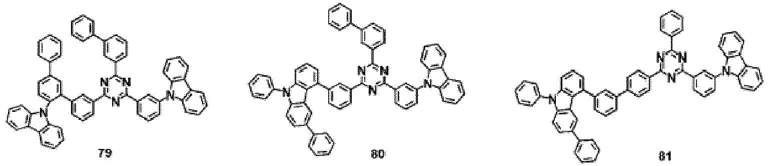

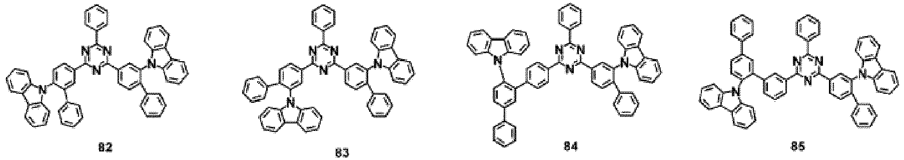

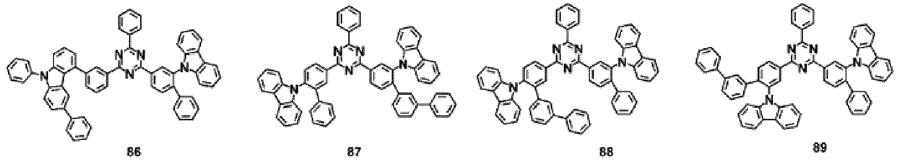

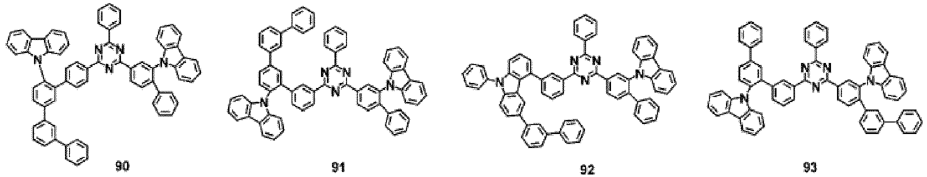

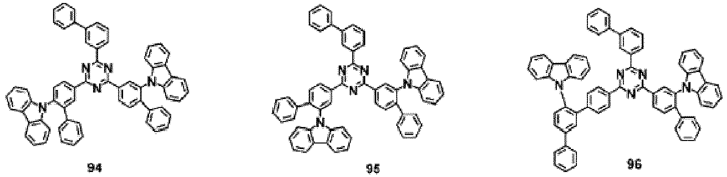

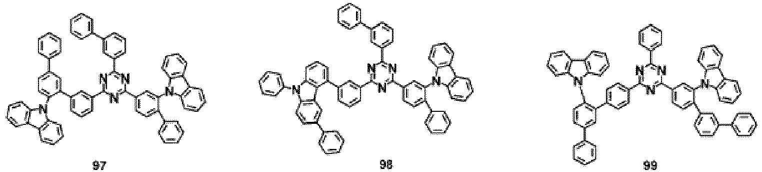

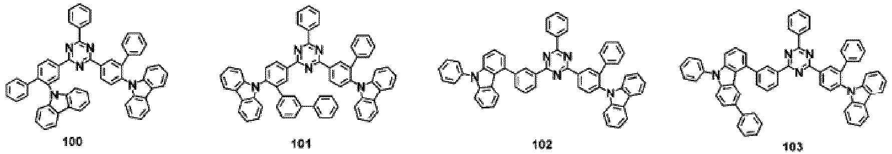

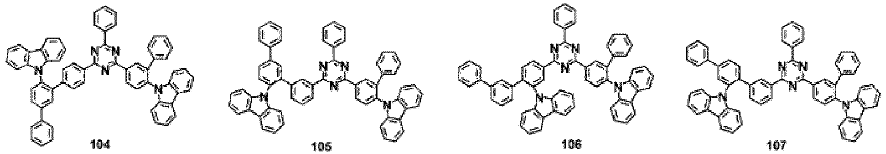

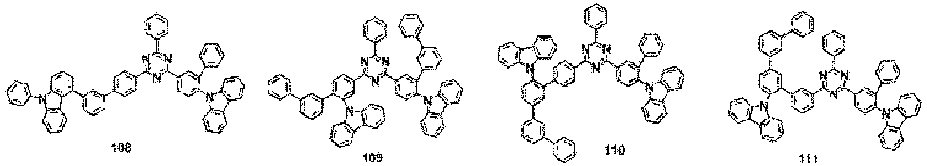

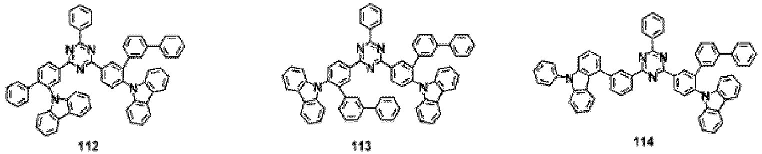

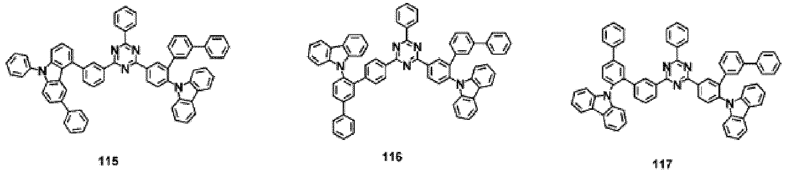

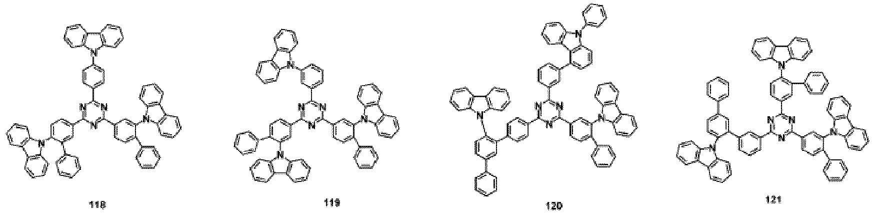

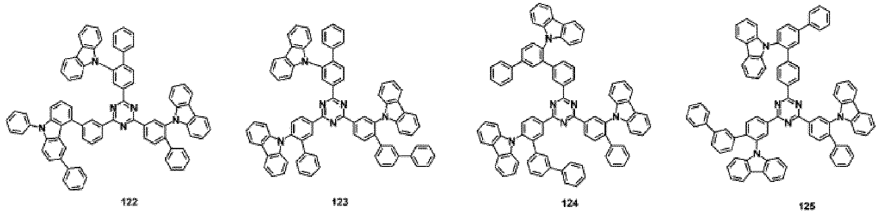

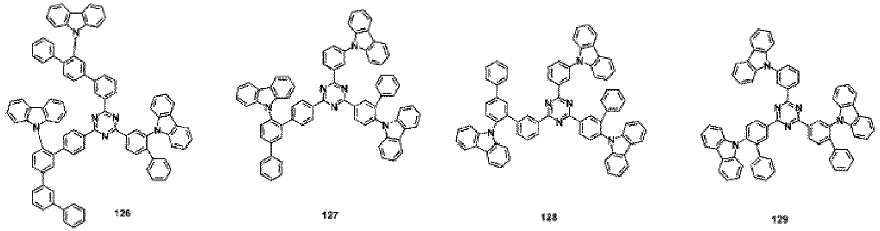

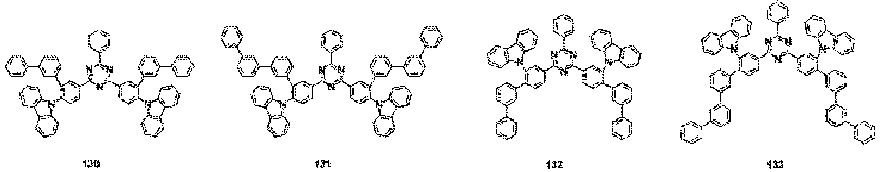

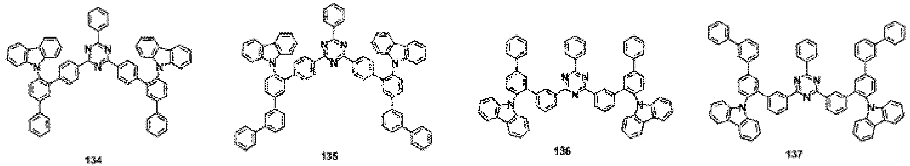

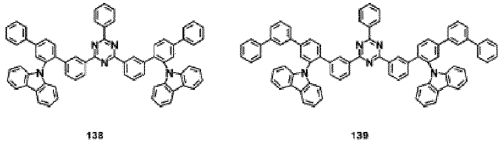

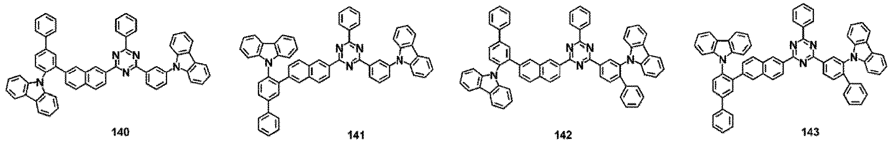

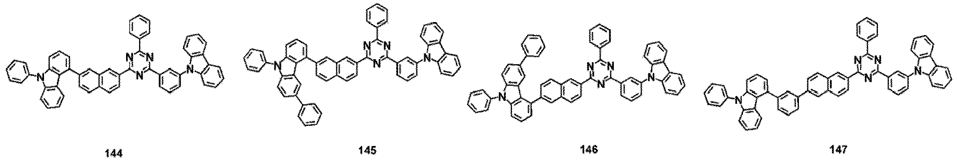

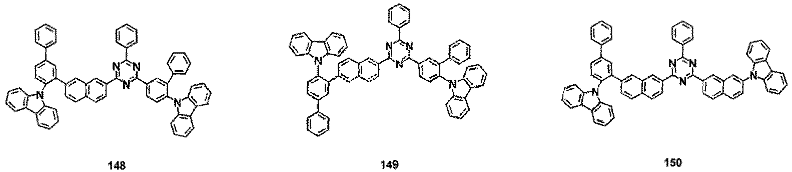

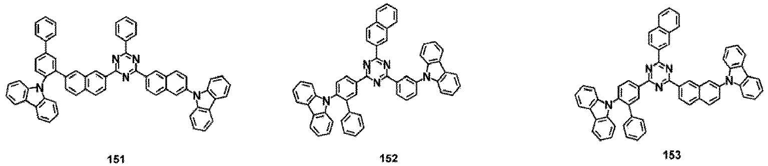

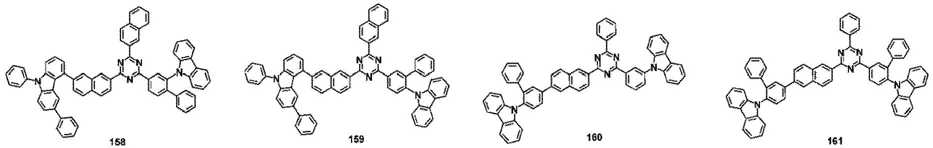

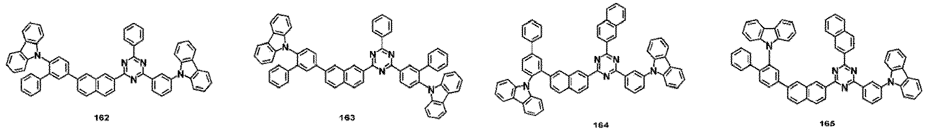

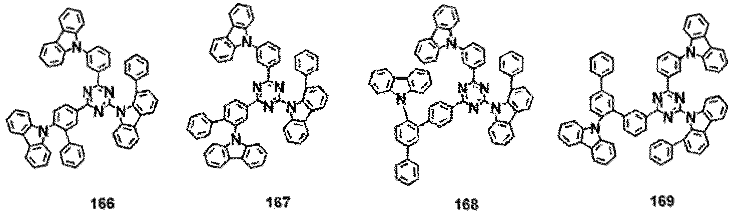

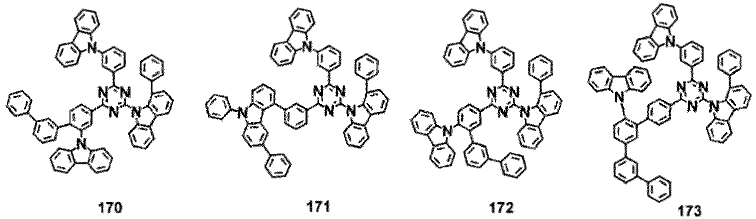

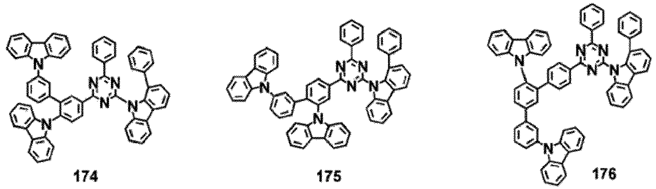

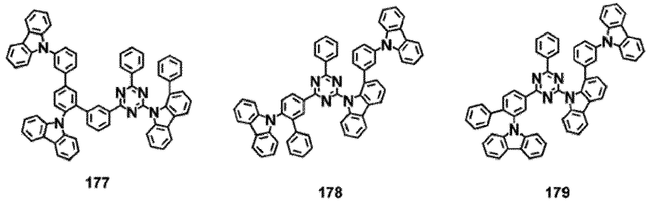

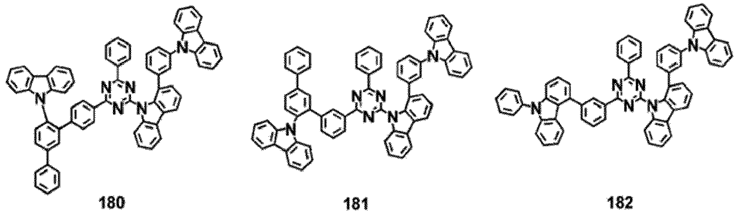

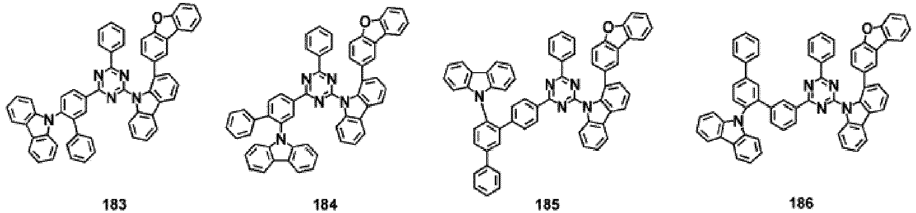

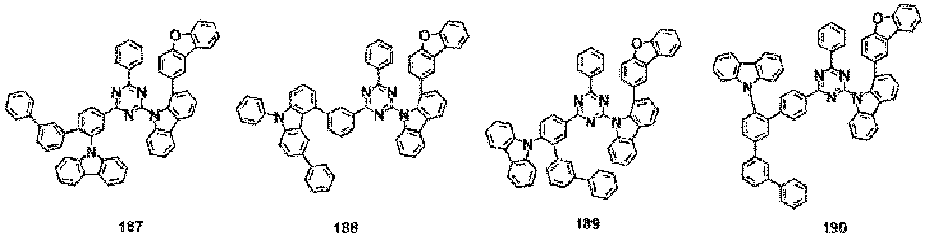

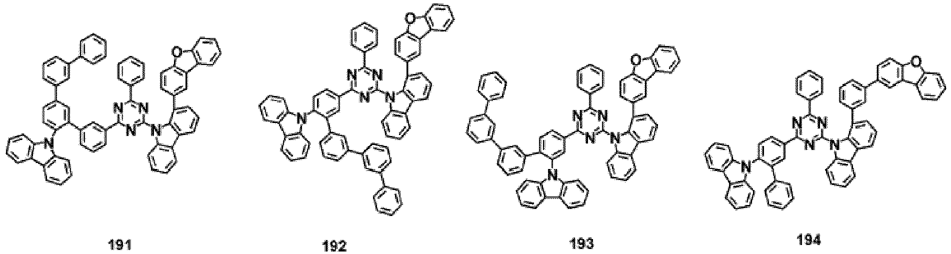

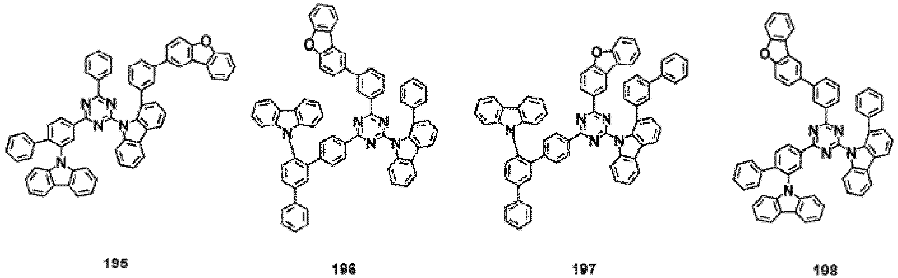

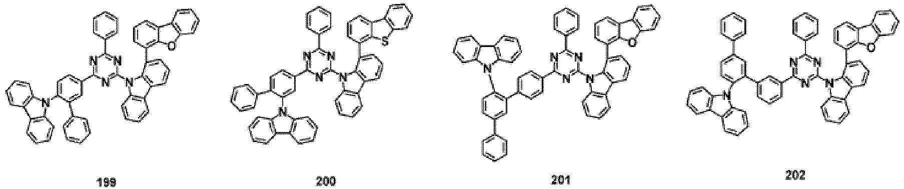

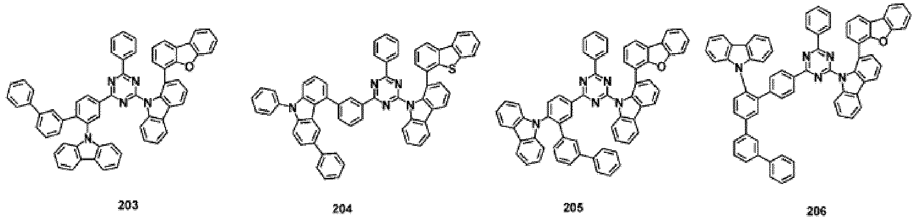

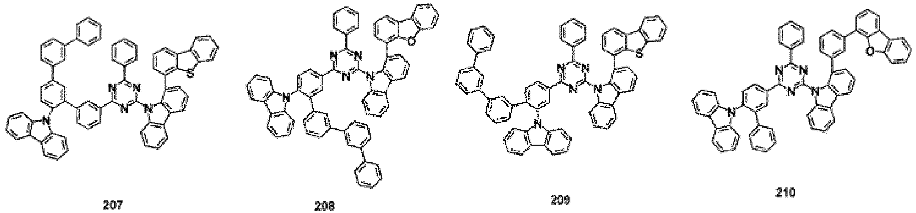

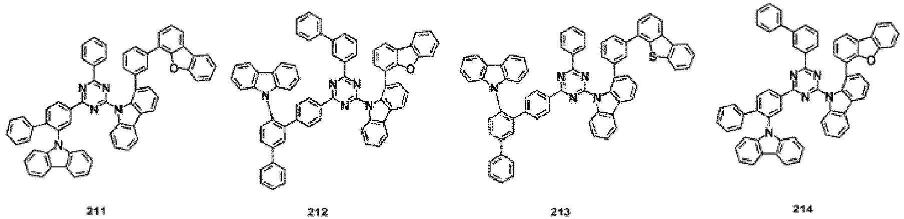

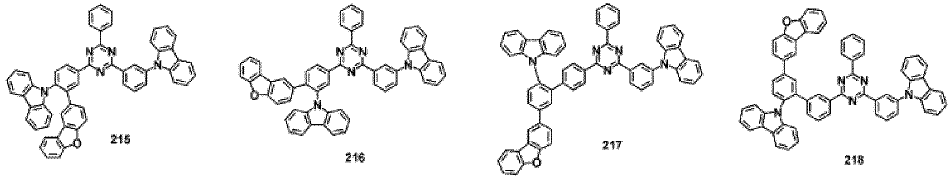

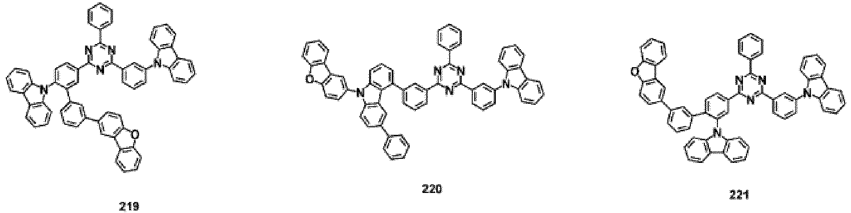

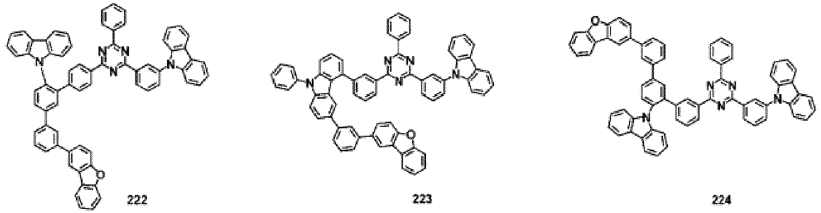

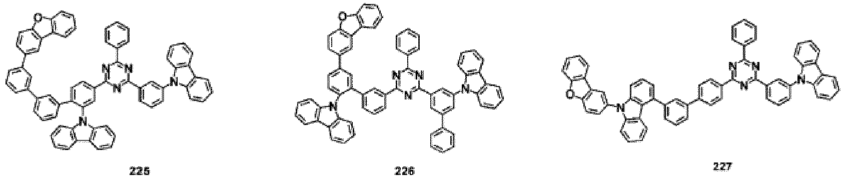

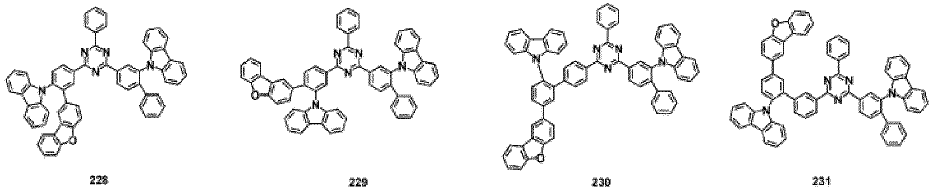

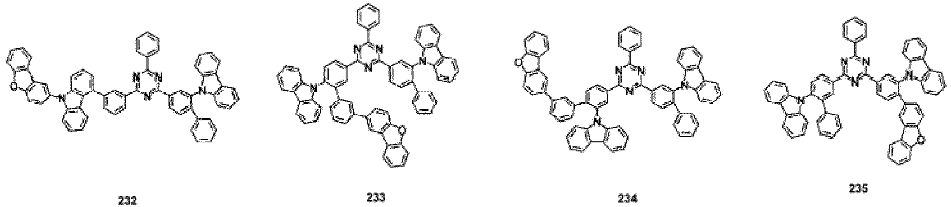

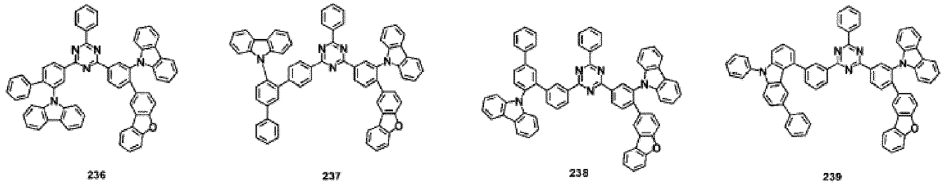

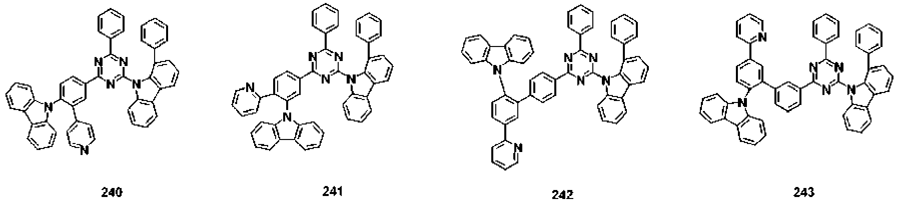

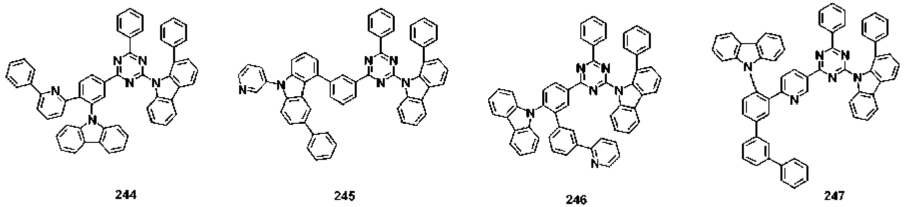

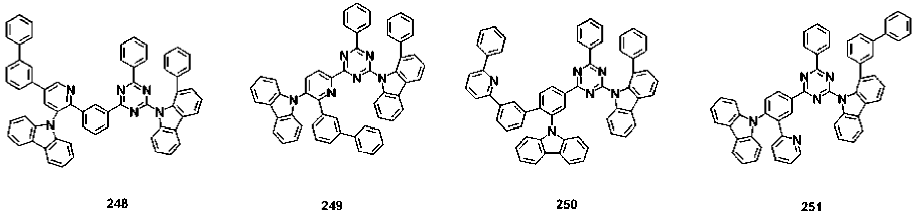

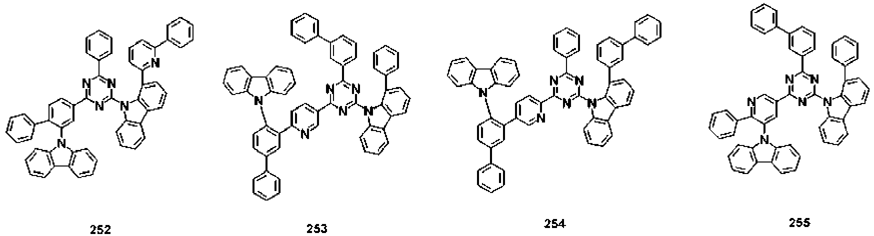

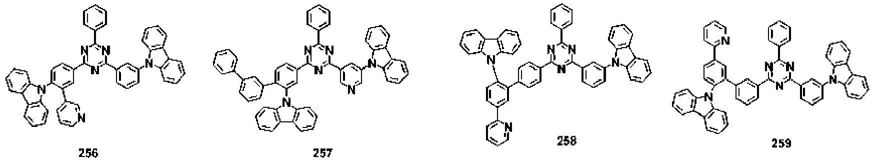

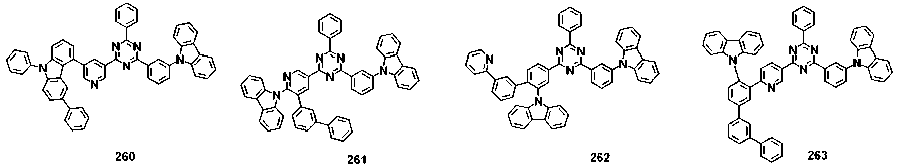

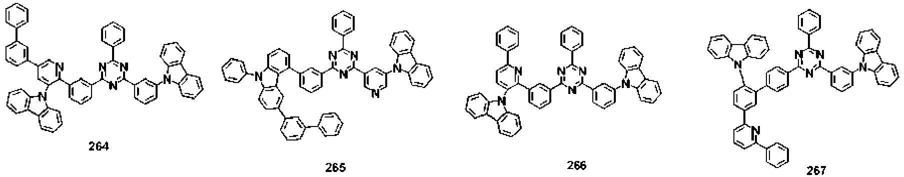

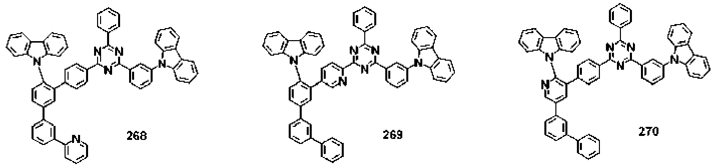

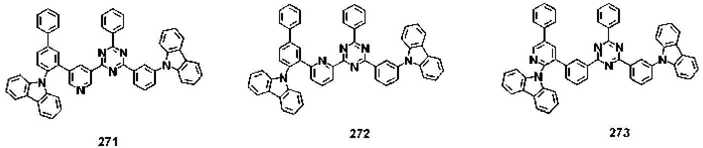

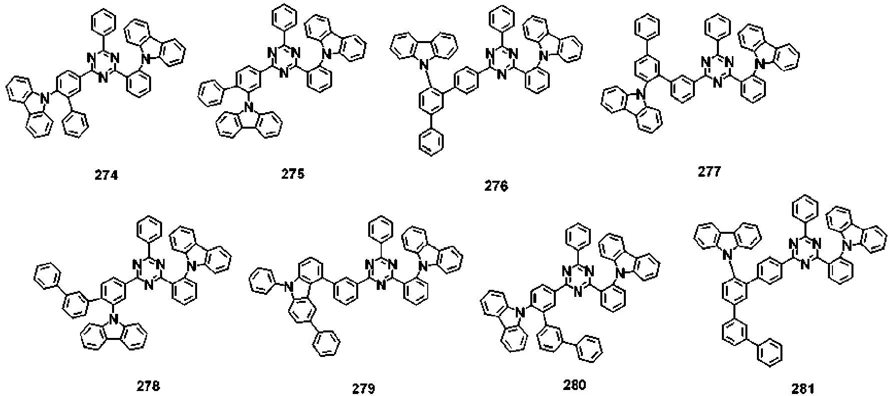

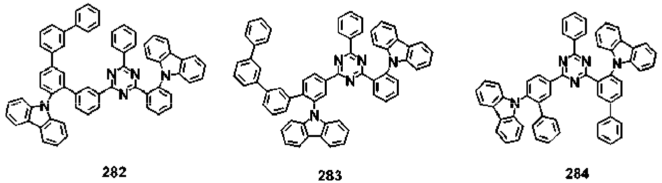

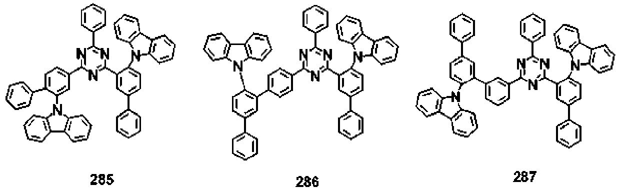

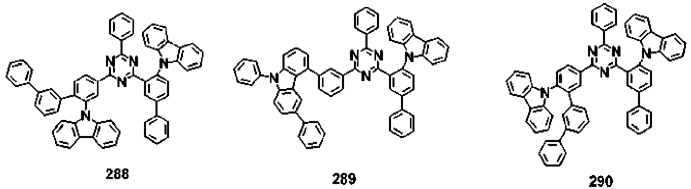

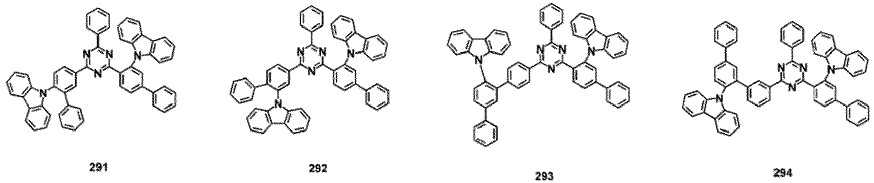

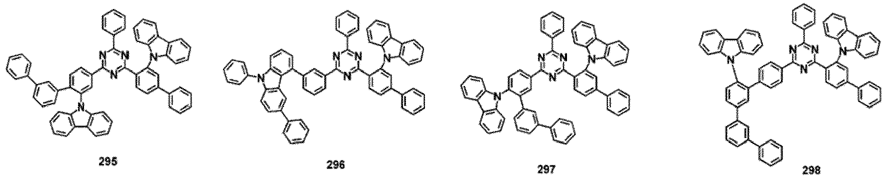

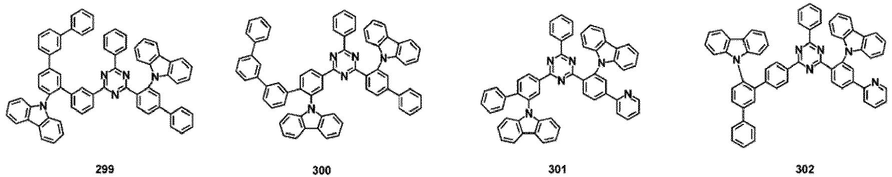

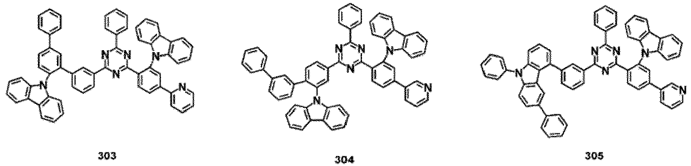

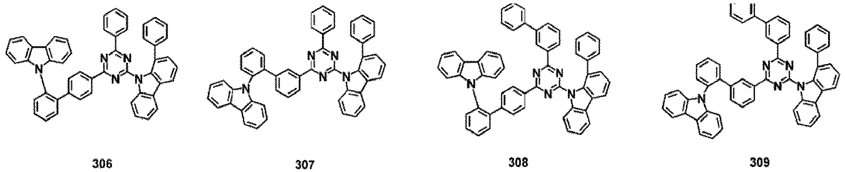

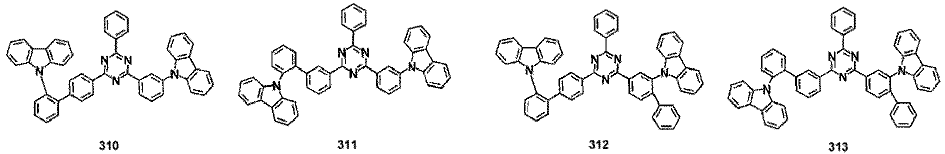

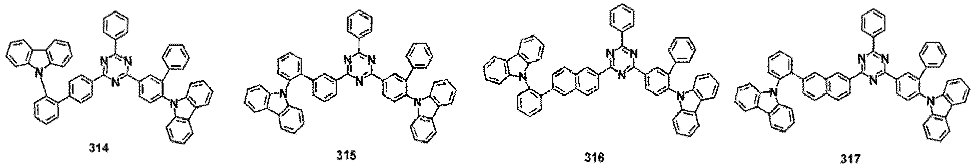

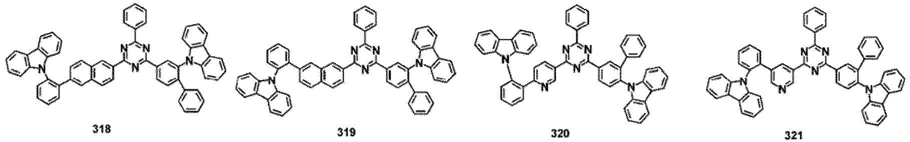

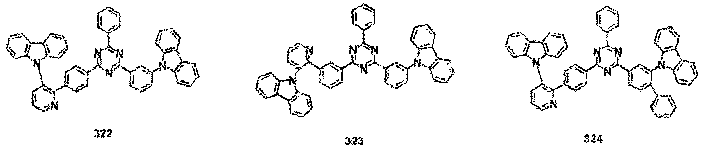

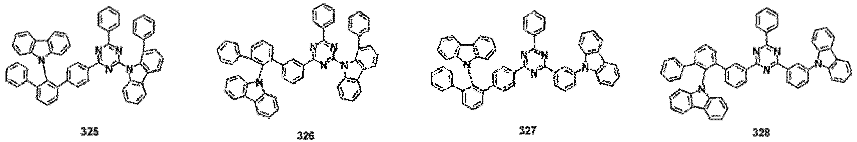

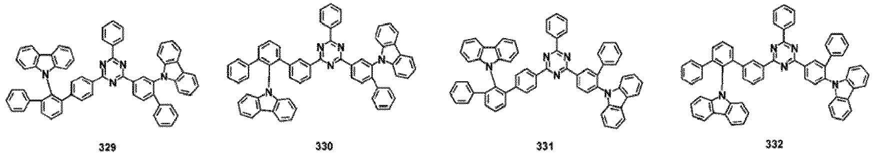

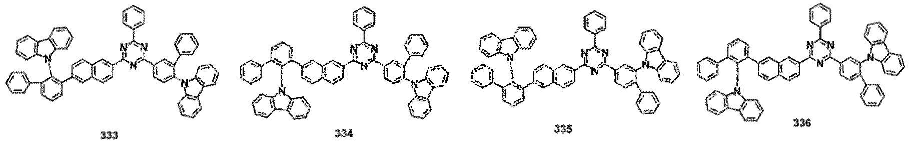

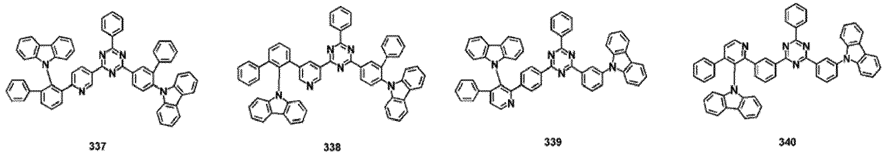

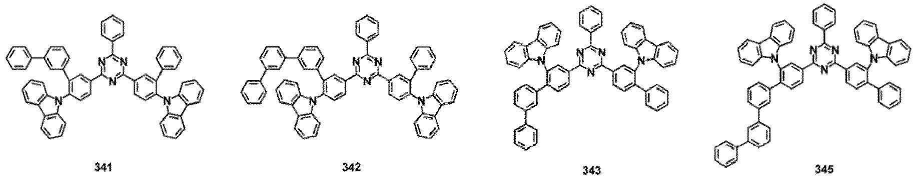

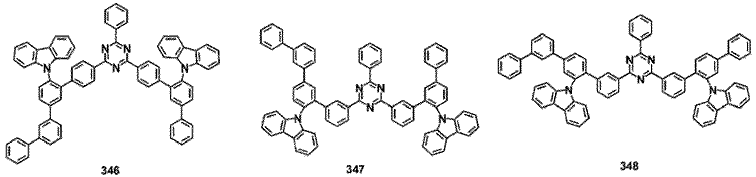

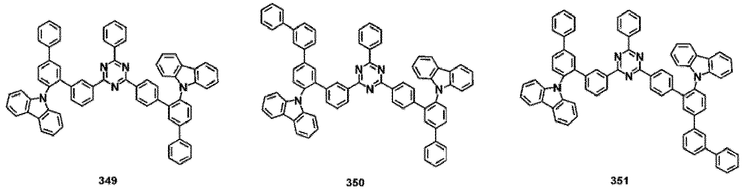

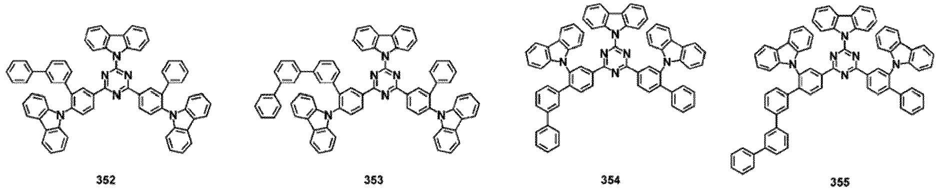

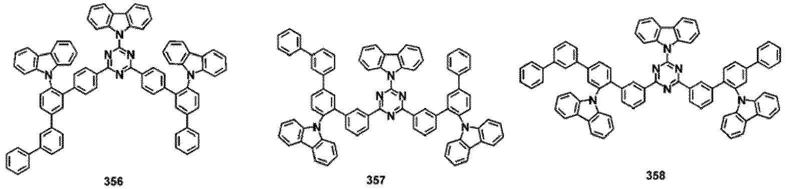

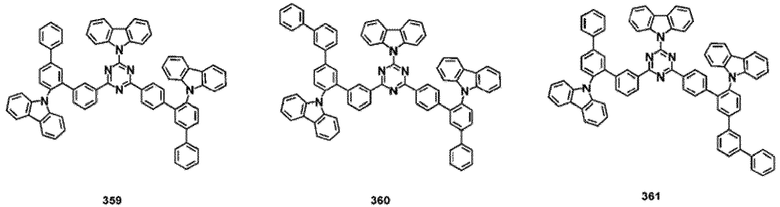

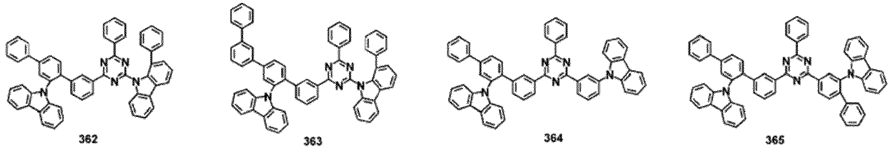

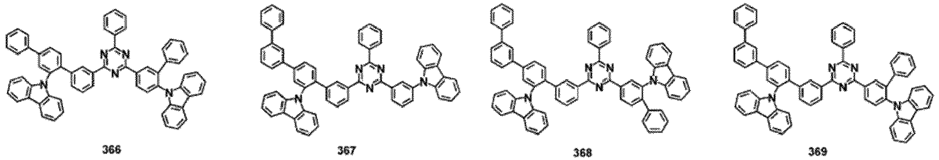

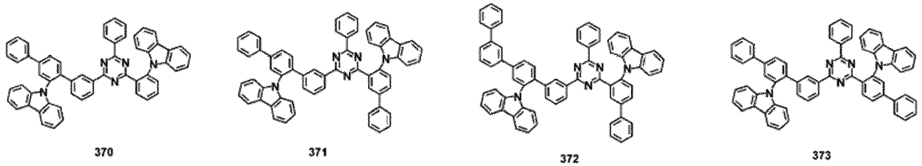

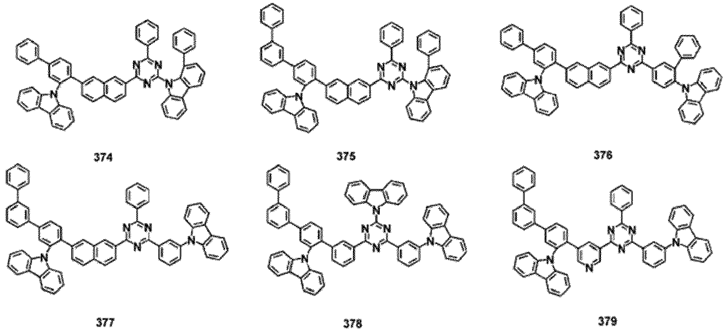

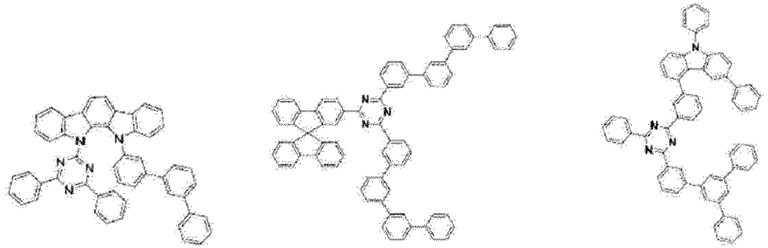

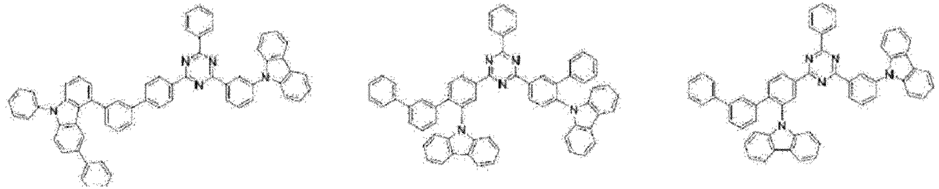

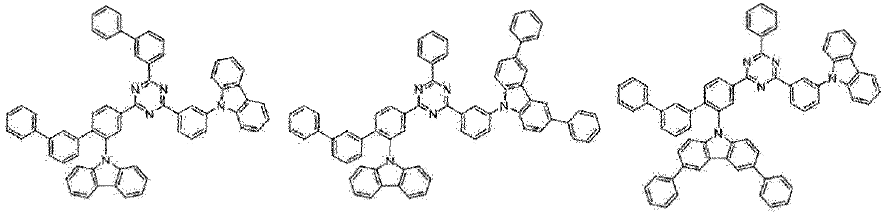

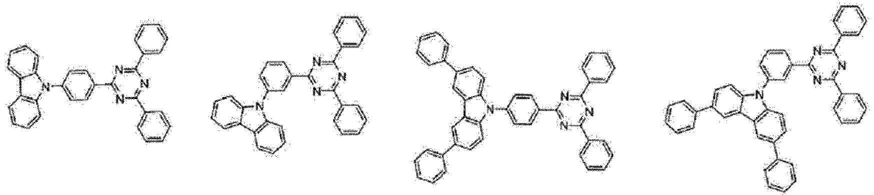

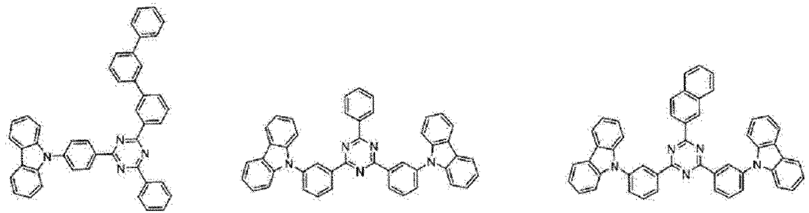

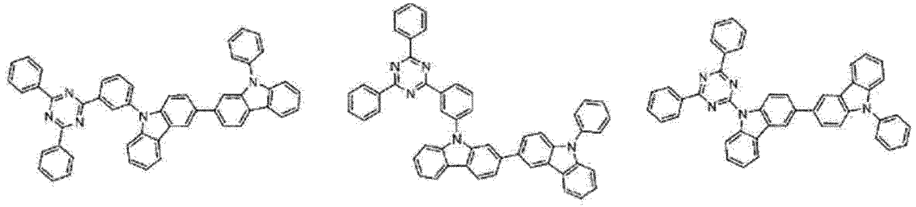

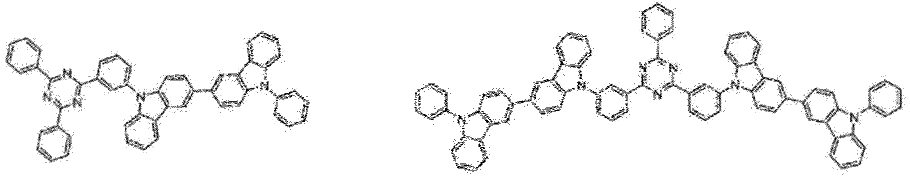

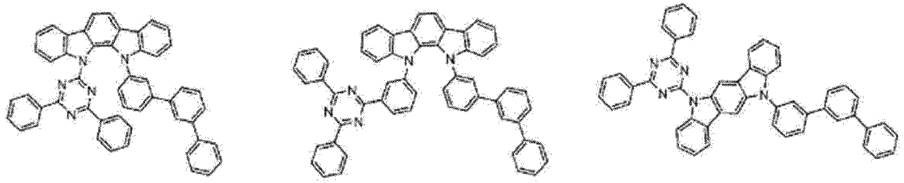

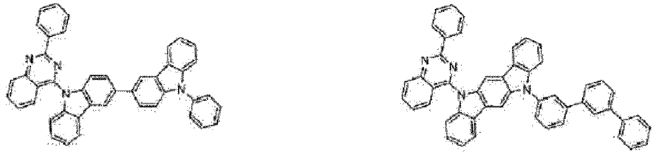

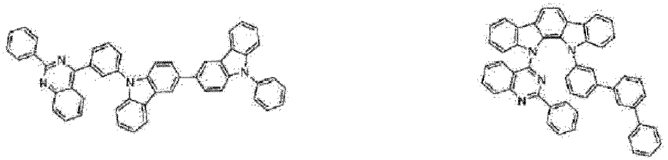

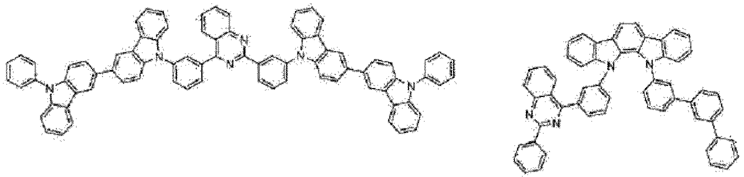

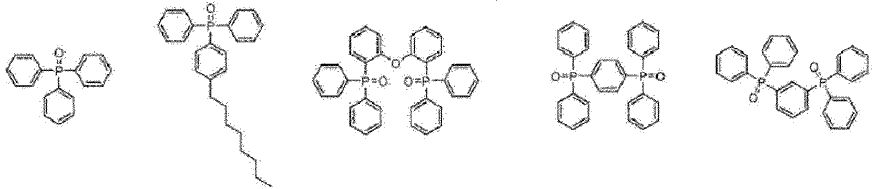

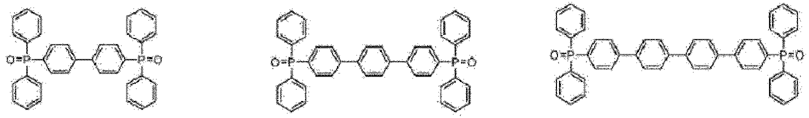

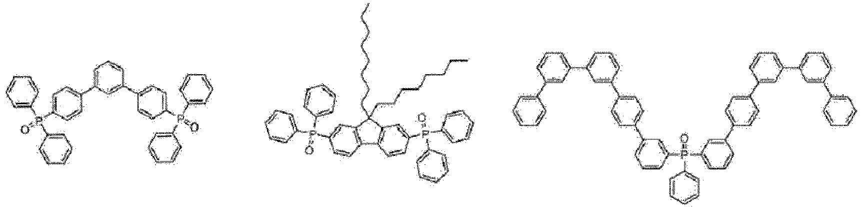

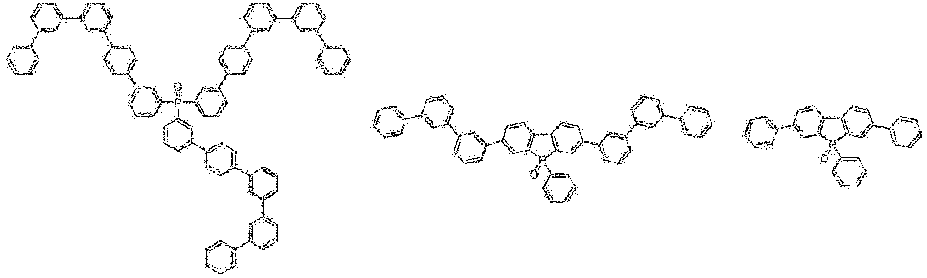

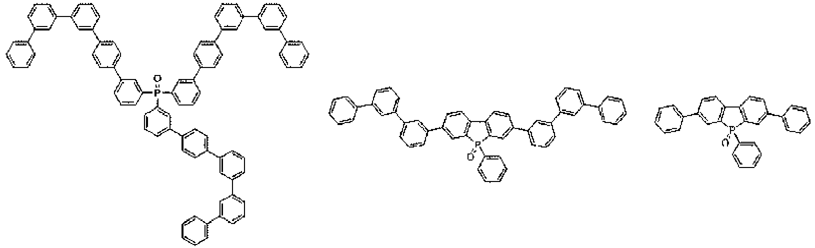

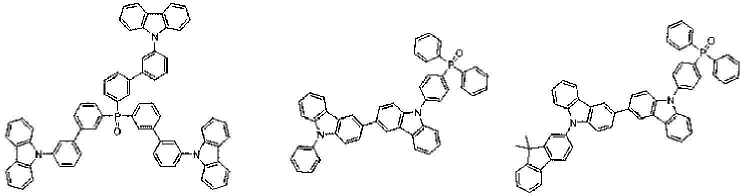

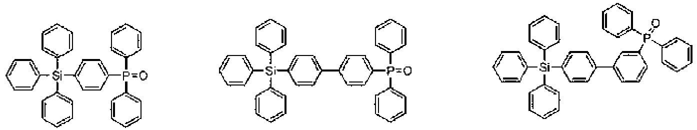

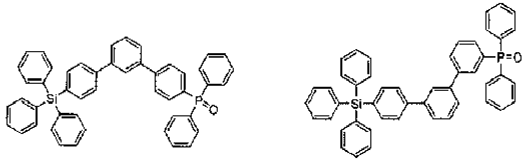

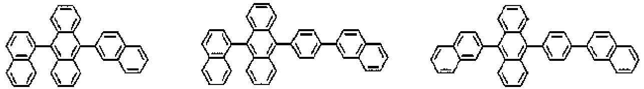

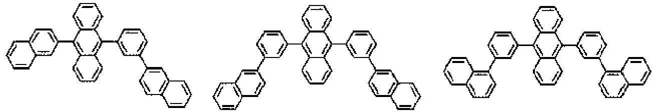

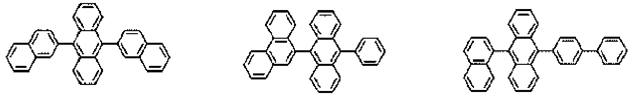

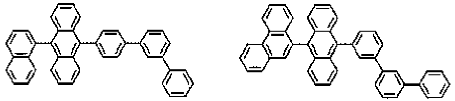

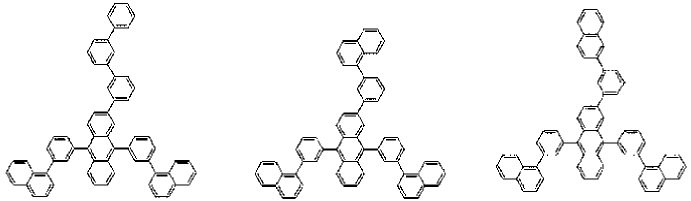

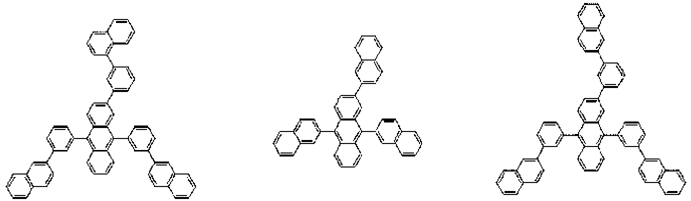

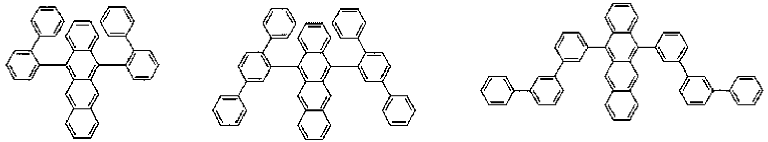

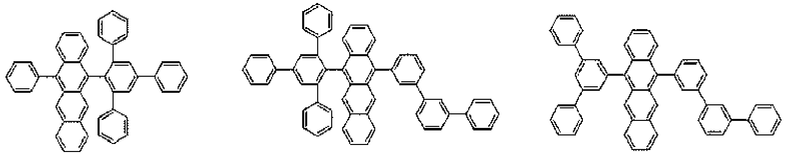

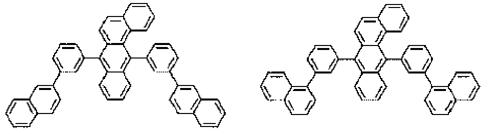

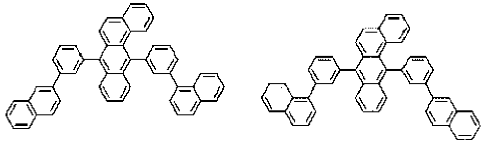

11. Organische lichtemittierende Vorrichtung nach einem der Ansprüche 1-10, wobei
die Formel 2-1 durch die Formel 2-1(1) dargestellt ist,
die Formel 2-2 durch die Formel 2-2(1) dargestellt ist,
die Formel 2-3 durch eine der Formeln 2-3(1) bis 2-3(3) dargestellt ist,
die Formel 2-4 durch eine der Formeln 2-4(1) bis 2-4(3) dargestellt ist: 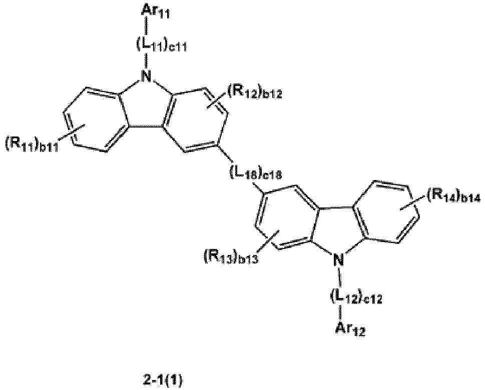 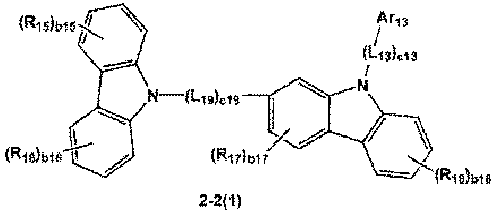 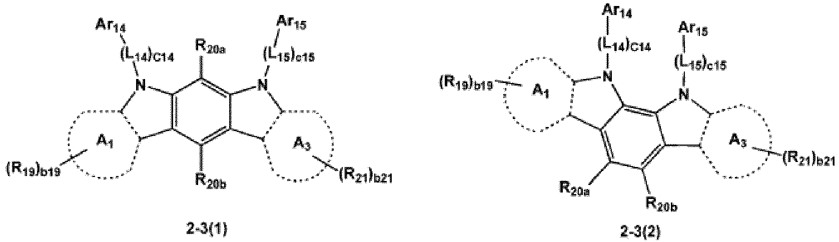 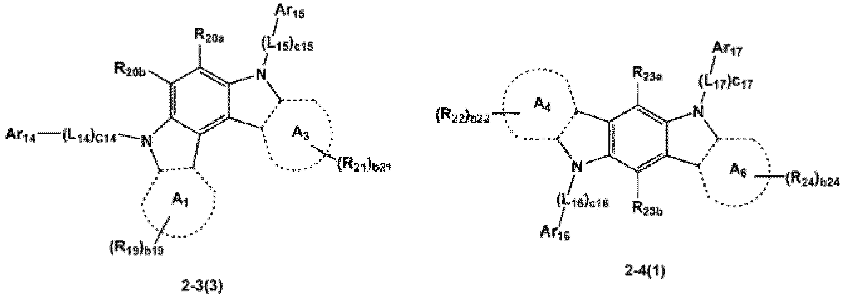 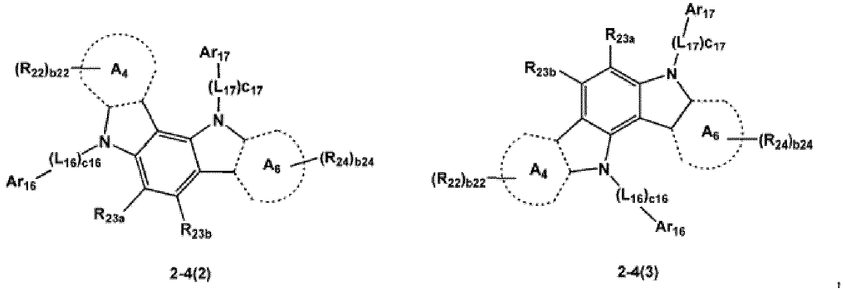
wobei in den Formeln 2-3(1) bis 2-3(3) R₂₀ₐ und R_{20b} unter Bezugnahme auf die in Verbindung mit R₂₀ von Anspruch 1 präsentierte Beschreibung zu verstehen sind, und
in den Formeln 2-4(1) bis 2-4(3) R₂₃ₐ und R_{23b} R_{20b} unter Bezugnahme auf die in Verbindung mit R₂₃ von Anspruch 1 präsentierte Beschreibung zu verstehen sind.

12. Organische lichtemittierende Vorrichtung nach einem der Ansprüche 1-11, wobei
die zweite Verbindung mindestens eine der folgenden Verbindungen beinhaltet: 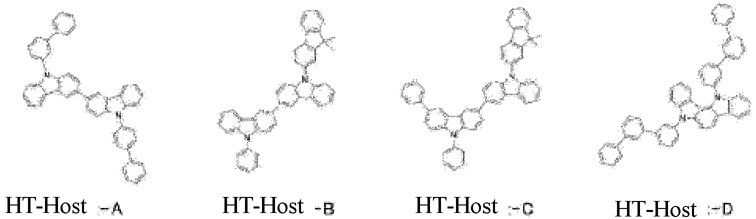 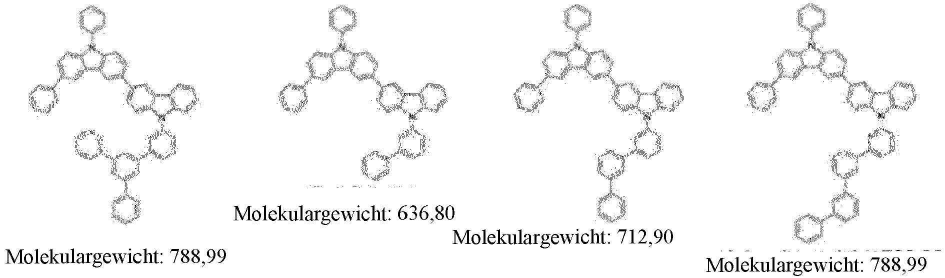 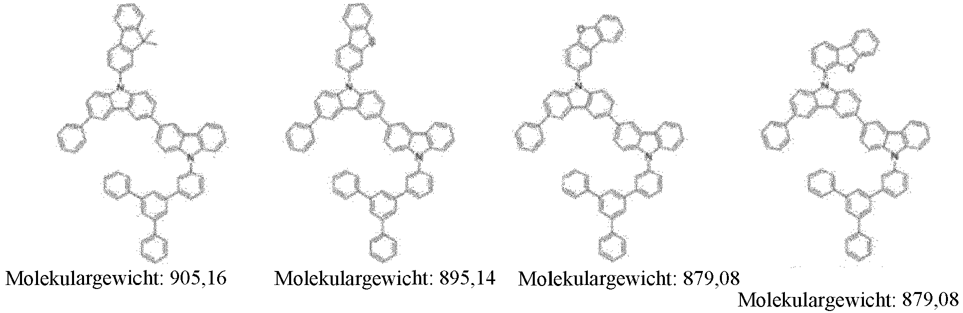 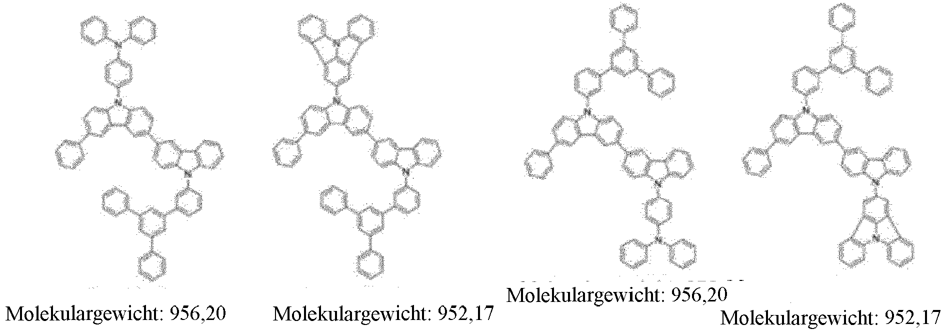 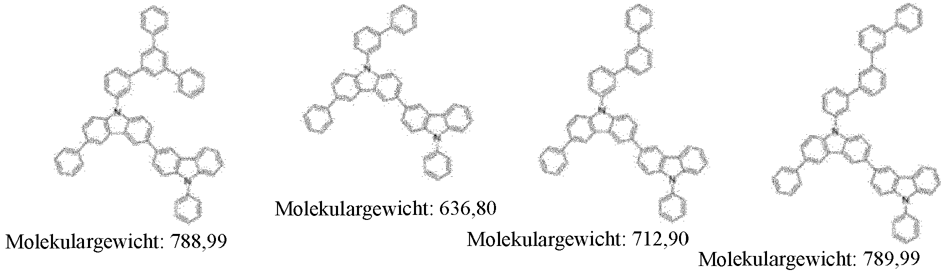 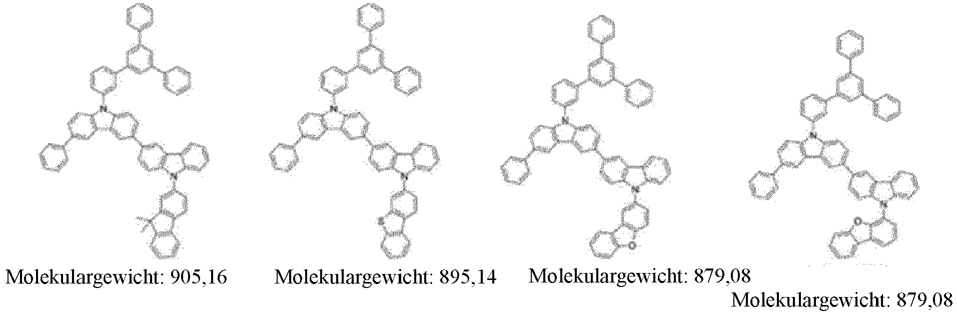 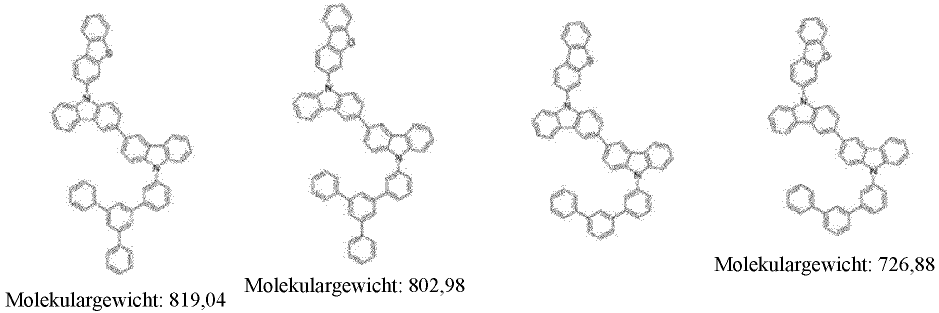 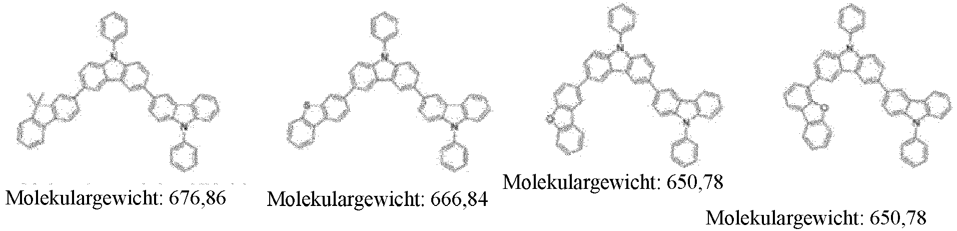 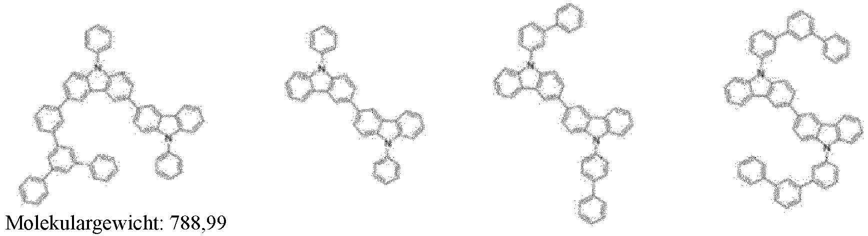 ; und/oder
wobei
die dritte Verbindung mindestens eine der folgenden Verbindungen beinhaltet:

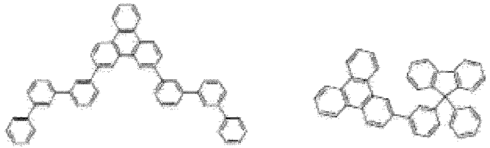

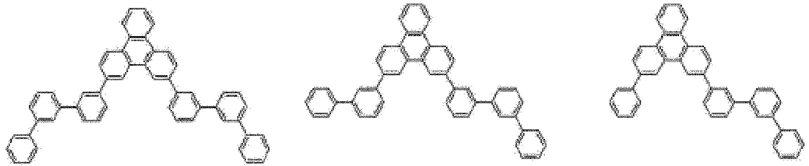

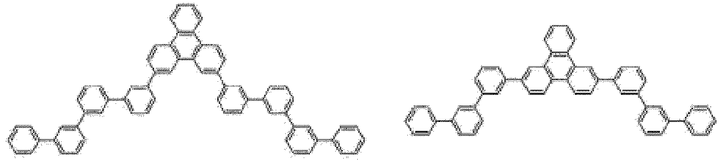

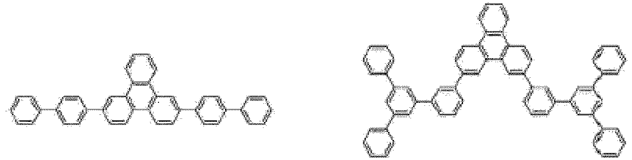

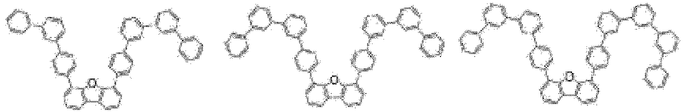

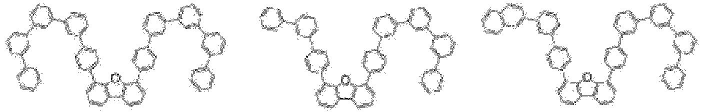

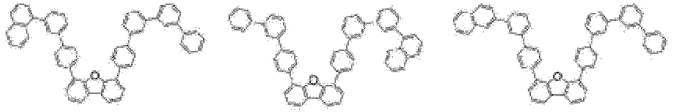

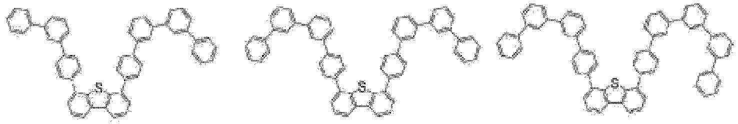

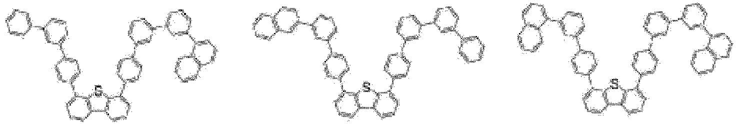

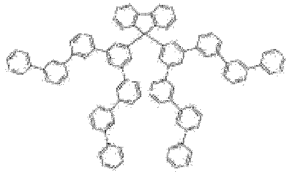

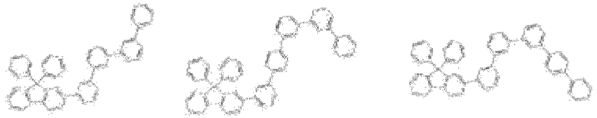

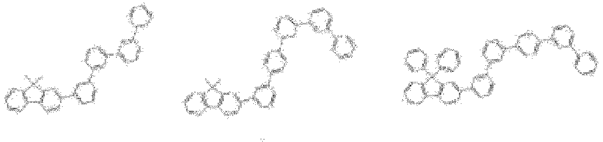

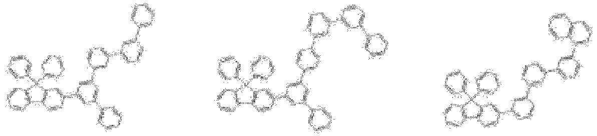

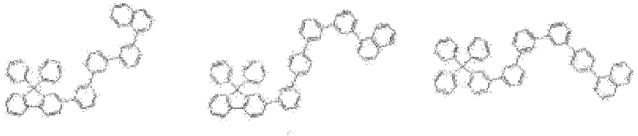

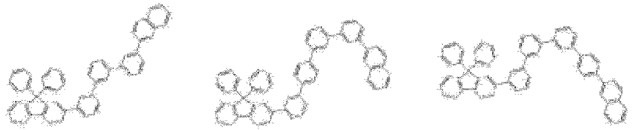

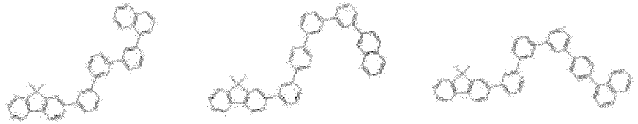

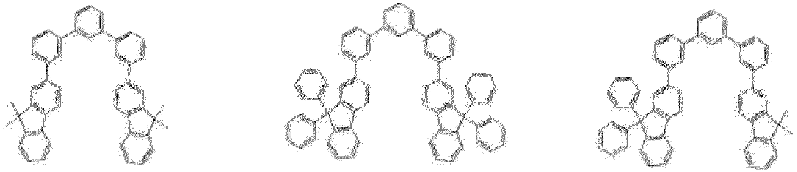

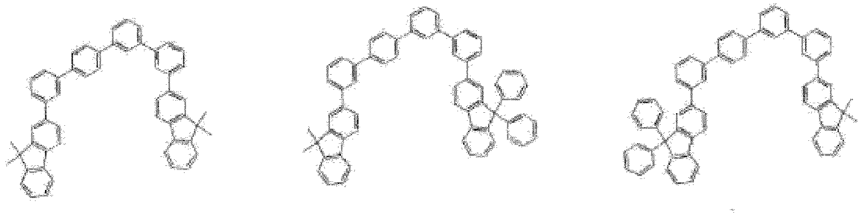

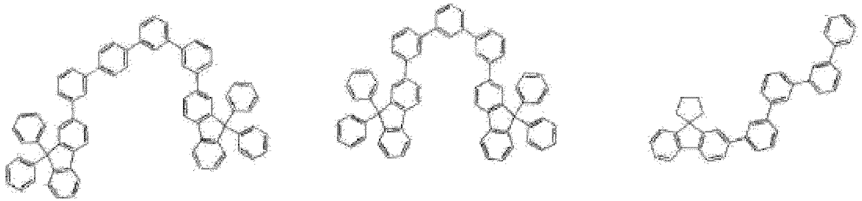

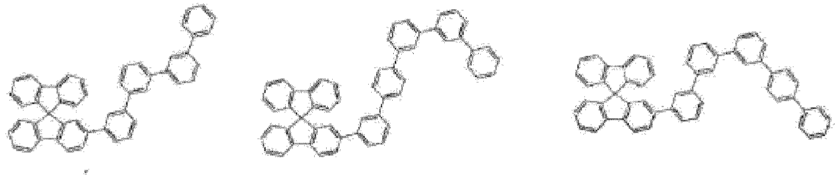

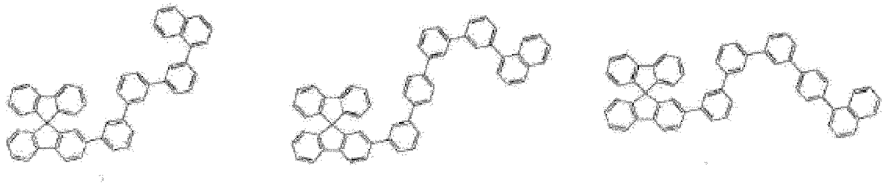

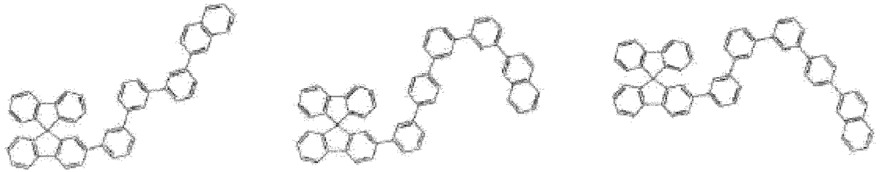

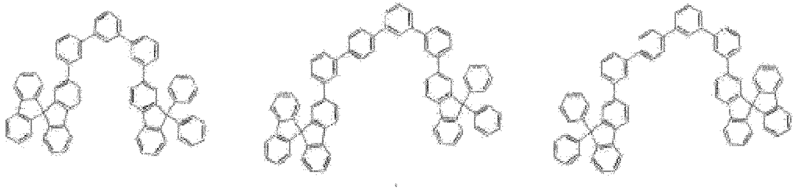

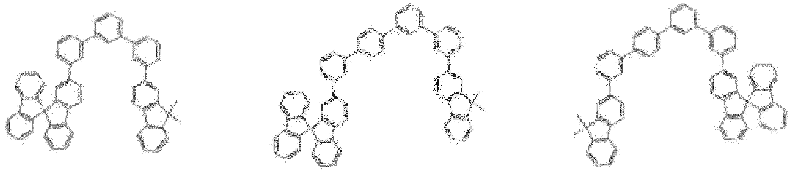

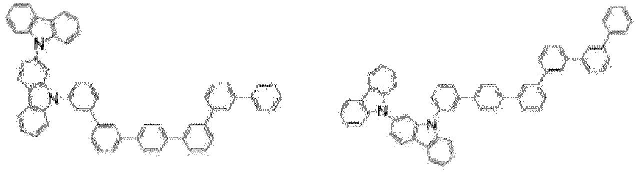

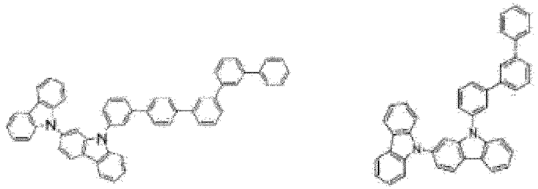

13. Organische lichtemittierende Vorrichtung nach einem der Ansprüche 1-12, wobei
die erste Verbindung mindestens eine durch die Formel 1-1 oder 1-4 dargestellte Verbindung beinhaltet,
die zweite Verbindung mindestens eine durch die Formel 2-1 oder 2-4 dargestellte Verbindung beinhaltet und
die dritte Verbindung mindestens eine durch die Formel 3-2 dargestellte Verbindung beinhaltet: 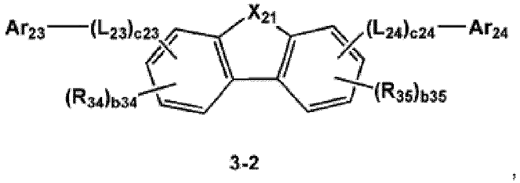
wobei in Formel 3-2
X₂₁ O oder S ist,
L₂₃ bis L₂₄ jeweils unabhängig aus einer substituierten oder unsubstituierten C₆-C₃₀ Arylengruppe ausgewählt sind,
c23 und c24 jeweils unabhängig 1, 2 oder 3 sind,
Ar₂₃ und Ar₂₄ jeweils unabhängig aus Wasserstoff und einer substituierten oder unsubstituierten C₆-C₃₀-Arylgruppe ausgewählt sind,
R₃₄ und R₃₅ jeweils unabhängig aus Wasserstoff, Deuterium, -F,-Cl, -Br, -I, einer Cyanogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe und einer substituierten oder unsubstituierten C₁-C₆₀-Alkoxygruppe ausgewählt sind und
b34 und b35 jeweils unabhängig eine ganze Zahl von 0 bis 3 sind; und/oder
wobei
die erste Verbindung mindestens eine durch die Formel 1-1 dargestellte Verbindung beinhaltet,
die zweite Verbindung mindestens eine durch die Formel 2-1 dargestellte Verbindung beinhaltet und
die dritte Verbindung mindestens eine durch die Formel 3-1 dargestellte Verbindung beinhaltet: 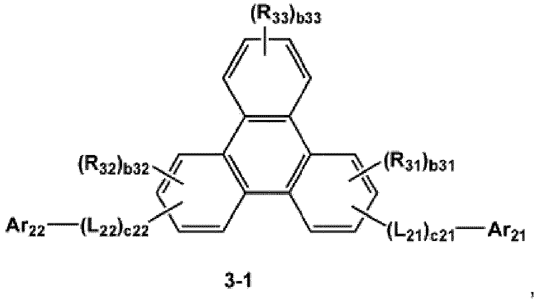
wobei in Formel 3-1
L₂₁ bis L₂₂ jeweils unabhängig aus einer substituierten oder unsubstituierten C₆-C₃₀-Arylengruppe ausgewählt sind,
c21 und c22 jeweils unabhängig 1, 2 oder 3 sind,
Ar₂₁ und Ar₂₂ jeweils unabhängig aus Wasserstoff und einer substituierten oder unsubstituierten C₆-C₃₀-Arylgruppe ausgewählt sind, wobei Ar₂₁ und Ar₂₂ jeweils nicht gleichzeitig Wasserstoff sind,
R₃₁ bis R₃₃ jeweils unabhängig aus Wasserstoff, Deuterium, -F, -Cl, -Br, -I, einer Cyanogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe und einer substituierten oder unsubstituierten C₁-C₆₀-Alkoxygruppe ausgewählt sind,
b31 und b32 jeweils unabhängig eine ganze Zahl von 0 bis 3 sind, und
b33 eine ganze Zahl von 0 bis 4 ist; und/oder
wobei
die erste Verbindung mindestens eine durch die Formel 1-1 dargestellte Verbindung beinhaltet,
die zweite Verbindung mindestens eine durch die Formel 2-1 dargestellte Verbindung beinhaltet und
die dritte Verbindung mindestens eine durch die Formel 3-4 dargestellte Verbindung beinhaltet: 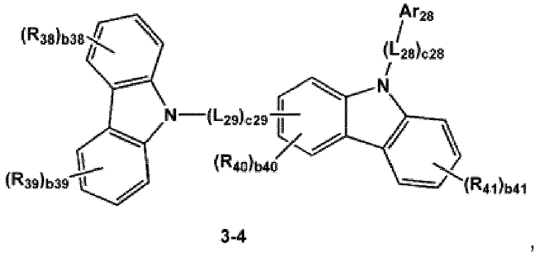
wobei in Formel 3-4,
L₂₈ bis L₂₉ jeweils unabhängig aus einer Einfachbindung und einer substituierten oder unsubstituierten C₆-C₃₀-Arylengruppe ausgewählt sind,
c28 und c29 jeweils unabhängig 1, 2 oder 3 sind,
Ar₂₈ aus Wasserstoff und einer substituierten oder unsubstituierten C₆-C₃₀-Arylgruppe ausgewählt ist,
R₃₈ bis R₄₁ jeweils unabhängig aus Wasserstoff, Deuterium, -F, -Cl, -Br, -I, einer Cyanogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe und einer substituierten oder unsubstituierten C₁-C₆₀-Alkoxygruppe ausgewählt sind,
b38, b39 und b41 jeweils unabhängig eine ganze Zahl von 0 bis 4 sind, und
b40 eine ganze Zahl von 0 bis 2 ist.

14. Organische lichtemittierende Vorrichtung nach einem der Ansprüche 1-13, wobei
die Emissionsschicht ferner einen fluoreszierenden Dotierstoff, einen phosphoreszierenden Dotierstoff oder eine Kombination davon umfasst.

15. Apparatur, die die organische lichtemittierende Vorrichtung nach einem der Ansprüche 1-14 beinhaltet.

## Revendications

1. Dispositif électroluminescent organique comprenant :
une première électrode ;
une seconde électrode ; et
une couche d'émission entre la première électrode et la seconde électrode,
où la couche d'émission comprend un premier composé, un deuxième composé et un troisième composé,
le premier composé comprend au moins un composé représenté par une des Formules 1-1 à 1-4,
le deuxième composé comprend au moins un composé représenté par une des Formules 2-1 à 2-4, et
le troisième composé comprend au moins un composé contenant au moins un groupe choisi parmi un groupe triphénylène, un groupe dibenzofurane, un groupe dibenzothiophène, un groupe fluorène et un groupe biscarbazole, dans lequel une bande interdite entre un niveau d'énergie d'orbitale moléculaire occupée la plus haute (HOMO) et un niveau d'énergie d'orbitale moléculaire inoccupée la plus basse (LUMO) du troisième composé est 3,3 eV ou plus : 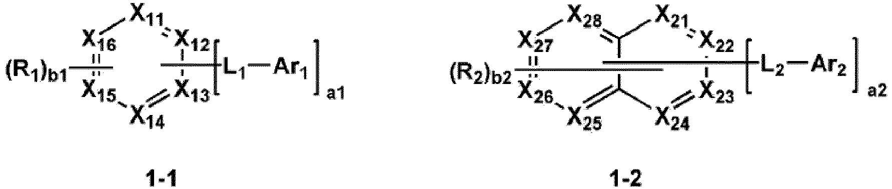 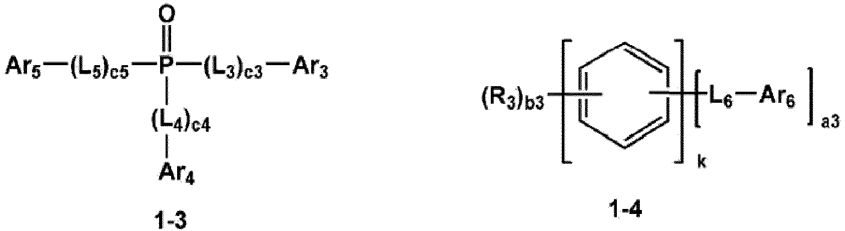 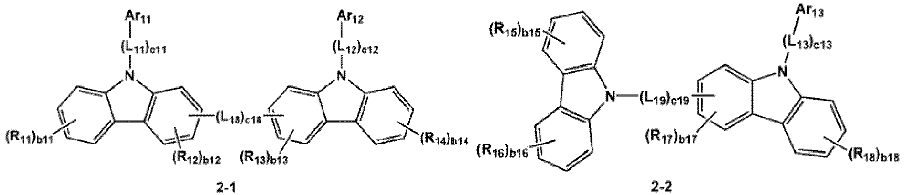 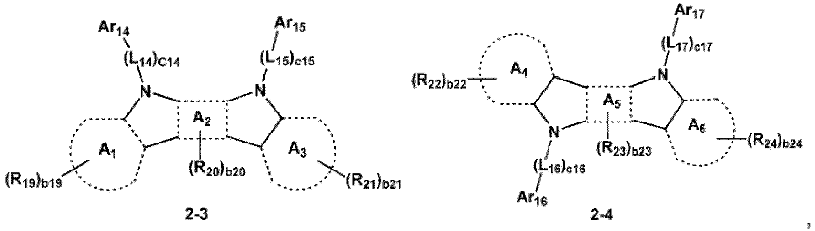
où, dans les formules 1-1 à 1-4,
X₁₁ à X₁₆ et X₂₁ à X₂₈ sont chacun indépendamment C ou N,
au moins un choisi parmi X₁₁ à X₁₆ est N,
au moins un choisi parmi X₂₁ à X₂₈ est N,
L₁ à L₆ sont chacun indépendamment choisis parmi une liaison simple, un groupe arylène en C₆-C₃₀ substitué ou non substitué, un groupe hétéroarylène en C₁-C₃₀ substitué ou non substitué, un groupe polycyclique condensé non aromatique divalent et un groupe hétéropolycyclique condensé non aromatique divalent,
c3 à c5 sont chacun indépendamment un nombre entier de 1 à 3,
Ar₁ à Ar₆ sont chacun indépendamment choisis parmi un groupe aryle en C₆-C₃₀ substitué ou non substitué, un groupe hétéroaryle en C₁-C₃₀ substitué ou non substitué, un groupe polycyclique condensé non aromatique monovalent substitué ou non substitué et un groupe hétéropolycyclique condensé non aromatique monovalent substitué ou non substitué,
deux un groupes adjacents quelconques parmi Ar₃ à Ar₅ sont éventuellement liés l'un à l'autre par l'intermédiaire d'une liaison simple pour former un cycle condensé,
a1 à a3 sont chacun indépendamment un nombre entier de 1 à 3,
R₁ à R₃ sont chacun indépendamment choisis parmi hydrogène, deutérium, -F, -Cl, -Br, -I, un groupe cyano, un groupe alkyle en C₁-C₆₀ substitué ou non substitué, un groupe alkényle en C₂-C₆₀ substitué ou non substitué, un groupe alkynyle en C₂-C₆₀ substitué ou non substitué et un groupe alkoxy en C₁-C₆₀ substitué ou non substitué,
b 1 est un nombre entier de 0 à 4,
b2 est un nombre entier de 0 à 6,
b3 est un nombre entier de 7 à 11, et
k est 3 ou 4, et
dans les Formules 2-1 à 2-4,
A₁ à A₆ sont chacun indépendamment choisis parmi un groupe carbocyclique en C₅-C₃₀ et un groupe hétérocyclique en C₁-C₃₀,
L₁₁ à L₁₉ sont chacun indépendamment choisis parmi une liaison simple, un groupe arylène en C₆-C₃₀ substitué ou non substitué, un groupe hétéroarylène en C₁-C₃₀ substitué ou non substitué, un groupe polycyclique condensé non aromatique divalent substitué ou non substitué et un groupe hétéropolycyclique condensé non aromatique divalent substitué ou non substitué,
c11 à c19 sont chacun indépendamment un nombre entier de 1 à 3,
Ar₁₁, Ar₁₂ et Ar₁₄ à Ar₁₇ sont chacun indépendamment choisis parmi un groupe aryle en C₆-C₃₀ substitué ou non substitué, un groupe hétéroaryle en C₁-C₃₀ substitué ou non substitué, un groupe polycyclique condensé non aromatique monovalent substitué ou non substitué et un groupe hétéropolycyclique condensé non aromatique monovalent substitué ou non substitué, où chacun de Ar₁₄ et Ar₁₅ n'est pas un groupe indolocarbazole et chacun de Ar₁₆ et Ar₁₇ n'est pas un groupe naphthyle en même temps,
Ar₁₃ est choisi parmi un groupe aryle en C₆-C₃₀ substitué ou non substitué et un groupe polycyclique condensé non aromatique monovalent substitué ou non substitué,
R₁₁ à R₂₄ sont chacun indépendamment choisis parmi hydrogène, deutérium, -F, -Cl, -Br, -I, un groupe cyano, un groupe alkyle en C₁-C₆₀ substitué ou non substitué, un groupe alkényle en C₂-C₆₀ substitué ou non substitué, un groupe alkynyle en C₂-C₆₀ substitué ou non substitué, et un groupe alkoxy en C₁-C₆₀ substitué ou non substitué, un groupe aryle en C₆-C₃₀ substitué ou non substitué, et un groupe hétéroaryle en C₁-C₃₀ substitué ou non substitué, un groupe polycyclique condensé non aromatique monovalent substitué ou non substitué, et un groupe hétéropolycyclique condensé non aromatique monovalent substitué ou non substitué,
b11, b14, b15, b16 et b18 à b24 sont chacun indépendamment un nombre entier de 0 à 4, b 12, b 13 et b 17 sont chacun indépendamment un nombre entier de 0 à 3,
au moins un substituant du un groupe arylène en C₆-C₃₀ substitué, un groupe hétéroarylène en C₁-C₃₀ substitué, un groupe polycyclique condensé non aromatique divalent substitué, un groupe hétéropolycyclique condensé non aromatique divalent substitué, un groupe alkyle en C₁-C₆₀ substitué, un groupe alkényle en C₂-C₆₀ substitué, un groupe alkynyle en C₂-C₆₀ substitué, un groupe alkoxy en C₁-C₆₀ substitué, un groupe aryle en C₆-C₃₀ substitué, un groupe hétéroaryle en C₁-C₃₀ substitué, un groupe polycyclique condensé non aromatique monovalent substitué et un groupe hétéropolycyclique condensé non aromatique monovalent substitué est choisi parmi :
deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alkényle en C₂-C₆₀, un groupe alkynyle en C₂-C₆₀ et un groupe alkoxy en C₁-C₆₀ ;
un groupe alkyle en C₁-C₆₀, un groupe alkényle en C₂-C₆₀, un groupe alkynyle en C₂-C₆₀, et un groupe alkoxy en C₁- C₆₀, chacun étant substitué par au moins un choisi parmi deutérium, - F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalkényle en C₃-C₁₀, un groupe hétérocycloalkényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -N(Q₁₁)(Q₁₂), - Si(Q₁₃)(Q₁₄)(Q₁₅), -B(Q₁₆)(Q₁₇) et -P(=O)(Q₁₈)(Q₁₉) ;
un groupe cycloalkyle en C₃-C₁₀, un groupe hétérocycloalkyle en C₁-C₁₀, un groupe cycloalkényle en C₃-C₁₀, un groupe hétérocycloalkényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent ;
un groupe cycloalkyle en C₃-C₁₀, un groupe hétérocycloalkyle en C₁-C₁₀, un groupe cycloalkényle en C₃-C₁₀, un groupe hétérocycloalkényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent, chacun étant substitué par au moins un choisi parmi deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alkényle en C₂-C₆₀, un groupe alkynyle en C₂-C₆₀, un groupe alkoxy en C₁-C₆₀, un groupe cycloalkyle en C₃-C₁₀, un groupe hétérocycloalkyle en C₁-C₁₀, un groupe cycloalkényle en C₃-C₁₀, un groupe hétérocycloalkényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), -B(Q₂₆)(Q₂₇) et -P(=O)(Q₂₈)(Q₂₉) ; et
-N(Q₃₁)(Q₃₂), -Si(Q₃₃)(Q₃₄)(Q₃₅), -B(Q₃₆)(Q₃₇) et -P(=O)(Q₃₈)(Q₃₉), et
Q1 à Q₉, Q₁₁ à Q₁₉, Q₂₁ à Q₂₉ et Q₃₁ à Q₃₉ sont chacun indépendamment choisis parmi hydrogène, deutérium, -F, -Cl, -Br, -I, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alkényle en C₂-C₆₀, un groupe alkynyle en C₂-C₆₀, un groupe alkoxy en C₁-C₆₀, un groupe cycloalkyle en C₃-C₁₀, un groupe hétérocycloalkyle en C₁-C₁₀, un groupe cycloalkényle en C₃-C₁₀, un groupe hétérocycloalkényle en C₁-C₁₀, un groupe aryle en C₆-C₆₀, un groupe aryle en C₆-C₆₀ substitué par au moins un choisi parmi un groupe alkyle en C₁-C₆₀, et un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent.

2. Dispositif électroluminescent organique selon la revendication 1, dans lequel
L₁ à L₆ et L₁₁ à L₁₉ sont chacun indépendamment choisis parmi une liaison simple, un groupe phénylène, un groupe pentalénylène, un groupe indénylène, un groupe naphthylène, un groupe azulénylène, un groupe heptalénylène, un groupe indacénylène, un groupe acénaphthylène, un groupe fluorénylène, un groupe spiro-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphthacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phthalazinylène, un groupe naphthyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzoimidazolylène, un groupe benzofuranylène(benzofuranylène, un groupe benzothiophénylène, un groupe isobenzothiazolylène, un groupe benzoxazolylène, un groupe isobenzoxazolyle, un groupe triazolylène, un groupe tétrazolylène, un groupe oxadiazolylène, un groupe triazinylène, un groupe dibenzofuranylène, un groupe dibenzothiophénylène, un groupe benzocarbazolylène et un groupe dibenzocarbazolylène ; et
un groupe phénylène, un groupe pentalénylène, un groupe indénylène, un groupe naphthylène, un groupe azulénylène, un groupe heptalénylène, un groupe indacénylène, un groupe acénaphthylène, un groupe fluorénylène, un groupe spiro-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphthacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phthalazinylène, un groupe naphthyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, et un groupe dibenzocarbazolylène, chacun étant substitué par au moins un choisi parmi deutérium, -F, -Cl, -Br, -I, -CD₃, -CD₂H, -CDH₂, - CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe phényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorénylène, un groupe benzofluorénylène, un groupe dibenzofluorénylène, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, et un groupe dibenzocarbazolyle.

3. Dispositif électroluminescent organique selon la revendication 1 ou 2, dans lequel
Ar₁ à Ar₆ sont chacun indépendamment choisis parmi :
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe indolocarbazolyle, un groupe indolodibenzofuranyle, un groupe indolodibenzothiophényle, un groupe indolofluorényle, un groupe indolospiro-fluorényle, un groupe indolophénanthrényle, un groupe indolotriphénylényle, un groupe indoloazadibenzofuranyle, et un groupe indoloazadibenzothiophényle ; et
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe indolocarbazolyle, un groupe indolodibenzofuranyle, un groupe indolodibenzothiophényle, un groupe indolofluorényle, un groupe indolospiro-fluorényle, un groupe indolophénanthrényle, un groupe indolotriphénylényle, un groupe indoloazadibenzofuranyle, et un groupe indoloazadibenzothiophényle, chacun étant substitué par au moins un choisi parmi deutérium, -F, -Cl, -Br, -I, -CD₃, -CD₂H, -CDH₂, -CF₃, - CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe indolocarbazolyle, un groupe indolodibenzofuranyle, un groupe indolodibenzothiophényle,un groupe indolofluorényle, un groupe indolospiro-fluorényle, un groupe indolophénanthrényle, un groupe indolotriphénylényle, un groupe indoloazadibenzofuranyle et un groupe indoloazadibenzothiophényle.

4. Dispositif électroluminescent organique selon l'une quelconque des revendications 1-3, dans lequel
R₁ à R₃ sont chacun indépendamment choisis parmi :
hydrogène, deutérium, -F, -Cl, -Br, -I, un groupe cyano, un groupe alkyle en C₁-C₂₀, et un groupe alkoxy en C₁-C₂₀ ; et
un groupe alkyle en C₁-C₂₀ et un groupe alkoxy en C₁-C₂₀ alkoxy, chacun étant substitué par au moins un choisi parmi deutérium, -F, -Cl, -Br, -I, un groupe cyano, un groupe alkyle en C₁-C₂₀, et un groupe alkoxy en C₁-C₂₀.

5. Dispositif électroluminescent organique selon l'une quelconque des revendications 1-4, dans lequel
A₁, A₂, A₃, A₄, A₅ et A₆ sont chacun indépendamment choisis parmi un groupe benzène, un groupe naphthalène, un groupe anthracène, un groupe thiophène, un groupe furane, un groupe pyrrole, un groupe indole, un groupe indène, un groupe benzosilole, un groupe benzothiophène, un groupe benzofurane, un groupe carbazole, un groupe fluorène, un groupe dibenzosilole, un groupe dibenzothiophène, un groupe dibenzofurane, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrazole, un groupe imidazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole et un groupe benzothiadiazole.

6. Dispositif électroluminescent organique selon l'une quelconque des revendications 1-5, dans lequel
Ar₁₁, Ar₁₂ et Ar₁₄ à Ar₁₇ sont chacun indépendamment choisis parmi :
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, et un groupe représenté par la Formule a ; et
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, et un groupe représenté par la Formule A, chacun étant substitué par au moins un choisi parmi deutérium, -F, -Cl, -Br, -I, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle et - N(Q₁₁)(Q₁₂),
chacun de Ar₁₄ et Ar₁₅ n'est pas un groupe indolocarbazole, et chacun de Ar₁₆ et Ar₁₇ n'est pas un groupe naphthalène en même temps, et
Q₁₁ et Q₁₂ sont chacun indépendamment choisis parmi un groupe phényle, un groupe biphényle, un groupe terphényle, et un groupe naphthyle : 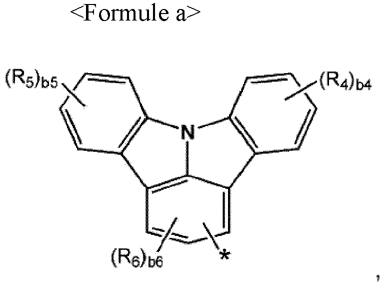
où, dans la Formule a,
R₄ à R₆ sont chacun indépendamment choisis parmi :
hydrogène, deutérium, -F, -Cl, -Br, -I, un groupe cyano, un groupe alkyle en C₁-C₂₀ et un groupe alkoxy en C₁-C₂₀ ; et
un groupe alkyle en C₁-C₂₀ et un groupe alkoxy en C₁-C₂₀ alkoxy, chacun étant substitué par au moins un choisi parmi deutérium, -F, -Cl, -Br, -I, un groupe cyano, un groupe alkyle en C₁-C₂₀, et un groupe alkoxy en C₁-C₂₀,
b4 est un nombre entier de 0 à 4,
b5 est un nombre entier de 0 à 4,
b6 est un nombre entier de 0 à 2,
« * » indique un site de liaison à un atome voisin.

7. Dispositif électroluminescent organique selon l'une quelconque des revendications 1-6, dans lequel
Ar₁₃ est choisi parmi :
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle et un groupe ovalényle ;
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, et un groupe ovalényle, chacun étant substitué par au moins un choisi parmi deutérium, -F, -Cl, -Br, -I, -CD₃, -CD₂H, -CDH₂, -CF₃, - CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle et un groupe ovalényle ; et/ou
dans lequel
R₁₁ à R₂₄ sont chacun indépendamment choisis parmi :
hydrogène, deutérium, -F, -Cl, -Br, -I, un groupe cyano, un groupe alkyle en C₁-C₂₀, et un groupe alkoxy en C₁-C₂₀ ;
un groupe alkyle en C₁-C₂₀ et un groupe alkoxy en C₁-C₂₀ alkoxy, chacun étant substitué par au moins un choisi parmi deutérium, -F, -Cl, -Br, -I, et un groupe cyano ;
un groupe phényle, un groupe biphényle, un groupe terphényle, un groupe fluorényle, un groupe spiro-fluorényle, un groupe benzofluorényle, un groupe dibenzofluorényle, un groupe pyridinyle, un groupe pyrazinyle, un groupe pyrimidinyle, un groupe pyridazinyle, un groupe carbazolyle, un groupe dibenzofuranyle, un groupe dibenzothiophényle, un groupe benzocarbazolyle et un groupe dibenzocarbazolyle ; et
un groupe phényle, un groupe biphényle, un groupe terphényle, un groupe fluorényle, un groupe spiro-fluorényle, un groupe benzofluorényle, un groupe dibenzofluorényle, un groupe pyridinyle, un groupe pyrazinyle, un groupe pyrimidinyle, un groupe pyridazinyle, un groupe carbazolyle, un groupe dibenzofuranyle, un groupe dibenzothiophényle, un groupe benzocarbazolyle, et un groupe dibenzocarbazolyle, chacun étant substitué par au moins un choisi parmi un groupe alkyle en C₁-C₂₀, un groupe alkoxy en C₁-C₂₀, un groupe phényle, un groupe biphényle, un groupe terphényle, un groupe fluorényle, un groupe spiro-fluorényle, un groupe benzofluorényle, un groupe dibenzofluorényle, un groupe pyridinyle, un groupe pyrazinyle, un groupe pyrimidinyle, un groupe pyridazinyle, un groupe carbazolyle, un groupe dibenzofuranyle, un groupe dibenzothiophényle, un groupe benzocarbazolyl, et un groupe dibenzocarbazolyle chacun étant substitué par au moins une choisi parmi deutérium, -F, -Cl, -Br, -I et un groupe cyano.

8. Dispositif électroluminescent organique selon l'une quelconque des revendications 1-7, dans lequel
le troisième composé comprend au moins un composé représenté par une des Formules 3-1 à 3-4 ci-dessous : 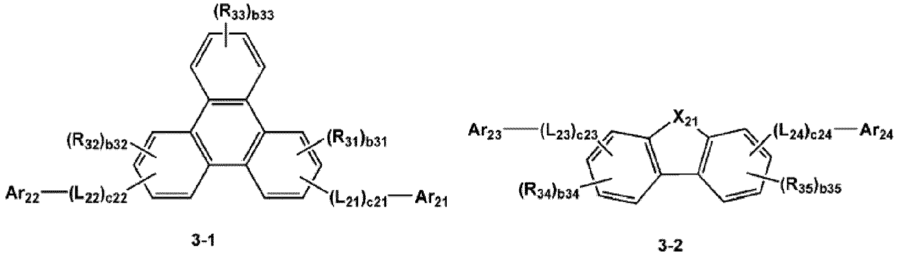 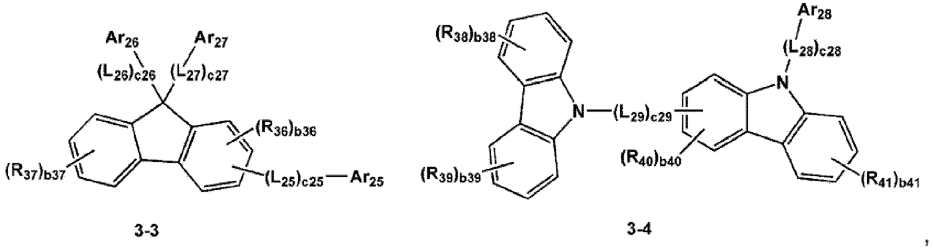
où, dans les Formules 3-1 à 3-4,
X₂₁ est O ou S,
L₂₁ à L₂₉ sont chacun indépendamment choisis parmi une liaison simple, un groupe arylène en C₆-C₃₀ substitué ou non substitué, un groupe hétéroarylène en C₁-C₃₀ substitué ou non substitué, un groupe polycyclique condensé non aromatique divalent et un groupe hétéropolycyclique condensé non aromatique divalent,
c21 à c29 sont chacun indépendamment un nombre entier de 1 à 3,
Ar₂₁ à Ar₂₈ sont chacun indépendamment choisis parmi hydrogène, un groupe aryle en C₆-C₃₀ substitué ou non substitué, un groupe hétéroaryle en C₁-C₃₀ substitué ou non substitué, un groupe polycyclique condensé non aromatique monovalent substitué ou non substitué et un groupe hétéropolycyclique condensé non aromatique monovalent substitué ou non substitué,
chacun de Ar₂₁ et Ar₂₂ n'est pas hydrogène en même temps,
Ar₂₆ et Ar₂₇ sont éventuellement liés l'un à l'autre par l'intermédiaire d'une liaison simple pour former un cycle condensé,
R₃₁ à R₄₁ sont chacun indépendamment choisis parmi hydrogène, deutérium, -F, -Cl, -Br, -I, un groupe cyano, un groupe alkyle en C₁-C₆₀ substitué ou non substitué, un groupe alkényle en C₂-C₆₀ substitué ou non substitué, un groupe alkynyle en C₂-C₆₀ substitué ou non substitué et un groupe alkoxy en C₁-C₆₀ substitué ou non substitué,
b31, b32, b34, b35, b36 et b40 sont chacun indépendamment un nombre entier de 0 à 3, et b33, b37, b38, b39 et b41 sont chacun indépendamment un nombre entier de 0 à 4 ;
de préférence où
Ar₂₁ à Ar₂₈ sont chacun indépendamment choisis parmi :
hydrogène, un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle et un groupe ovalényle ;
un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, et un groupe ovalényle, chacun étant substitué par au moins un choisi parmi deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe phényle, un groupe biphényle, un groupe terphényle, un groupe quaterphényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, et un groupe ovalényle.

9. Dispositif électroluminescent organique selon l'une quelconque des revendications 1-8, dans lequel
La Formule 1-1 est représentée par la Formule 1-1(1),
La Formule 1-2 est représentée par la Formule 1-2(1),
La Formule 1-4 est représentée par une des Formules 1-4(1), 1-4(2) et 1-4(3) : 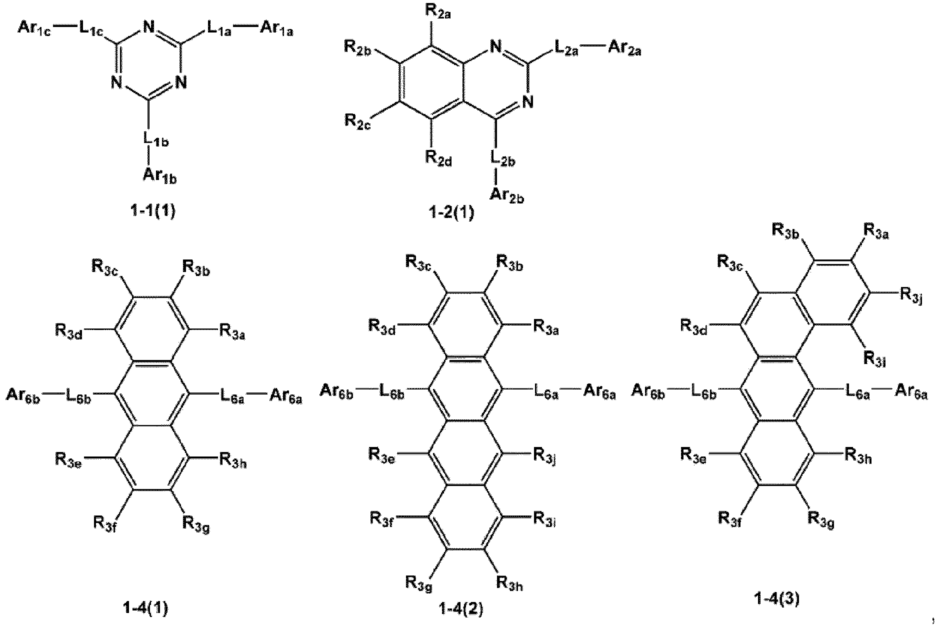
où dans la Formule 1-1(1), L₁ₐ, L_{1b} et L_{1c} sont compris en se référant à la description présentée en relation avec L₁ selon la revendication 1, et Ar₁ₐ, Ar_{1b}, et Ar_{1c} sont compris en se référant à la description présentée en relation avec Ar₁ selon la revendication 1, et
dans la Formule 1-2(1), L₂ₐ et L_{2b} sont compris en se référant à la description présentée en relation avec L₂ selon la revendication 1, Ar₂ₐ et Ar_{2b} sont compris en se référant à la description présentée en relation avec Ar₂ selon la revendication 1, et R₂ₐ, R_{2b}, R_{2c} et R_{2d} sont compris en se référant à la description présentée en relation avec R₂ selon la revendication 1,
dans la Formule 1-4(1) à 1-4(3), L₆ₐ et L_{6b} sont compris en se référant à la description présentée en relation avec L₆ selon la revendication 1, Ar₆ₐ et Ar_{6b} sont compris en se référant à la description présentée en relation avec Ar₆ selon la revendication 1 et à R₃ⱼ sont compris en se référant à la description présentée en relation avec R₃ selon la revendication 1.

10. Dispositif électroluminescent organique selon l'une quelconque des revendications 1-9, dans lequel
le premier composé comprend au moins un des composés suivants :

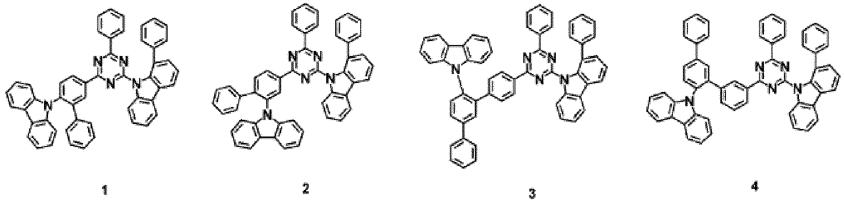

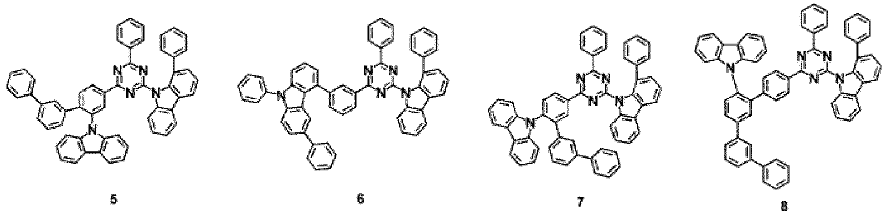

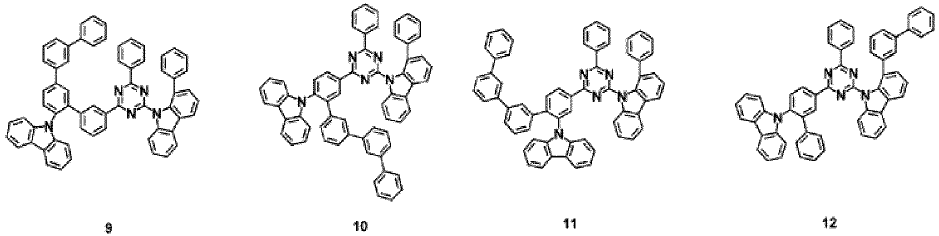

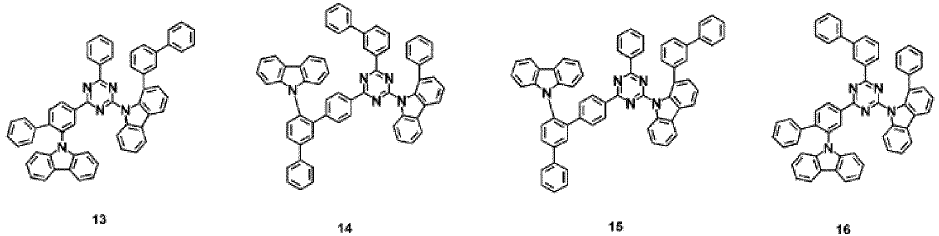

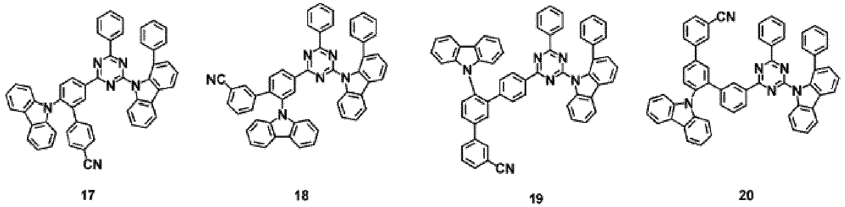

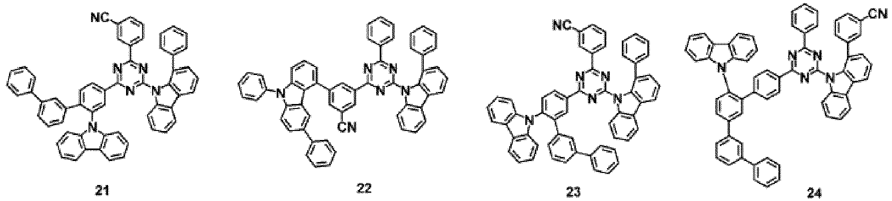

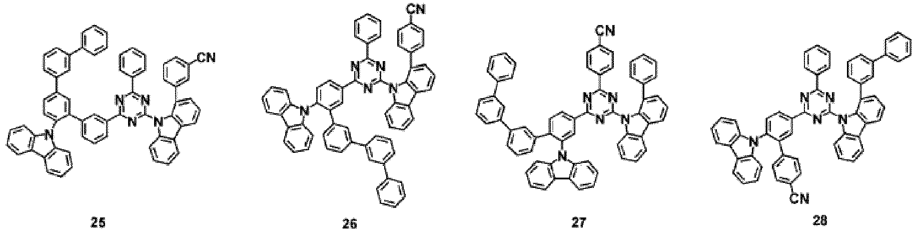

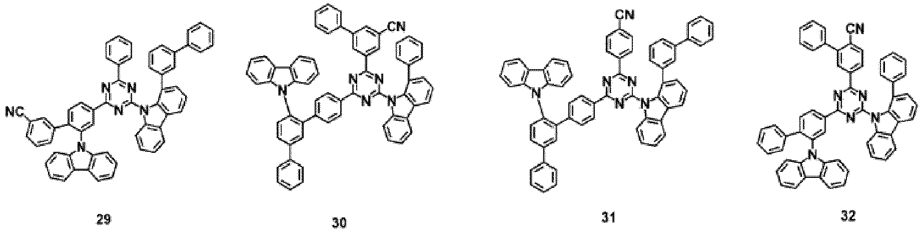

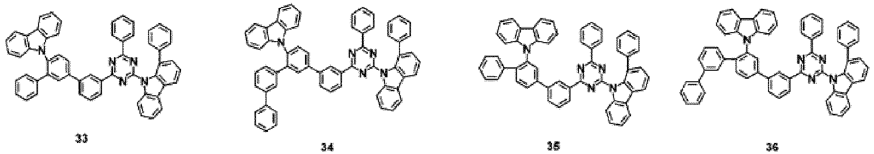

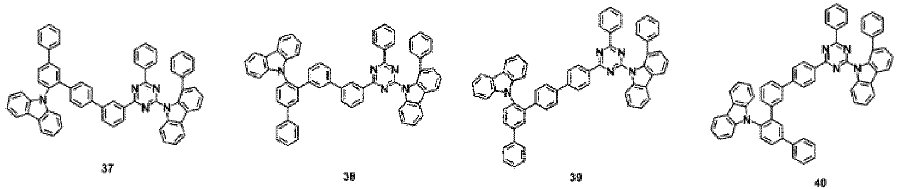

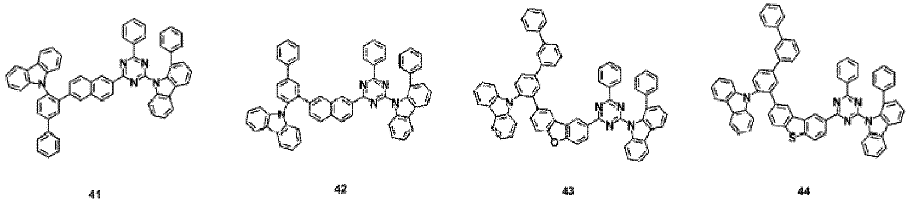

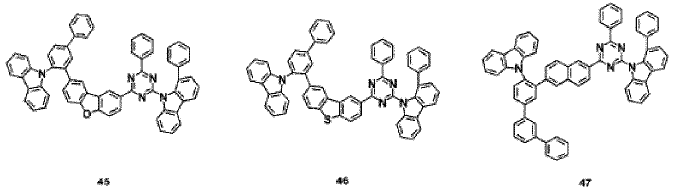

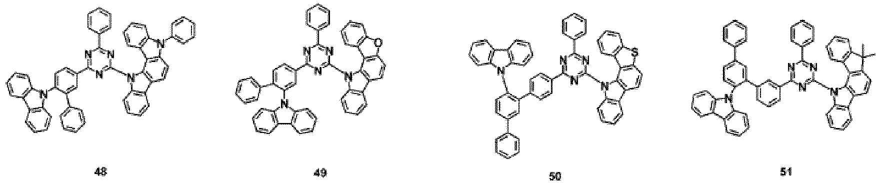

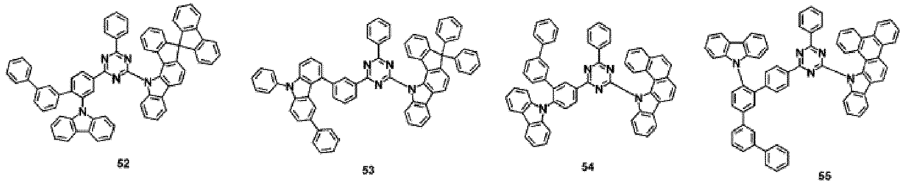

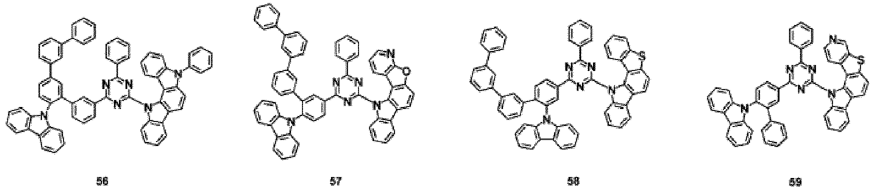

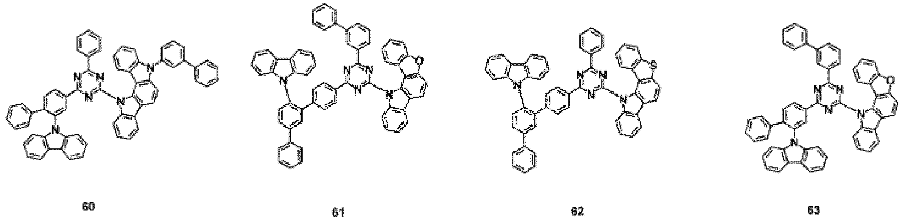

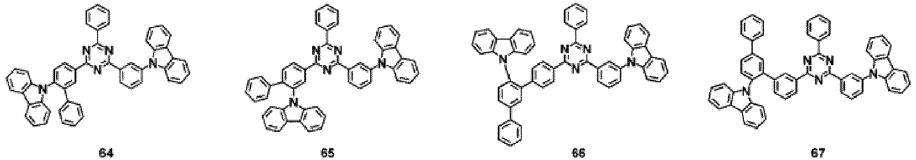

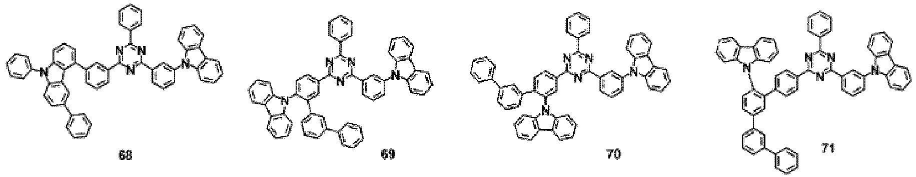

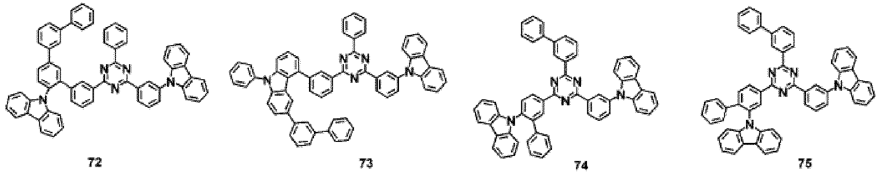

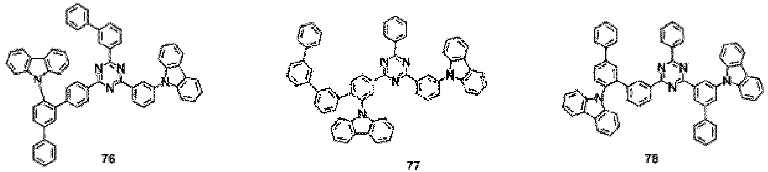

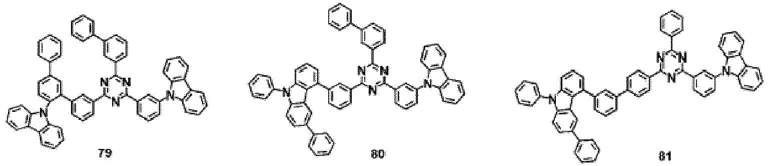

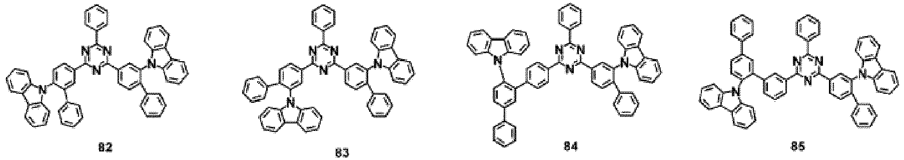

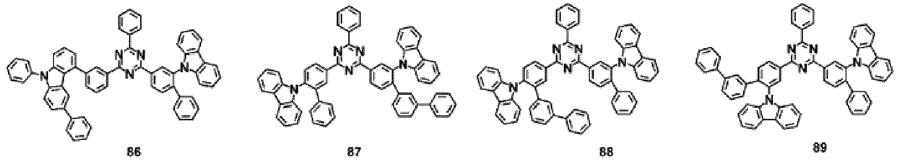

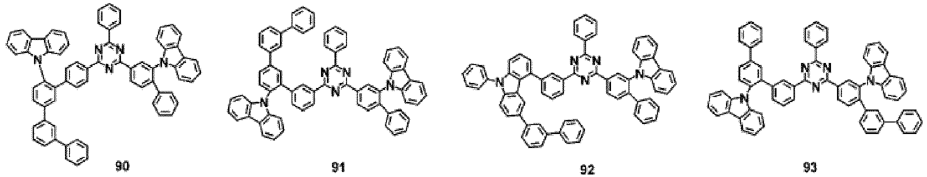

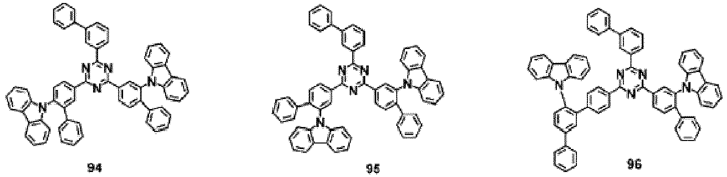

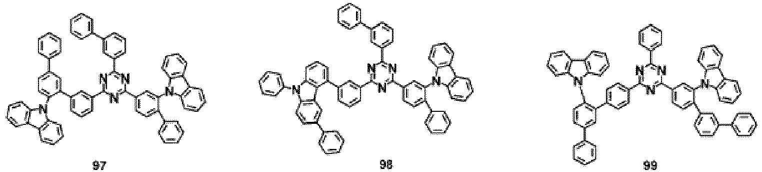

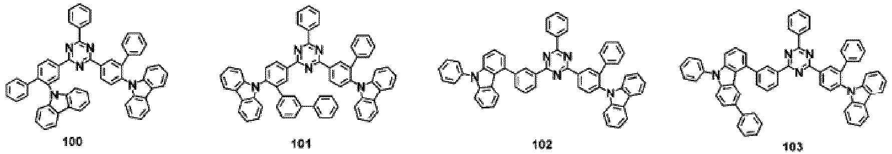

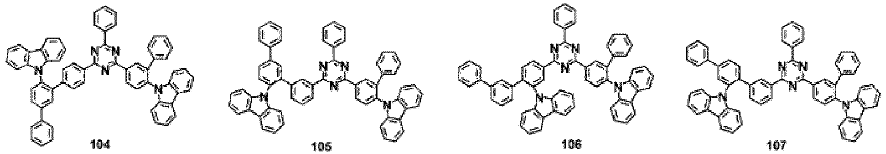

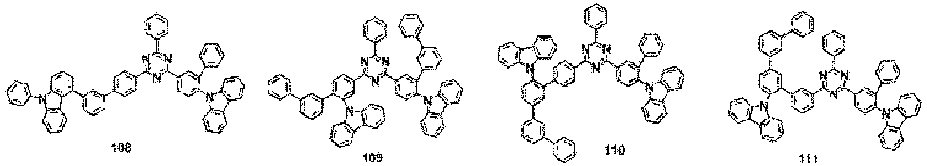

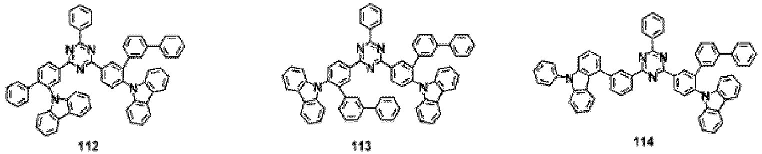

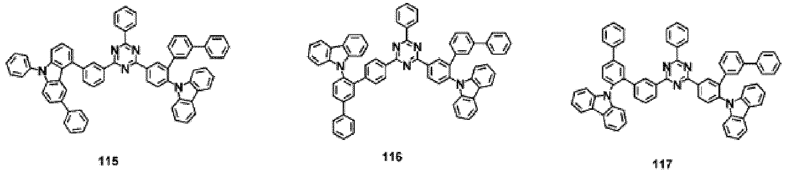

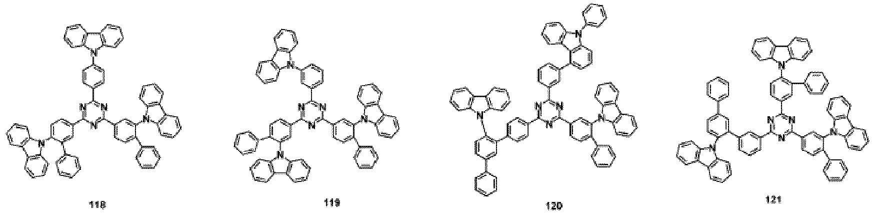

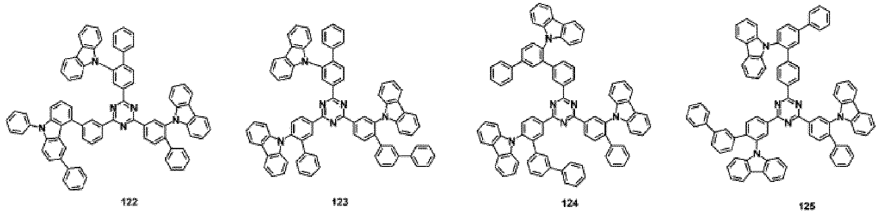

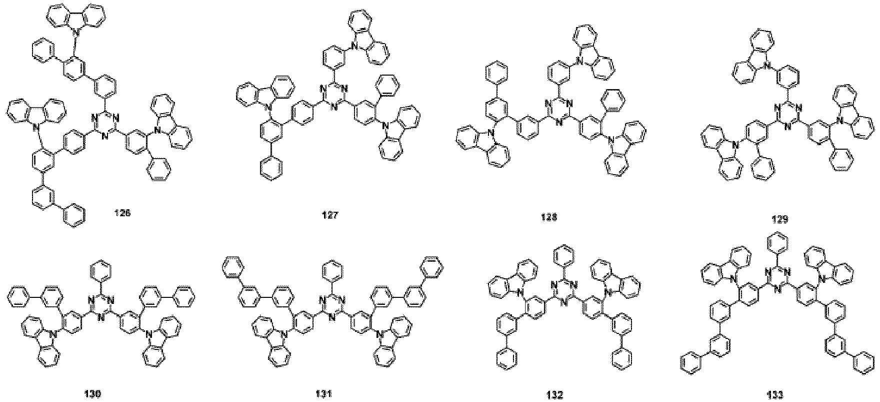

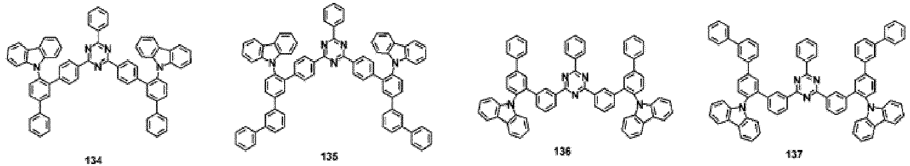

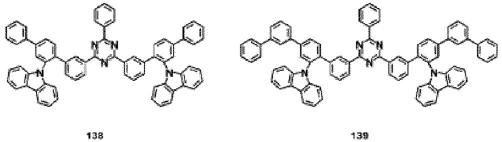

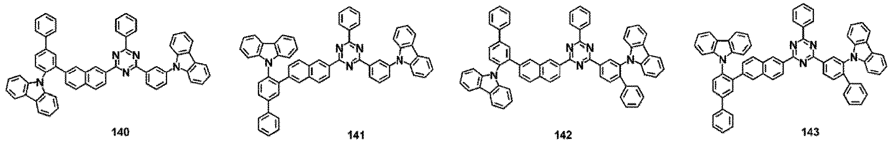

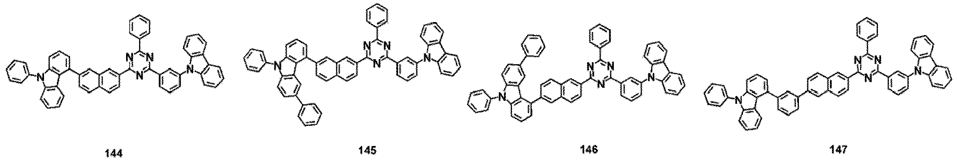

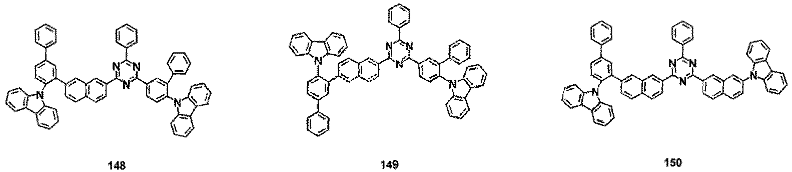

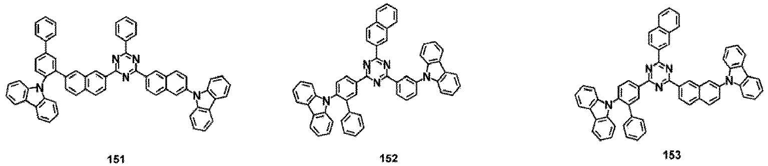

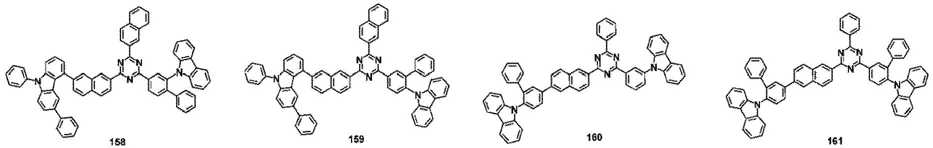

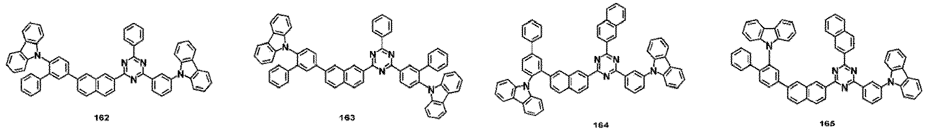

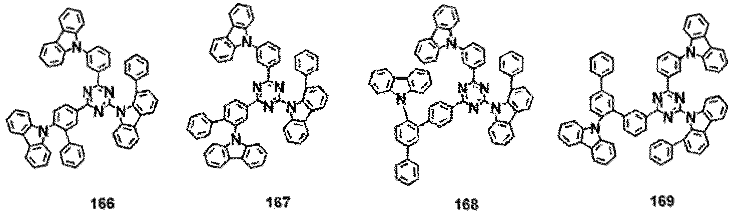

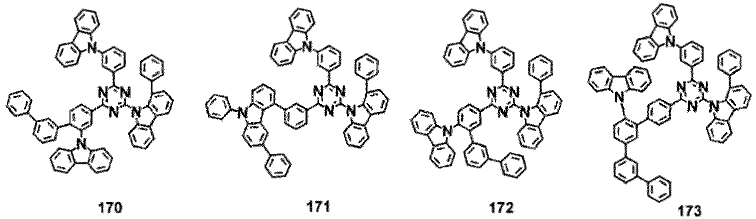

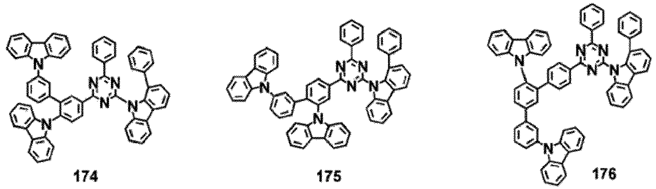

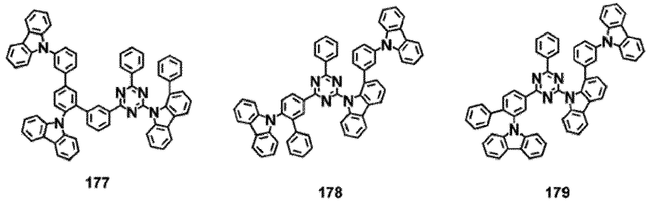

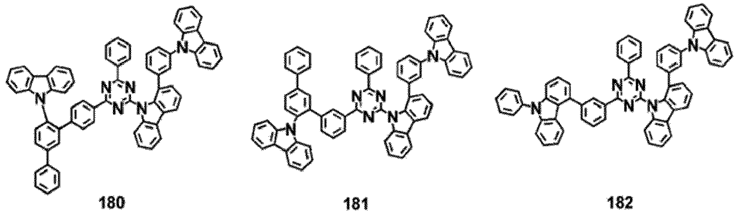

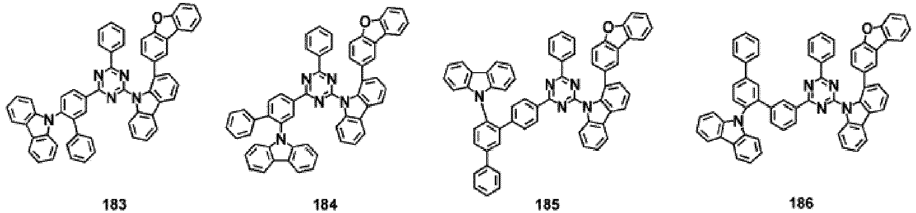

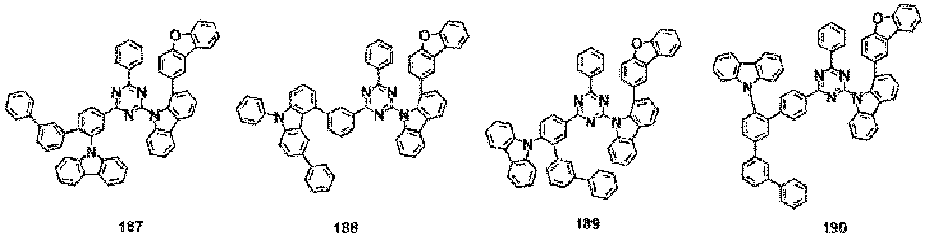

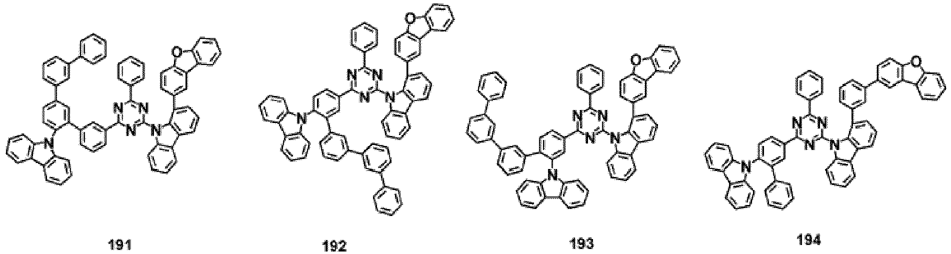

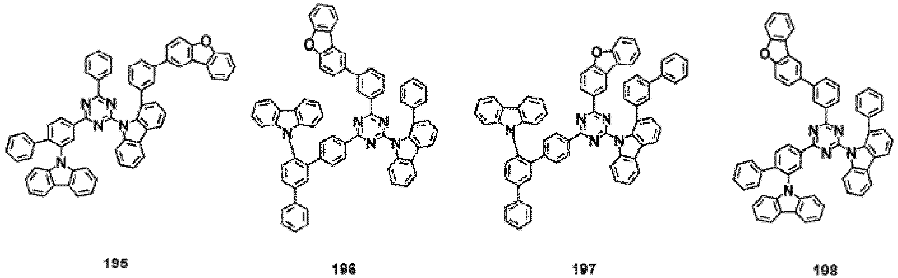

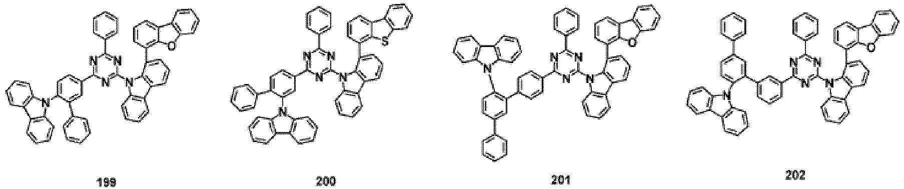

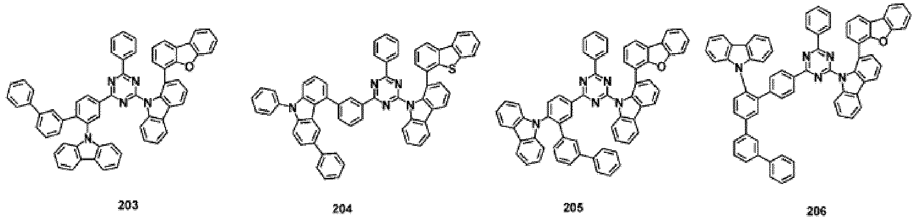

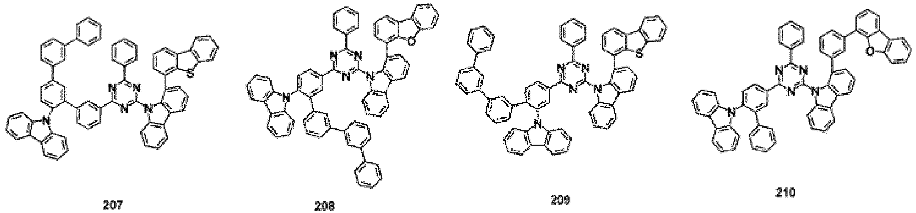

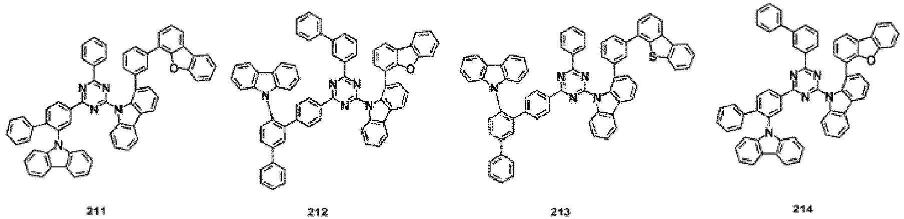

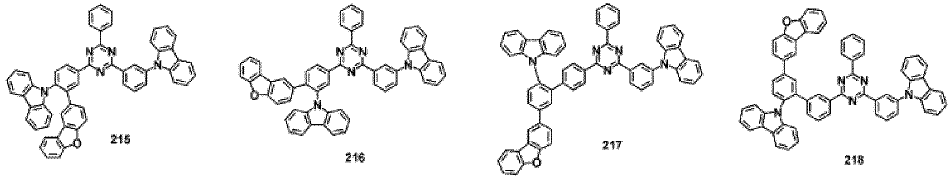

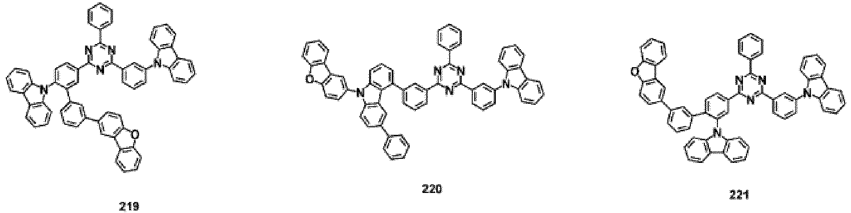

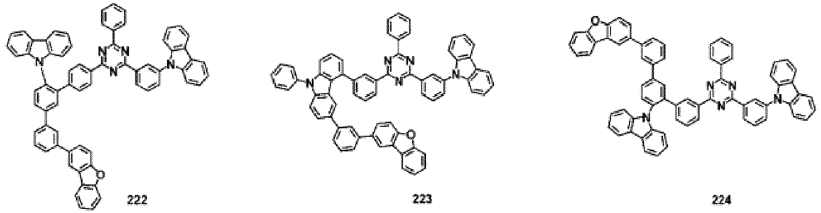

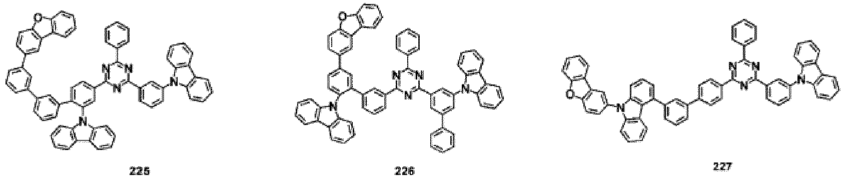

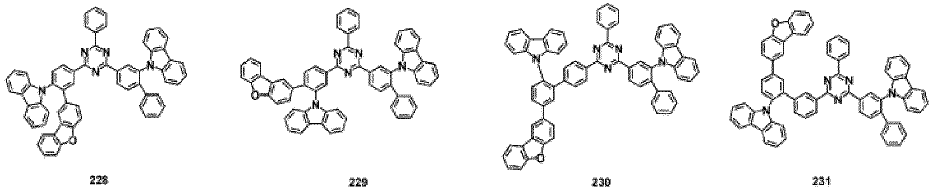

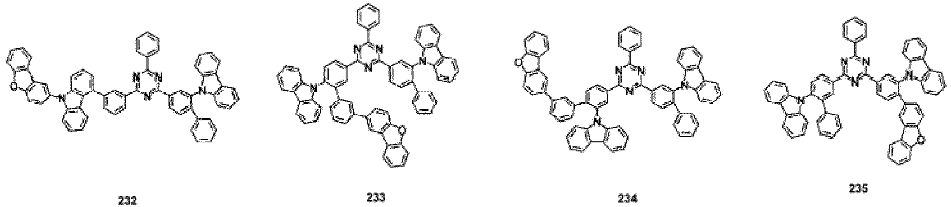

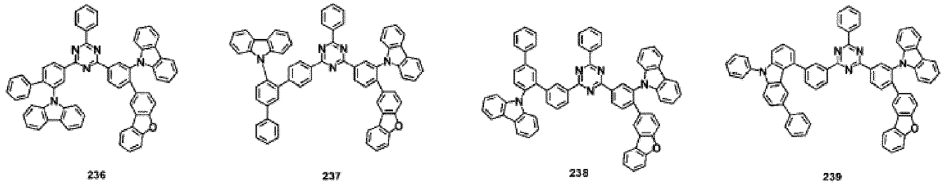

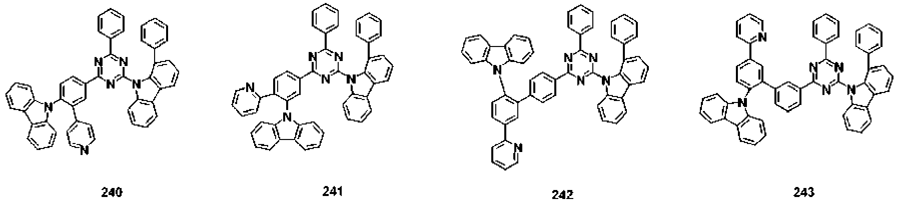

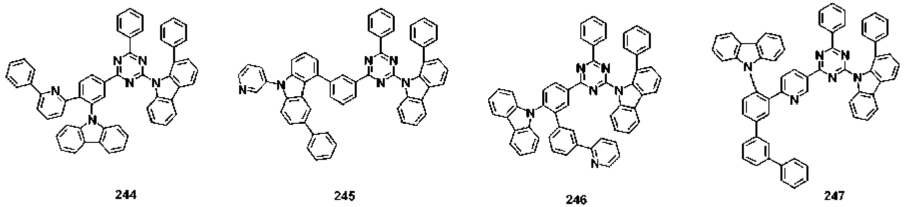

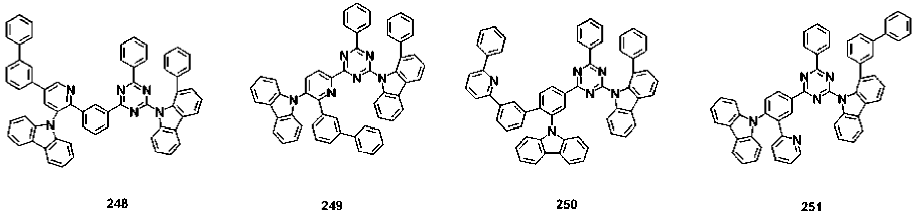

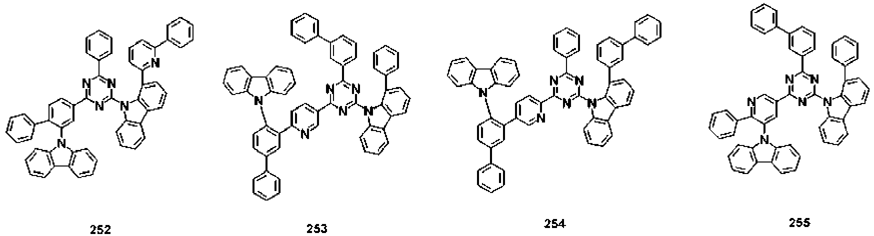

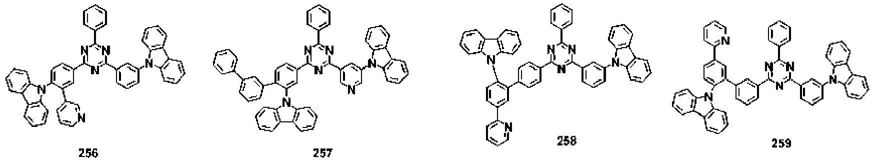

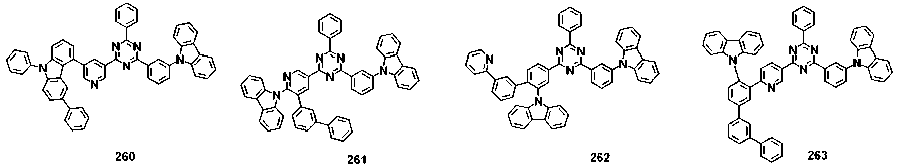

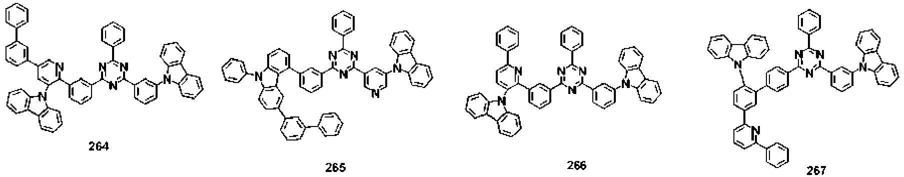

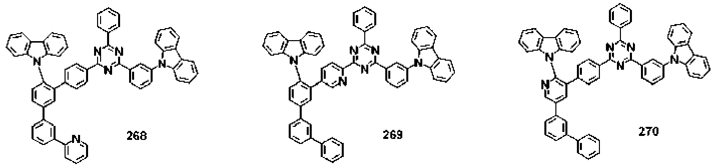

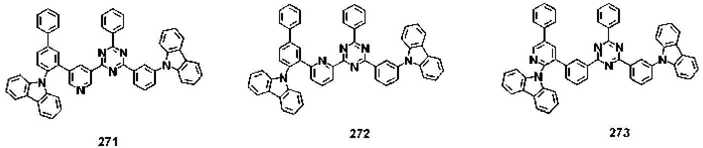

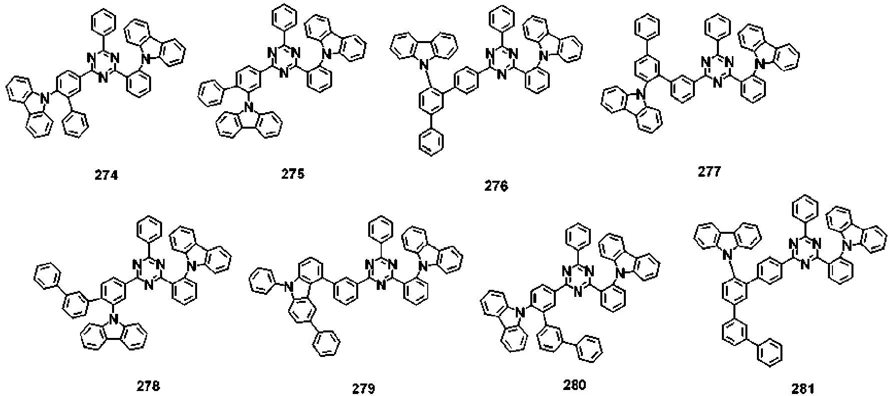

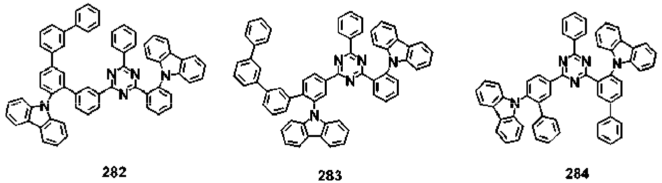

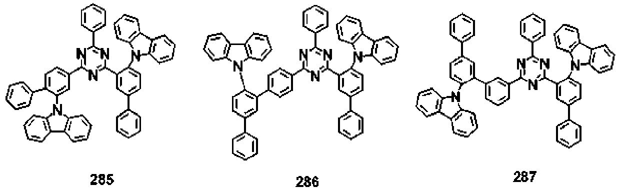

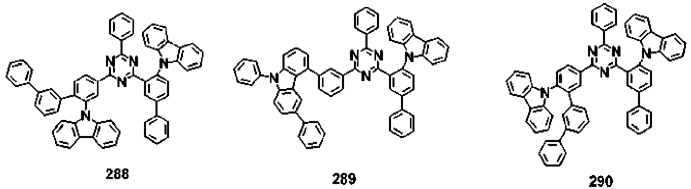

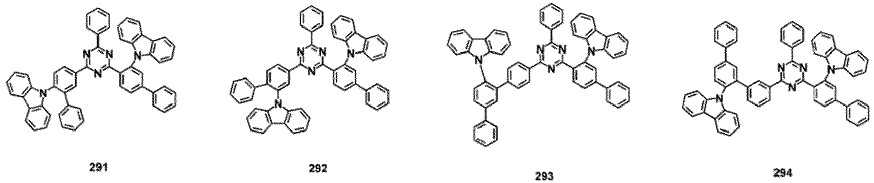

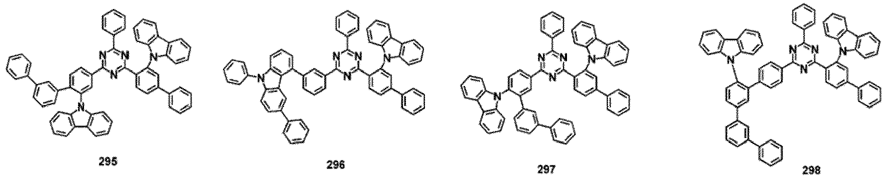

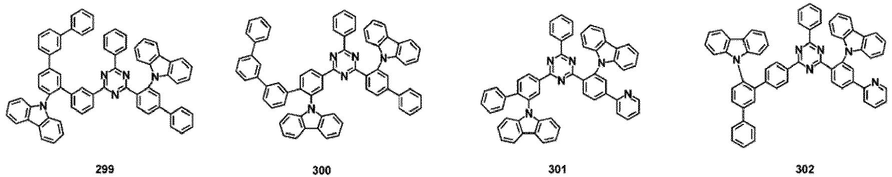

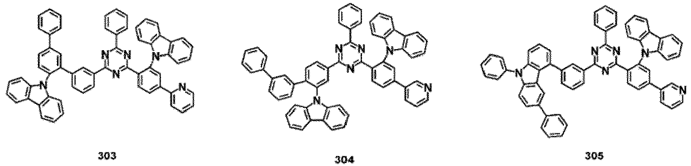

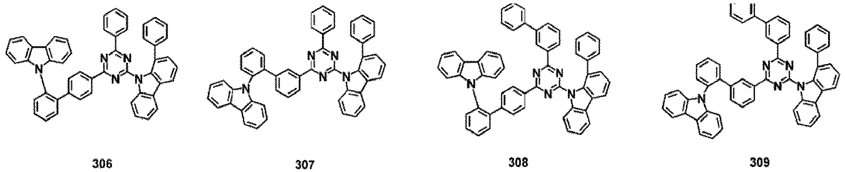

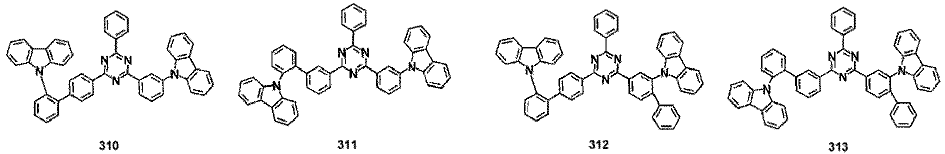

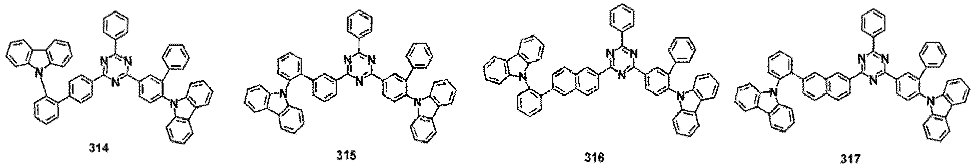

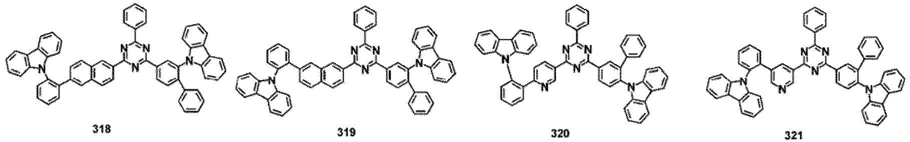

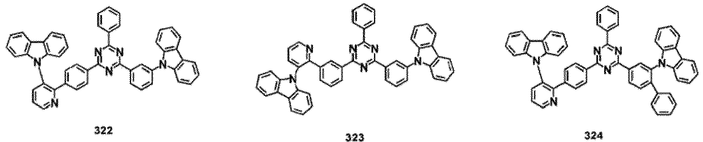

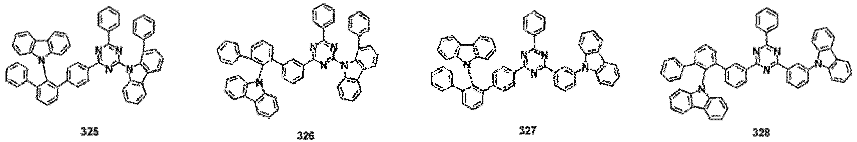

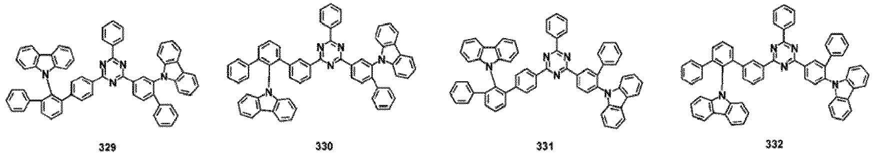

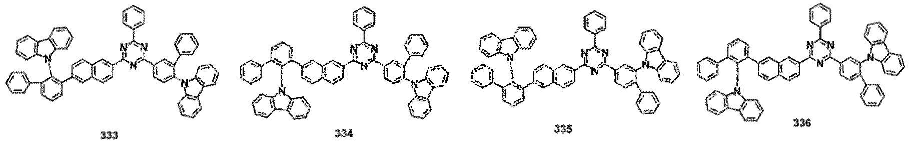

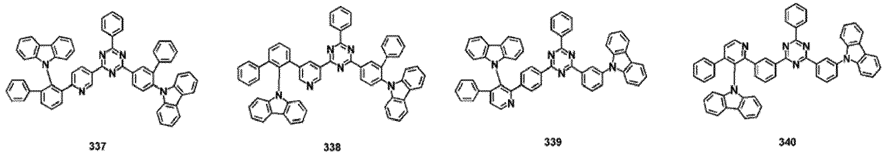

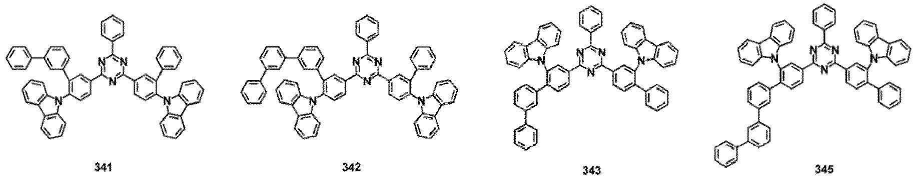

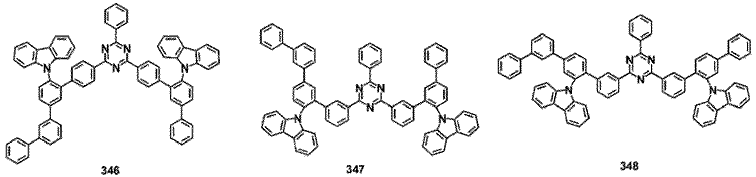

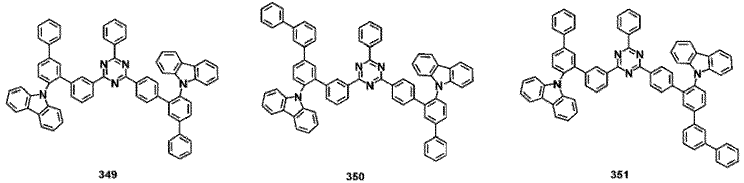

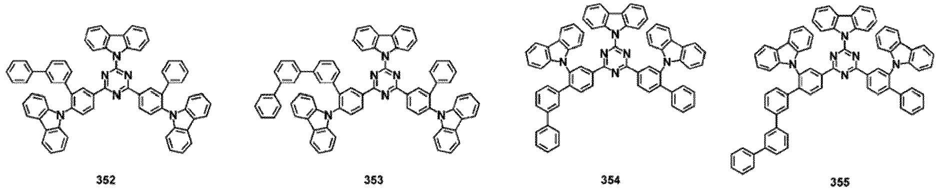

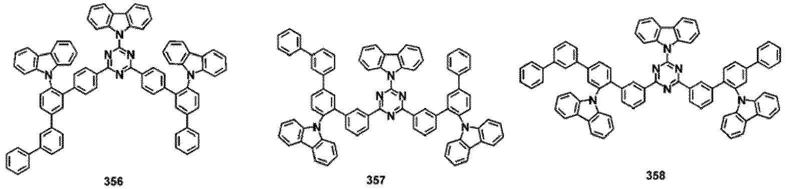

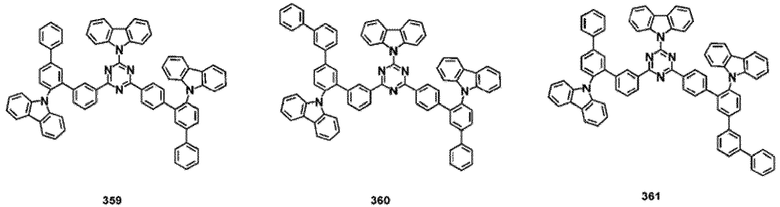

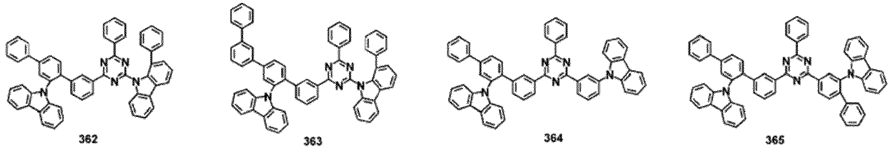

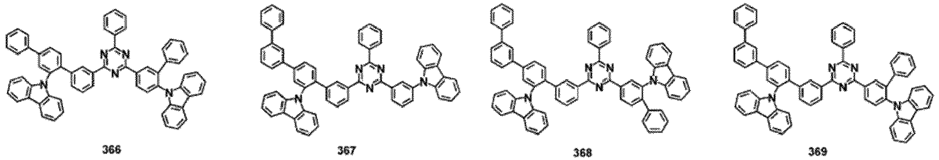

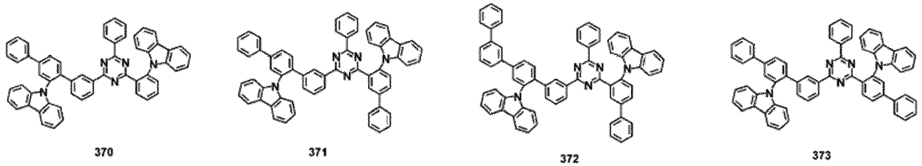

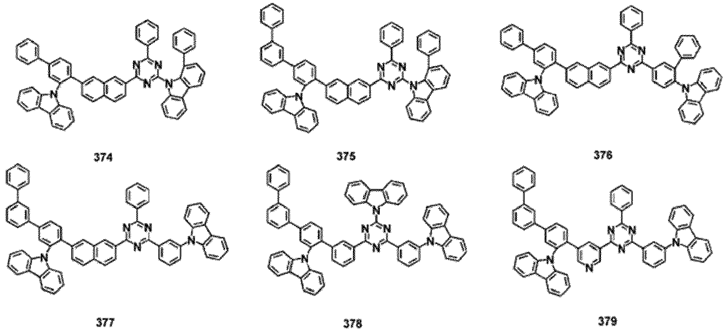

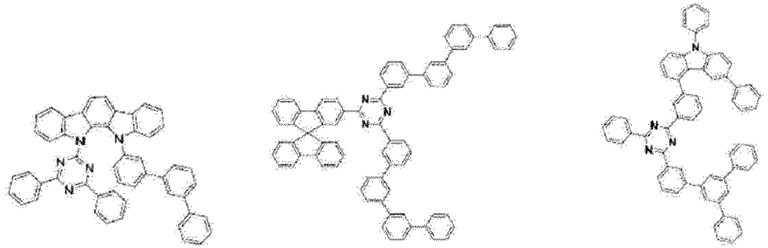

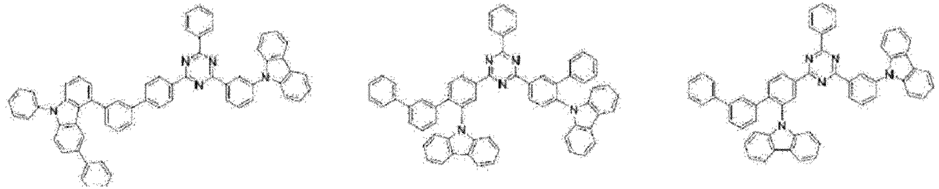

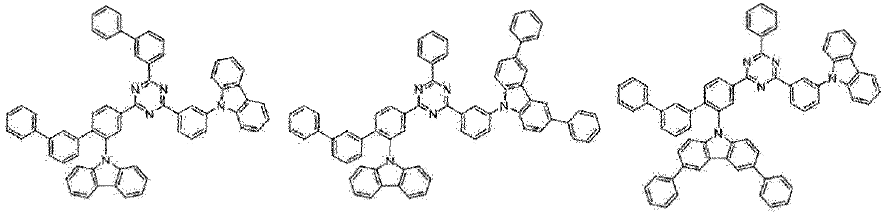

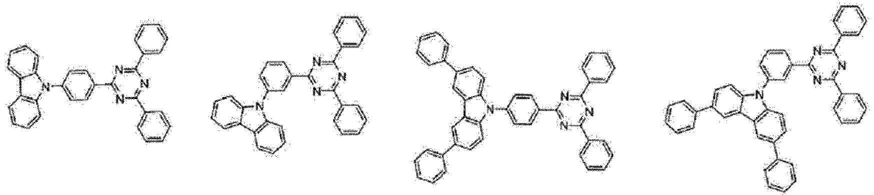

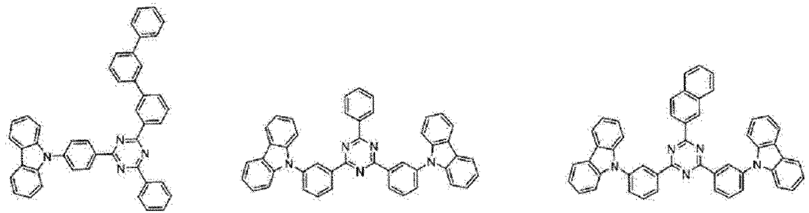

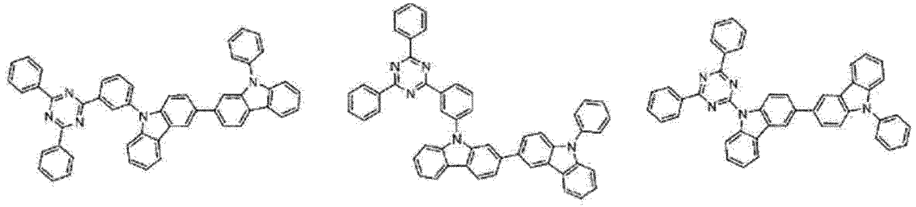

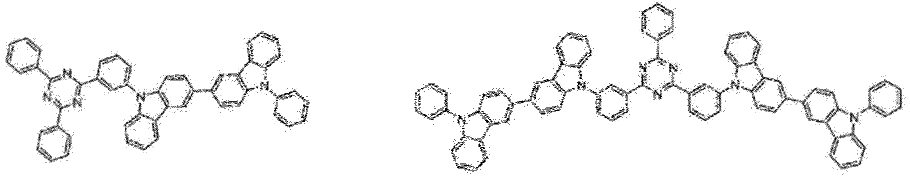

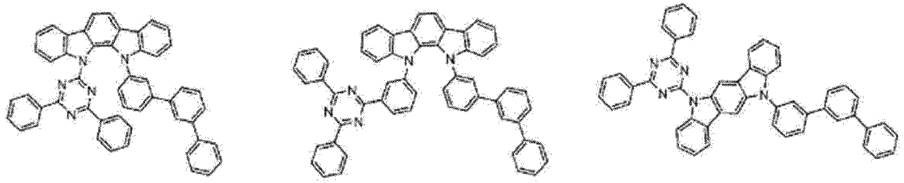

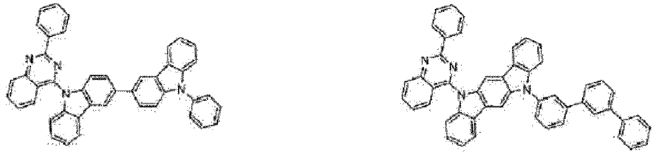

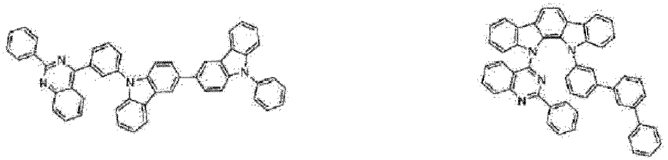

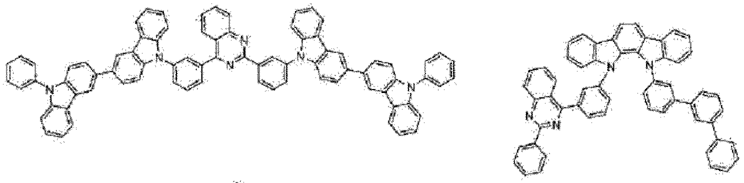

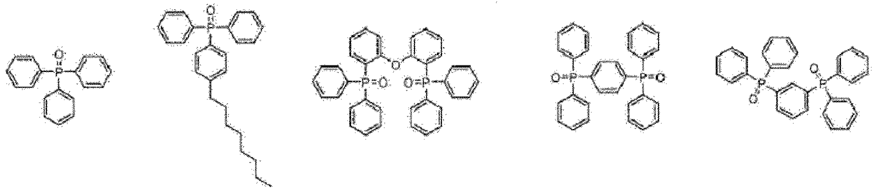

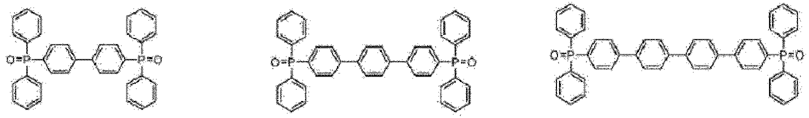

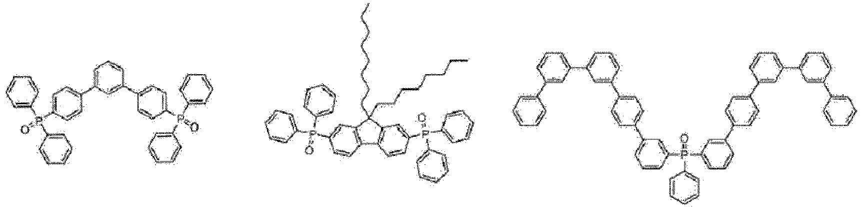

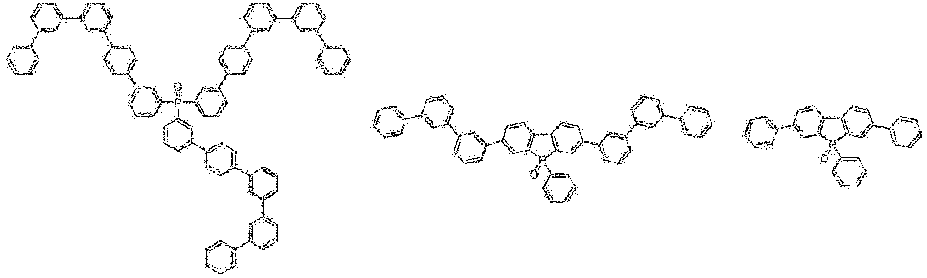

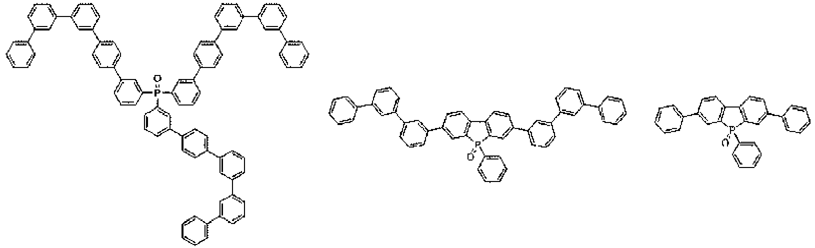

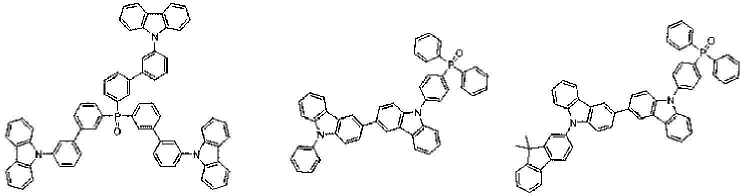

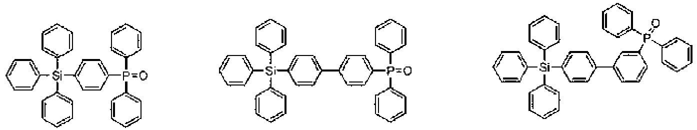

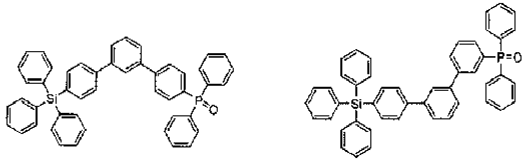

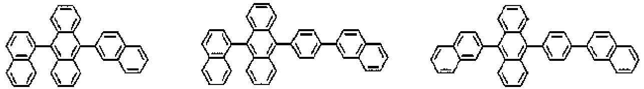

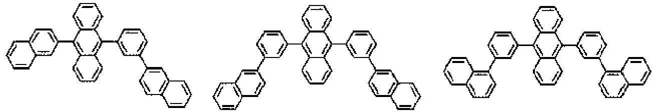

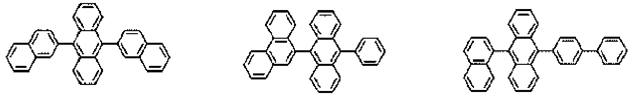

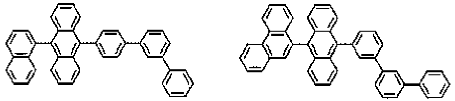

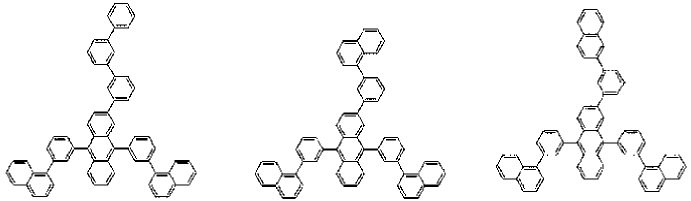

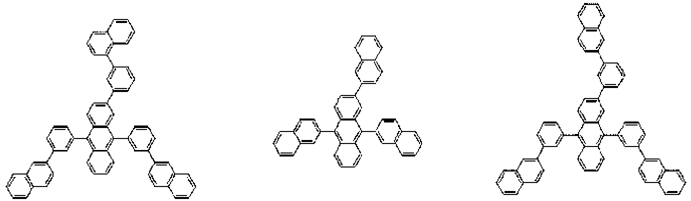

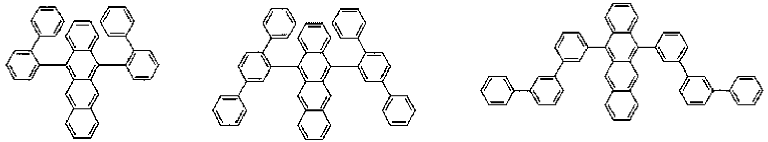

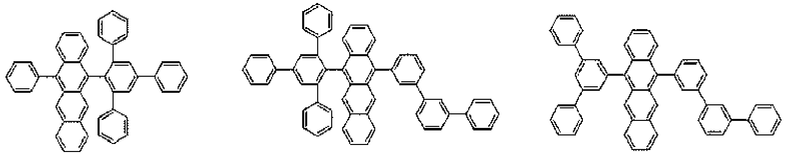

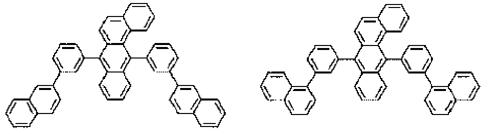

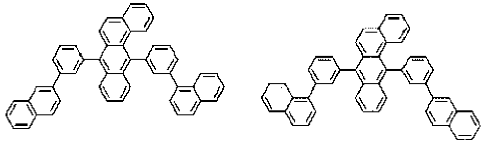

11. Dispositif électroluminescent organique selon l'une quelconque des revendications 1-10, dans lequel
La Formule 2-1 est représentée par la Formule 2-1(1),
La Formule 2-2 est représentée par la Formule 2-2(1),
La Formule 2-3 est représentée par une des Formules 2-3(1) à 2-3(3),
La Formule 2-4 est représentée par une des Formules 2-4(1) à 2-4(3) : 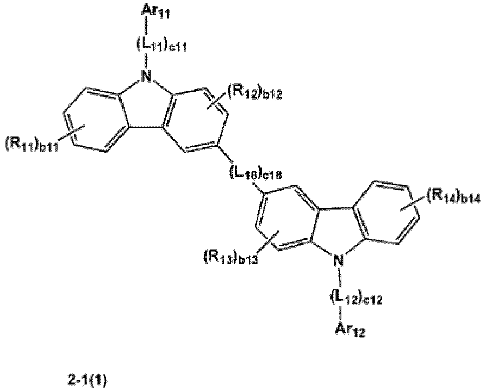 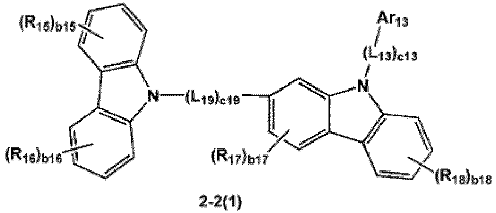 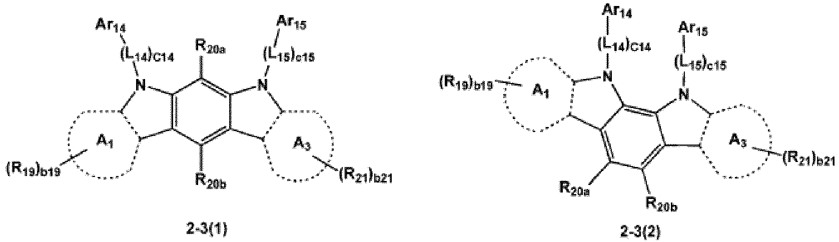 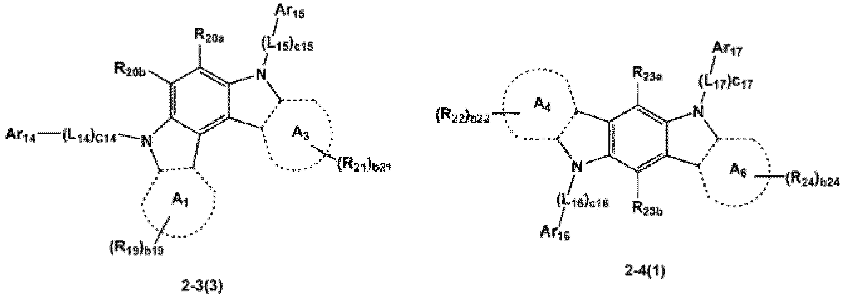 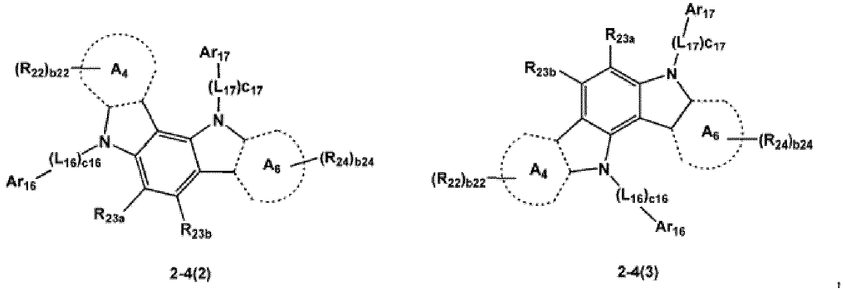
où, dans les Formules 2-3(1) à 2-3(3), R₂₀ₐ et R_{20b} sont compris en se référant à la description présentée en relation avec R₂₀ selon la revendication 1, et
dans les Formules 2-4(1) à 2-4(3), R₂₃ₐ et R_{23b} R_{20b} sont compris en se référant à la description présentée en relation avec R₂₃ selon la revendication 1.

12. Dispositif électroluminescent organique selon l'une quelconque des revendications 1-11, dans lequel le deuxième composé comprend au moins un des composés suivants : 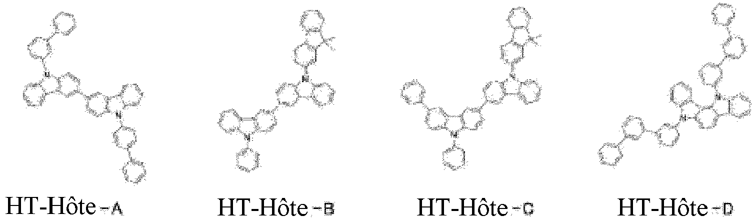 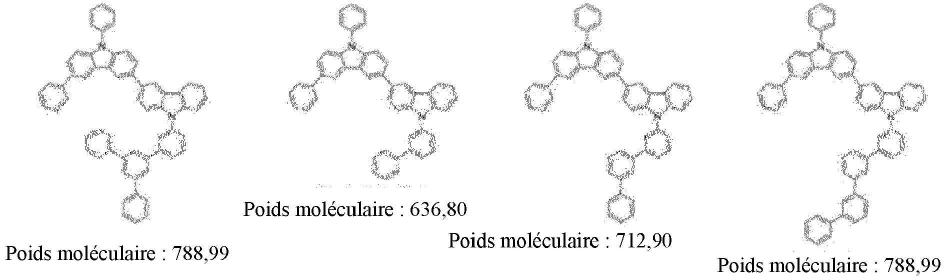 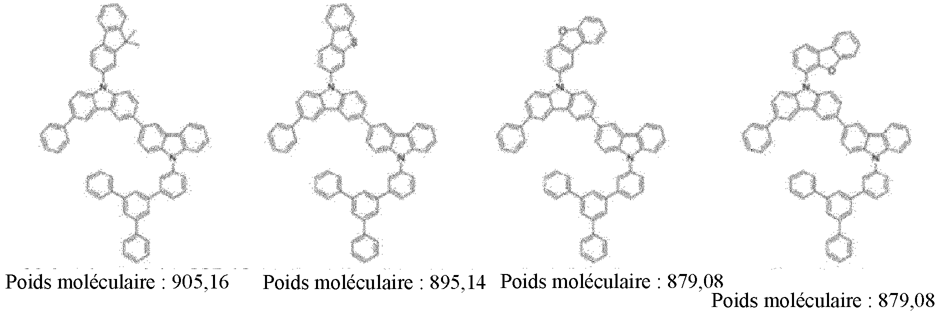 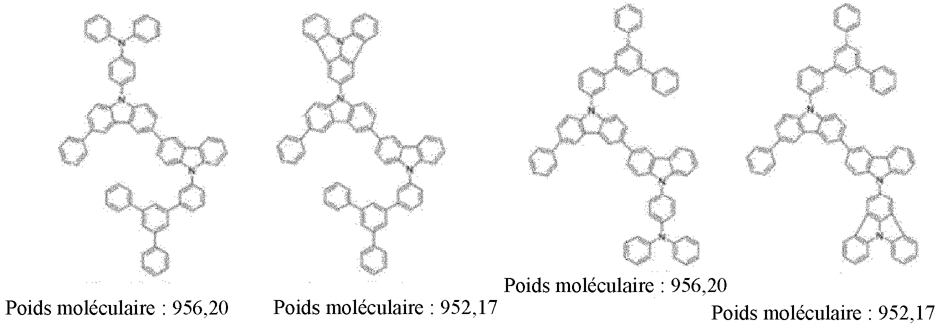 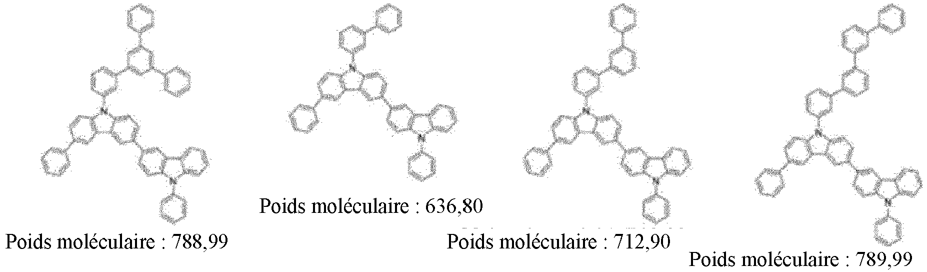 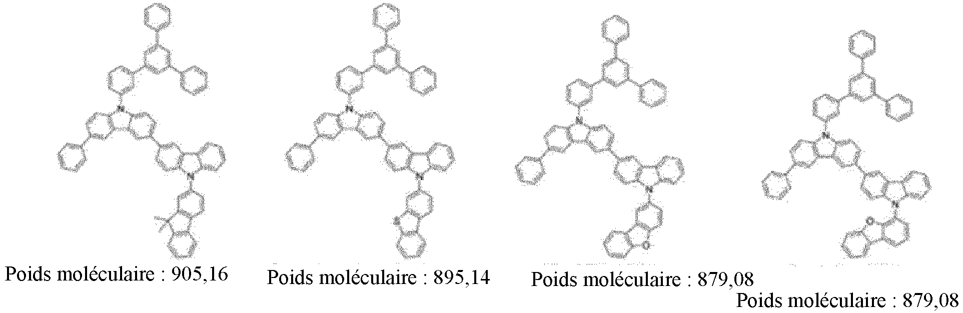 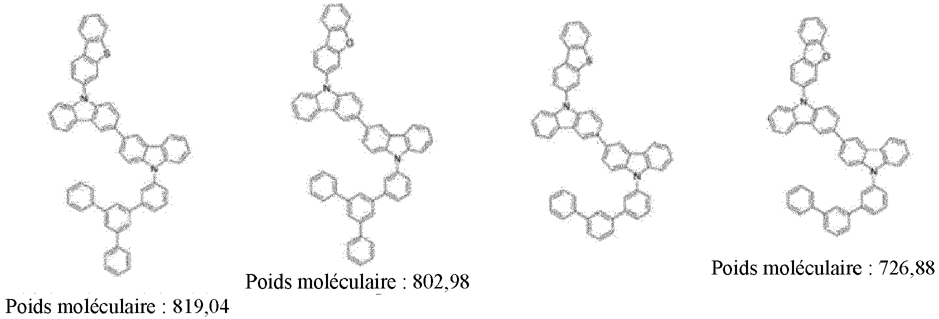 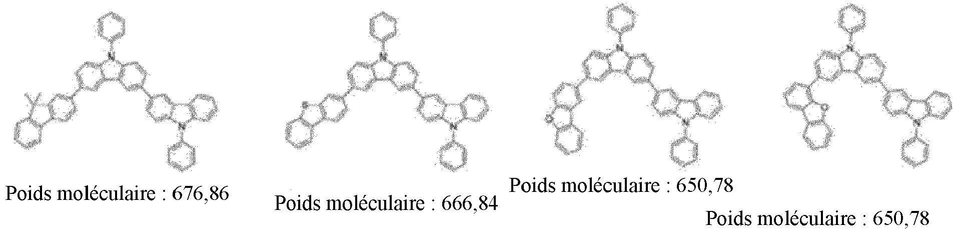 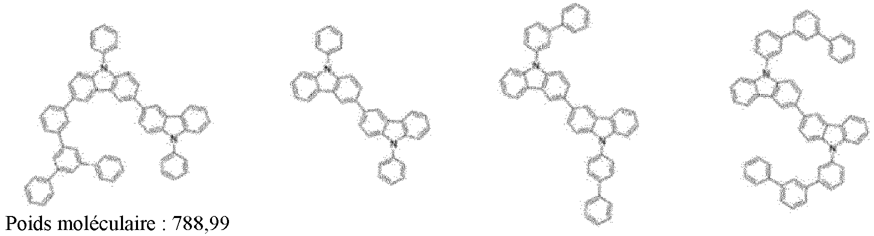 ; et/ou
dans lequel
le troisième composé comprend au moins un des composés suivants :

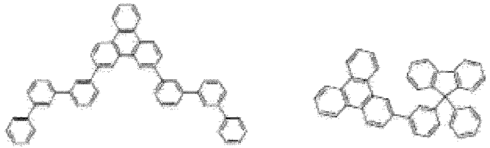

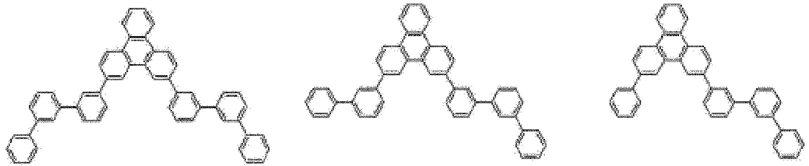

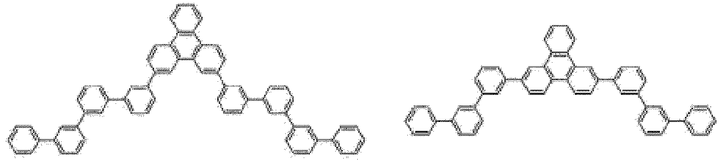

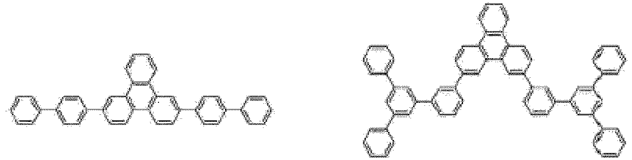

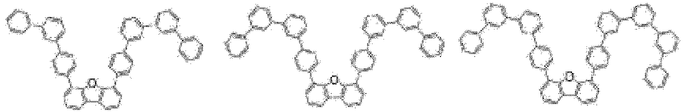

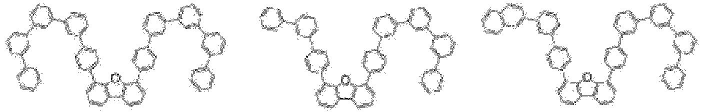

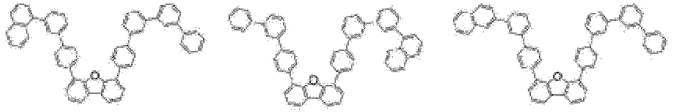

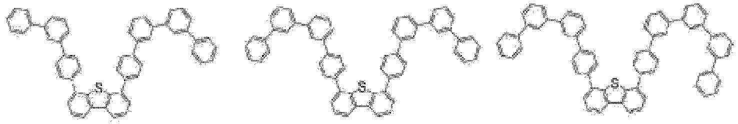

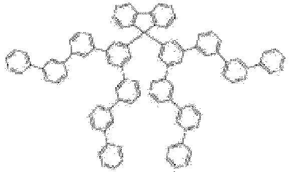

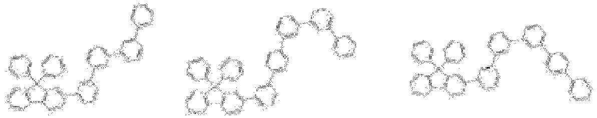

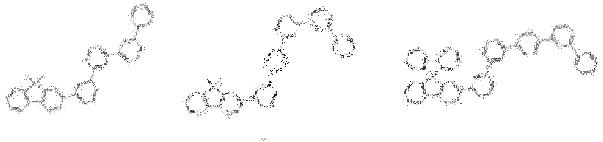

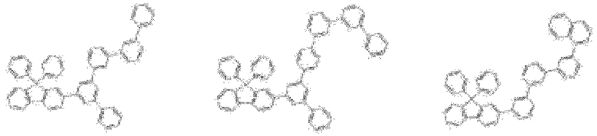

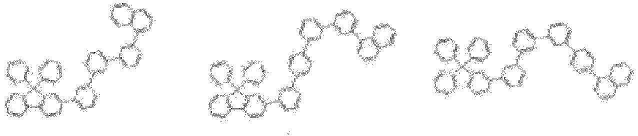

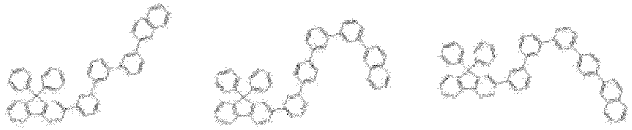

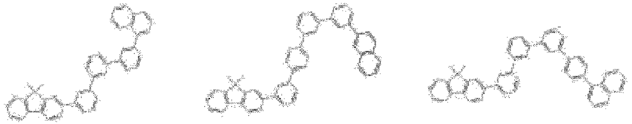

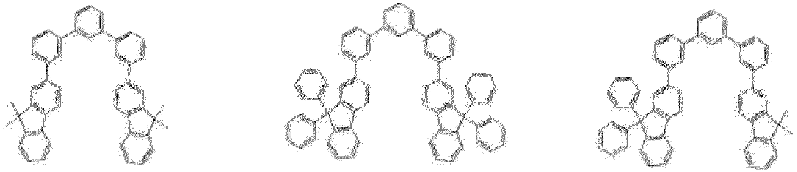

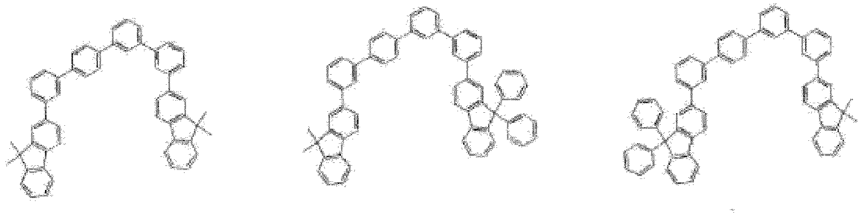

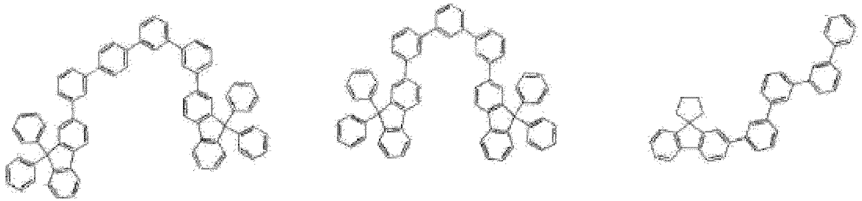

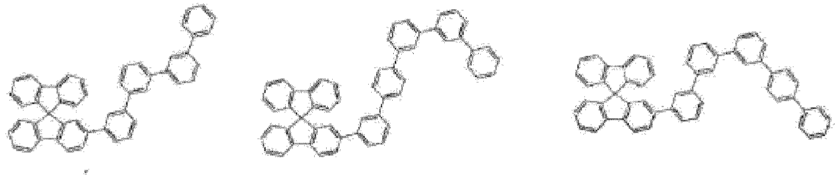

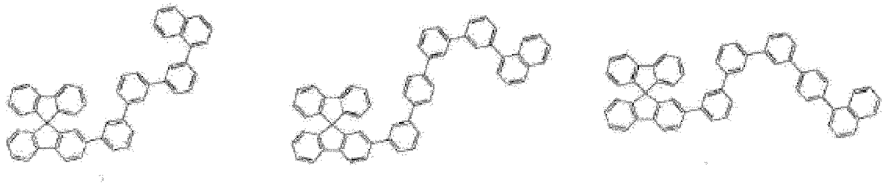

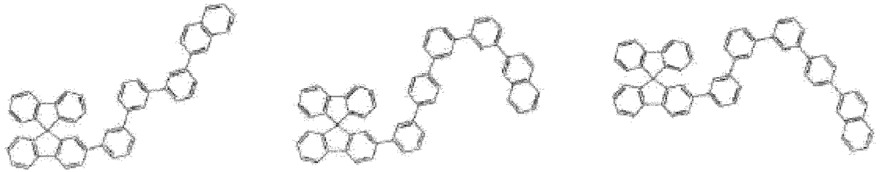

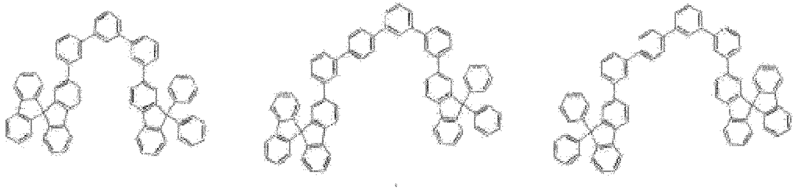

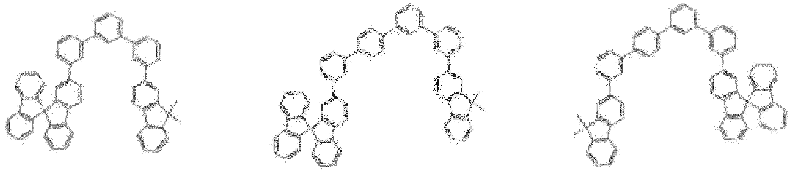

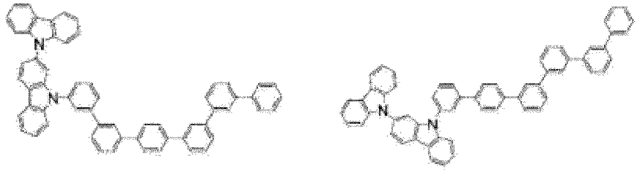

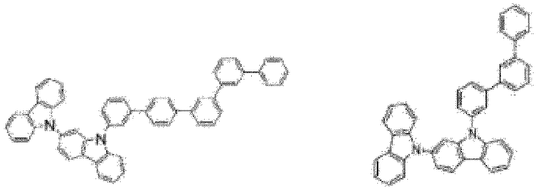

13. Dispositif électroluminescent organique selon l'une quelconque des revendications 1-12, dans lequel
le premier composé comprend au moins un composé représenté par la Formule 1-1 ou 1-4,
le deuxième composé comprend au moins un composé représenté par la Formule 2-1 ou 2-4, et
le troisième composé comprend au moins un composé représenté par la Formule 3-2 : 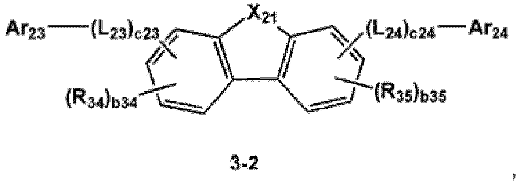
où, dans la Formule 3-2,
X₂₁ est O ou S,
L₂₃ à L₂₄ sont chacun indépendamment choisis dans un groupe arylène en C₆-C₃₀ substitué ou non substitué,
c23 et c24 sont chacun indépendamment 1, 2 ou 3,
Ar₂₃ et Ar₂₄ sont chacun indépendamment choisis parmi hydrogène et un groupe aryle en C₆-C₃₀ substitué ou non substitué,
R₃₄ et R₃₅ sont chacun indépendamment choisis parmi hydrogène, deutérium, -F, -Cl, -Br, -I, un groupe cyano, un groupe alkyle en C₁-C₆₀ substitué ou non substitué, un groupe alkényle en C₂-C₆₀ substitué ou non substitué, un groupe alkynyle en C₂-C₆₀ substitué ou non substitué et un groupe alkoxy en C₁-C₆₀ substitué ou non substitué, et
b34 et b35 sont chacun indépendamment un nombre entier de 0 à 3 ; et/ou
dans lequel
le premier composé comprend au moins un composé représenté par la Formule 1-1,
le deuxième composé comprend au moins un composé représenté par la Formule 2-1, et
le troisième composé comprend au moins un composé représenté par la Formule 3-1 : 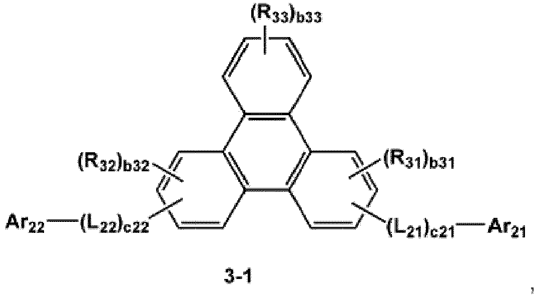
où, dans la Formule 3-1,
L₂₁ à L₂₂ sont chacun indépendamment choisis dans un groupe arylène en C₆-C₃₀ substitué ou non substitué,
c21 et c22 sont chacun indépendamment 1, 2 ou 3,
Ar₂₁ et Ar₂₂ sont chacun indépendamment choisis parmi hydrogène et un groupe aryle en C₆-C₃₀ substitué ou non substitué, où chacun de Ar₂₁ et Ar₂₂ n'est pas hydrogène en même temps,
R₃₁ à R₃₃ sont chacun indépendamment choisis parmi hydrogène, deutérium, -F, -Cl, -Br, -I, un groupe cyano, un groupe alkyle en C₁-C₆₀ substitué ou non substitué, un groupe alkényle en C₂-C₆₀ substitué ou non substitué, un groupe alkynyle en C₂-C₆₀ substitué ou non substitué et un groupe alkoxy en C₁-C₆₀ substitué ou non substitué,
b31 et b32 sont chacun indépendamment un nombre entier de 0 à 3, et
b33 est un nombre entier de 0 à 4 ; et/ou
dans lequel
le premier composé comprend au moins un composé représenté par la Formule 1-1,
le deuxième composé comprend au moins un composé représenté par la Formule 2-1, et
le troisième composé comprend au moins un composé représenté par la Formule 3-4 : 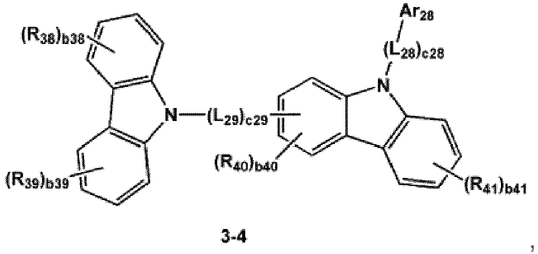
où, dans la Formule 3-4,
L₂₈ à L₂₉ sont chacun indépendamment choisis parmi une liaison simple et un groupe arylène en C₆-C₃₀ substitué ou non substitué,
c28 et c29 sont chacun indépendamment 1, 2 ou 3,
Ar₂₈ est choisi parmi hydrogène et un groupe aryle en C₆-C₃₀ substitué ou non substitué,
R₃₈ à R₄₁ sont chacun indépendamment choisis parmi hydrogène, deutérium, -F, -Cl, -Br, -I, un groupe cyano, un groupe alkyle en C₁-C₆₀ substitué ou non substitué, un groupe alkényle en C₂-C₆₀ substitué ou non substitué, un groupe alkynyle en C₂-C₆₀ substitué ou non substitué et un groupe alkoxy en C₁-C₆₀ substitué ou non substitué,
b38, b39 et b41 sont chacun indépendamment un nombre entier de 0 à 4, et
b40 est un nombre entier de 0 à 2.

14. Dispositif électroluminescent organique selon l'une quelconque des revendications 1-13, dans lequel
la couche d'émission comprend en outre un dopant fluorescent, un dopant phosphorescent, ou une combinaison de ceux-ci.

15. Appareil comprenant le dispositif électroluminescent organique selon l'une quelconque des revendications 1-14.
